(19) Europäisches Patentamt
European Patent Office
Office européen des brevets

(11) **EP 4 130 195 B1**

(12) **EUROPEAN PATENT SPECIFICATION**

(45) Date of publication and mention of the grant of the patent:
**03.09.2025 Bulletin 2025/36**

(21) Application number: **21781833.5**

(22) Date of filing: **09.03.2021**

(51) International Patent Classification (IPC):
***H10K 85/30*** *(2023.01)* ***H10K 85/60*** *(2023.01)*
***C09K 11/06*** *(2006.01)* *H10K 50/11* *(2023.01)*

(52) Cooperative Patent Classification (CPC):
**H10K 85/658; C09K 11/06; H10K 85/341; H10K 85/342; H10K 85/346;** C09K 2211/1007; C09K 2211/1029; C09K 2211/1033; C09K 2211/1037; C09K 2211/104; C09K 2211/1044; C09K 2211/1059; C09K 2211/185; H10K 50/11; H10K 50/171; (Cont.)

(86) International application number:
**PCT/JP2021/009142**

(87) International publication number:
**WO 2021/199948 (07.10.2021 Gazette 2021/40)**

(54) **COMPOSITION AND LIGHT-EMITTING ELEMENT CONTAINING SAME**
ZUSAMMENSETZUNG UND LICHTEMITTIERENDES ELEMENT DAMIT
COMPOSITION ET ÉLÉMENT ÉLECTROLUMINESCENT LA CONTENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2020 JP 2020064369**

(43) Date of publication of application:
**08.02.2023 Bulletin 2023/06**

(73) Proprietor: **Sumitomo Chemical Company, Limited**
**Tokyo 103-6020 (JP)**

(72) Inventors:
- **SAITO, Takakazu**
  **Tsukuba-shi, Ibaraki 300-3294 (JP)**
- **MATSUMOTO, Ryuji**
  **Tsukuba-shi, Ibaraki 300-3294 (JP)**
- **IIJIMA, Takayuki**
  **Tsukuba-shi, Ibaraki 300-3294 (JP)**
- **ASADA, Kohei**
  **Tsukuba-shi, Ibaraki 300-3294 (JP)**
- **ABE, Taichi**
  **Tsukuba-shi, Ibaraki 300-3294 (JP)**

(74) Representative: **J A Kemp LLP**
**80 Turnmill Street**
**London EC1M 5QU (GB)**

(56) References cited:
**WO-A1-2016/143624** **WO-A1-2019/004247**
**WO-A1-2020/203209** **JP-A- 2017 502 516**
**US-A1- 2015 207 077** **US-A1- 2017 166 599**
**US-A1- 2018 040 821**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 130 195 B1

(52) Cooperative Patent Classification (CPC): (Cont.)
H10K 2101/10; H10K 2101/40

## Description

### Technical Field

The present invention relates to a composition and a light emitting device containing the same.

### Background Art

Light emitting devices such as an organic electroluminescent device, and the like can be suitably used, for example, for display and illumination applications. As the light emitting material used for a light emitting layer in a light emitting device, for example, a composition containing a phosphorescent compound FIrpic or Dopant-1, and a compound A-65 having a condensed hetero ring skeleton containing an oxygen atom and a boron atom in the ring is suggested in Patent Document 1.

US 2015/207077 A1, US 2018/040821 A1 and US 2017/166599 A1 disclose OLEDs in which in the light emitting layers compositions are used comprising a polymeric host and a phosphorescent dopant.

[Chemical Formula 1]

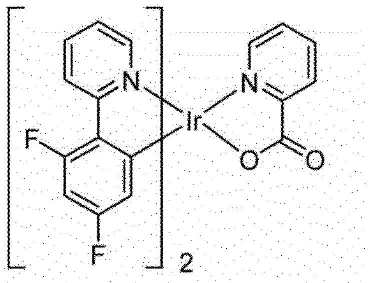

FIrpic

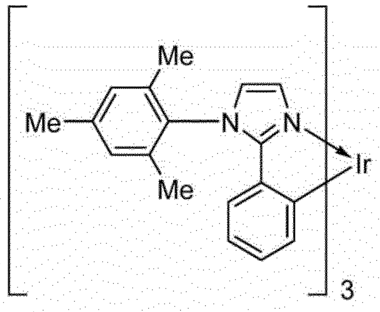

Dopant-1

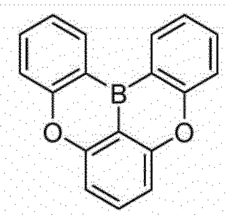

A-65

### Prior Art Document

### Patent Document

Patent Document 1: International Publication No. WO 2017/018326

### Summary of the Invention

### Problem to be Solved by the Invention

However, a light emitting device fabricated using the above-described composition is not necessarily sufficient in light emission efficiency.

Then, the present invention has an object of providing a composition which is useful for production of a light emitting device excellent in light emission efficiency.

### Means for Solving the Problem

The present invention provides the following [1] to [10].

[1] A composition comprising

a phosphorescent compound represented by the formula (1) and
a compound (F) having a condensed hetero ring skeleton containing at least one atom (a) selected from the group consisting of a nitrogen atom and a boron atom in the ring,
wherein if the value of the energy level of the lowest triplet excited state of the above-described phosphorescent compound is expressed as $T_P$ (eV), the value of the energy level of the lowest triplet excited state of the above-described compound (F) is expressed as $T_F$ (eV) and the number of the above-described atom (a) in the above-described condensed hetero ring skeleton per 1000 of the molecular weight of the above-described compound (F) is expressed as $N_f$, then, the formula (A) and the formula (B) are satisfied:

$$|T_P|-|T_F| \geq 0.15 \qquad (A)$$

$$0.01 \leq N_f \leq 4.5 \qquad (B)$$

[Chemical Formula 2]

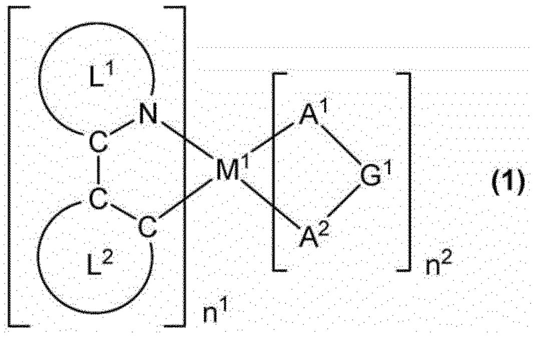

(1)

[wherein,

$M^1$ represents a ruthenium atom, a rhodium atom, a palladium atom, an iridium atom or a platinum atom. $n^1$ represents an integer of 1 or more, $n^2$ represents an integer of 0 or more, and $n^1+n^2$ is 2 or 3. $n^1+n^2$ is 3 when $M^1$ is a ruthenium atom, a rhodium atom or an iridium atom, while $n^1+n^2$ is 2 when $M^1$ is a palladium atom or a platinum atom.

Ring $L^1$ represents an aromatic hetero ring, and this ring optionally has a substituent. When a plurality of the substituents are present, they may be the same or different and may be combined together to form a ring together with atoms to which they are attached. When a plurality of Ring $L^1$ are present, they may be the same or different.

Ring $L^2$ represents an aromatic hydrocarbon ring, and this ring optionally has a substituent. When a plurality of the substituents are present, they may be the same or different and may be combined together to form a ring together with atoms to which they are attached. When a plurality of Ring $L^2$ are present, they may be the same or different.

The substituent which Ring $L^1$ optionally has and the substituent which Ring $L^2$ optionally has may be combined together to form a ring together with atoms to which they are attached.

At least one ring selected from the group consisting of Ring $L^1$ and Ring $L^2$ has at least one group represented by the formula (1-T). When a plurality of the groups represented by the formula (1-T) are present, they may be the same or different.

$A^1$-$G^1$-$A^2$ represents an anionic bidentate ligand. $A^1$ and $A^2$ each independently represent a carbon atom, an oxygen atom or a nitrogen atom, and these atoms may be ring-constituent atoms. $G^1$ represents a single bond, or an atomic group constituting a bidentate ligand together with $A^1$ and $A^2$. When a plurality of $A^1$-$G^1$-$A^2$ are present, they may be the same or different.]

[Chemical Formula 3]

$$-R^{1T} \qquad \textbf{(1-T)}$$

[wherein, $R^{1T}$ represents an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group, and these groups optionally have a substituent.].

[2] The composition according to [1], wherein the phosphorescent compound represented by the above-described formula (1) is a phosphorescent compound represented by the formula (1-A):

[Chemical Formula 4]

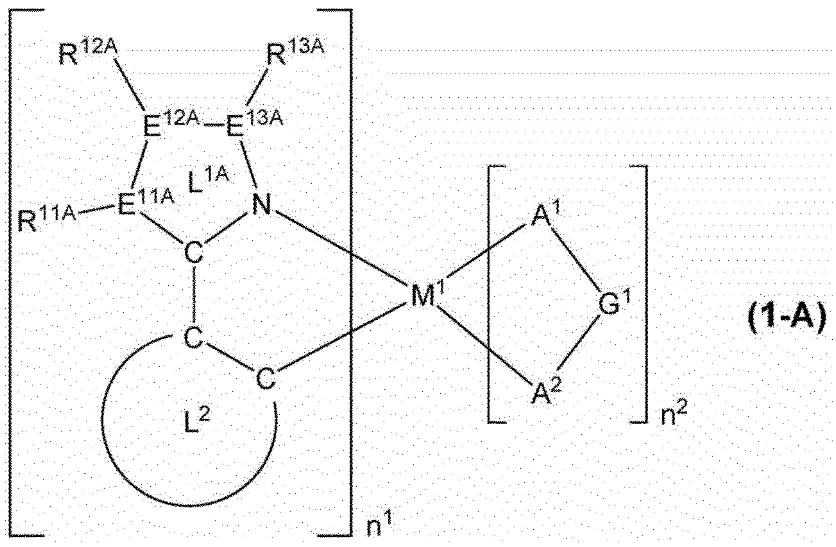
(1-A)

[wherein, $M^1$, $n^1$, $n^2$, Ring $L^2$ and $A^1$-$G^1$-$A^2$ represent the same meaning as described above.

Ring $L^{1A}$ represent a triazole ring or a diazole ring constituted of a nitrogen atom, a carbon atom, $E^{11A}$, $E^{12A}$ and $E^{13A}$. When a plurality of Ring $L^{1A}$ are present, they may be the same or different.

$E^{11A}$, $E^{12A}$ and $E^{13A}$ each independently represent a nitrogen atom or a carbon atom. When a plurality of $E^{11A}$, $E^{12A}$ and $E^{13A}$ are present, they may be the same or different at each occurrence.

$R^{11A}$, $R^{12A}$ and $R^{13A}$ each independently represent a hydrogen atom or a group represented by the above-described formula (1-T). When a plurality of $R^{11A}$, $R^{12A}$ and $R^{13A}$ are present, they may be the same or different at each occurrence. $R^{11A}$ and $R^{12A}$ may be combined together to form a ring together with atoms to which they are attached. $R^{12A}$ and $R^{13A}$ may be combined together to form a ring together with atoms to which they are attached. $R^{11A}$ and the substituent which Ring $L^2$ optionally has may be combined together to form a ring together with atoms to which they are attached.

At least one selected from the group consisting of $R^{11A}$, $R^{12A}$, $R^{13A}$, and the substituent which Ring $L^2$ optionally has is a group represented by the above-described formula (1-T). When a plurality of the groups represented by the above-described formula (1-T) are present, they may be the same or different.

When $E^{11A}$ is a nitrogen atom, then, $R^{11A}$ may be present or absent. When $E^{12A}$ is a nitrogen atom, then, $R^{12A}$ may be present or absent. When $E^{13A}$ is a nitrogen atom, then, $R^{13A}$ may be present or absent.].

[3] The composition according to [2], wherein the phosphorescent compound represented by the above-described formula (1-A) is a phosphorescent compound represented by the formula (1-A-2):

[Chemical Formula 5]

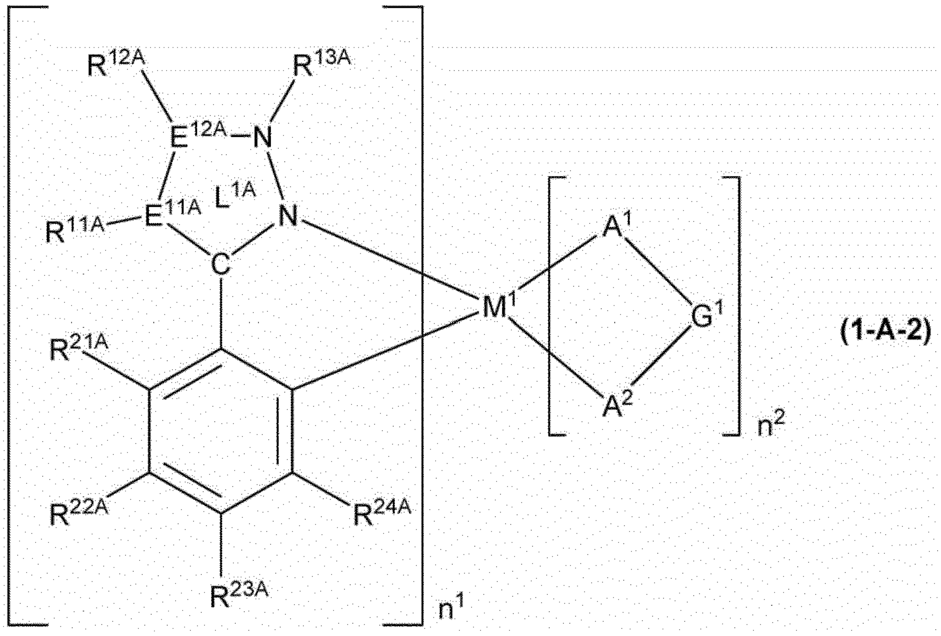

(1-A-2)

[wherein,

$M^1$, $n^1$, $n^2$, Ring $L^{1A}$, $E^{11A}$, $E^{12A}$, $R^{11A}$, $R^{12A}$, $R^{13A}$ and $A^1$-$G^1$-$A^2$ represent the same meaning as described above. $R^{21A}$, $R^{22A}$, $R^{23A}$ and $R^{24A}$ each independently represent a hydrogen atom or a group represented by the above-described formula (1-T). When a plurality of $R^{21A}$, $R^{22A}$, $R^{23A}$ and $R^{24A}$ are present, they may be the same or different at each occurrence. $R^{21A}$ and $R^{22A}$ may be combined together to form a ring together with atoms to which they are attached. $R^{22A}$ and $R^{23A}$ may be combined together to form a ring together with atoms to which they are attached. $R^{23A}$ and $R^{24A}$ may be combined together to form a ring together with atoms to which they are attached. $R^{11A}$ and $R^{21A}$ may be combined together to form a ring together with atoms to which they are attached.
At least one selected from the group consisting of $R^{11A}$, $R^{12A}$, $R^{13A}$, $R^{21A}$, $R^{22A}$, $R^{23A}$ and $R^{24A}$ is a group represented by the above-described formula (1-T).].

[4] The composition according to [1], wherein the phosphorescent compound represented by the above-described formula (1) is a phosphorescent compound represented by the formula (1-B):

[Chemical Formula 6]

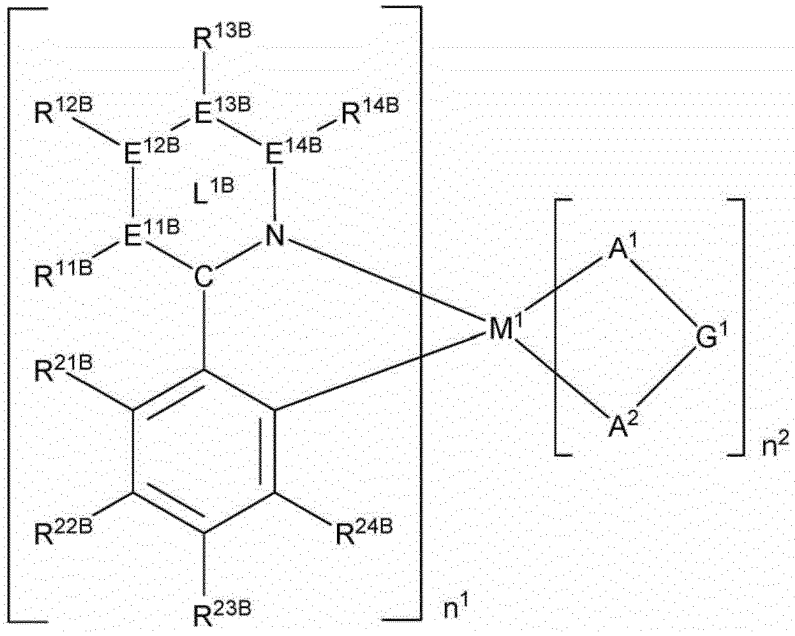

(1-B)

[wherein,

$M^1$, $n^1$, $n^2$ and $A^1$-$G^1$-$A^2$ represent the same meaning as described above.

$E^{11B}$, $E^{12B}$, $E^{13B}$ and $E^{14B}$ each independently represent a nitrogen atom or a carbon atom. When a plurality of $E^{11B}$, $E^{12B}$, $E^{13B}$ and $E^{14B}$ are present, they may be the same or different at each occurrence. When $E^{11B}$ is a nitrogen atom, then, $R^{11B}$ is absent. When $E^{12B}$ is a nitrogen atom, then, $R^{12B}$ is absent. When $E^{13B}$ is a nitrogen atom, then, $R^{13B}$ is absent. When $E^{14B}$ is a nitrogen atom, then, $R^{14B}$ is absent.

Ring $L^{1B}$ represents a pyridine ring or a pyrimidine ring constituted of a nitrogen atom, a carbon atom, $E^{11B}$, $E^{12B}$, $E^{13B}$ and $E^{14B}$. When a plurality of Ring $L^{1B}$ are present, they may be the same or different.

$R^{11B}$, $R^{12B}$, $R^{13B}$, $R^{14B}$, $R^{21B}$, $R^{22B}$, $R^{23B}$ and $R^{24B}$ each independently represent a hydrogen atom or a group represented by the above-described formula (1-T). When a plurality of $R^{11B}$, $R^{12B}$, $R^{13B}$, $R^{14B}$, $R^{21B}$, $R^{22B}$, $R^{23B}$ and $R^{24B}$ are present, they may be the same or different at each occurrence. $R^{11B}$ and $R^{12B}$, $R^{12B}$ and $R^{13B}$, $R^{13B}$ and $R^{14B}$, $R^{11B}$ and $R^{21B}$, $R^{21B}$ and $R^{22B}$, $R^{22B}$ and $R^{23B}$, and $R^{23B}$ and $R^{24B}$ may each be combined together to form a ring together with atoms to which they are attached. At least one selected from the group consisting of $R^{11B}$, $R^{12B}$, $R^{13B}$, $R^{14B}$, $R^{21B}$, $R^{22B}$, $R^{23B}$ and $R^{24B}$ is a group represented by the above-described formula (1-T).].

[5] The composition according to any one of [1] to [4], wherein the above-described $R^{1T}$ is an alkyl group, a cycloalkyl group, a group represented by the formula (D-A), a group represented by the formula (D-B) or a group represented by the formula (D-C):

[Chemical Formula 7]

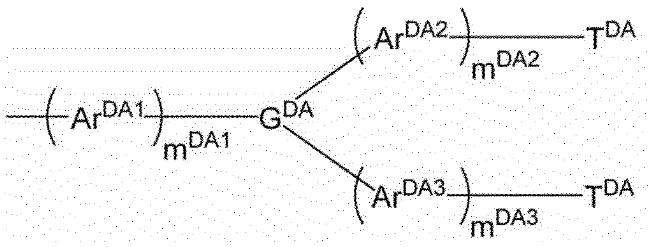

(D-A)

[wherein,

$m^{DA1}$, $m^{DA2}$ and $m^{DA3}$ each independently represent an integer of 0 or more.

$G^{DA}$ represents a nitrogen atom, an aromatic hydrocarbon group or a hetero ring group, and these groups optionally have a substituent.
$Ar^{DA1}$, $Ar^{DA2}$ and $Ar^{DA3}$ each independently represent an arylene group or a divalent hetero ring group, and these groups optionally have a substituent. When a plurality of $Ar^{DA1}$, $Ar^{DA2}$ and $Ar^{DA3}$ are present, they may be the same or different at each occurrence.
$T^{DA}$ represents an aryl group or a monovalent hetero ring group, and these groups optionally have a substituent. A plurality of $T^{DA}$ may be the same or different.]

[Chemical Formula 8]

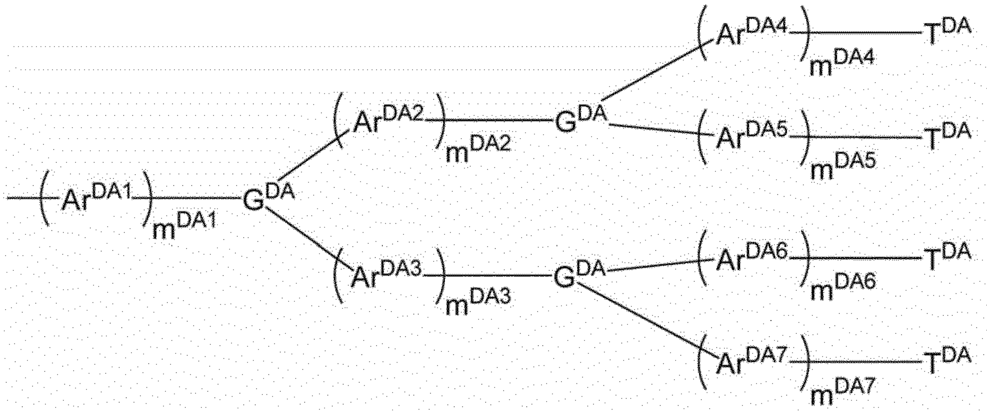

(D-B)

[wherein,

$m^{DA1}$, $m^{DA2}$, $m^{DA3}$, $m^{DA4}$, $m^{DA5}$ , $m^{DA6}$ and $m^{DA7}$ each independently represent an integer of 0 or more.
$G^{DA}$ represents a nitrogen atom, an aromatic hydrocarbon group or a hetero ring group, and these groups optionally have a substituent. A plurality of $G^{DA}$ may be the same or different.
$Ar^{DA1}$, $Ar^{DA2}$ , $Ar^{DA3}$ , $Ar^{DA4}$ , $Ar^{DA5}$, $Ar^{DA6}$ and $Ar^{DA7}$ each independently represent an arylene group or a divalent hetero ring group, and these groups optionally have a substituent. When a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence.
$T^{DA}$ represents an aryl group or a monovalent hetero ring group, and these groups optionally have a substituent. A plurality of $T^{DA}$ may be the same or different.]

[Chemical Formula 9]

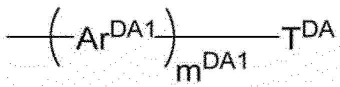

(D-C)

[wherein,

$m^{DA1}$ represents an integer of 0 or more.
$Ar^{DA1}$ represents an arylene group or a divalent hetero ring group, and these groups optionally have a substituent. When a plurality of $Ar^{DA1}$ are present, they may be the same or different.
$T^{DA}$ represents an aryl group or a monovalent hetero ring group, and these groups optionally have a substituent.].

[6] The composition according to any one of [1] to [5], wherein if the value of the energy level in the lowest singlet excited state of the above-described compound (F) is expressed as $S_F$ (eV), then, the formula (C) is satisfied:

$$|T_P| - |S_F| \geq -0.30 \qquad (C).$$

[7] The composition according to any one of [1] to [6], wherein the above-described condensed hetero ring skeleton has both a nitrogen atom and a boron atom in the ring, as the above-described atom (a).

[8] The composition according to any one of [1] to [7], wherein the composition further comprises a compound represented by the formula (H-1):

[Chemical Formula 10]

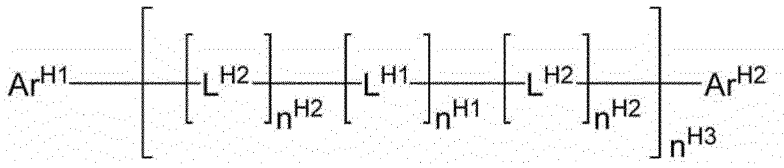

(H-1)

[wherein,

$Ar^{H1}$ and $Ar^{H2}$ each independently represent an aryl group or a monovalent hetero ring group, and these groups optionally have a substituent.

$n^{H1}$ and $n^{H2}$ each independently represent 0 or 1. When a plurality of $n^{H1}$ are present, they may be the same or different. A plurality of $n^{H2}$ may be the same or different.

$n^{H3}$ represents an integer of 0 or more.

$L^{H1}$ represents an arylene group, a divalent hetero ring group or a group represented by $-[C(R^{H11})2]n_{H11}-$, and these groups optionally have a substituent. When a plurality of $L^{H1}$ are present, they may be the same or different. $n^{H11}$ represents an integer of 1 or more and 10 or less. $R^{H11}$ represents a hydrogen atom, an alkyl group, a cycloalkyl group, an alkoxy group, a cycloalkoxy group, an aryl group or a monovalent hetero ring group, and these groups optionally have a substituent. A plurality of $R^{H11}$ may be the same or different and may be combined together to form a ring together with carbon atoms to which they are attached.

$L^{H2}$ represents a group represented by $-N(-L^{H21}-R^{H21})-$. When a plurality of $L^{H2}$ are present, they may be the same or different.

$L^{H21}$ represents a single bond, an arylene group or a divalent hetero ring group, and these groups optionally have a substituent. $R^{H21}$ represents a hydrogen atom, an alkyl group, a cycloalkyl group, an aryl group or a monovalent hetero ring group, and these groups optionally have a substituent.].

[9] The composition according to any one of [1] to [8], wherein the composition further comprises at least one material selected from the group consisting of a hole transporting material, a hole injection material, an electron transporting material, an electron injection material, a light emitting material, an antioxidant and a solvent.

[10] A light emitting device comprising the composition as described in any one of [1] to [9].

Effect of the Invention

According to the present invention, it is possible to provide a composition which is useful for production of a light emitting device excellent in light emission efficiency. Further, according to the present invention, it is possible to provide a light emitting device containing the composition.

Modes for Carrying Out the Invention

Suitable embodiments of the present invention will be illustrated in detail below.

<Explanation of common terms>

Terms commonly used in the present specification have the following meanings unless otherwise stated.

"Room temperature" denotes 25°C.

Me represents a methyl group, Et represents an ethyl group, Bu represents a butyl group, i-Pr represents an isopropyl group, and t-Bu represents a tert-butyl group.

A hydrogen atom may be a heavy hydrogen atom, or may be a light hydrogen atom.

The "low molecular compound" means a compound having no molecular weight distribution and having a molecular weight of $1\times10^4$ or less.

The "polymer compound" means a polymer having molecular weight distribution and having a polystyrene-equivalent number-average molecular weight of $1\times10^3$ or more (for example, $1\times10^3$ to $1\times10^8$)

The "constitutional unit" means a unit occurring once or more times in a polymer compound. A constitutional unit

occurring twice or more times in a polymer compound is generally referred to also as "repeating unit".

The polymer compound may be any of a block copolymer, a random copolymer, an alternative copolymer, or a graft copolymer, and may also be in another form.

The end group of the polymer compound is preferably a stable group since if a polymerization active group remains intact there, there is a possibility of a decrease in a light emitting property or luminance life when the polymer compound is used for fabrication of a light emitting device. The end group of the polymer compound is preferably a group conjugatively bonded to the main chain and includes, for example, an aryl group or a monovalent hetero ring group bonding to the main chain of the polymer compound via a carbon-carbon bond.

The "alkyl group" may be any of linear or branched. The number of carbon atoms of the linear alkyl group is, not including the number of carbon atoms of the substituent, usually 1 to 50, preferably 1 to 20, and more preferably 1 to 10. The number of carbon atoms of the branched alkyl group is, not including the number of carbon atoms of the substituent, usually 3 to 50, preferably 3 to 20, and more preferably 4 to 10.

The alkyl group optionally has a substituent. The alkyl group includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group. Further, the alkyl group may also be a group obtained by substituting a part or all of hydrogen atoms in these groups with a substituent (for example, a cycloalkyl group, an alkoxy group, a cycloalkoxy group, an aryl group, a fluorine atom, and the like). Such an alkyl group includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group).

The number of carbon atoms of the "cycloalkyl group" is, not including the number of carbon atoms of the substituent, usually 3 to 50, and preferably 4 to 10. The cycloalkyl group optionally has a substituent. The cycloalkyl group includes, for example, a cyclohexyl group, a cyclohexylmethyl group, and a cyclohexylethyl group.

The number of carbon atoms of the "alkylene group" is, not including the number of carbon atoms of the substituent, usually 1 to 20, preferably 1 to 15, and more preferably 1 to 10. The alkylene group optionally has a substituent. The alkylene group includes, for example, a methylene group, an ethylene group, a propylene group, a butylene group, a hexylene group, and an octylene group.

The number of carbon atoms of the "cycloalkylene group" is, not including the number of carbon atoms of the substituent, usually 3 to 20. The cycloalkylene group optionally has a substituent. The cycloalkylene group includes, for example, a cyclohexylene group.

The "aromatic hydrocarbon group" means a group obtained by removing from an aromatic hydrocarbon one or more hydrogen atoms bonding directly to carbon atoms constituting the ring. The group obtained by removing from an aromatic hydrocarbon one hydrogen atom bonding directly to a carbon atom constituting the ring is referred to also as "aryl group". The group obtained by removing from an aromatic hydrocarbon two hydrogen atoms bonding directly to carbon atoms constituting the ring is referred to also as "arylene group".

The number of carbon atoms of the aromatic hydrocarbon group is, not including the number of carbon atoms of the substituent, usually 6 to 60, preferably 6 to 30, and more preferably 6 to 18.

The "aromatic hydrocarbon group" includes, for example, groups obtained by removing from a monocyclic aromatic hydrocarbon (including, for example, benzene) or a polycyclic aromatic hydrocarbon (including, for example, bicyclic aromatic hydrocarbons such as naphthalene, indene, and the like; tricyclic aromatic hydrocarbons such as anthracene, phenanthrene, dihydrophenanthrene, fluorene, and the like; tetracyclic aromatic hydrocarbons such as triphenylene, naphthacene, benzofluorene, pyrene, chrysene, fluoranthene, and the like; pentacyclic aromatic hydrocarbons such as dibenzofluorene, perylene, benzofluoranthene, and the like; hexacyclic aromatic hydrocarbons such as spirobifluorene, and the like; heptacyclic aromatic hydrocarbons such as benzospirobifluorene, acenaphthofluoranthene, and the like; and, octacyclic aromatic hydrocarbons such as dibenzospirobifluorene, and the like) one or more hydrogen atoms bonding directly to carbon atoms constituting the ring. The aromatic hydrocarbon group includes groups obtained by bonding a plurality of these groups. The aromatic hydrocarbon group optionally has a substituent.

The arylene group is preferably a group represented by the formula (A-1) to the formula (A-23). The arylene group may be a group obtained by bonding a plurality of these groups.

[Chemical Formula 11]

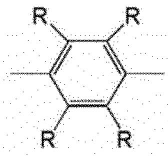
(A-1)

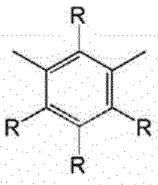
(A-2)

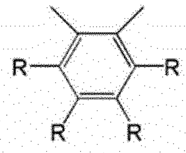
(A-3)

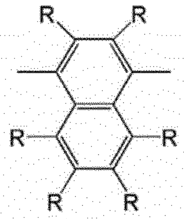
(A-4)

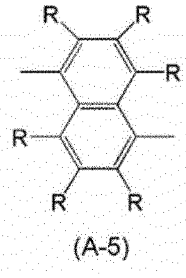
(A-5)

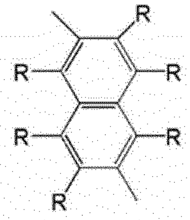
(A-6)

[Chemical Formula 12]

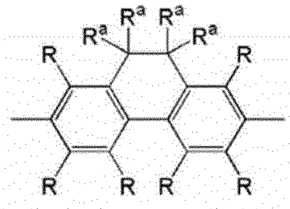
(A-7)

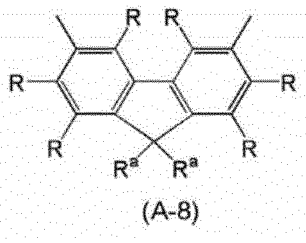
(A-8)

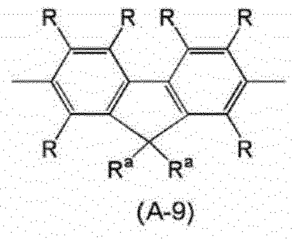
(A-9)

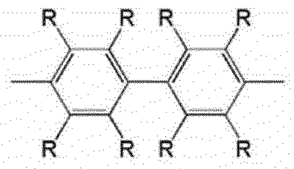
(A-10)

[Chemical Formula 13]

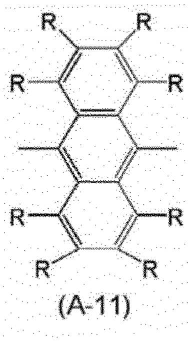
(A-11)

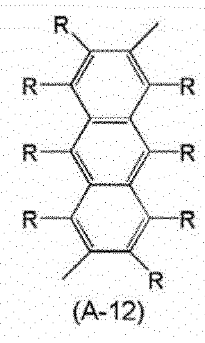
(A-12)

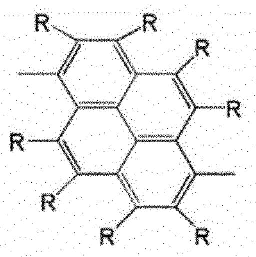
(A-13)

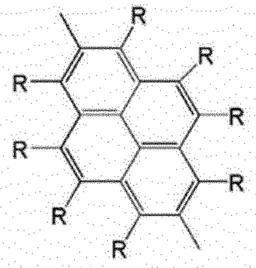
(A-14)

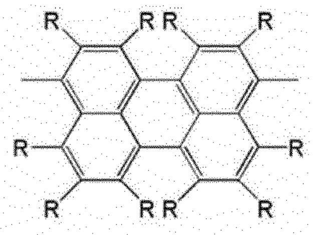
(A-15)

[Chemical Formula 14]

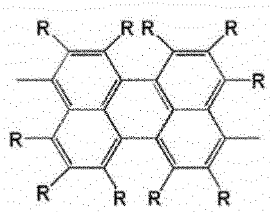
(A-16)

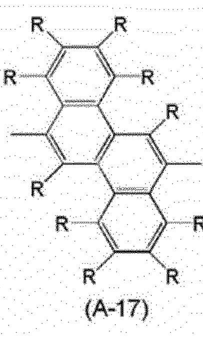
(A-17)

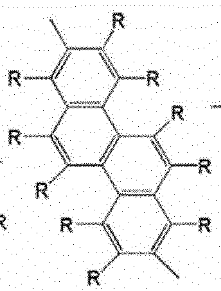
(A-18)

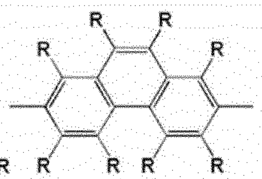
(A-19)

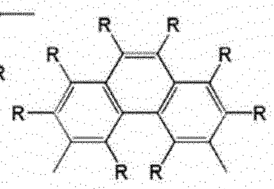
(A-20)

[Chemical Formula 15]

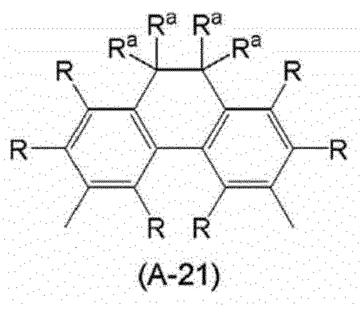
(A-21)

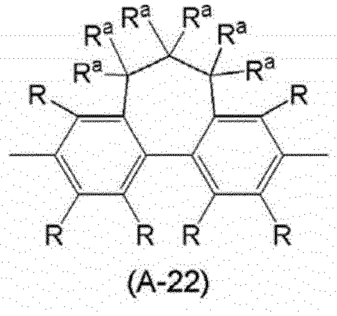
(A-22)

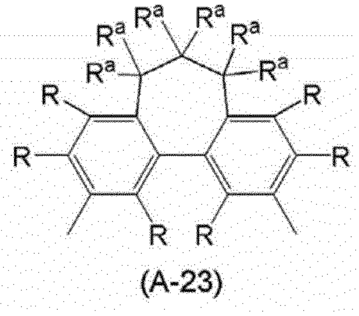
(A-23)

In the formulae, R and $R^a$ each independently represent a hydrogen atom, an alkyl group, a cycloalkyl group, an aryl group or a monovalent hetero ring group. A plurality of R and $R^a$ may be the same or different at each occurrence, and groups $R^a$ may be combined together to form a ring together with atoms to which they are attached.

The "alkoxy group" may be any of linear or branched. The number of carbon atoms of the linear alkoxy group is, not including the number of carbon atoms of the substituent, usually 1 to 40, and preferably 1 to 10. The number of carbon atoms of the branched alkoxy group is, not including the number of carbon atoms of the substituent, usually 3 to 40, and preferably 4 to 10.

The alkoxy group optionally has a substituent. The alkoxy group includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group.

The number of carbon atoms of the "cycloalkoxy group" is, not including the number of carbon atoms of the substituent, usually 3 to 40, and preferably 4 to 10. The cycloalkoxy group optionally has a substituent. The cycloalkoxy group includes, for example, a cyclohexyloxy group.

The number of carbon atoms of the "aryloxy group" is, not including the number of carbon atoms of the substituent, usually 6 to 60, and preferably 6 to 48. The aryloxy group optionally has a substituent. The aryloxy group includes, for example, a phenoxy group, a 1-naphthyloxy group, a 2-naphthyloxy group, a 1-anthracenyloxy group, a 9-anthracenyloxy group, and a 1-pyrenyloxy group.

The "hetero ring group" means a group obtained by removing from a heterocyclic compound one or more hydrogen atoms bonding directly to carbon atoms or hetero atoms constituting the ring. Of hetero ring groups, "aromatic hetero ring group" which is a group obtained by removing from an aromatic heterocyclic compound one or more hydrogen atoms bonding directly to carbon atoms or hetero atoms constituting the ring is preferred. A group obtained by removing from a heterocyclic compound p hydrogen atoms bonding directly to carbon atoms or hetero atoms constituting the ring (p represents an integer of 1 or more) is referred to also as "p-valent hetero ring group". A group obtained by removing from an aromatic heterocyclic compound p hydrogen atoms bonding directly to carbon atoms or hetero atoms constituting the ring is referred to also as "p-valent aromatic hetero ring group".

The "aromatic heterocyclic compound" includes, for example, compounds in which the hetero ring itself shows aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, and compounds in which an aromatic ring is condensed to the hetero ring even if the hetero ring itself shows no aromaticity, such as phenoxazine, phenothiazine, dibenzoborole, dibenzosilole, benzopyran, and the like.

The number of carbon atoms of the hetero ring group is, not including the number of carbon atoms of the substituent, usually 1 to 60, preferably 2 to 40, and more preferably 3 to 20. The number of hetero atoms of the aromatic hetero ring group is, not including the number of hetero atoms of the substituent, usually 1 to 30, preferably 1 to 10, more preferably 1 to 5, and further preferably 1 to 3.

The hetero ring group includes, for example, groups obtained by removing from a monocyclic heterocyclic compound (including, for example, furan, thiophene, pyrrole, diazole, triazole, pyridine, diazabenzene and triazine) or a polycyclic heterocyclic compound (including, for example, bicyclic heterocyclic compounds such as azanaphthalene, diazanaphthalene, benzofuran, indole, benzodiazole, benzothiadiazole, and the like; tricyclic heterocyclic compounds such as dibenzofuran, dibenzothiophene, dibenzoborole, dibenzosilole, dibenzophosphole, dibenzoselenophene, phenoxazine, phenothiazine, 9,10-dihydroacridine, 5,10-dihydrophenazine, phenazaborine, phenophosphazine, phenoselenazine, phenazasiline, azaanthracene, diazaanthracene, azaphenanthrene, diazaphenanthrene, and the like; tetracyclic heterocyclic compounds such as hexaazatriphenylene, benzoindole, benzonaphthofuran, and the like; pentacyclic heterocyclic compounds such as dibenzocarbazole, indolocarbazole, indenocarbazole, and the like; hexacyclic heterocyclic compounds such as carbazolocarbazole, benzoindolocarbazole, benzoindenocarbazole, and the like; and, heptacyclic heterocyclic compounds such as dibenzoindolocarbazole, and the like) one or more hydrogen atoms bonding directly to atoms constituting the ring. The hetero ring group includes groups obtained by bonding a plurality of these

groups. The hetero ring group optionally has a substituent.

The divalent hetero ring group is preferably a group represented by the formula (AA-1) to the formula (AA-34). The divalent hetero ring group includes groups obtained by bonding a plurality of these groups.

[Chemical Formula 16]

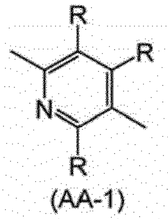
(AA-1)
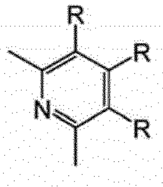
(AA-2)
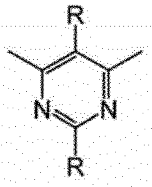
(AA-3)
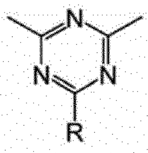
(AA-4)
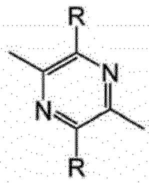
(AA-5)
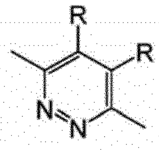
(AA-6)
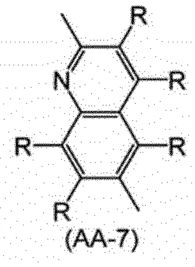
(AA-7)

[Chemical Formula 17]

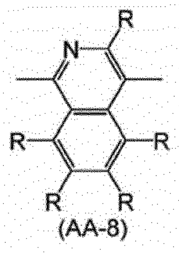
(AA-8)
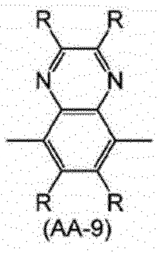
(AA-9)
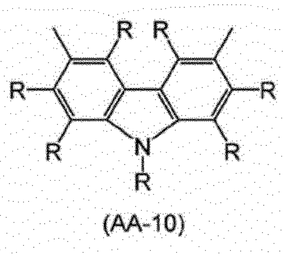
(AA-10)
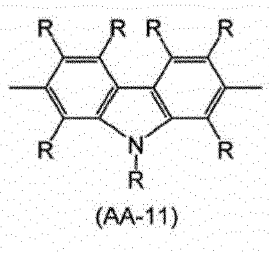
(AA-11)
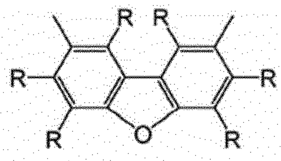
(AA-12)

[Chemical Formula 18]

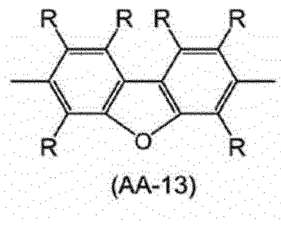
(AA-13)
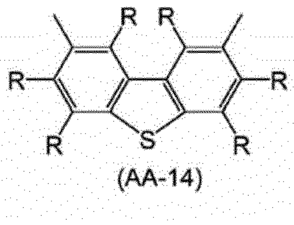
(AA-14)
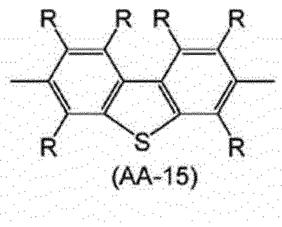
(AA-15)
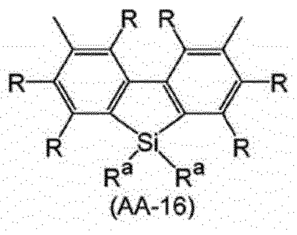
(AA-16)

[Chemical Formula 19]

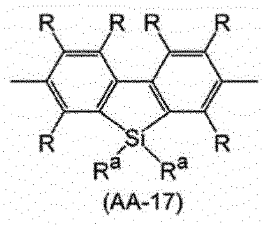
(AA-17)
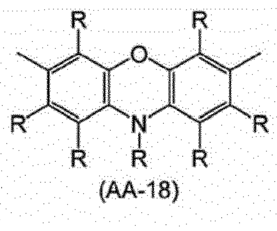
(AA-18)
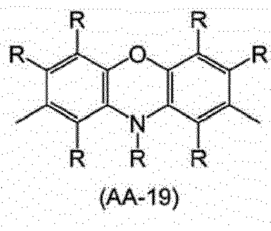
(AA-19)
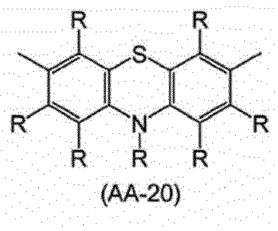
(AA-20)

[Chemical Formula 20]

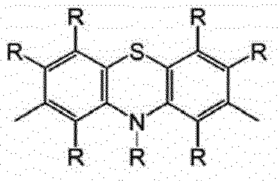
(AA-21)
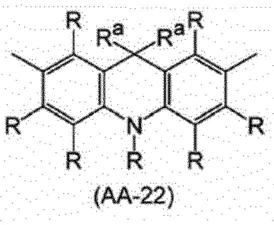
(AA-22)
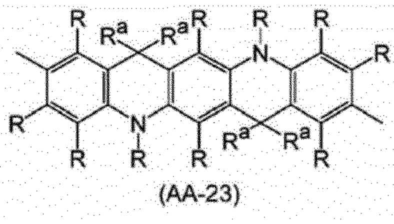
(AA-23)
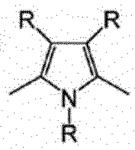
(AA-24)
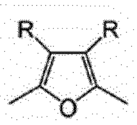
(AA-25)

[Chemical Formula 21]

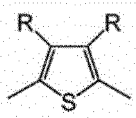
(AA-26)
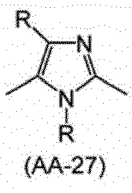
(AA-27)
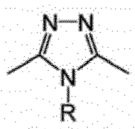
(AA-28)
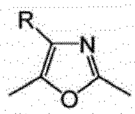
(AA-29)
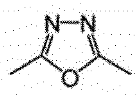
(AA-30)
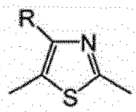
(AA-31)
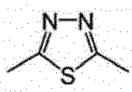
(AA-32)

[Chemical Formula 22]

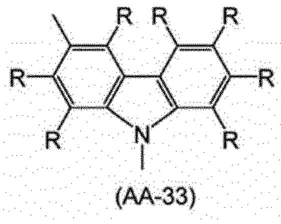
(AA-33)
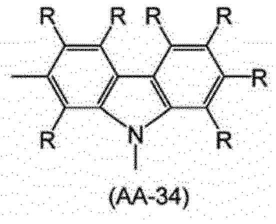
(AA-34)

In the formulae, R and $R^a$ represent the same meaning as described above.

The "halogen atom" denotes a fluorine atom, a chlorine atom, a bromine atom or an iodine atom.

The "amino group" optionally has a substituent, and substituted amino groups (namely, secondary amino groups or tertiary amino groups, more preferably tertiary amino groups) are preferred. The substituent which an amino group has is preferably an alkyl group, a cycloalkyl group, an aryl group or a monovalent hetero ring group. When a plurality of the substituents which an amino group has are present, they may be the same or different and may be combined together to form a ring together with nitrogen atoms to which they are attached.

The substituted amino group includes, for example, a dialkylamino group, a dicycloalkylamino group, and a diarylamino group.

The amino group includes, for example, a dimethylamino group, a diethylamino group, a diphenylamino group, a bis(4-methylphenyl)amino group, a bis(4-tert-butylphenyl)amino group, and a bis(3,5-di-tert-butylphenyl)amino group.

The "alkenyl group" may be any of linear or branched. The number of carbon atoms of the linear alkenyl group is, not including the number of carbon atoms of the substituent, usually 2 to 30, and preferably 3 to 20. The number of carbon atoms of the branched alkenyl group is, not including the number of carbon atoms of the substituent, usually 3 to 30, and preferably 4 to 20.

The number of carbon atoms of the "cycloalkenyl group" is, not including the number of carbon atoms of the substituent, usually 3 to 30, and preferably 4 to 20.

The alkenyl group and the cycloalkenyl group optionally have a substituent. The alkenyl group includes, for example, a vinyl group, 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and groups obtained by substituting a part or all of hydrogen atoms in these groups with a substituent. The cycloalkenyl group includes, for example, a cyclohexenyl group, a cyclohexadiethyl group, a cyclooctatrienyl group and a norbornylenyl group, and groups obtained by substituting a part or all of hydrogen atoms in these groups with a substituent.

The "alkynyl group" may be any of linear or branched. The number of carbon atoms of the alkynyl group is, not including carbon atoms of the substituent, usually 2 to 20, and preferably 3 to 20. The number of carbon atoms of the branched alkynyl group is, not including carbon atoms of the substituent, usually 4 to 30, and preferably 4 to 20.

The number of carbon atoms of the "cycloalkynyl group" is, not including carbon atoms of the substituent, usually

4 to 30, and preferably 4 to 20.

The alkynyl group and the cycloalkynyl group optionally have a substituent. The alkynyl group includes, for example, an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and groups obtained by substituting a part or all of hydrogen atoms in these groups with a substituent. The cycloalkynyl group includes, for example, a cyclooctynyl group.

The "cross-linkable group" is a group capable of generating a new bond by being subjected to heating, irradiation with ultraviolet light, irradiation with near-ultraviolet light, irradiation with visible light, irradiation with infrared light, radical reaction, and the like. The cross-linkable group is preferably a group represented by any of the formula (B-1) to the formula (B-18). These groups optionally have a substituent.

[Chemical Formula 23]

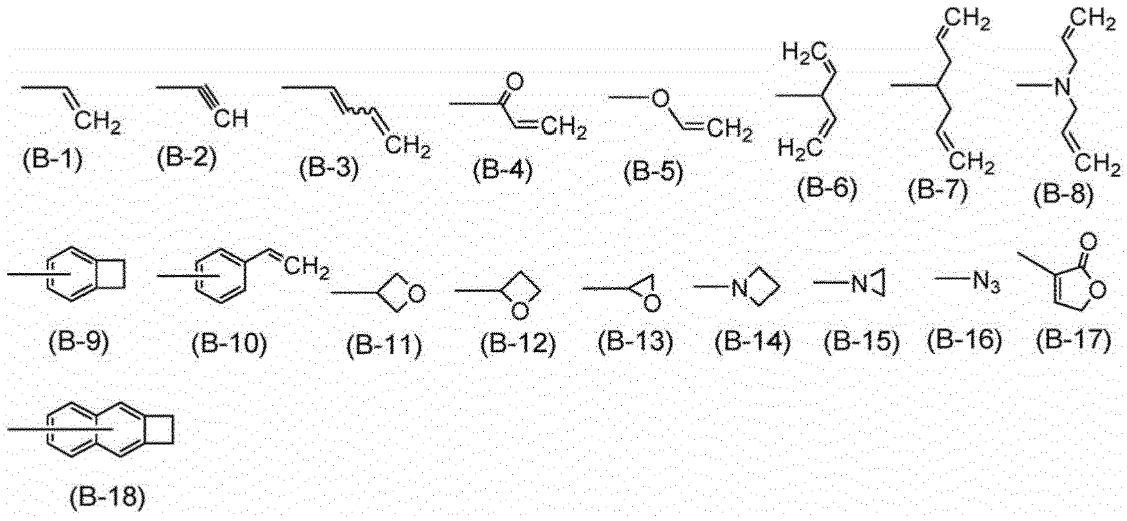

(B-1) (B-2) (B-3) (B-4) (B-5) (B-6) (B-7) (B-8)

(B-9) (B-10) (B-11) (B-12) (B-13) (B-14) (B-15) (B-16) (B-17)

(B-18)

The "substituent" denotes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may be a cross-linkable group. When a plurality of the substituents are present, they may be combined together to form a ring together with atoms to which they are attached, but it is preferable that they do not form a ring.

<Composition for light emitting device>

The composition of the present embodiment contains a phosphorescent compound represented by the formula (1) and a compound having a condensed hetero ring skeleton containing at least one atom selected from the group consisting of a nitrogen atom and a boron atom (hereinafter, referred to as atom (a)) in the ring (hereinafter, referred to as compound (F)). In the composition of the present embodiment, the phosphorescent compound and the compound (F) each may be used singly or in combination of two or more.

The composition of the present embodiment can make the compound (F) emit light efficiently owing to energy transfer from the phosphorescent compound to the compound (F), since $|T_P|-|T_F|$ is 0.15 or more. For this reason, the composition of the present embodiment can be suitably used as a composition for light emitting device.

In the composition of the present embodiment, the content of the compound (F) is usually 0.01 parts by mass to 99 parts by mass, when the sum of the phosphorescent compound and the compound (F) is taken as 100 parts by mass, and it is preferably 0.05 parts by mass to 50 parts by mass, more preferably 0.1 parts by mass to 30 parts by mass, further preferably 0.5 parts by mass to 25 parts by mass, and particularly preferably 1 part by mass to 20 parts by mass, since a light emitting device containing the composition of the present embodiment is more excellent in light emission efficiency.

The value of the energy level in the lowest singlet excited state of the phosphorescent compound (hereinafter, referred to also as $S_P$) and the value of the energy level in the lowest singlet excited state of the compound (F) (hereinafter, referred to also as $S_F$) can be determined by quantum chemical calculation, but they can also be determined by converting the maximum peak wavelength at the longest wavelength side of light emission spectrum at room temperature of each compound (hereinafter, referred to also as "$\lambda_{PL,RT}$") into energy value. When the phosphorescent compound and the compound (F) are low molecular compounds, it is preferable that $S_P$ and $S_F$ are each determined by quantum chemical calculation. When the phosphorescent compound and the compound (F) are polymer compounds, it is preferable that $S_P$

and $S_F$ are each determined by converting $\lambda_{PL,RT}$ into energy value.

The value of the energy level in the lowest triplet excited state of the phosphorescent compound ($T_P$) and the value of the energy level in the lowest triplet excited state of the compound (F) ($T_F$) are determined by quantum chemical calculation, but they can also be determined by converting the maximum peak wavelength at the longest wavelength side of light emission spectrum at 77K of each compound (hereinafter, referred to also as "$\lambda_{PL,77K}$") into energy value. When the phosphorescent compound and the compound (F) are low molecular compounds, it is preferable that $T_P$ and $T_F$ are each determined by quantum chemical calculation. When the phosphorescent compound and the compound (F) are polymer compounds, it is preferable that $T_P$ and $T_F$ are each determined by converting $\lambda_{PL,77K}$ into energy value.

$\lambda_{PL,RT}$ and $\lambda_{PL,77K}$ of the phosphorescent compound and the compound (F) can each be measured using a solution method or a film forming method.

When a solution method is used, a compound is dissolved in an organic solvent such as xylene, toluene, chloroform, tetrahydrofuran, 2-methyltetrahydrofuran, and the like to prepare a dilute solution ($1\times10^{-6}$ % by mass to $1\times10^{-3}$ % by mass), and the PL spectrum of the dilute solution is measured at room temperature or 77K. As the organic solvent for dissolving the compound, xylene or 2-methyltetrahydrofuran is preferred.

When a film forming method is used, a compound is dissolved in the same organic solvent as the solvent to be contained in an ink described later to prepare a solution for film formation, a film is fabricated by the same method as the method for fabricating a film described later using the solution for film formation, and the PL spectrum of the film is measured at room temperature or 77K. As the organic solvent for dissolving the compound, xylene or 2-methyltetrahydrofuran is preferred.

In the composition of the present embodiment, $|T_P|-|T_F|$ is 0.15 or more, and $|T_P|-|T_F|$ is preferably 0.18 or more, more preferably 0.20 or more, and further preferably 0.25 or more, since the loss in energy transfer from the phosphorescent compound to the compound (F) is suppressed, and resultantly, a light emitting device containing the composition of the present embodiment is more excellent in light emission efficiency.

In the composition of the present embodiment, $|T_P|-|T_F|$ is preferably 0.80 or less, more preferably 0.50 or less, and further preferably 0.35 or less, since the emission rate of the compound (F) becomes larger, the color purity of a light emitting device containing the composition of the present embodiment is more excellent, and particularly, the loss in light emission efficiency in a light emitting device using a color filter together is suppressed, and resultantly, a light emitting device containing the composition of the present embodiment is more excellent in light emission efficiency.

In the composition of the present embodiment, $|T_P|-|T_F|$ is preferably 0.18 or more and 0.80 or less, more preferably 0.20 or more and 0.50 or less, and further preferably 0.25 or more and 0.35 or less.

The maximum peak wavelength at the longest wavelength side of absorption spectrum at room temperature of a compound (hereinafter, referred to also as "$\lambda_{ABS, RT}$") can be evaluated by dissolving a compound in an organic solvent such as xylene, toluene, chloroform, tetrahydrofuran, 2-methyltetrahydrofuran, and the like to prepare a dilute solution ($1\times10^{-6}$ % by mass to $1\times10^{-3}$ % by mass), and measuring the ultraviolet-visible absorption spectrum of the dilute solution at room temperature. As the organic solvent for dissolving the compound, xylene or 2-methyltetrahydrofuran is preferred.

In the composition of the present embodiment, the difference between $\lambda_{PL,RT}$ of the phosphorescent compound and $\lambda_{ABS,RT}$ of the compound (F) is preferably -20 nm or more and 40 nm or less, more preferably -15 nm or more and 30 nm or less, further preferably -15 nm or more and 20 nm or less, and particularly preferably -5 nm or more and 15 nm or less, since energy transfer from the phosphorescent compound to the compound (F) becomes more efficient, and, a light emitting device containing the composition of the present embodiment is more excellent in light emission efficiency.

<Phosphorescent compound>

The "phosphorescent compound" usually means a compound showing a phosphorescent property at room temperature, and it is preferably a compound showing light emission from the triplet excited state at room temperature. This compound showing light emission from the triplet excited state has a central metal atom and a ligand.

As the central metal atom, exemplified are metal atoms having an atomic number of 40 or more, exhibiting the spin-orbital interaction with a compound, and capable of causing the intersystem crossing between singlet state and triplet state. As the metal atom, a ruthenium atom, a rhodium atom, a palladium atom, an iridium atom and a platinum atom are exemplified.

As the ligand, neutral or anionic monodentate ligands or neutral or anionic polydentate ligands, forming at least one bond selected from the group consisting of a coordination bond and a covalent bond with the central metal atom, are exemplified. As the bond between the central metal atom and the ligand, a metal-nitrogen bond, a metal-carbon bond, a metal-oxygen bond, a metal-phosphorus bond, a metal-sulfur bond and a metal-halogen bond are exemplified. The polydentate ligand usually denotes a bidentate or more and hexadentate or less ligand.

The phosphorescent compound is available from Aldrich, Luminescence Technology Corp., American Dye Source, and the like.

In addition, it is also possible to produce the phosphorescent compound by known methods described in

literatures such as "Journal of the American Chemical Society, Vol. 107, 1431-1432 (1985)", "Journal of The American Chemical Society, Vol. 106, 6647-6653 (1984)", International Publication No. WO 2004/026886, International Publication No. WO 2006/121811, International Publication No. WO 2011/024761, International Publication No. WO 2007/097153, and the like, as the other acquisition methods than above.

[Phosphorescent compound represented by the formula (1)]

The phosphorescent compound represented by the formula (1) is a phosphorescent compound constituted of a central metal $M^1$, a ligand of which number is defined by index $n^1$, and a ligand of which number is defined by index $n^2$.

$M^1$ is preferably an iridium atom or a platinum atom, and more preferably an iridium atom, since a light emitting device containing the composition of the present embodiment is more excellent in light emission efficiency.

When $M^1$ is a rhodium atom or an iridium atom, $n^1$ is preferably 2 or 3, and more preferably 3.

When $M^1$ is a palladium atom or a platinum atom, $n^1$ is preferably 2.

Ring $L^1$ is preferably a 5-membered or 6-membered aromatic hetero ring, and more preferably a 5-membered aromatic hetero ring.

Ring $L^1$ includes, for example, a pyridine ring, a diazabenzene ring, a quinoline ring, an isoquinoline ring, a diazole ring and a triazole ring, and is preferably a pyridine ring, a quinoline ring, an isoquinoline ring, a diazole ring or a triazole ring, more preferably a pyridine ring, a diazole ring or a triazole ring, further preferably a diazole ring or a triazole ring, and particularly preferably a triazole ring.

Ring $L^2$ is preferably a 5-membered or 6-membered aromatic hydrocarbon ring, and more preferably a 6-membered aromatic hydrocarbon ring.

Ring $L^2$ includes, for example, a benzene ring, a naphthalene ring, a fluorene ring, a phenanthrene ring and an indene ring, and is preferably a benzene ring, a naphthalene ring or a fluorene ring, and more preferably a benzene ring.

At least one ring selected from the group consisting of Ring $L^1$ and Ring $L^2$ has a group represented by the formula (1-T). "At least one ring selected from the group consisting of Ring $L^1$ and Ring $L^2$ has a group represented by the formula (1-T)" means that a part or all of hydrogen atoms bonding directly to carbon atoms or nitrogen atoms constituting at least one ring among a plurality of rings are substituted with a group represented by the formula (1-T). In the phosphorescent compound represented by the formula (1), when a plurality of Ring $L^1$ and Ring $L^2$ are present (namely, when $n^1$ is 2 or 3), at least one ring among a plurality of Ring $L^1$ and Ring $L^2$ may have a group represented by the formula (1-T), and it is preferable that all of a plurality of Ring $L^1$, all of a plurality of Ring $L^2$, or all of a plurality of Ring $L^1$ and Ring $L^2$ have a group represented by the formula (1-T), it is more preferable that all of a plurality of Ring $L^1$, or all of a plurality of Ring $L^2$ have a group represented by the formula (1-T), and it is further preferable that all of a plurality of Ring $L^1$ have a group represented by the formula (1-T).

When a plurality of the groups represented by the formula (1-T) are present, they may be the same or different.

The substituent which Ring $L^1$ and Ring $L^2$ optionally have is preferably a group represented by the formula (1-T), since a light emitting device containing the composition of the present embodiment is more excellent in light emission efficiency.

At least one ring selected from the group consisting of Ring $L^1$ and Ring $L^2$ has a group represented by the formula (1-T), and it is preferable that a carbon atom constituting at least one ring selected from the group consisting of Ring $L^1$ and Ring $L^2$ is bonded directly to a group represented by the formula (1-T) , since a light emitting device containing the composition of the present embodiment is more excellent in light emission efficiency.

Ring $L^1$ and Ring $L^2$ may have other substituent than the group represented by the formula (1-T). The other substituent is preferably an alkenyl group or a cycloalkenyl group, and these groups optionally further have a substituent.

When Ring $L^1$ has a plurality of other substituents, they may be the same or different and may be combined together to form a ring together with atoms to which they are attached.

When Ring $L^2$ has a plurality of other substituents, they may be the same or different and may be combined together to form a ring together with atoms to which they are attached.

The other substituent for Ring $L^1$ and the other substituent for Ring $L^2$ may be combined together to form a ring together with atoms to which they are attached.

[Group represented by the formula (1-T)]

$R^{1T}$ is preferably an alkyl group, a cycloalkyl group, an aryl group, a monovalent hetero ring group or a substituted amino group, more preferably an alkyl group, a cycloalkyl group or an aryl group, further preferably an alkyl group or an aryl group, and particularly preferably an alkyl group. These groups optionally have a substituent.

The aryl group for $R^{1T}$ is preferably a phenyl group, a naphthyl group, an anthracenyl group, a phenanthrenyl group, a dihydrophenanthrenyl group, a fluorenyl group or a pyrenyl group, more preferably a phenyl group, a naphthyl group or a fluorenyl group, and further preferably a phenyl group, and these groups optionally have a substituent.

The monovalent hetero ring group for $R^{1T}$ is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiadinyl group, more preferably a pyridyl group, a pyrimidinyl group, a triazinyl group, a dibenzofuranyl group, a carbazolyl group, an azacarbazolyl group or a diazacarbazolyl group, and further preferably a pyridyl group, a pyrimidinyl group or a triazinyl group, and these groups optionally have a substituent.

In the substituted amino group for $R^{1T}$, the substituent which an amino group has is preferably an aryl group or a monovalent hetero ring group, and these groups optionally further have a substituent. The examples and preferable ranges of the aryl group for the substituent which an amino group has are the same as the examples and preferable ranges of the aryl group for $R^{1T}$. The examples and preferable ranges of the monovalent hetero ring group for the substituent which an amino group has are the same as the examples and preferable ranges of the monovalent hetero ring group for $R^{1T}$.

The examples and preferable ranges of the substituent which $R^{1T}$ optionally has are the same as the examples and preferable ranges of $R^{1T}$.

$R^{1T}$ is preferably an alkyl group, a cycloalkyl group, or, a group represented by the formula (D-A), the formula (D-B) or the formula (D-C), more preferably an alkyl group, or, a group represented by the formula (D-A), the formula (D-B) or the formula (D-C), further preferably an alkyl group, or, a group represented by the formula (D-A) or the formula (D-C), and further preferably an alkyl group, or, a group represented by the formula (D-C), since a light emitting device containing the composition of the present embodiment is more excellent in light emission efficiency.

$m^{DA1}$, $m^{DA2}$, $m^{DA3}$, $m^{DA4}$, $m^{DA5}$, $m^{DA6}$ and $m^{DA7}$ are each usually an integer of 10 or less, preferably an integer of 5 or less, more preferably an integer of 2 or less, and further preferably 0 or **1.** It is preferable that $m^{DA2}$, $m^{DA3}$, $m^{DA4}$, $m^{DA5}$, $m^{DA6}$ and $m^{DA7}$ are the same integer, and it is more preferable that $m^{DA1}$, $m^{DA2}$, $m^{DA3}$, $m^{DA4}$, $m^{DA5}$, $m^{DA6}$ and $m^{DA7}$ are the same integer.

In the group represented by the formula (D-A) and the formula (D-B) for $R^{1T}$, $G^{DA}$ is preferably a group represented by the formula (GDA-11) to the formula (GDA-15), more preferably a group represented by the formula (GDA-11) to the formula (GDA-14), and further preferably a group represented by the formula (GDA-11).

[Chemical Formula 24]

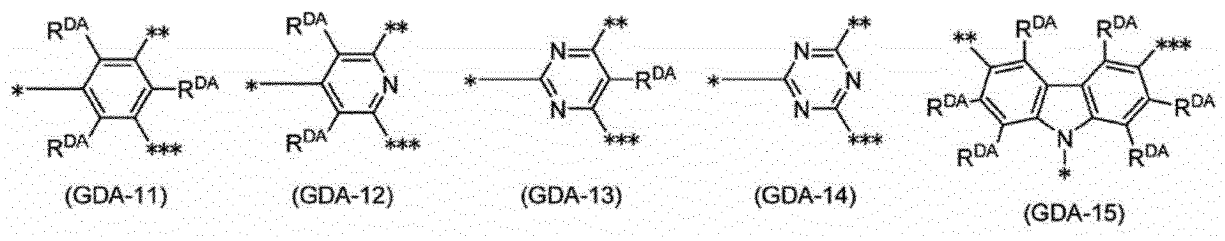

(GDA-11) (GDA-12) (GDA-13) (GDA-14) (GDA-15)

[wherein,

* represents a bond to $Ar^{DA1}$ in the formula (D-A), $Ar^{DA1}$ in the formula (D-B), $Ar^{DA2}$ in the formula (D-B) or $Ar^{DA3}$ in the formula (D-B).

** represents a bond to $Ar^{DA2}$ in the formula (D-A), $Ar^{DA2}$ in the formula (D-B), $Ar^{DA4}$ in the formula (D-B) or $Ar^{DA6}$ in the formula (D-B).

*** represents a bond to $Ar^{DA3}$ in the formula (D-A), $Ar^{DA3}$ in the formula (D-B), $Ar^{DA5}$ in the formula (D-B) or $Ar^{DA7}$ in the formula (D-B).

$R^{DA}$ represents a hydrogen atom, an alkyl group, a cycloalkyl group, an alkoxy group, a cycloalkoxy group, an aryl group or a monovalent hetero ring group, and these groups optionally further have a substituent. When a plurality of $R^{DA}$ are present, they may be the same or different.]

$R^{DA}$ is preferably a hydrogen atom, an alkyl group, a cycloalkyl group, an alkoxy group or a cycloalkoxy group, and more preferably a hydrogen atom, an alkyl group or a cycloalkyl group, and these groups optionally have a substituent.

$Ar^{DA1}$, $Ar^{DA2}$, $Ar^{DA3}$, $Ar^{DA4}$, $Ar^{DA5}$, $Ar^{DA6}$ and $Ar^{DA7}$ are each preferably a phenylene group, a fluorenediyl group or a carbazolediyl group, more preferably a group represented by the formula (A-1) to the formula (A-3), the formula (A-8), the formula (A-9), the formula (AA-10), the formula (AA-11), the formula (AA-33) or the formula (AA-34), further preferably a group represented by the formula (ArDA-1) to the formula (ArDA-5), particularly preferably a group represented by the formula (ArDA-1) to the formula (ArDA-3), and especially preferably a group represented by the formula (ArDA-1).

[Chemical Formula 25]

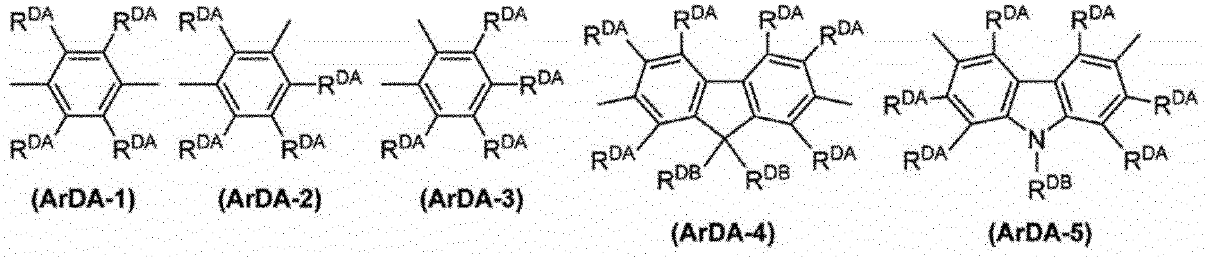

(ArDA-1) (ArDA-2) (ArDA-3) (ArDA-4) (ArDA-5)

[wherein,

$R^{DA}$ represents the same meaning as described above.

$R^{DB}$ represents a hydrogen atom, an alkyl group, a cycloalkyl group, an aryl group or a monovalent hetero ring group, and these groups optionally have a substituent. When a plurality of $R^{DB}$ are present, they may be the same or different.]

$R^{DB}$ is preferably an alkyl group, a cycloalkyl group, an aryl group or a monovalent hetero ring group, more preferably an aryl group or a monovalent hetero ring group, and further preferably an aryl group, and these groups optionally have a substituent.

$T^{DA}$ is preferably a group represented by the formula (TDA-1) to the formula (TDA-3), and more preferably a group represented by the formula (TDA-1).

[Chemical Formula 26]

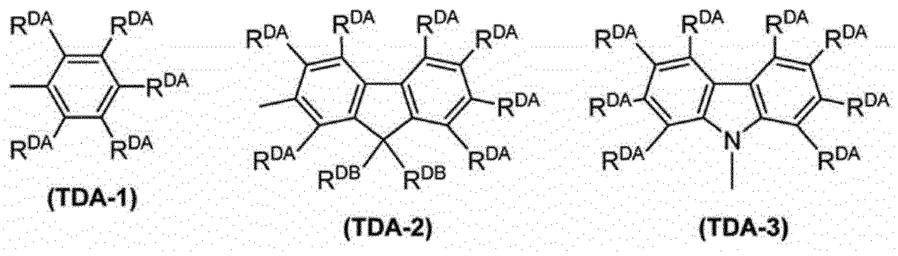

(TDA-1) (TDA-2) (TDA-3)

[wherein, $R^{DA}$ and $R^{DB}$ represent the same meaning as described above.]

The group represented by the formula (D-A) for $R^{1T}$ is preferably a group represented by the formula (D-A1) to the formula (D-A4), more preferably a group represented by the formula (D-A1), the formula (D-A3) or the formula (D-A4), and further preferably a group represented by the formula (D-A1) or the formula (D-A3).

[Chemical Formula 27]

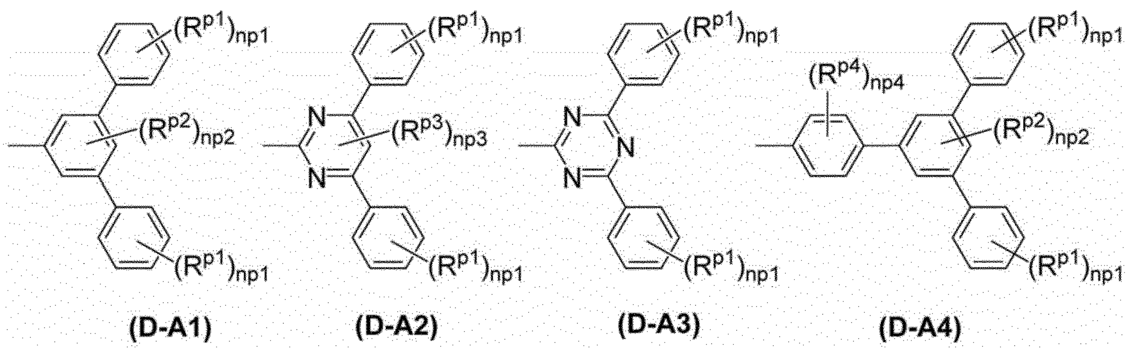

(D-A1) (D-A2) (D-A3) (D-A4)

[wherein,

$R^{p1}$, $R^{p2}$, $R^{p3}$ and $R^{p4}$ each independently represent an alkyl group, a cycloalkyl group, an alkoxy group, a cycloalkoxy

group or a halogen atom. When a plurality of $R^{p1}$, $R^{p2}$ and $R^{p4}$ are present, they may be the same or different at each occurrence.

np1 represents an integer of 0 to 5, np2 represents an integer of 0 to 3, np3 represents 0 or 1, and np4 represents an integer of 0 to 4. A plurality of np1 may be the same or different.]

The group represented by the formula (D-B) for $R^{1T}$ is preferably a group represented by the formula (D-B1) to the formula (D-B3), and more preferably a group represented by the formula (D-B1) or the formula (D-B3).

[Chemical Formula 28]

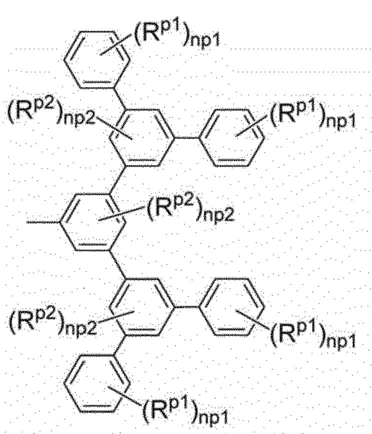

(D-B1)

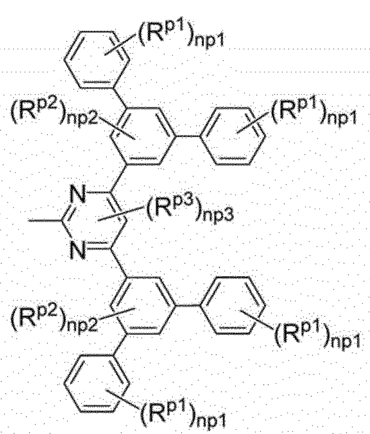

(D-B2)

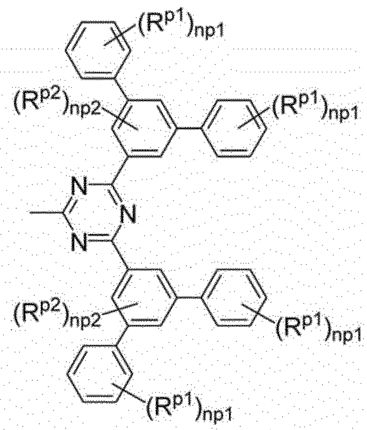

(D-B3)

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. When a plurality of np1 and np2 are present, they may be the same or different at each occurrence.]

The group represented by the formula (D-C) for $R^{1T}$ is preferably a group represented by the formula (D-C1) to the formula (D-C13), more preferably a group represented by the formula (D-C1) to the formula (D-C3) or the formula (D-C8) to the formula (D-C10), further preferably a group represented by the formula (D-C1), the formula (D-C2) or the formula (D-C9), and particularly preferably a group represented by the formula (D-C9).

[Chemical Formula 29]

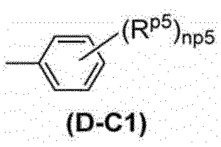

(D-C1)

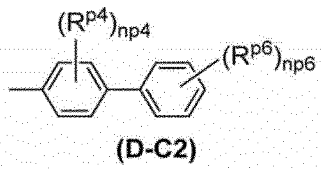

(D-C2)

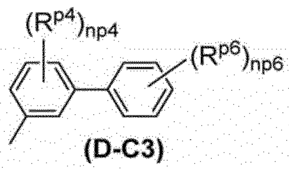

(D-C3)

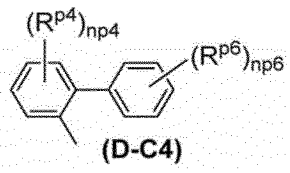

(D-C4)

[Chemical Formula 30]

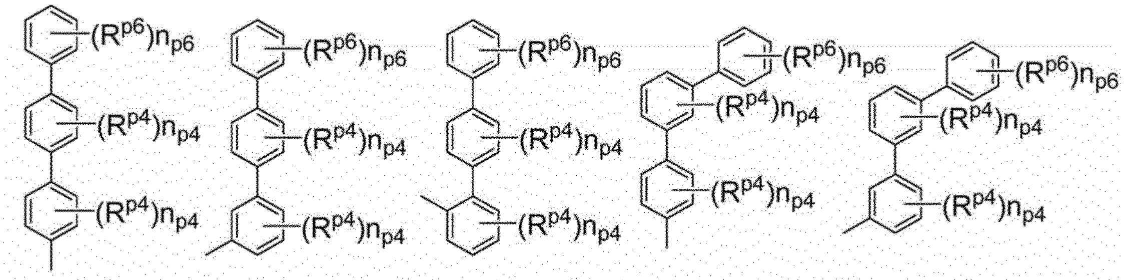

(D-C5) (D-C6) (D-C7) (D-C8) (D-C9)

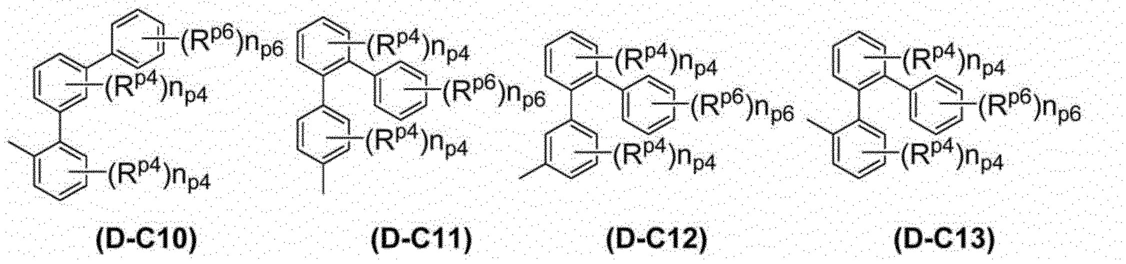

(D-C10) (D-C11) (D-C12) (D-C13)

[wherein,

$R^{p4}$, $R^{p5}$ and $R^{p6}$ each independently represent an alkyl group, a cycloalkyl group, an alkoxy group, a cycloalkoxy group or a halogen atom. When a plurality of $R^{p4}$, $R^{p5}$ and $R^{p6}$ are present, they may be the same or different at each occurrence.

np4 is an integer of 0 to 4, np5 is an integer of 0 to 5, and np6 is an integer of 0 to 5.]

np1 is preferably 0 or 1, and more preferably 1. np2 is preferably 0 or 1, and more preferably 0. np3 is preferably 0. np4 is preferably an integer of 0 to 2. np5 is preferably an integer of 1 to 3. np6 is preferably an integer of 0 to 2.

$R^{p1}$, $R^{p2}$, $R^{p3}$, $R^{p4}$, $R^{p5}$ and $R^{p6}$ are each preferably an alkyl group or a cycloalkyl group, more preferably a methyl group, an ethyl group, an isopropyl group, a tert-butyl group, a hexyl group, a 2-ethylhexyl group, a cyclohexyl group, a methoxy group, a 2-ethylhexyloxy group, a tert-octyl group or a cyclohexyloxy group, and further preferably a methyl group, an ethyl group, an isopropyl group, a tert-butyl group, a hexyl group, a 2-ethylhexyl group or a tert-octyl group.

The group represented by the formula (D-A) is preferably a group represented by the formula (D-A1) to the formula (D-A4), more preferably a group represented by the formula (D-A1) or the formula (D-A4), and further preferably a group represented by the formula (D-A1).

The group represented by the formula (D-B) is preferably a group represented by the formula (D-B1) to the formula (D-B3), and more preferably a group represented by the formula (D-B1).

The group represented by the formula (D-C) is preferably a group represented by the formula (D-C1) to the formula (D-C13), more preferably a group represented by the formula (D-C1) to the formula (D-C3), further preferably a group represented by the formula (D-C1) or the formula (D-C2), and particularly preferably a group represented by the formula (D-C1).

The group represented by the formula (D-A) includes, for example, groups represented by the formula (D-A-1) to the formula (D-A-12).

[Chemical Formula 31]

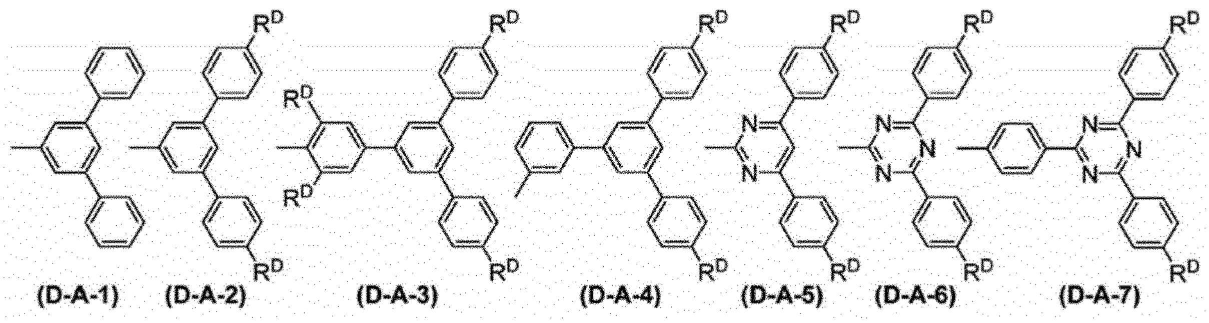

(D-A-1) (D-A-2) (D-A-3) (D-A-4) (D-A-5) (D-A-6) (D-A-7)

[Chemical Formula 32]

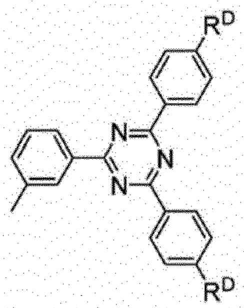
(D-A-8)
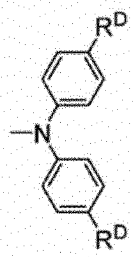
(D-A-9)
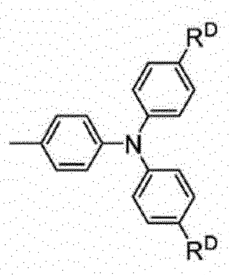
(D-A-10)
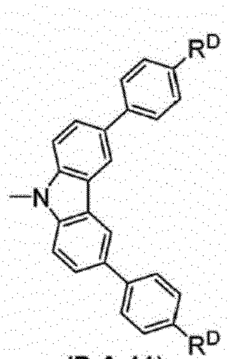
(D-A-11)
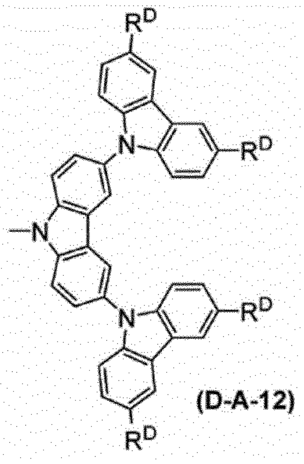
(D-A-12)

[wherein, $R^D$ represents a methyl group, an ethyl group, an isopropyl group, a tert-butyl group, a hexyl group, a 2-ethylhexyl group, a tert-octyl group, a cyclohexyl group, a methoxy group, a 2-ethylhexyloxy group or a cyclohexyloxy group. When a plurality of $R^D$ are present, they may be the same or different.]

The group represented by the formula (D-B) includes, for example, groups represented by the formula (D-B-1) to the formula (D-B-4).

[Chemical Formula 33]

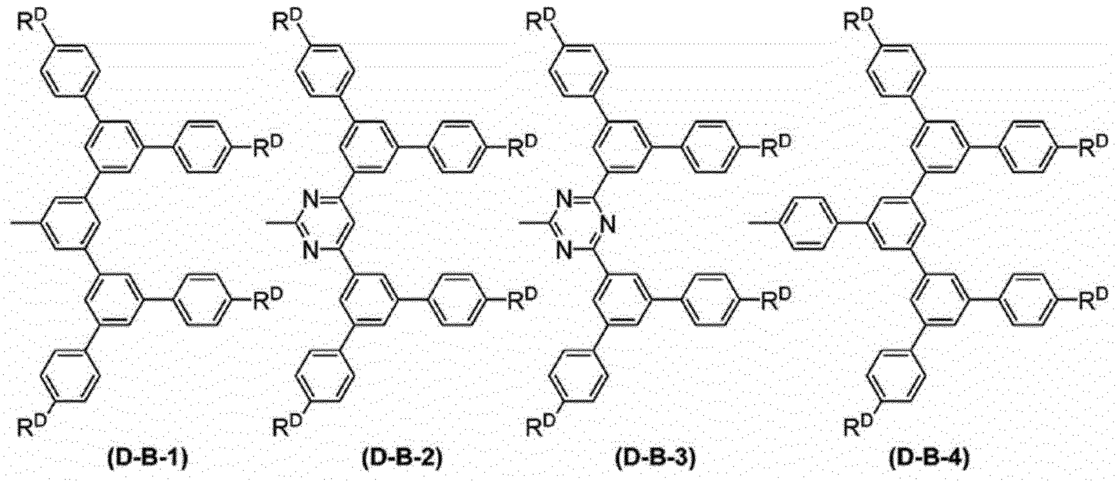
(D-B-1) (D-B-2) (D-B-3) (D-B-4)

[wherein, $R^D$ represents the same meaning as described above.]

The group represented by the formula (D-C) includes, for example, groups represented by the formula (D-C-1) to the formula (D-C-26).

[Chemical Formula 34]

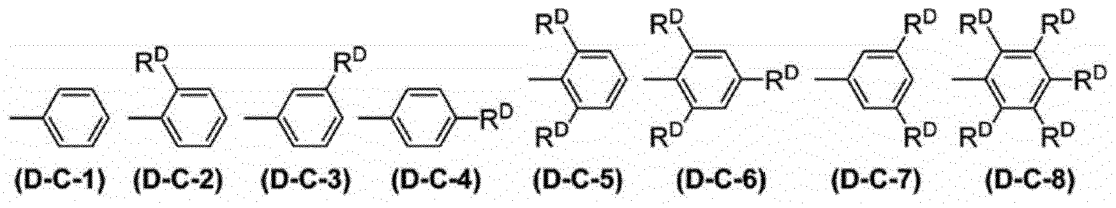
(D-C-1) (D-C-2) (D-C-3) (D-C-4) (D-C-5) (D-C-6) (D-C-7) (D-C-8)

[Chemical Formula 35]

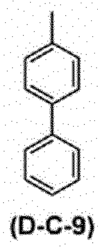
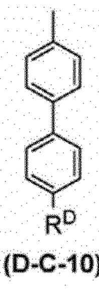
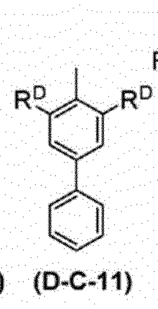
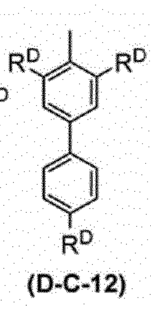
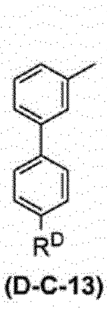
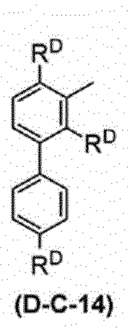
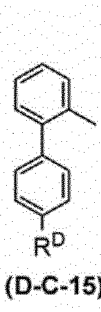
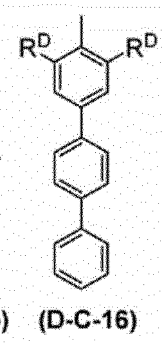
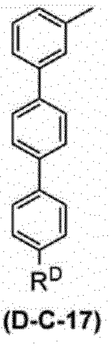

(D-C-9) (D-C-10) (D-C-11) (D-C-12) (D-C-13) (D-C-14) (D-C-15) (D-C-16) (D-C-17)

[Chemical Formula 36]

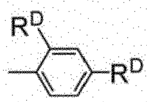
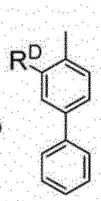
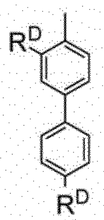
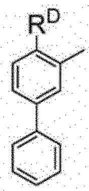
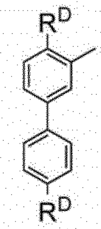
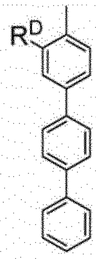
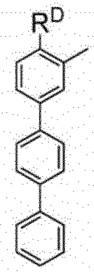
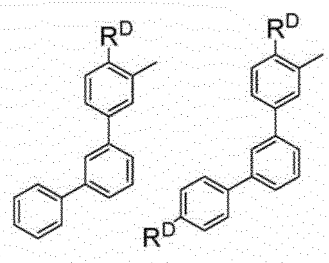

(D-C-18) (D-C-19) (D-C-20) (D-C-21) (D-C-22) (D-C-23) (D-C-24) (D-C-25) (D-C-26)

[wherein, $R^D$ represents the same meaning as described above.]

$R^D$ is preferably a methyl group, an ethyl group, an isopropyl group, a tert-butyl group, a hexyl group, a 2-ethylhexyl group or a tert-octyl group.

[Anionic bidentate ligand]

The anionic bidentate ligand represented by $A^1$-$G^1$-$A^2$ includes, for example, ligands represented by the following formulae.

[Chemical Formula 37]

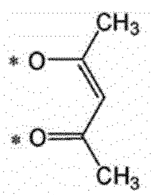
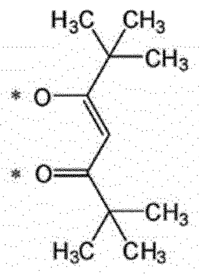
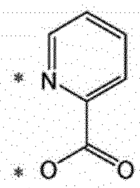
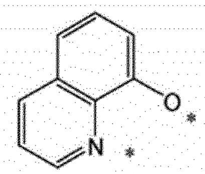
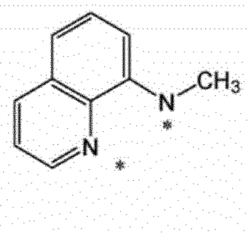

[Chemical Formula 38]

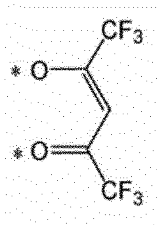
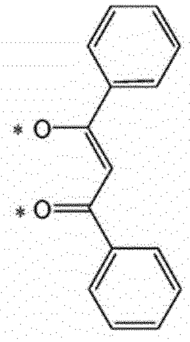
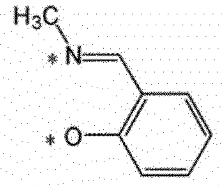
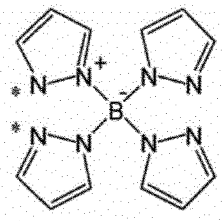

[wherein, * represents a site binding to $M^1$.]

The anionic bidentate ligand represented by $A^1$-$G^1$-$A^2$ may be a ligand represented by the following formula.

[Chemical Formula 39]

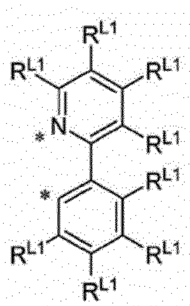
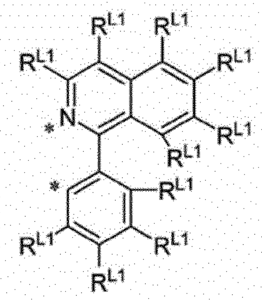
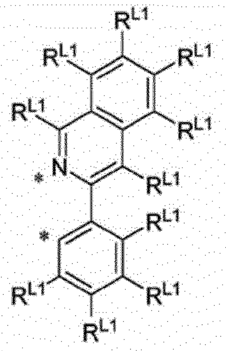
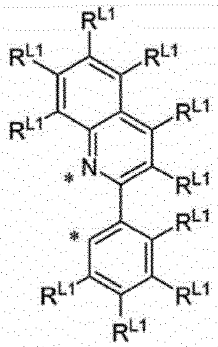
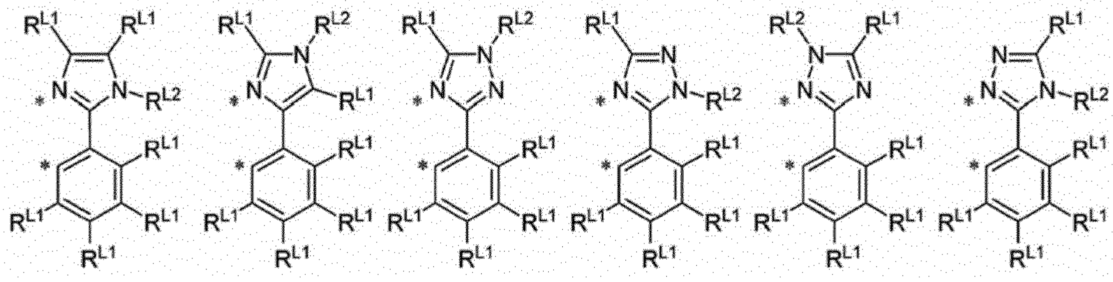

[wherein,

* represents a site binding to $M^1$.
$R^{L1}$ represents a hydrogen atom, an alkyl group, a cycloalkyl group or a halogen atom, and these groups optionally have a substituent. A plurality of $R^{L1}$ may be the same or different.
$R^{L2}$ represents an alkyl group, a cycloalkyl group, an aryl group, a monovalent hetero ring group or a halogen atom, and these groups optionally have a substituent.]
$R^{L1}$ is preferably a hydrogen atom, an alkyl group, a cycloalkyl group or a fluorine atom, and more preferably a hydrogen atom or an alkyl group, and these groups optionally have a substituent.
$R^{L2}$ is preferably an alkyl group, a cycloalkyl group, an aryl group or a monovalent hetero ring group, more preferably an aryl group or a monovalent hetero ring group, and further preferably an aryl group, and these groups optionally have a substituent.

[Phosphorescent compound represented by the formula (1-A)]

When Ring $L^1$ is a 5-membered aromatic hetero ring, the phosphorescent compound represented by the formula (1) is preferably a phosphorescent compound represented by the formula (1-A).

When Ring $L^{1A}$ is a diazole ring, an imidazole ring in which $E^{11A}$ is a nitrogen atom, an imidazole ring in which $E^{12A}$

is a nitrogen atom or a pyrazole ring in which $E^{13A}$ is a nitrogen atom is preferred, and an imidazole ring in which $E^{11A}$ is a nitrogen atom is more preferred.

When Ring $L^{1A}$ is a triazole ring, a triazole ring in which $E^{11A}$ and $E^{12A}$ are each a nitrogen atom or a triazole ring in which $E^{11A}$ and $E^{13A}$ are each a nitrogen atom is preferred, and a triazole ring in which $E^{11A}$ and $E^{13A}$ are each a nitrogen atom is more preferred.

When $E^{11A}$ is a nitrogen atom and $R^{11A}$ is present, $R^{11A}$ is preferably an alkyl group, a cycloalkyl group, an aryl group or a monovalent hetero ring group, more preferably an aryl group or a monovalent hetero ring group, and further preferably an aryl group, and these groups optionally have a substituent.

When $E^{11A}$ is a carbon atom, $R^{11A}$ is preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom, an alkyl group or a cycloalkyl group, and particularly preferably a hydrogen atom, and these groups optionally have a substituent.

When $E^{12A}$ is a nitrogen atom and $R^{12A}$ is present, $R^{12A}$ is preferably an alkyl group, a cycloalkyl group, an aryl group or a monovalent hetero ring group, more preferably an aryl group or a monovalent hetero ring group, and further preferably an aryl group, and these groups optionally have a substituent.

When $E^{12A}$ is a carbon atom, $R^{12A}$ is preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom, an alkyl group or a cycloalkyl group, and particularly preferably an alkyl group, and these groups optionally have a substituent.

When $E^{13A}$ is a nitrogen atom and $R^{13A}$ is present, $R^{13A}$ is preferably an alkyl group, a cycloalkyl group, an aryl group or a monovalent hetero ring group, more preferably an aryl group or a monovalent hetero ring group, and further preferably an aryl group, and these groups optionally have a substituent.

When $E^{13A}$ is a carbon atom, $R^{13A}$ is preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom, an alkyl group or a cycloalkyl group, and particularly preferably an alkyl group, and these groups optionally have a substituent.

The examples and preferable ranges of the aryl group, the monovalent hetero ring group and the substituted amino group for $R^{11A}$, $R^{12A}$ and $R^{13A}$ are the same as the examples and preferable ranges of the aryl group, the monovalent hetero ring group and the substituted amino group for $R^{1T}$, respectively, and these groups optionally have a substituent.

The examples and preferable ranges of the substituent which $R^{11A}$, $R^{12A}$ and $R^{13A}$ optionally have are the same as the examples and preferable ranges of the substituent which $R^{1T}$ optionally has, respectively, and these groups optionally further have a substituent.

The aryl group, the monovalent hetero ring group or the substituted amino group for $R^{11A}$, $R^{12A}$ and $R^{13A}$ is preferably a group represented by the formula (D-A), the formula (D-B) or the formula (D-C), more preferably a group represented by the formula (D-A) or the formula (D-C), and further preferably a group represented by the formula (D-C), since a light emitting device containing the composition of the present embodiment is more excellent in light emission efficiency.

It is preferable that at least one selected from the group consisting of $R^{11A}$, $R^{12A}$ and $R^{13A}$ is a group represented by the formula (1-T), it is more preferable that $R^{11A}$ and $R^{12A}$ are each a group represented by the formula (1-T), and, $R^{11A}$ and $R^{13A}$ are each a group represented by the formula (1-T), and it is further preferable that $R^{11A}$ and $R^{12A}$ are each a group represented by the formula (1-T), since a light emitting device containing the composition of the present embodiment is more excellent in light emission efficiency.

When at least one selected from the group consisting of $R^{11A}$, $R^{12A}$ and $R^{13A}$ is an aryl group optionally having a substituent or a monovalent hetero ring group optionally having a substituent, it is preferable that $R^{11A}$ is an aryl group optionally having a substituent or a monovalent hetero ring group optionally having a substituent or $R^{13A}$ is an aryl group optionally having a substituent or a monovalent hetero ring group optionally having a substituent, it is more preferable that $R^{11A}$ is an aryl group optionally having a substituent or a monovalent hetero ring group optionally having a substituent, and it is particularly preferable that $R^{11A}$ is an aryl group optionally having a substituent.

$R^{11A}$ and $R^{12A}$ may be combined together to form a ring together with atoms to which they are attached, but it is preferable that they do not form a ring since the maximum peak wavelength of the light emission spectrum of the phosphorescent compound becomes longer.

$R^{12A}$ and $R^{13A}$ may be combined together to form a ring together with atoms to which they are attached, but it is preferable that they do not form a ring since the maximum peak wavelength of the light emission spectrum of the phosphorescent compound becomes longer.

$R^{11A}$ and the substituent which Ring $L^2$ optionally has may be combined together to form a ring together with atoms to which they are attached, but it is preferable that they do not form a ring since the maximum peak wavelength of the light emission spectrum of the phosphorescent compound becomes longer.

The phosphorescent compound represented by the formula (1-A) is preferably a phosphorescent compound represented by the formula (1-A-1) or the formula (1-A-2), and more preferably a phosphorescent compound represented by the formula (1-A-2), since a light emitting device containing the composition of the present embodiment is more excellent in light emission efficiency.

[Chemical Formula 40]

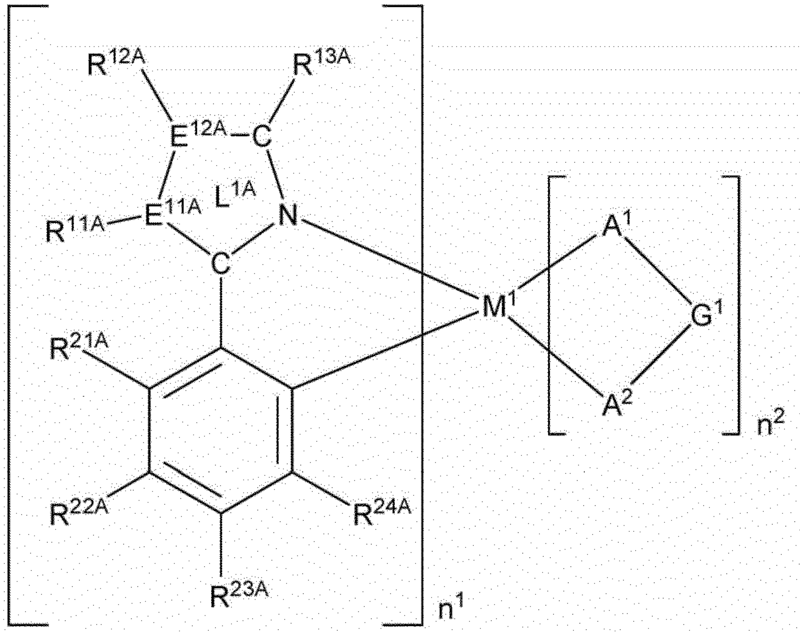

**(1-A-1)**

[wherein, $M^1$, $n^1$, $n^2$, Ring $L^{1A}$, $E^{11A}$, $E^{12A}$, $R^{11A}$, $R^{12A}$, $R^{13A}$, $R^{21A}$, $R^{22A}$, $R^{23A}$, $R^{24A}$ and $A^1$-$G^1$-$A^2$ represent the same meaning as described above.

At least one selected from the group consisting of $R^{11A}$, $R^{12A}$, $R^{13A}$, $R^{21A}$, $R^{22A}$, $R^{23A}$ and $R^{24A}$ is a group represented by the above-described formula (1-T).]

The examples and preferable ranges of $R^{21A}$, $R^{22A}$, $R^{23A}$ and $R^{24A}$ are the same as the examples and preferable ranges for $R^{1T}$, and these groups optionally have a substituent.

The examples and preferable ranges of the aryl group, the monovalent hetero ring group and the substituted amino group for $R^{21A}$, $R^{22A}$, $R^{23A}$ and $R^{24A}$ are the same as the examples and preferable ranges of the aryl group, the monovalent hetero ring group and the substituted amino group for $R^{1T}$, respectively.

The examples and preferable ranges of the substituent which $R^{21A}$, $R^{22A}$, $R^{23A}$ and $R^{24A}$ optionally have are the same as the examples and preferable ranges of the substituent which $R^{1T}$ optionally has.

It is preferable that at least one selected from the group consisting of $R^{21A}$, $R^{22A}$, $R^{23A}$ and $R^{24A}$ is a group represented by the formula (1-T), since a light emitting device containing the composition of the present embodiment is more excellent in light emission efficiency.

When at least one selected from the group consisting of $R^{21A}$, $R^{22A}$, $R^{23A}$ and $R^{24A}$ is a group represented by the formula (1-T), it is preferable that $R^{22A}$ or $R^{23A}$ is a group represented by the formula (1-T), and it is more preferable that $R^{22A}$ is a group represented by the formula (1-T).

The phosphorescent compound represented by the formula (1-A-1) is preferably a phosphorescent compound represented by the formula (1-A-11), a phosphorescent compound represented by the formula (1-A-12), a phosphorescent compound represented by the formula (1-A-13) or a phosphorescent compound represented by the formula (1-A-14), more preferably a phosphorescent compound represented by the formula (1-A-11) or a phosphorescent compound represented by the formula (1-A-13), and further preferably a phosphorescent compound represented by the formula (1-A-11), since a light emitting device containing the composition of the present embodiment is further excellent in light emission efficiency.

[Chemical Formula 41]

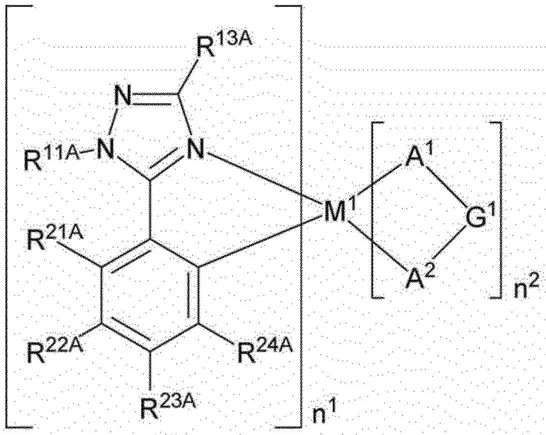

**(1-A-11)**

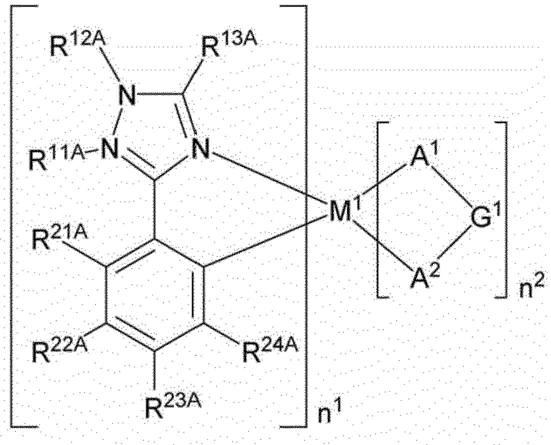

**(1-A-12)**

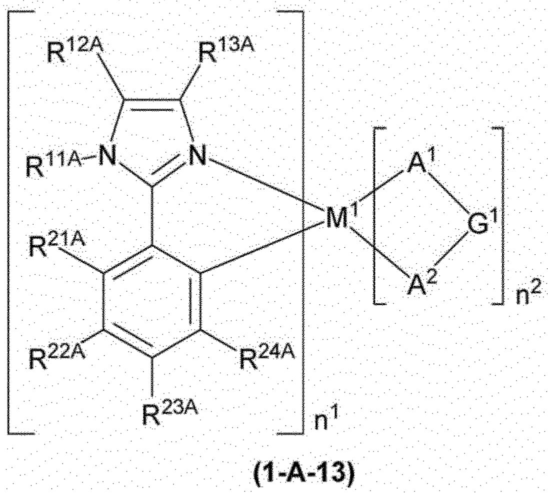

**(1-A-13)**

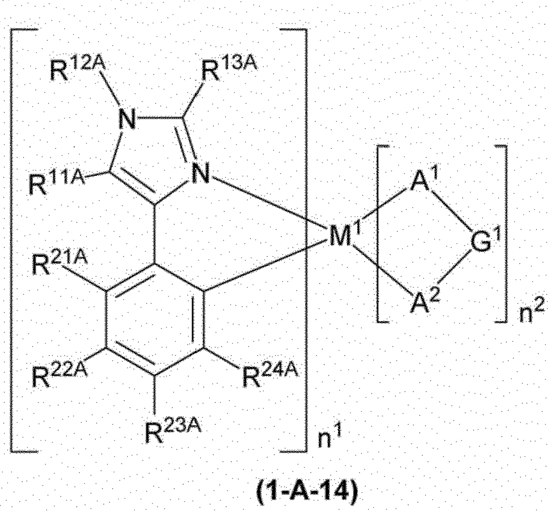

**(1-A-14)**

[wherein, $M^1$, $n^1$, $n^2$, $R^{11A}$, $R^{12A}$, $R^{13A}$, $R^{21A}$, $R^{22A}$, $R^{23A}$, $R^{24A}$ and $A^1$-$G^1$-$A^2$ represent the same meaning as described above.

In the formula (1-A-11), at least one selected from the group consisting of $R^{11A}$, $R^{13A}$, $R^{21A}$, $R^{22A}$, $R^{23A}$ and $R^{24A}$ is a group represented by the above-described formula (1-T), in the formula (1-A-12), at least one selected from the group consisting of $R^{12A}$, $R^{13A}$, $R^{21A}$, $R^{22A}$, $R^{23A}$ and $R^{24A}$ is a group represented by the above-described formula (1-T), and in the formula (1-A-13) and the formula (1-A-14), at least one selected from the group consisting of $R^{11A}$, $R^{12A}$, $R^{13A}$, $R^{21A}$, $R^{22A}$, $R^{23A}$ and $R^{24A}$ is a group represented by the above-described formula (1-T).]

The phosphorescent compound represented by formula (1-A-1) includes, for example, phosphorescent compounds represented by the following formulae and a compound P3 described later, and the like.

[Chemical Formula 42]

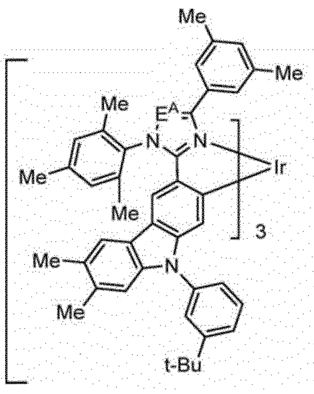

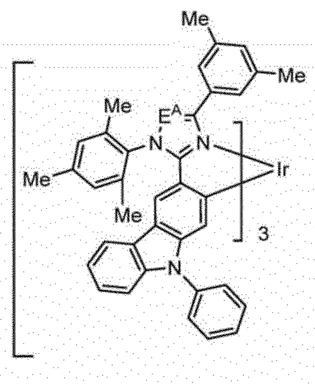

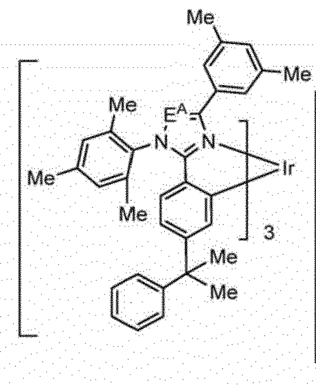

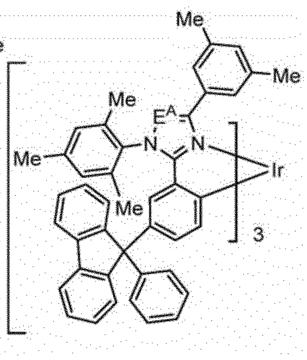

[Chemical Formula 43]

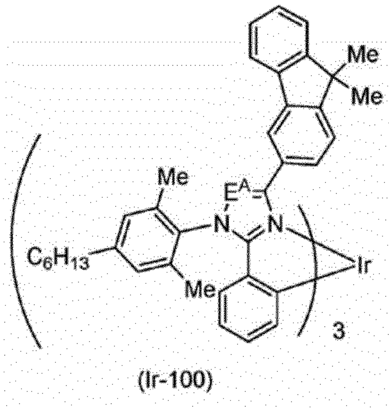

(Ir-100)

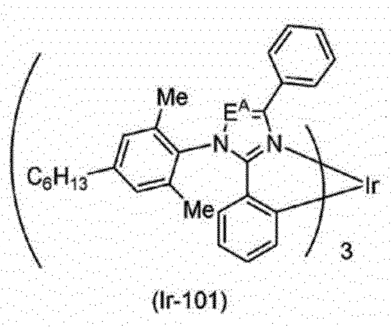

(Ir-101)

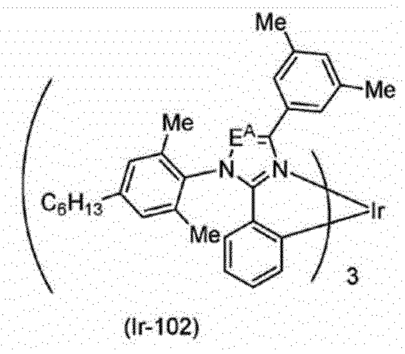

(Ir-102)

[Chemical Formula 44]

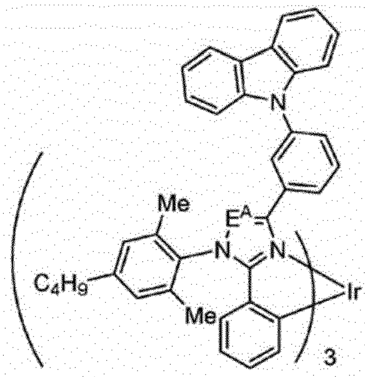

(Ir-103)

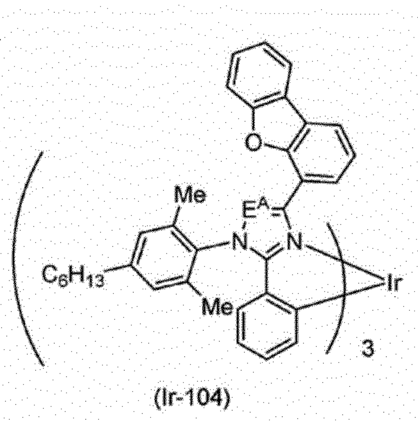

(Ir-104)

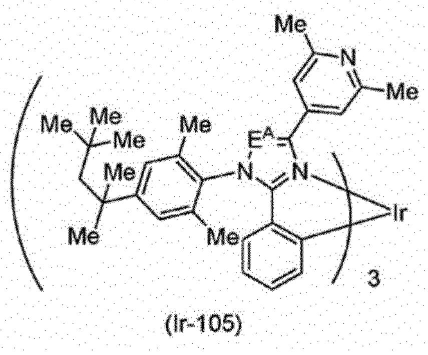

(Ir-105)

[Chemical Formula 45]

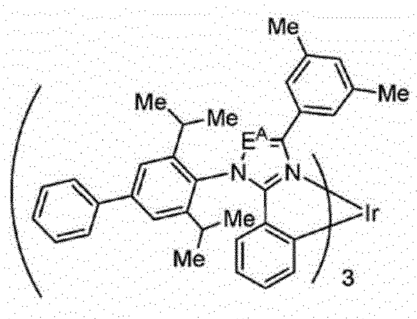

(Ir-106)

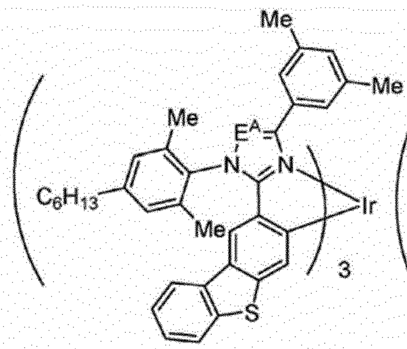

(Ir-107)

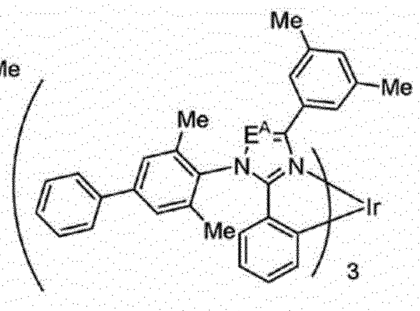

(Ir-108)

[Chemical Formula 46]

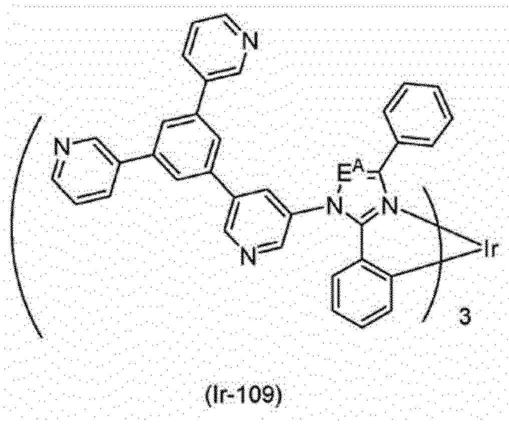

(Ir-109)

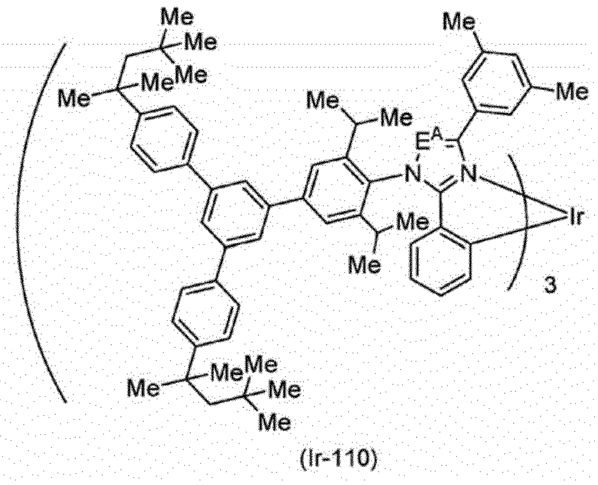

(Ir-110)

[Chemical Formula 47]

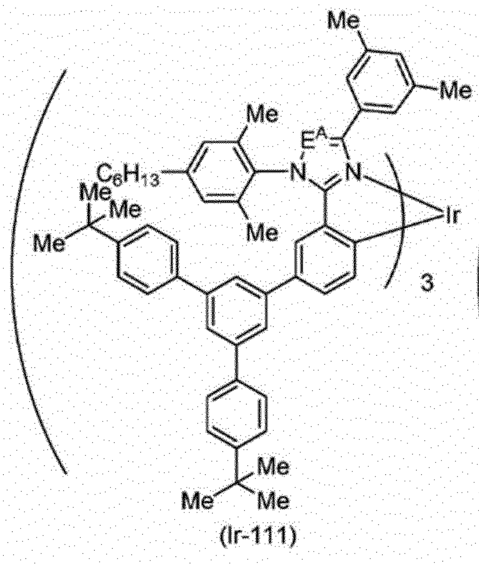

(Ir-111)

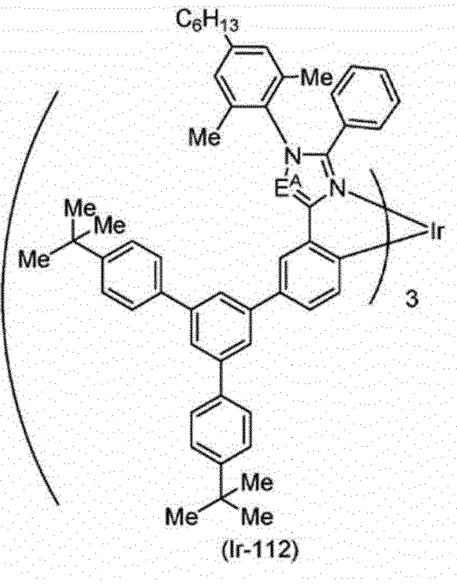

(Ir-112)

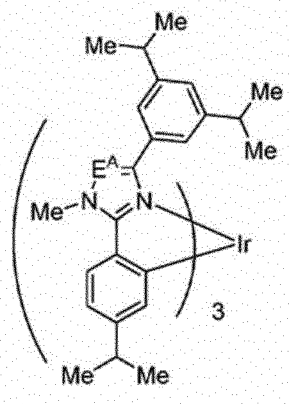

(Ir-113)

[Chemical Formula 48]

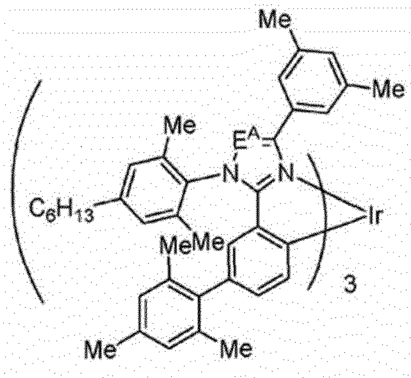

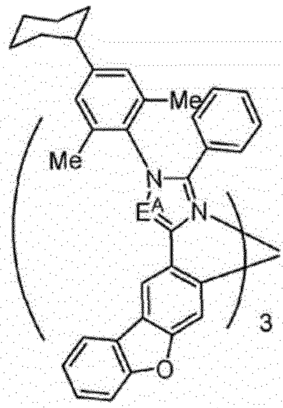

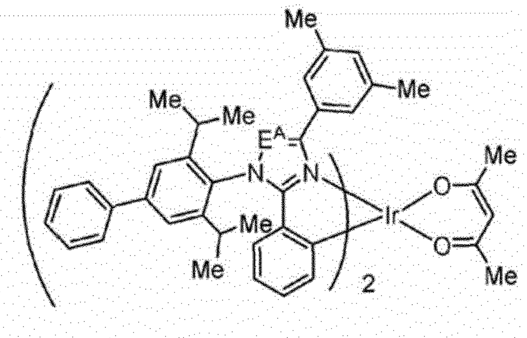

(Ir-114) (Ir-115) (Ir-116)

[Chemical Formula 49]

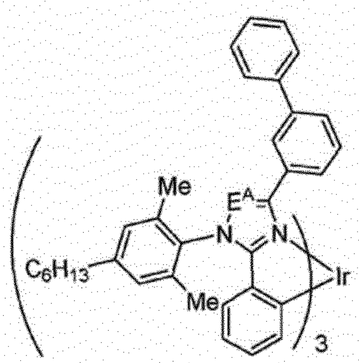

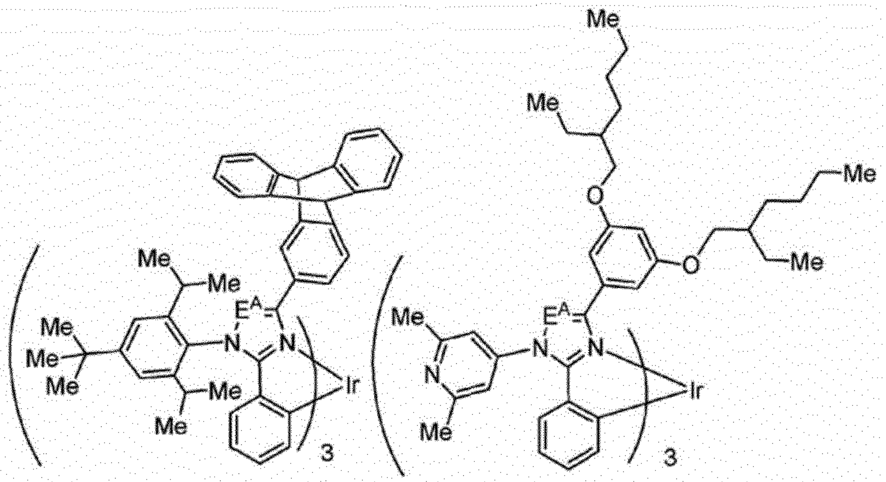

(Ir-117) (Ir-118) (Ir-119)

[Chemical Formula 50]

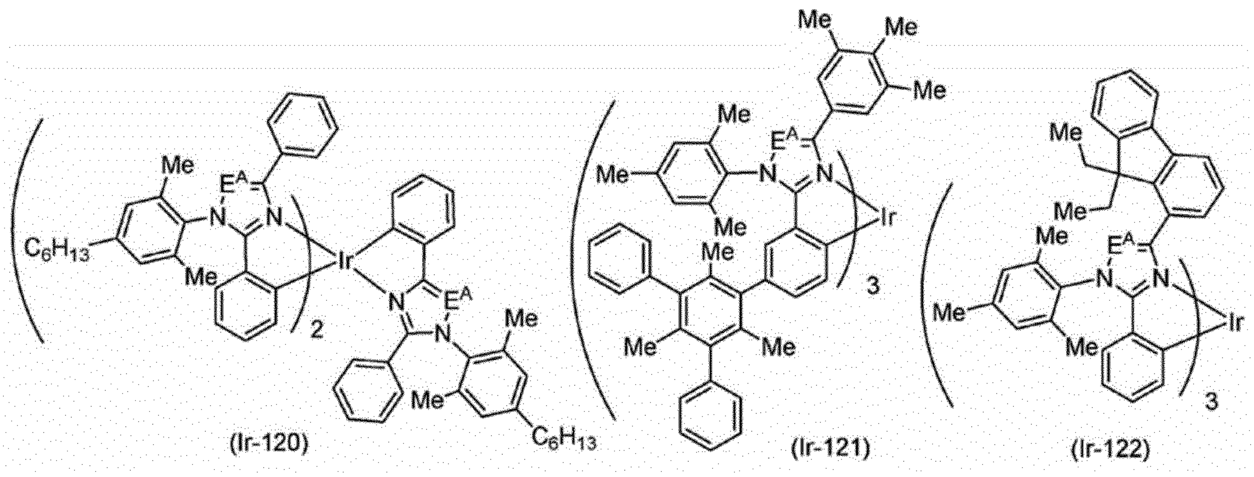

(Ir-120) (Ir-121) (Ir-122)

[Chemical Formula 51]

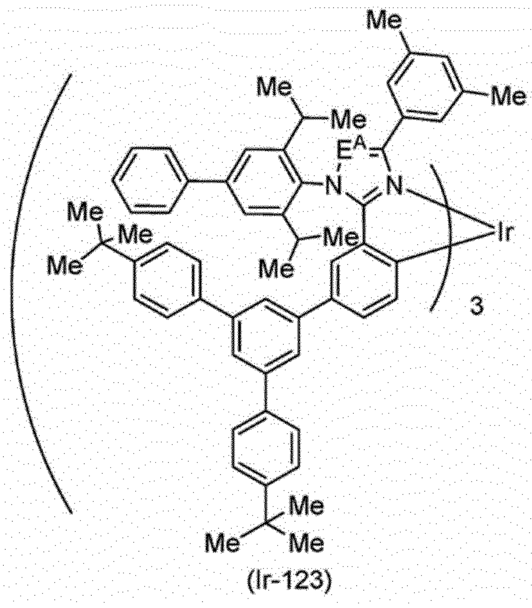

(Ir-123)

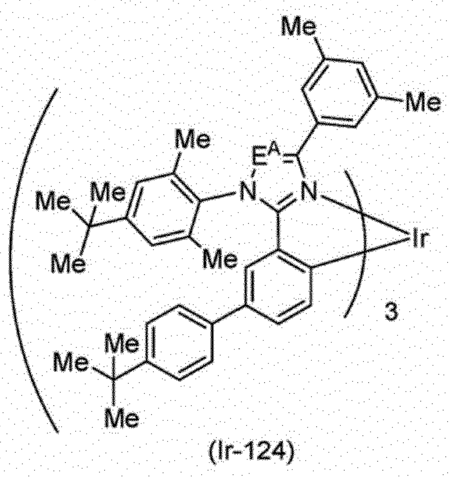

(Ir-124)

[Chemical Formula 52]

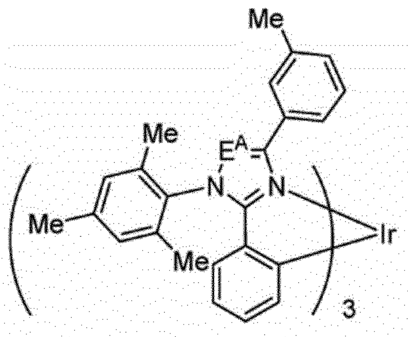

(Ir-125)

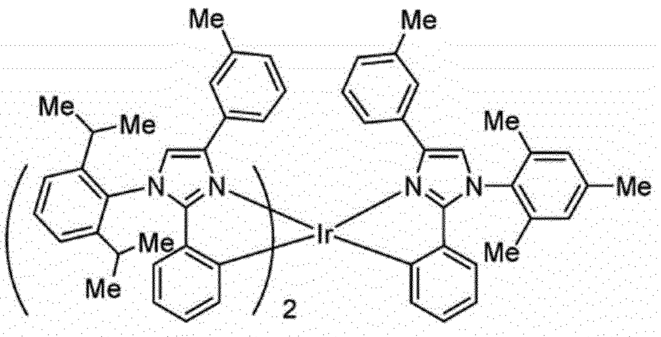

(Ir-126)

[Chemical Formula 53]

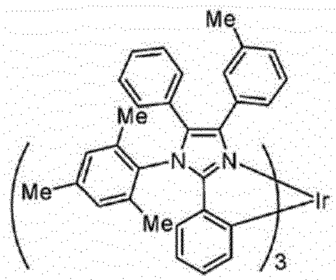

(Ir-127)

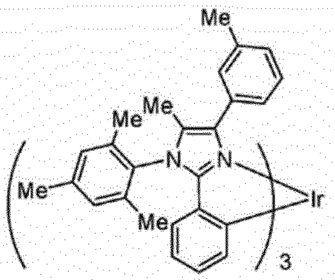

(Ir-128)

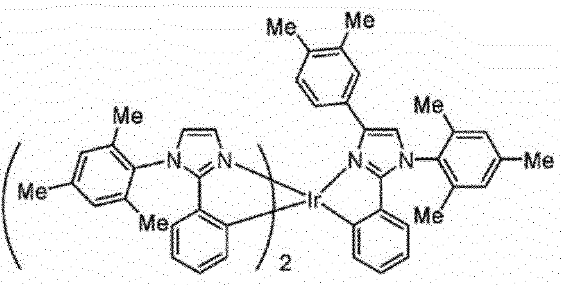

(Ir-129)

[Chemical Formula 54]

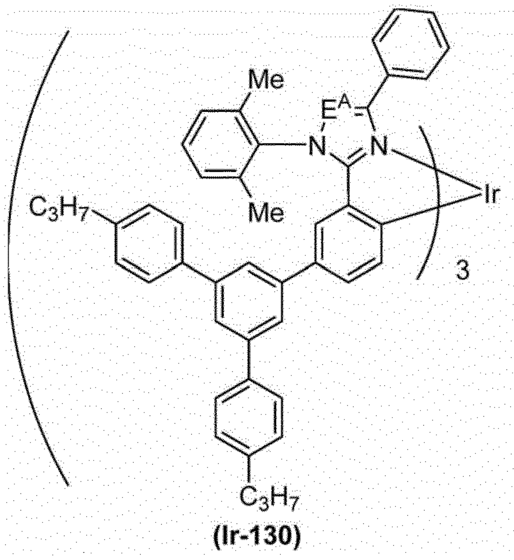

(Ir-130)

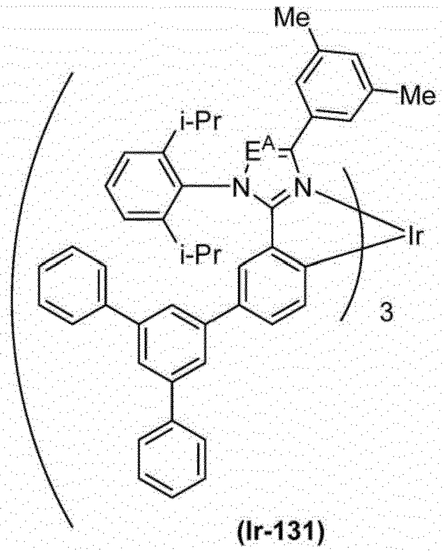

(Ir-131)

[Chemical Formula 55]

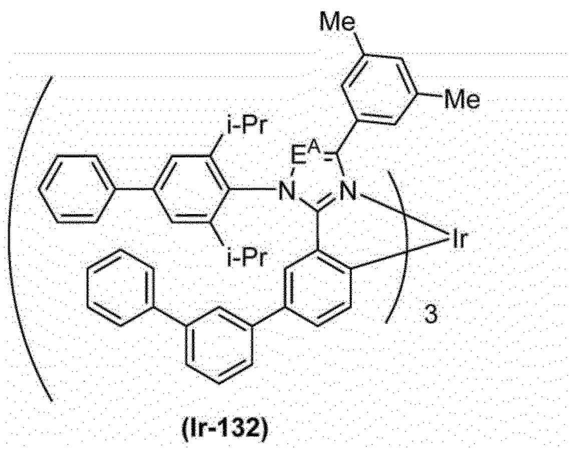

(Ir-132)

[Chemical Formula 56]

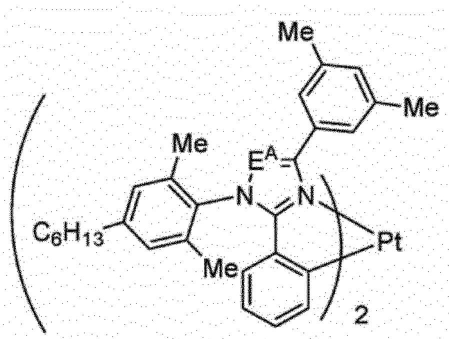

(Pt-100)

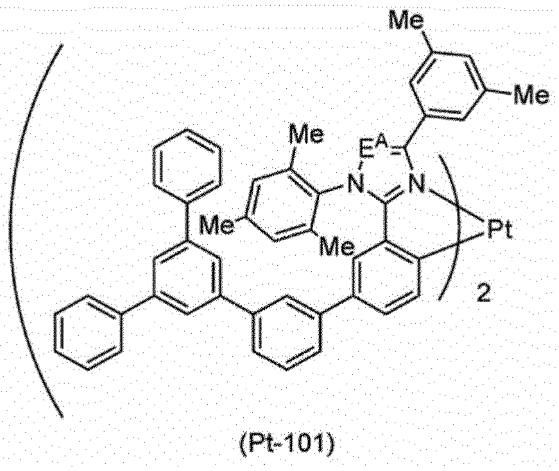

(Pt-101)

[Chemical Formula 57]

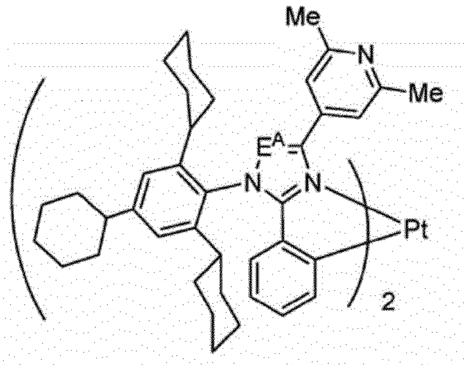

(Pt-102)

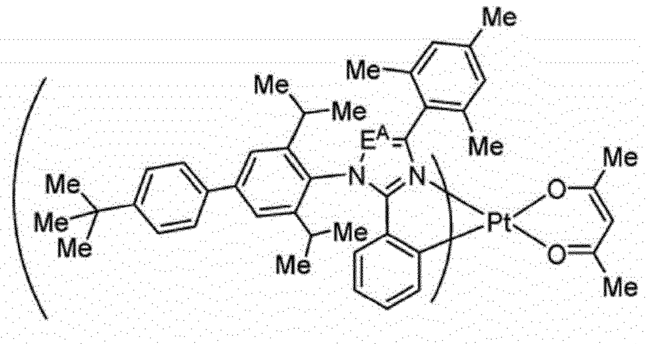

(Pt-103)

[Chemical Formula 58]

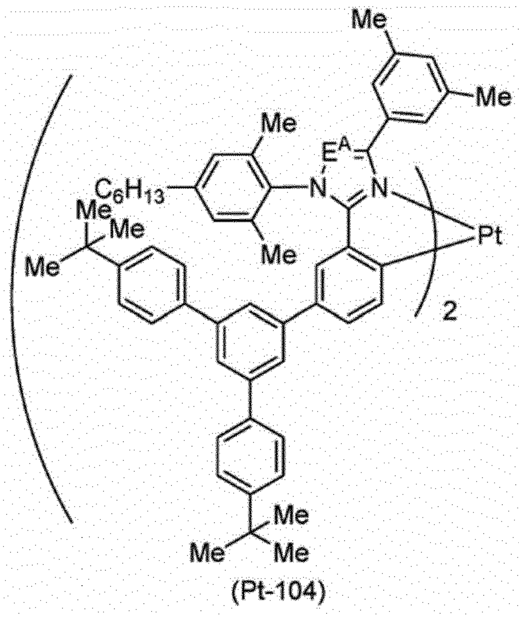

(Pt-104)

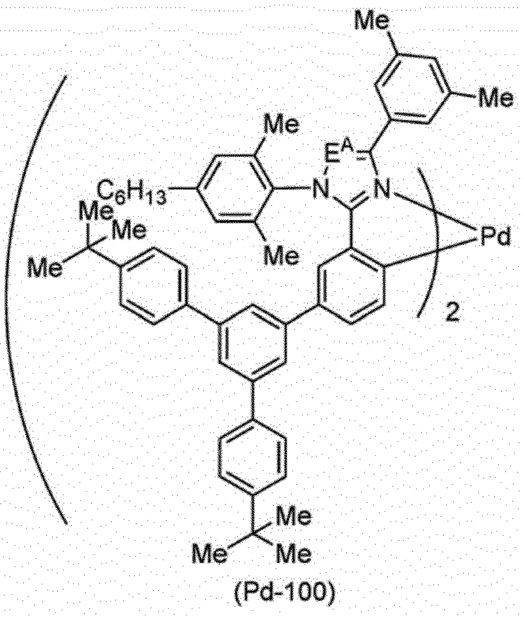

(Pd-100)

[Chemical Formula 59]

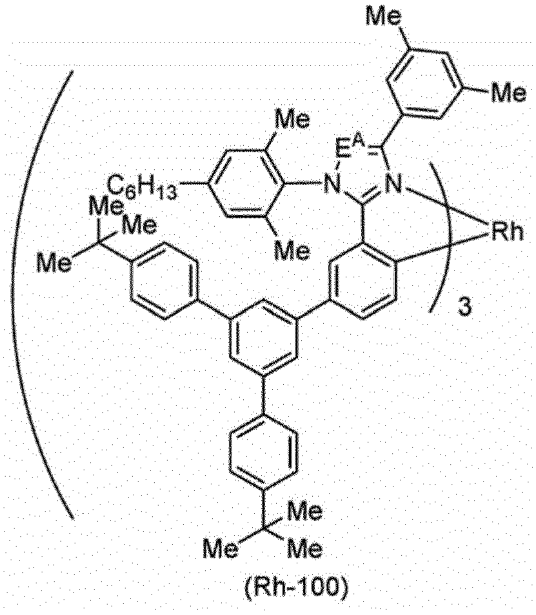

(Rh-100)

[Chemical Formula 60]

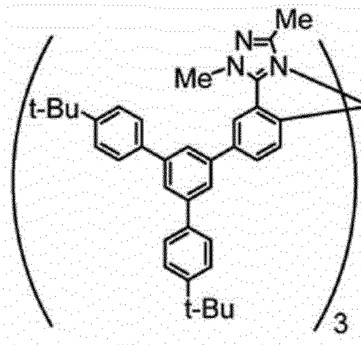

COM-9

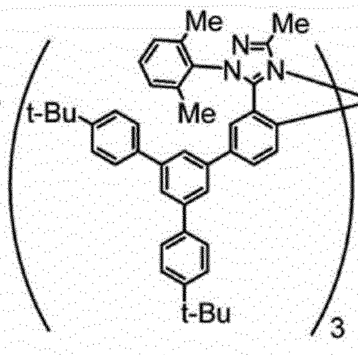

COM-10

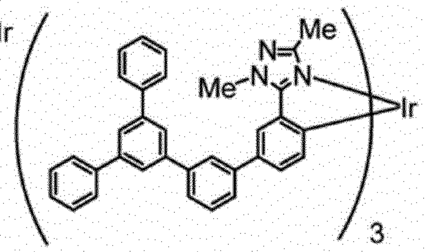

COM-11

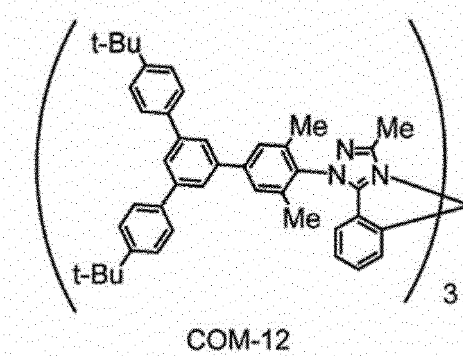

COM-12

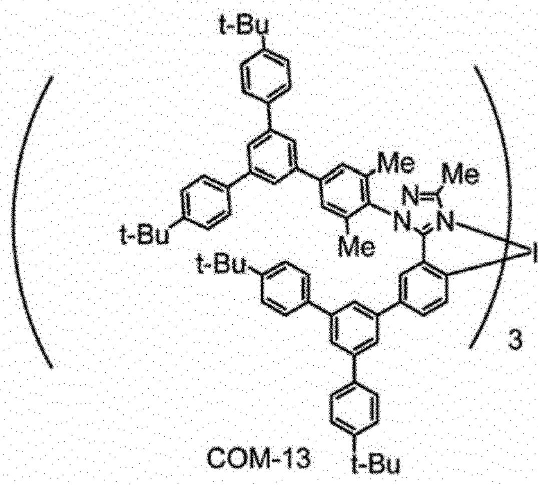

COM-13

[Chemical Formula 61]

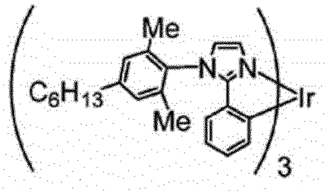

COM-14

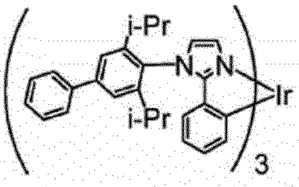

COM-15

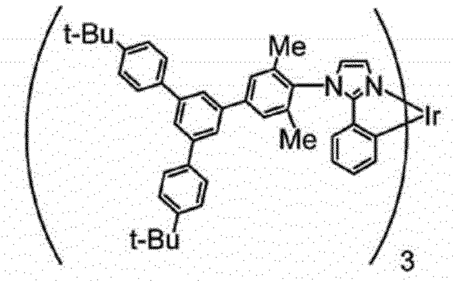

COM-16

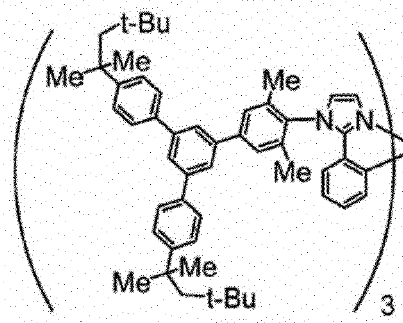

COM-17

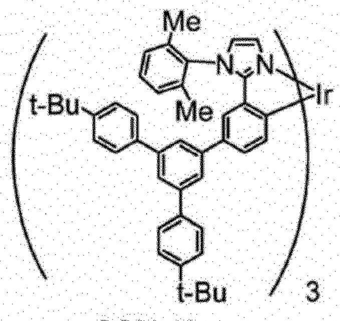

COM-18

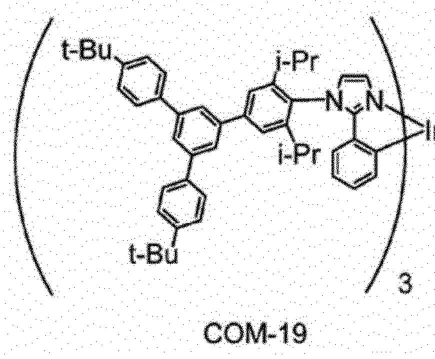

COM-19

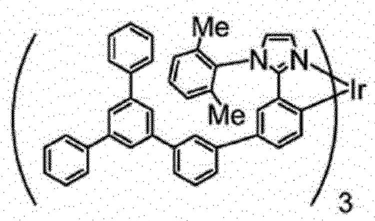

COM-20

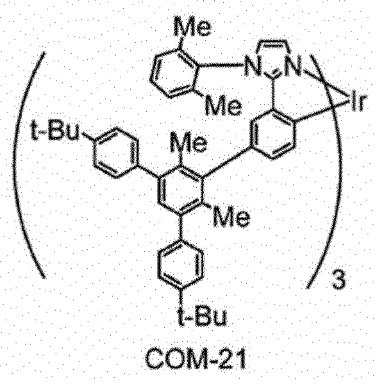

COM-21

In the formulae, $E^A$ represents a group represented by -CH= or a group represented by -N=.

The phosphorescent compound represented by the formula (1-A-2) is preferably a phosphorescent compound represented by the formula (1-A-21), a phosphorescent compound represented by the formula (1-A-22) or a phosphorescent compound represented by the formula (1-A-23), more preferably a phosphorescent compound represented by the formula (1-A-21) or a phosphorescent compound represented by the formula (1-A-22), and further preferably a phosphorescent compound represented by the formula (1-A-21), since a light emitting device containing the composition of the present embodiment is further excellent in light emission efficiency.

[Chemical Formula 62]

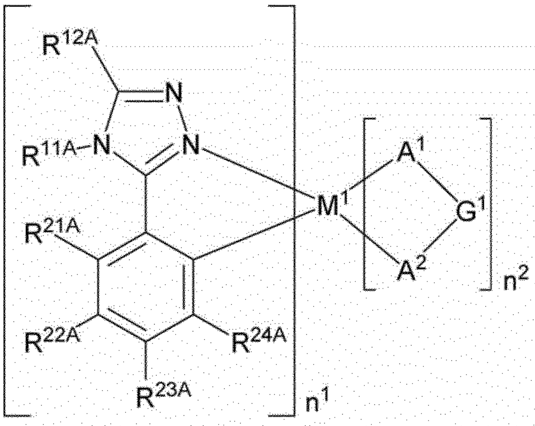

**(1-A-21)**

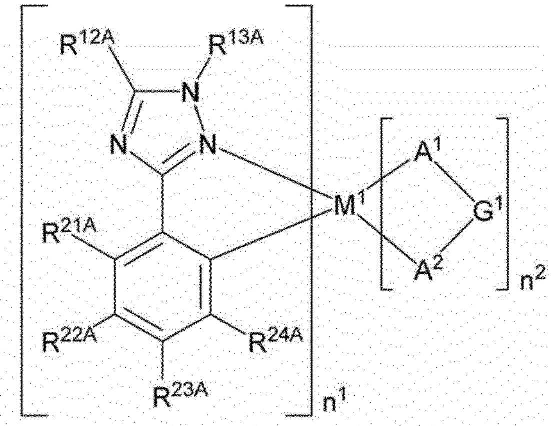

**(1-A-22)**

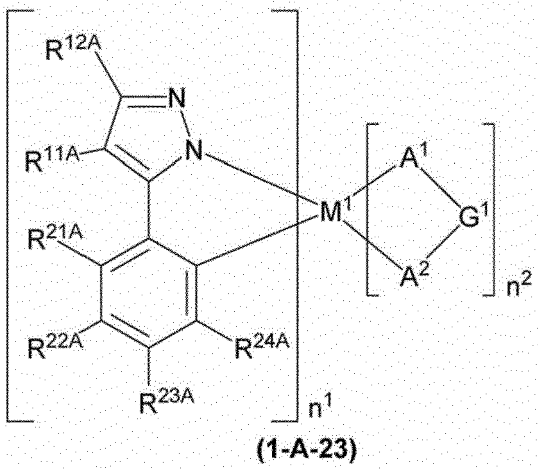

**(1-A-23)**

[wherein, $M^1$, $n^1$, $n^2$, $R^{11A}$, $R^{12A}$, $R^{13A}$, $R^{21A}$, $R^{22A}$, $R^{23A}$, $R^{24A}$ and $A^1$-$G^1$-$A^2$ represent the same meaning as described above.

In the formula (1-A-21) and the formula (1-A-23), at least one selected from the group consisting of $R^{11A}$, $R^{12A}$, $R^{21A}$, $R^{22A}$, $R^{23A}$ and $R^{24A}$ is a group represented by the above-described formula (1-T), and in the formula (1-A-22), at least one selected from the group consisting of $R^{12A}$, $R^{13A}$, $R^{21A}$, $R^{22A}$, $R^{23A}$ and $R^{24A}$ is a group represented by the above-described formula (1-T).]

In the formula (1-A-21) and the formula (1-A-23), it is preferable that at least one selected from the group consisting of $R^{11A}$ and $R^{12A}$ is a group represented by the formula (Ar-1A), and it is more preferable that $R^{11A}$ is a group represented by the formula (Ar-1A), since a light emitting device containing the composition of the present embodiment is more excellent in light emission efficiency.

In the formula (1-A-22), it is preferable that at least one selected from the group consisting of $R^{12A}$ and $R^{13A}$ is a group represented by the formula (Ar-1A), and it is more preferable that $R^{12A}$ is a group represented by the formula (Ar-1A).

[Chemical Formula 63]

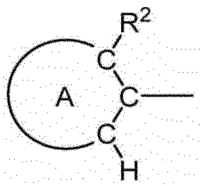

**(Ar-1A)**

[wherein,

Ring A is an aromatic hydrocarbon ring or an aromatic hetero ring, and these rings optionally have a substituent. When a plurality of the above-described substituents are present, they may be combined together to form a ring together with

atoms to which they are attached.

$R^2$ represents an alkyl group, a cycloalkyl group, an alkoxy group, a cycloalkoxy group, an aryl group, an aryloxy group, a monovalent hetero ring group, a substituted amino group or halogen atom, and these groups optionally have a substituent.]

The examples and preferable ranges of the aromatic hydrocarbon ring for Ring A are the same as the examples and preferable ranges of the aromatic hydrocarbon ring for Ring $L^2$. The examples and preferable ranges of the aromatic hetero ring for Ring A are the same as the examples and preferable ranges of the aromatic hetero ring for Ring $L^1$.

Ring A is preferably a 5-membered or 6-membered aromatic hydrocarbon ring, or a 5-membered or 6-membered aromatic hetero ring, more preferably a 6-membered aromatic hydrocarbon ring or a 6-membered aromatic hetero ring, and further preferably a 6-membered aromatic hydrocarbon ring, and these rings optionally have a substituent.

Ring A is preferably a benzene ring, a fluorene ring, a spirobifluorene ring, a dihydrophenanthrene ring, a pyridine ring, a diazabenzene ring, a carbazole ring, a dibenzofuran ring or a dibenzothiophene ring, more preferably a benzene ring, a pyridine ring or a diazabenzene ring, and further preferably a benzene ring, since a light emitting device containing the composition of the present embodiment is more excellent in light emission efficiency, and these rings optionally have a substituent.

The examples and preferable ranges of the substituent which Ring A optionally has are the same as the examples and preferable ranges of the substituent which Ring $L^2$ optionally has.

When a plurality of the substituents which Ring A optionally has are present, it is preferable that they are not combined together to form a ring together with atoms to which they are attached, since synthesis of a phosphorescent compound becomes easy.

$R^2$ is preferably an alkyl group, a cycloalkyl group, an aryl group, a monovalent hetero ring group or a substituted amino group, more preferably an alkyl group, a cycloalkyl group or an aryl group, and further preferably an alkyl group, since a light emitting device containing the composition of the present embodiment is more excellent in light emission efficiency, and these groups optionally further have a substituent.

The examples and preferable ranges of the aryl group, the monovalent hetero ring group and the substituted amino group for $R^2$ are the same as the examples and preferable ranges of the aryl group, the monovalent hetero ring group and the substituted amino group for $R^{11A}$ to $R^{13A}$.

The examples and preferable ranges of the substituent which $R^2$ optionally has are the same as the examples and preferable ranges of the substituent which $R^{11A}$ to $R^{13A}$ optionally have.

The group represented by the formula (Ar-1A) is preferably a group represented by the formula (Ar-2A), since a light emitting device containing the composition of the present embodiment is more excellent in light emission efficiency.

[Chemical Formula 64]

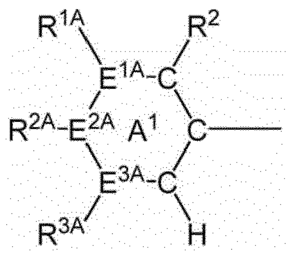

(Ar-2A)

[wherein, $R^2$ represents the same meaning as described above.

Ring $A^1$ is a benzene ring, a pyridine ring or a diazabenzene ring.

$E^{1A}$, $E^{2A}$ and $E^{3A}$ each independently represent a nitrogen atom or a carbon atom. When $E^{1A}$ is a nitrogen atom, then, $R^{1A}$ is absent. When $E^{2A}$ is a nitrogen atom, then, $R^{2A}$ is absent. When $E^{3A}$ is a nitrogen atom, then, $R^{3A}$ is absent.

$R^{1A}$, $R^{2A}$ and $R^{3A}$ each independently represent a hydrogen atom, an alkyl group, a cycloalkyl group, an alkoxy group, a cycloalkoxy group, an aryl group, an aryloxy group, a monovalent hetero ring group, a substituted amino group or halogen atom, and these groups optionally have a substituent.

$R^{1A}$ and $R^{2A}$, and $R^{2A}$ and $R^{3A}$ may each be combined together to form a ring together with atoms to which they are attached.]

$E^{1A}$ to $E^{3A}$ are each preferably a carbon atom.

When Ring $A^1$ is a pyridine ring, a pyridine ring in which $E^{1A}$ is a nitrogen atom is preferred.

When Ring $A^1$ is a diazabenzene ring, a pyrimidine ring in which $E^{1A}$ and $E^{3A}$ are each a nitrogen atom is preferred.

Ring $A^1$ is preferably a benzene ring.

$R^{1A}$ to $R^{3A}$ are each preferably a hydrogen atom, an alkyl group, a cycloalkyl group, an aryl group, a monovalent hetero ring group or a substituted amino group, and more preferably a hydrogen atom, an alkyl group or an aryl group, since a light emitting device containing the composition of the present embodiment is more excellent in light emission efficiency, and these groups optionally have a substituent.

$R^{1A}$ and $R^{3A}$ are each further preferably a hydrogen atom.

$R^{2A}$ is further preferably an alkyl group or an aryl group, and particularly preferably an alkyl group, and these groups optionally have a substituent.

The examples and preferable ranges of the aryl group, the monovalent hetero ring group and the substituted amino group for $R^{1A}$ to $R^{3A}$ are the same as the examples and preferable ranges of the aryl group, the monovalent hetero ring group and the substituted amino group for $R^{11A}$ to $R^{13A}$, respectively.

The examples and preferable ranges of the substituent which $R^{1A}$ to $R^{3A}$ optionally have are the same as the examples and preferable ranges of the substituent which $R^{11A}$ to $R^{13A}$ optionally have.

The group represented by the above-described formula (Ar-2A) is preferably a group represented by the formula (Ar-3A), since a light emitting device containing the composition of the present embodiment is more excellent in light emission efficiency.

[Chemical Formula 65]

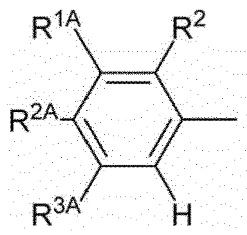

(Ar-3A)

[wherein, $R^2$, $R^{1A}$, $R^{2A}$ and $R^{3A}$ represent the same meaning as described above.]

$R^{1A}$ and $R^{2A}$, and $R^{2A}$ and $R^{3A}$ may each be combined together to form a ring together with atoms to which they are attached, but it is preferable that they do not form a ring, since synthesis of a phosphorescent compound becomes easy.

The phosphorescent compound represented by the formula (1-A-2) includes, for example, phosphorescent compounds represented by the following formulae and compounds P4 and P5 described later, and the like.

[Chemical Formula 66]

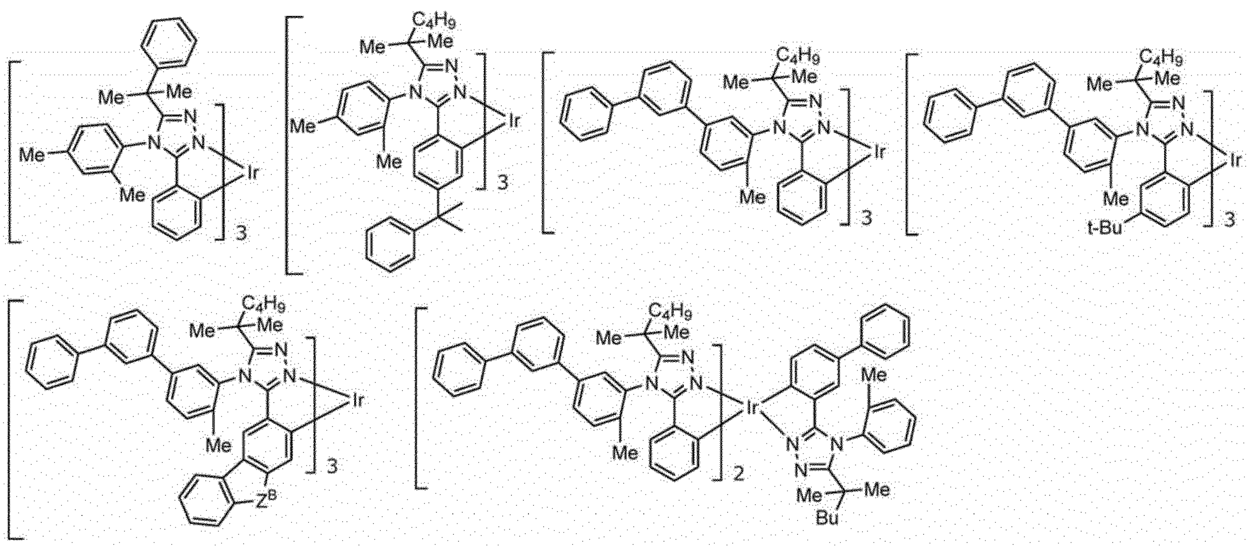

[Chemical Formula 67]

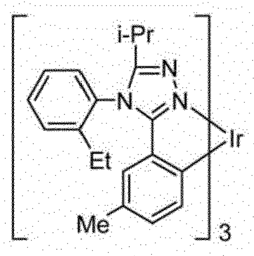
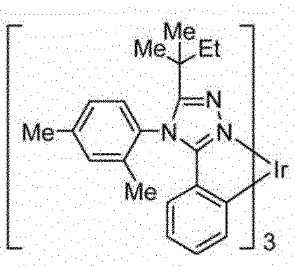
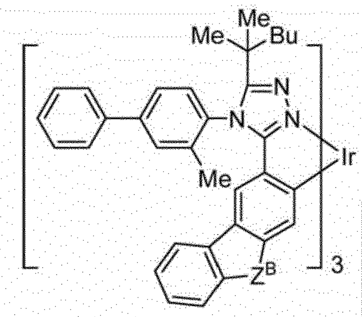
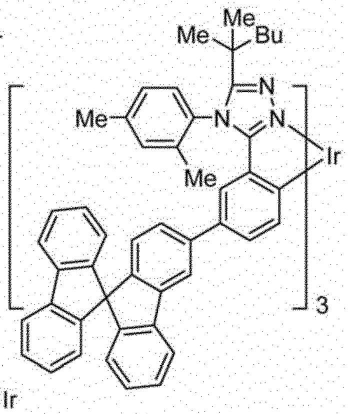
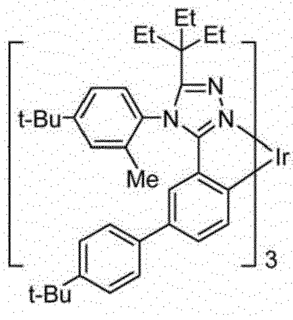
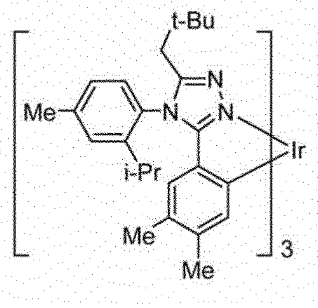
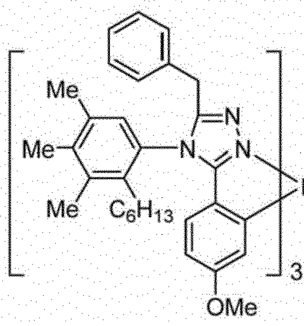

[Chemical Formula 68]

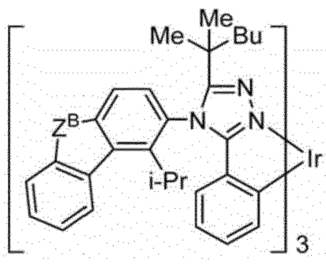
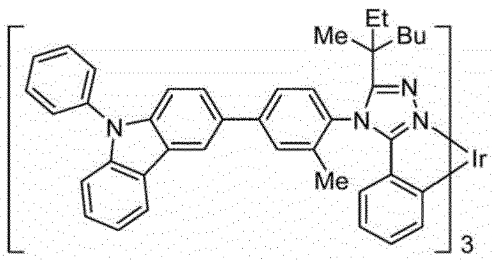
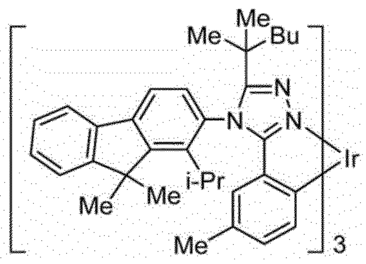

[Chemical Formula 69]

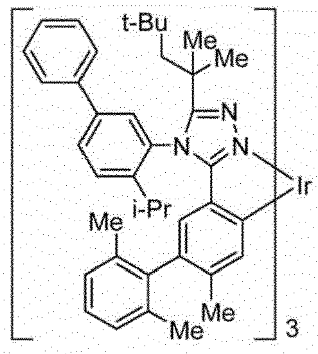

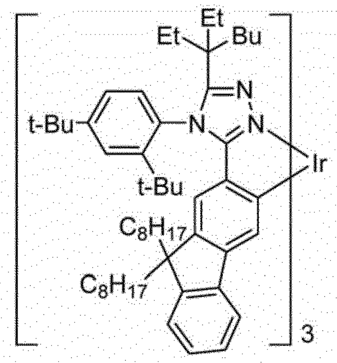

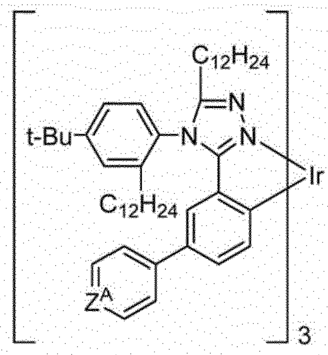

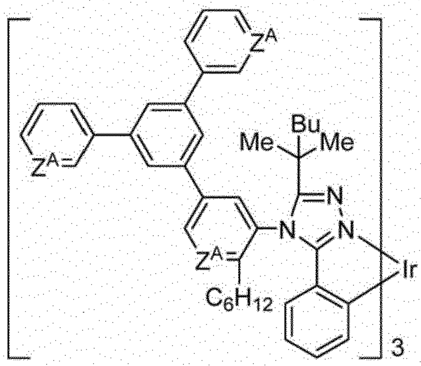

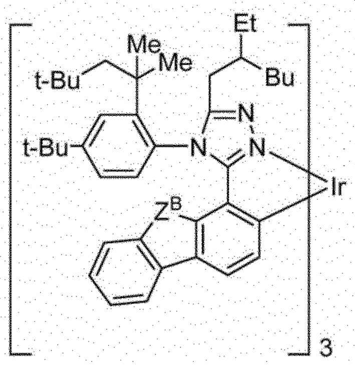

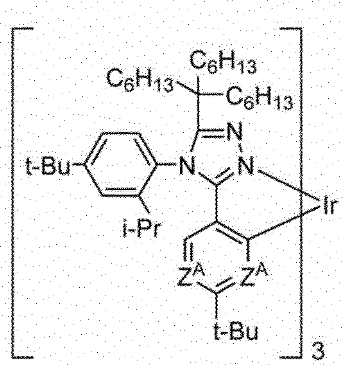

[Chemical Formula 70]

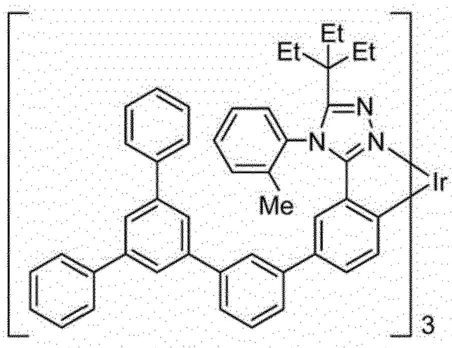

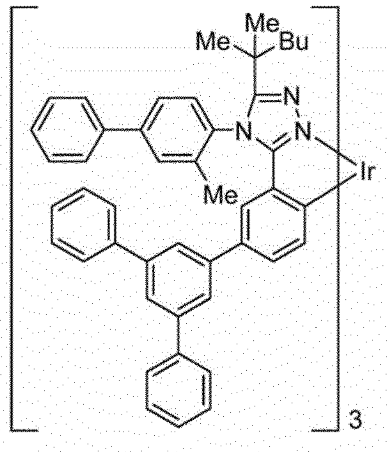

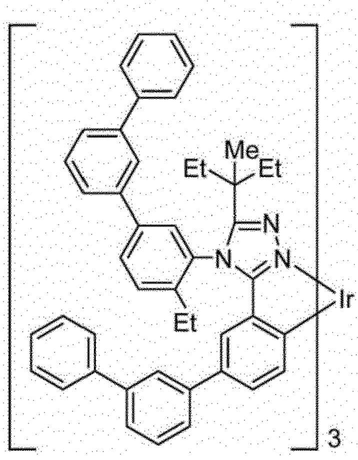

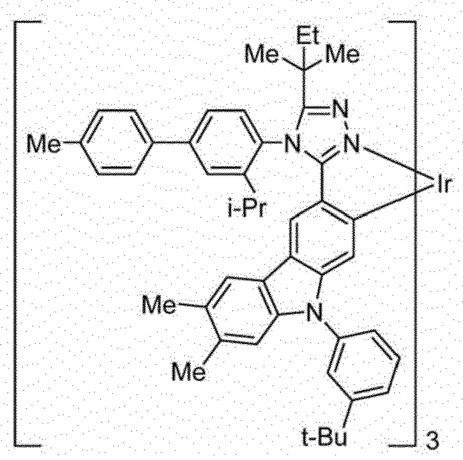

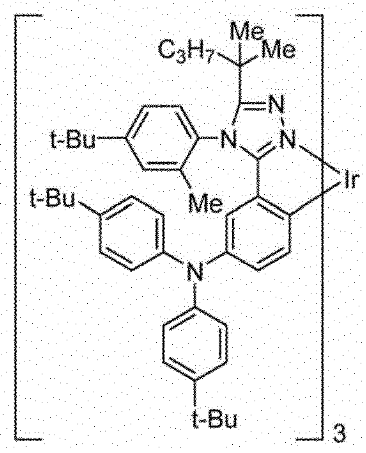

[Chemical Formula 71]

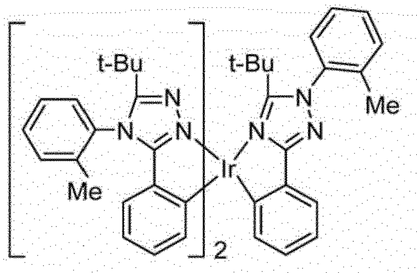

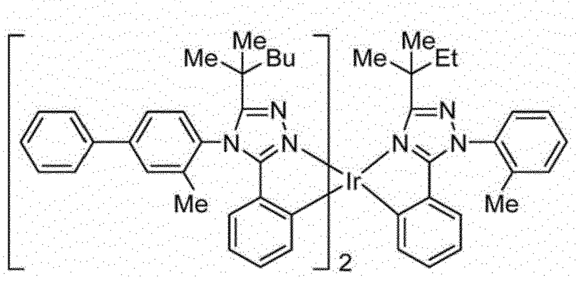

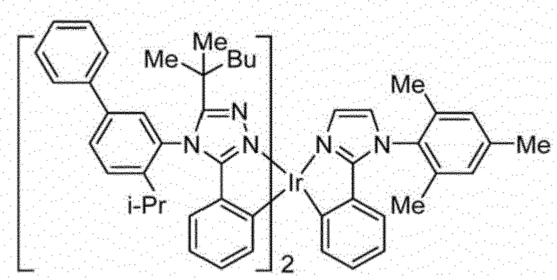

[Chemical Formula 72]

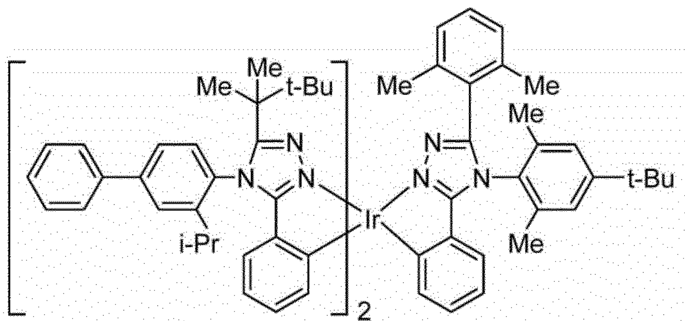

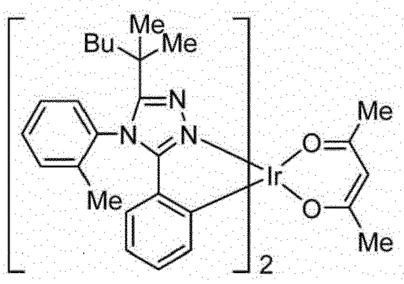

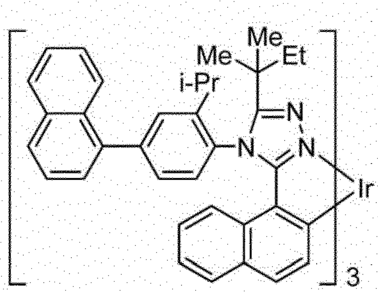

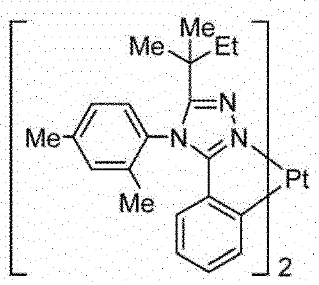

[Chemical Formula 73]

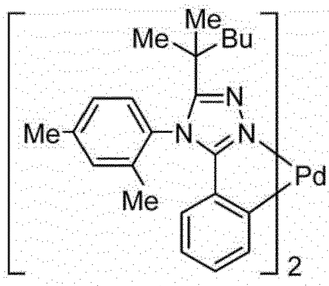

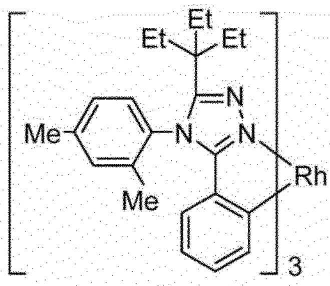

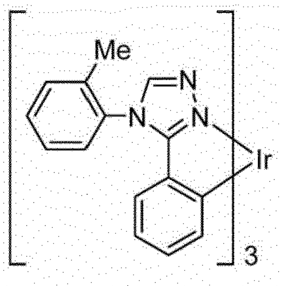

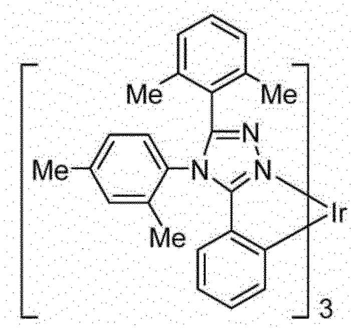

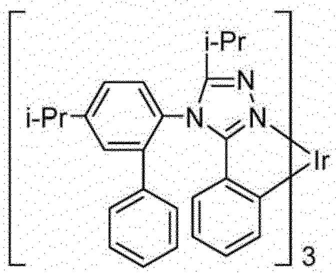

[Chemical Formula 74]

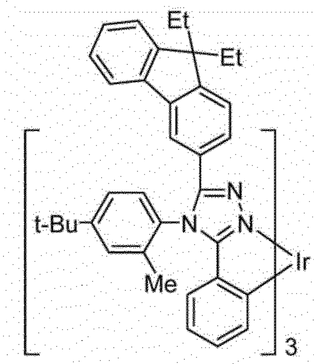

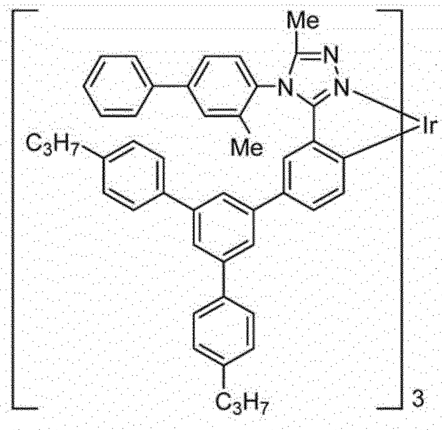

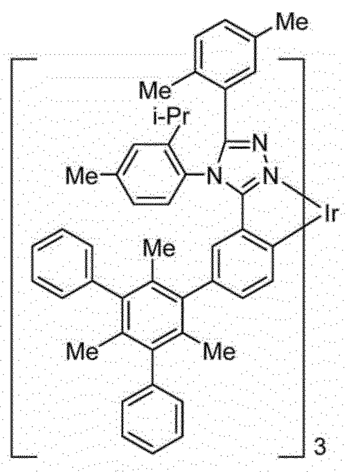

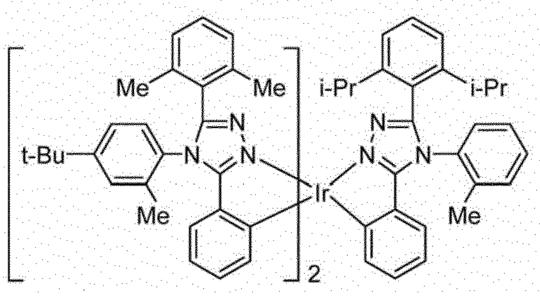

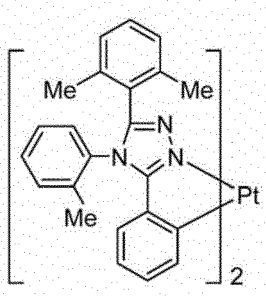

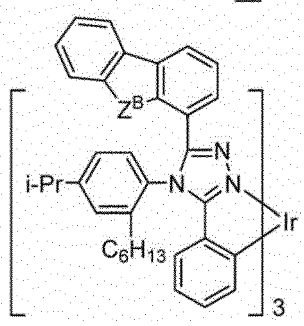

[Chemical Formula 75]

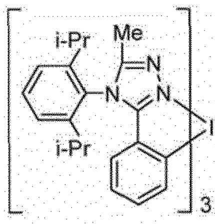
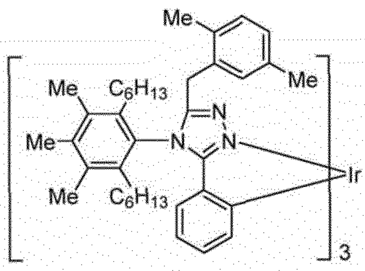
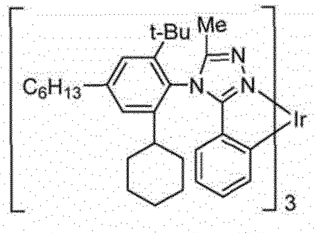
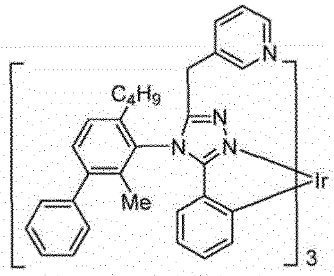
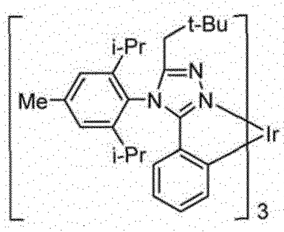
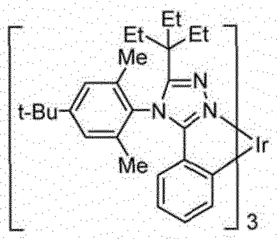
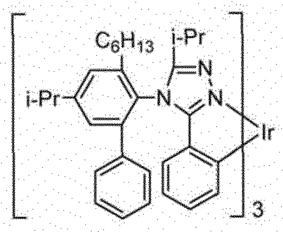
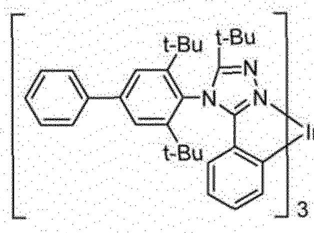
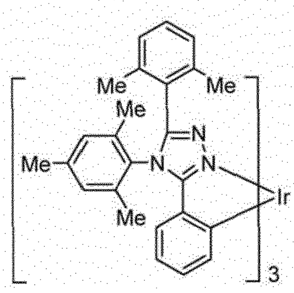
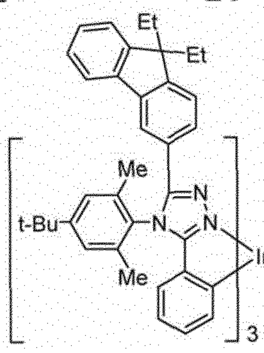
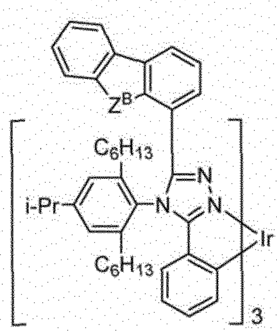
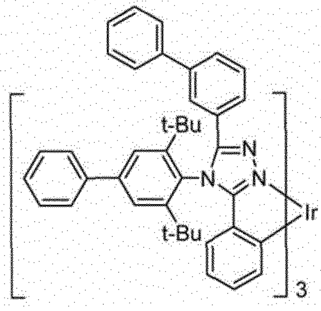

[Chemical Formula 76]

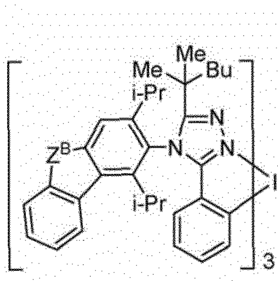 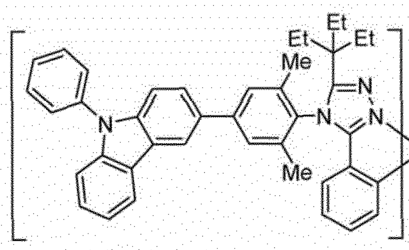 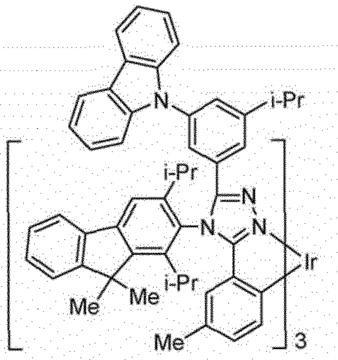

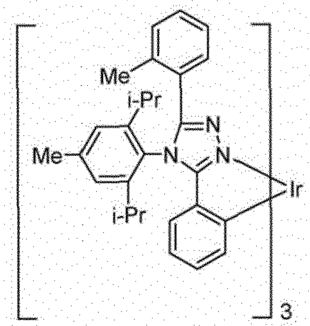 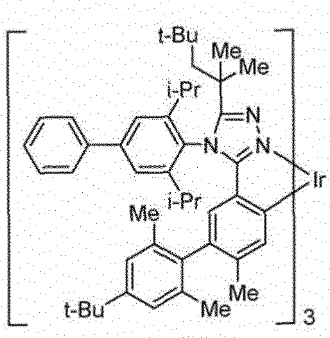 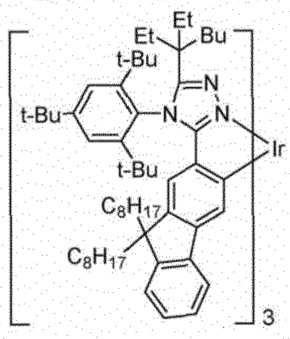

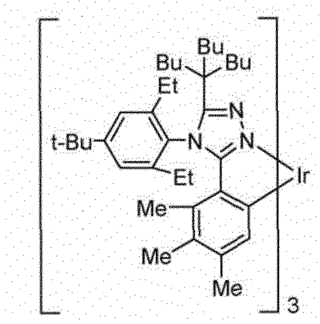 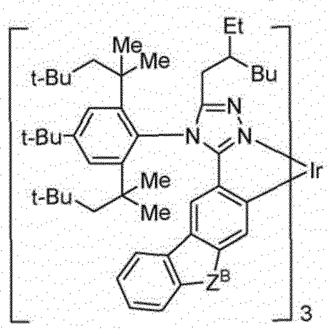 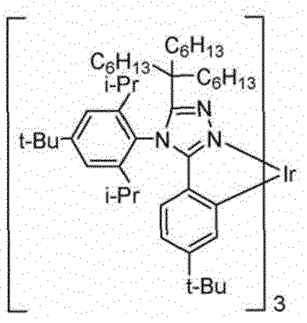 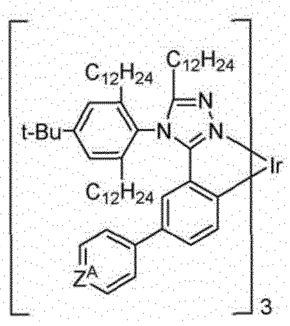

[Chemical Formula 77]

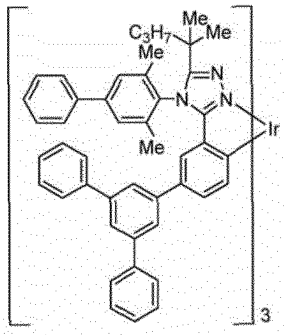
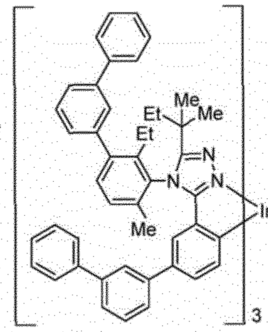
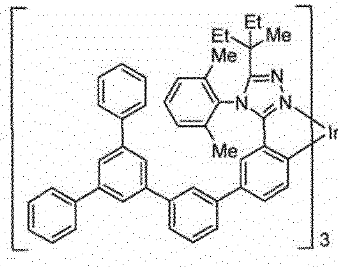
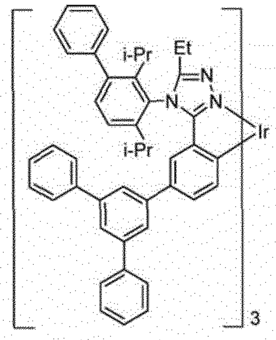
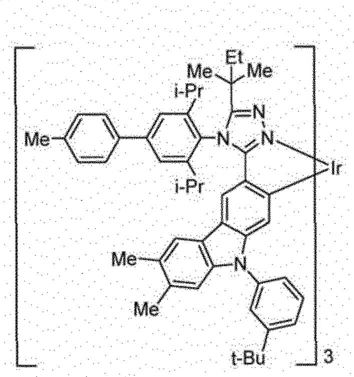
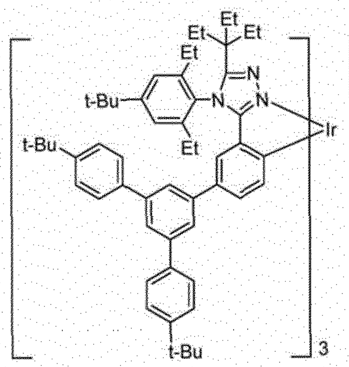
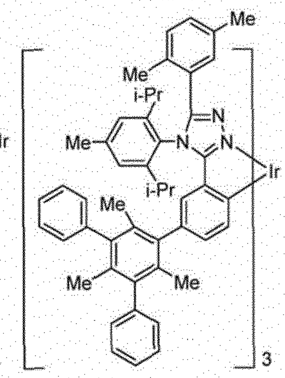
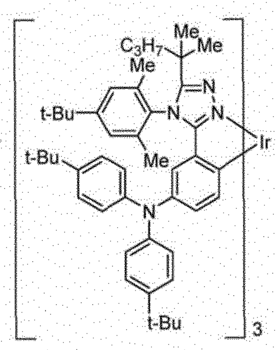
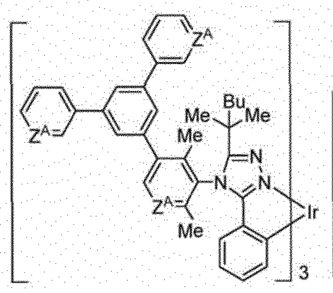
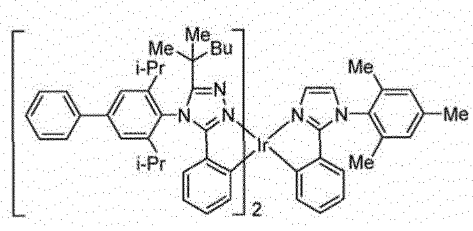
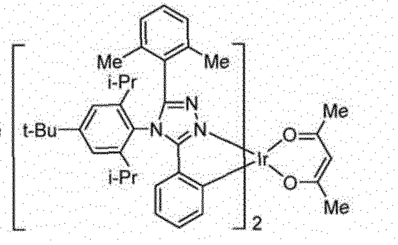

[Chemical Formula 78]

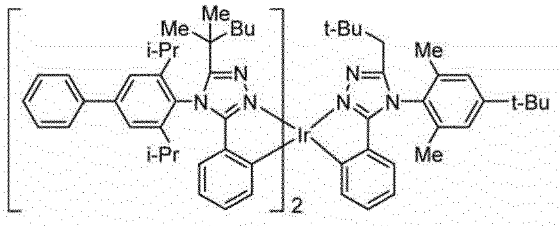
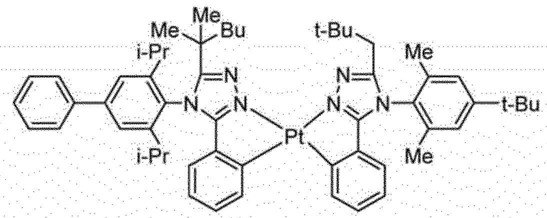
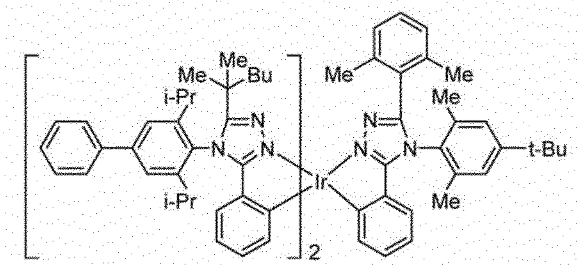
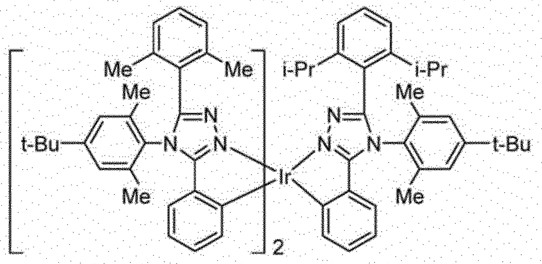
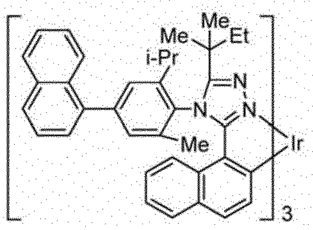
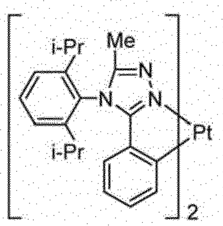
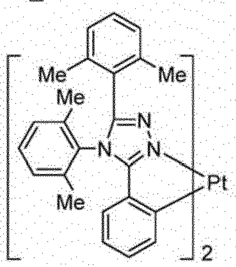
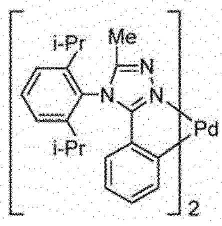
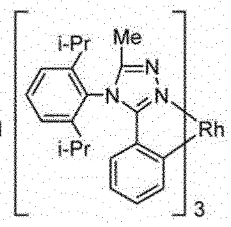

In the formulae, $Z^A$ represents a group represented by -CH= or a group represented by -N=. When a plurality of $Z^A$ are present, they may be the same or different. $Z^A$ is preferably a group represented by -N=. $Z^B$ represents a group represented by -O- or a group represented by -S-.

[Phosphorescent compound represented by the formula (1-B)]

When Ring $L^1$ is a 6-membered aromatic hetero ring, it is preferable that the phosphorescent compound represented by the formula (1) is a phosphorescent compound represented by the formula (1-B), since a light emitting device containing the composition of the present embodiment is more excellent in light emission efficiency.

When Ring $L^{1B}$ is a pyrimidine ring, a pyrimidine ring in which $E^{11B}$ is a nitrogen atom is preferred.

Ring $L^{1B}$ is preferably a pyridine ring.

When Ring $L^{1B}$ has a group represented by the formula (1-T), it is preferable that $R^{11B}$, $R^{12B}$ or $R^{13B}$ is a group represented by the formula (1-T), it is more preferable that $R^{12B}$ or $R^{13B}$ is a group represented by the formula (1-T), and it is further preferable that $R^{13B}$ is a group represented by the formula (1-T).

When the benzene ring to which $R^{21B}$ to $R^{24B}$ are bonded has a group represented by the formula (1-T), it is preferable that $R^{22B}$, $R^{23B}$ or $R^{24B}$ is a group represented by the formula (1-T), and it is more preferable that $R^{22B}$ or $R^{23B}$ is a group represented by the formula (1-T).

The phosphorescent compound represented by the formula (1-B) is preferably a phosphorescent compound represented by the formula (1-B-1), a phosphorescent compound represented by the formula (1-B-2), a phosphorescent compound represented by the formula (1-B-3), a phosphorescent compound represented by the formula (1-B-4) or a phosphorescent compound represented by the formula (1-B-5), and more preferably a phosphorescent compound represented by the formula (1-B-1), a phosphorescent compound represented by the formula (1-B-2) or a phosphorescent compound represented by the formula (1-B-3), since a light emitting device containing the composition of the present embodiment is further excellent in light emission efficiency.

[Chemical Formula 79]

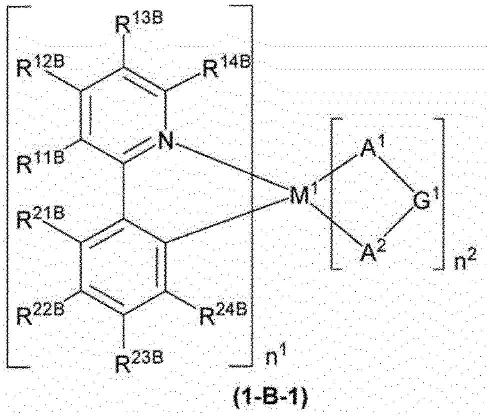

(1-B-1)

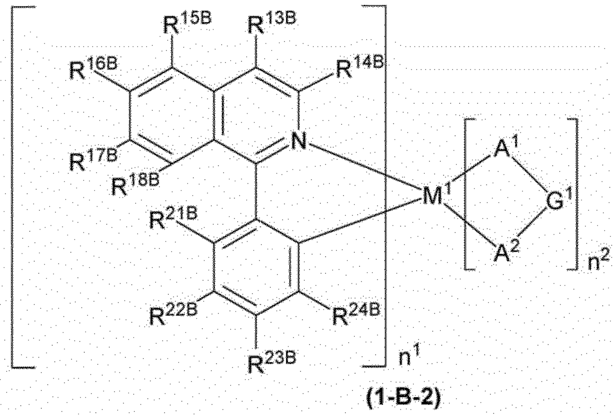

(1-B-2)

[Chemical Formula 80]

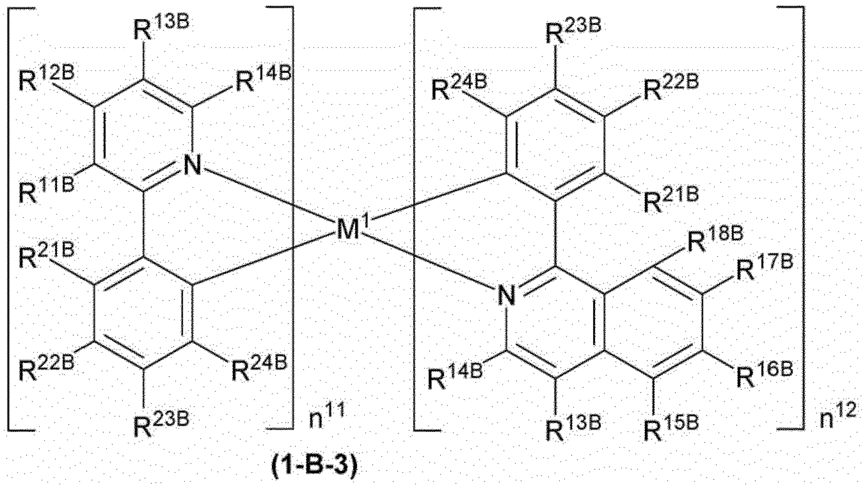

(1-B-3)

[Chemical Formula 81]

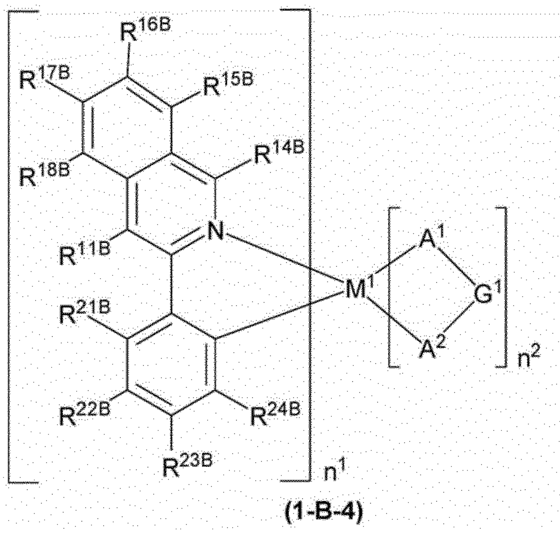

(1-B-4)

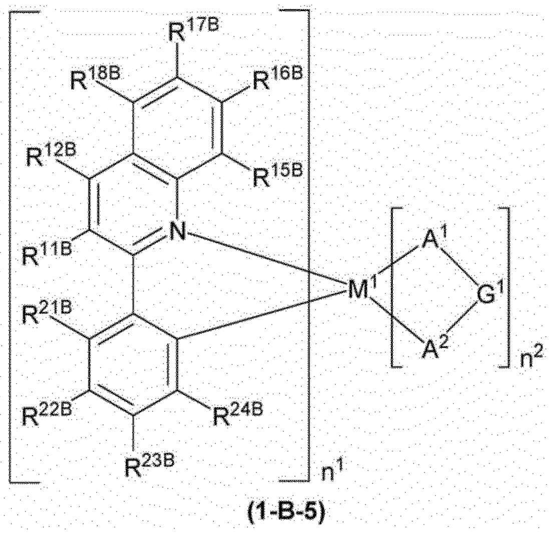

(1-B-5)

[wherein,

$M^1$, $n^1$, $n^2$, $R^{11B}$, $R^{12B}$, $R^{13B}$, $R^{14B}$, $R^{21B}$, $R^{22B}$, $R^{23B}$, $R^{24B}$ and $A^1$-$G^1$-$A^2$ represent the same meaning as described above.

$n^{11}$ and $n^{12}$ each independently represent an integer of 1 or more, and $n^{11}+n^{12}$ is 2 or 3. $n^{11}+n^{12}$ is 3 when $M^1$ is a ruthenium atom, a rhodium atom or an iridium atom, while $n^{11}+n^{12}$ is 2 when $M^1$ is a palladium atom or a platinum atom.

$R^{15B}$, $R^{16B}$, $R^{17B}$ and $R^{18B}$ each independently represent a hydrogen atom or a group represented by the above-described formula (1-T). When a plurality of $R^{15B}$, $R^{16B}$, $R^{17B}$ and $R^{18B}$ are present, they may be the same or different at each occurrence. $R^{15B}$ and $R^{16B}$, $R^{16B}$ and $R^{17B}$, and $R^{17B}$ and $R^{18B}$ may each be combined together to form a ring together with atoms to which they are attached.

In the formula (1-B-1) and the formula (1-B-3), at least one selected from the group consisting of $R^{11B}$, $R^{12B}$, $R^{13B}$, $R^{14B}$, $R^{21B}$, $R^{22B}$, $R^{23B}$ and $R^{24B}$ is a group represented by the above-described formula (1-T), in the formula (1-B-2), at least one selected from the group consisting of $R^{13B}$, $R^{14B}$, $R^{21B}$, $R^{22B}$, $R^{23B}$ and $R^{24B}$ is a group represented by the above-described formula (1-T), in the formula (1-B-4), at least one selected from the group consisting of $R^{11B}$, $R^{14B}$, $R^{21B}$, $R^{22B}$, $R^{23B}$ and $R^{24B}$ is a group represented by the above-described formula (1-T), and in the formula (1-B-5), at least one selected from the group consisting of $R^{11B}$, $R^{12B}$, $R^{21B}$, $R^{22B}$, $R^{23B}$ and $R^{24B}$ is a group represented by the above-described formula (1-T).]

It is preferable that $R^{15B}$, $R^{16B}$, $R^{17B}$ and $R^{18B}$ are each a hydrogen atom.

The phosphorescent compound represented by the formula (1-B) includes, for example, phosphorescent compounds represented by the following formulae.

[Chemical Formula 82]

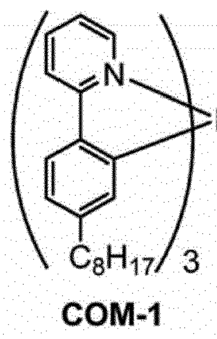

COM-1

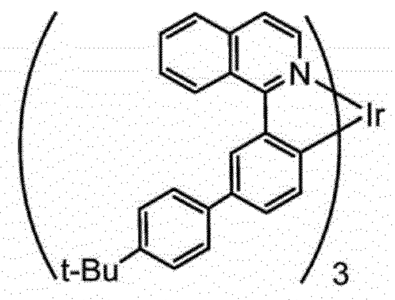

COM-3

[Chemical Formula 83]

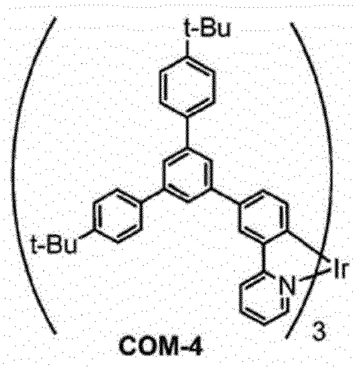

COM-4

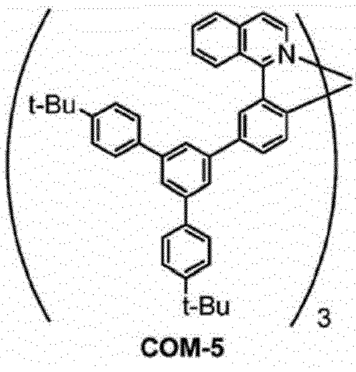

COM-5

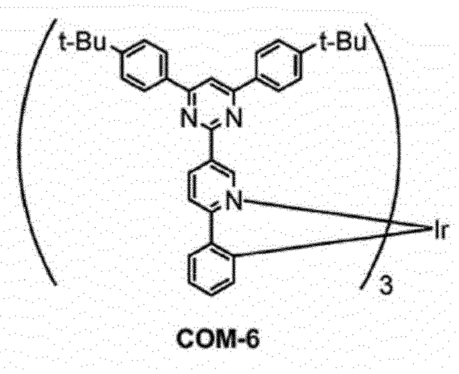

COM-6

[Chemical Formula 84]

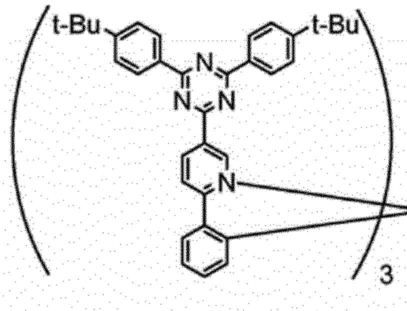

COM-7

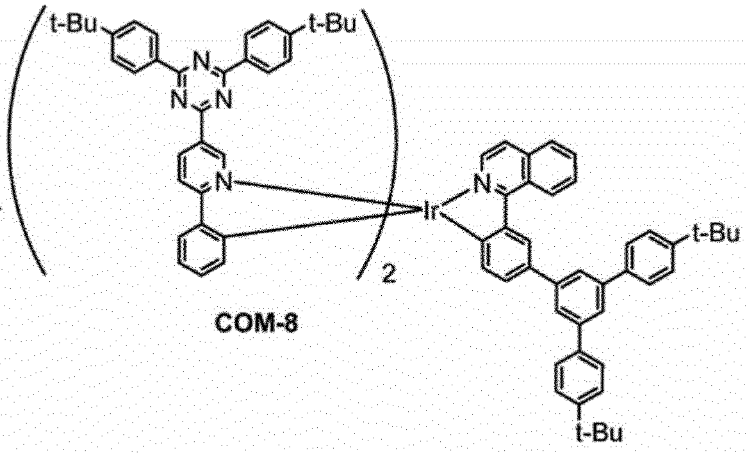

COM-8

[Chemical Formula 85]

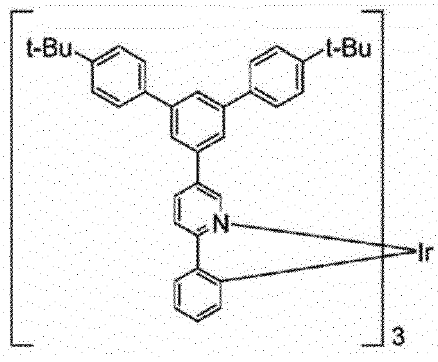

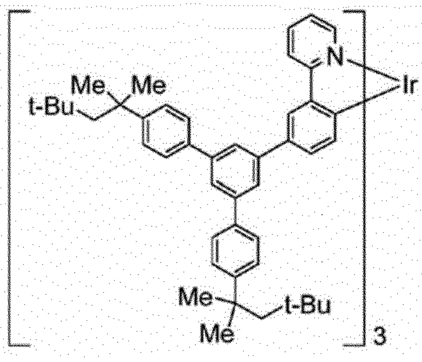

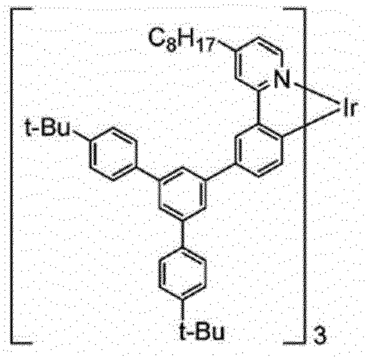

[Chemical Formula 86]

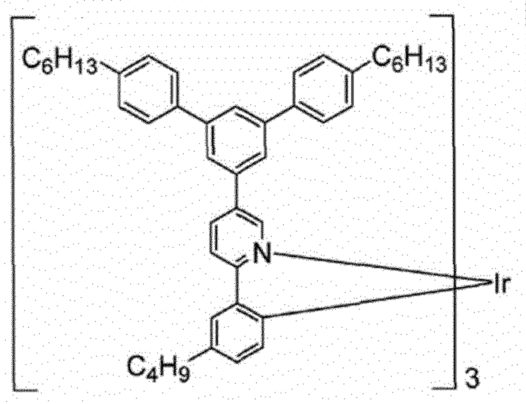

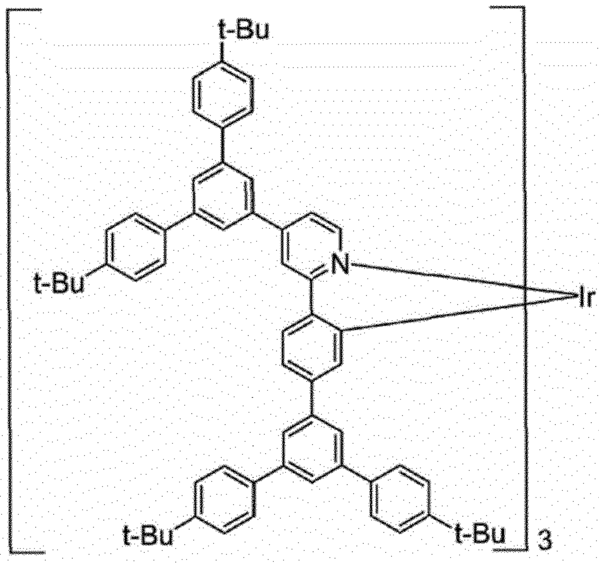

[Chemical Formula 87]

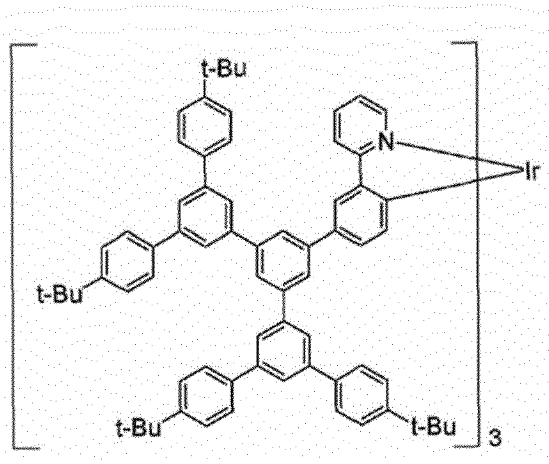

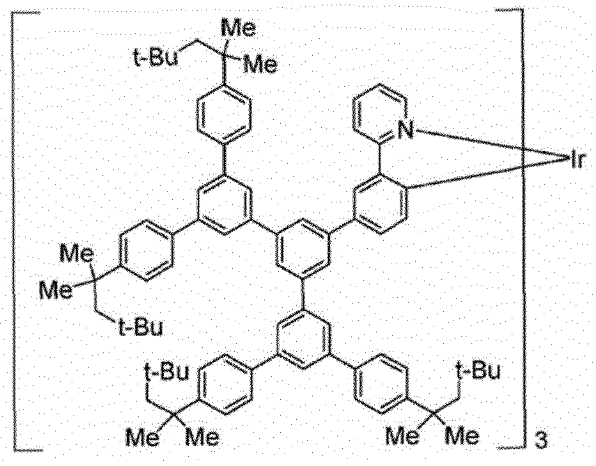

[Chemical Formula 88]

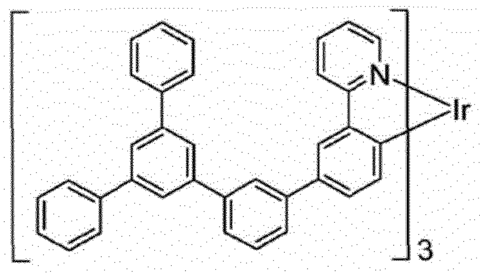

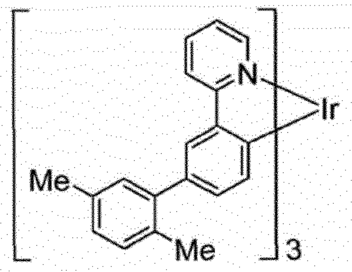

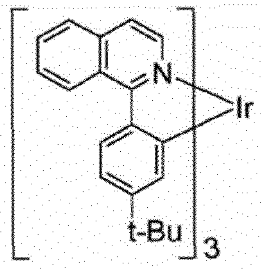

[Chemical Formula 89]

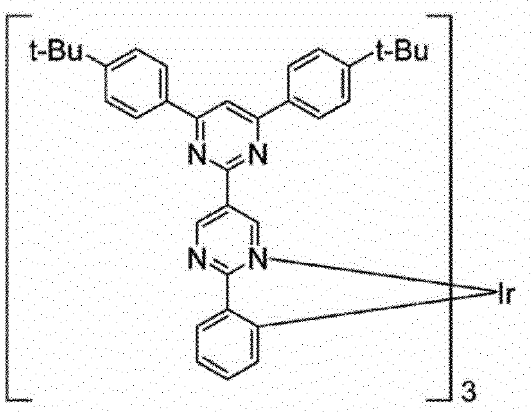

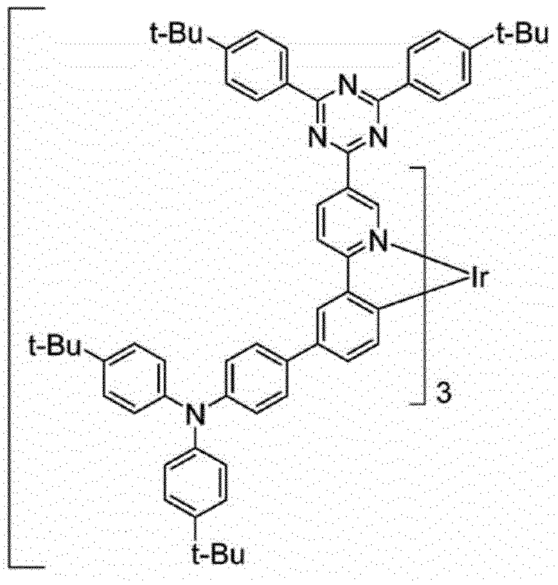

[Chemical Formula 90]

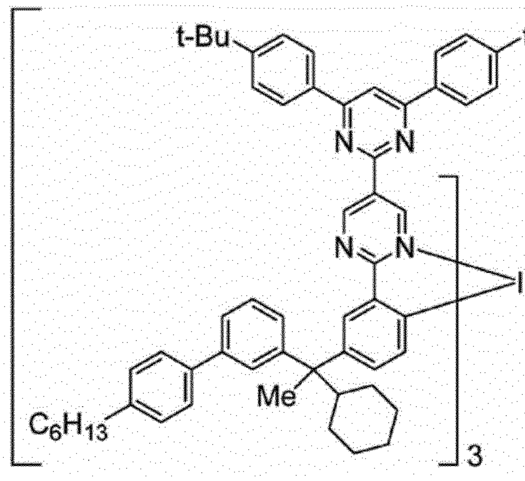
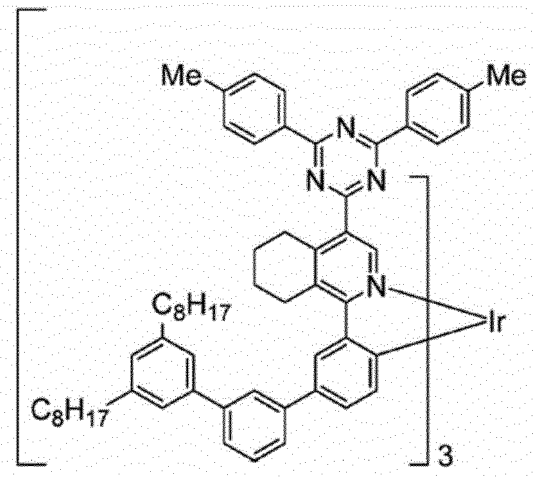

[Chemical Formula 91]

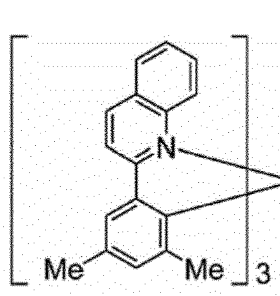
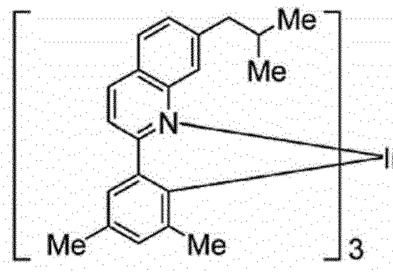
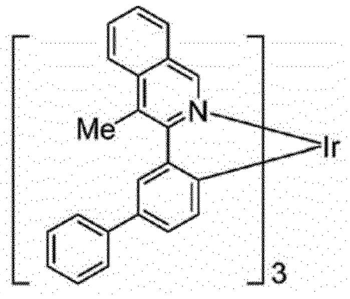

<Compound (F)>

The compound (F) is a compound having a condensed hetero ring skeleton (f) containing at least one atom (a) selected from the group consisting of a nitrogen atom and a boron atom in the ring, and satisfying the above-described formula (B). The compound (F) is classified into low molecular compounds and polymer compounds, and the composition of the present embodiment may contain any compound, and a low molecular compound is preferred, since a light emitting device containing the composition of the present embodiment is more excellent in light emission efficiency.

The compound (F) is preferably a compound containing no metal atom.

In the compound (F), when the condensed hetero ring skeleton (f) contains nitrogen atoms, it is preferable that at least one among nitrogen atoms contained in the condensed hetero ring skeleton (f) is a nitrogen atom not forming a double bond, and it is more preferable that all nitrogen atoms contained in the condensed hetero ring skeleton (f) are each a nitrogen atom not forming a double bond.

The number of carbon atoms of the condensed hetero ring skeleton (f) is, not including the number of carbon atoms of the substituent, usually 1 to 60, preferably 5 to 40, and more preferably 10 to 25.

The number of boron atoms of the condensed hetero ring skeleton (f) is, not including the number of boron atoms of the substituent, usually 1 to 10, preferably 1 to 5, more preferably 1 to 3, and further preferably 1.

The number of nitrogen atoms of the condensed hetero ring skeleton (f) is, not including the number of nitrogen atoms of the substituent, usually 1 to 20, preferably 1 to 15, more preferably 1 to 10, further preferably 2 to 5, and particularly preferably 2 or 3.

The number of hetero atoms of the condensed hetero ring skeleton (f) is, not including the number of hetero atoms of the substituent, usually 2 to 30, preferably 2 to 15, more preferably 2 to 10, further preferably 2 to 5, and particularly preferably 2 or 3.

The condensed hetero ring skeleton (f) more preferably contains a boron atom and a nitrogen atom in the ring, and further preferably contains a boron atom and a nitrogen atom not forming a double bond in the ring, since the light emitting device of the present embodiment is more excellent in light emission efficiency.

The condensed hetero ring skeleton (f) is preferably a tri to dodecacyclic condensed hetero ring skeleton, more preferably a tri to hexacyclic condensed hetero ring skeleton, and further preferably a pentacyclic condensed hetero ring skeleton, since the light emitting device of the present embodiment is more excellent in light emission efficiency.

The compound (F) can also be said to be a compound having a hetero ring group (f') containing a condensed hetero ring skeleton (f).

The hetero ring group (f') may be a group obtained by removing from a polycyclic heterocyclic compound containing an atom (a) in the ring one or more hydrogen atoms bonding directly to atoms constituting the ring, and the group optionally has a substituent. In the hetero ring group (f'), the polycyclic heterocyclic compound is preferably a polycyclic heterocyclic compound containing a boron atom and a nitrogen atom in the ring, and more preferably a polycyclic heterocyclic compound containing a boron atom and a nitrogen atom not forming a double bond in the ring. In the hetero ring group (f'), the polycyclic heterocyclic compound is preferably a tri to dodecacyclic heterocyclic compound, more preferably a tri to hexacyclic heterocyclic compound, and further preferably a pentacyclic heterocyclic compound.

The substituent which the hetero ring group (f') optionally has is preferably a halogen atom, a cyano group, an alkyl group, a cycloalkyl group, an alkoxy group, a cycloalkoxy group, an aryl group, a monovalent hetero ring group or a substituted amino group, more preferably an alkyl group, a cycloalkyl group, an alkoxy group, a cycloalkoxy group, an aryl group, a monovalent hetero ring group or a substituted amino group, further preferably an alkyl group, a cycloalkyl group, an aryl group, a monovalent hetero ring group or a substituted amino group, and particularly preferably an alkyl group, an aryl group, a monovalent hetero ring group or a substituted amino group, and these groups optionally further have a substituent.

The aryl group for the substituent which the hetero ring group (f') optionally has is preferably a group obtained by removing from a monocyclic or bicyclic to hexacyclic aromatic hydrocarbon one hydrogen atom bonding directly to an atom constituting the ring, more preferably a group obtained by removing from a monocyclic, bicyclic or tricyclic aromatic hydrocarbon one hydrogen atom bonding directly to an atom constituting the ring, further preferably a group obtained by removing from benzene, naphthalene, anthracene, phenanthrene or fluorene one hydrogen atom bonding directly to an atom constituting the ring, and particularly preferably a phenyl group, and these groups optionally have a substituent.

The monovalent hetero ring group for the substituent which the hetero ring group (f') optionally has is preferably a group obtained by removing from a monocyclic or bicyclic to hexacyclic heterocyclic compound one hydrogen atom bonding directly to an atom constituting the ring, more preferably a group obtained by removing from a monocyclic, bicyclic or tricyclic heterocyclic compound one hydrogen atom bonding directly to an atom constituting the ring, further preferably a group obtained by removing from pyridine, diazabenzene, triazine, azanaphthalene, diazanaphthalene, carbazole, dibenzofuran, dibenzothiophene, phenoxazine or phenothiazine one hydrogen atom bonding directly to an atom constituting the ring, particularly preferably a group obtained by removing from pyridine, carbazole, phenoxazine or phenothiazine one hydrogen atom bonding directly to an atom constituting the ring, and especially preferably a group obtained by removing from carbazole one hydrogen atom bonding directly to an atom constituting the ring, since the light emitting device of the present embodiment is more excellent in light emission efficiency, and these groups optionally have a substituent.

In the substituted amino group for the substituent which the hetero ring group (f') optionally has, the substituent which an amino group has is preferably an aryl group or a monovalent hetero ring group, and more preferably an aryl group, and these groups optionally further have a substituent. The examples and preferable ranges of the aryl group and the monovalent hetero ring group for the substituent which an amino group has are the same as the examples and preferable ranges of the aryl group and the monovalent hetero ring group for the substituent which the hetero ring group (f') optionally has, respectively.

The substituent which the substituent which the hetero ring group (f') optionally has optionally further has is preferably a halogen atom, an alkyl group, a cycloalkyl group, an alkoxy group, a cycloalkoxy group, an aryl group, a monovalent hetero ring group or a substituted amino group, more preferably an alkyl group, a cycloalkyl group, an aryl group, a monovalent hetero ring group or a substituted amino group, and further preferably an alkyl group or a cycloalkyl group, and these groups optionally further have a substituent.

The examples and preferable ranges of the aryl group, the monovalent hetero ring group and the substituted amino group for the substituent which the substituent which the hetero ring group (f') optionally has optionally further has are the same as the examples and preferable ranges of the aryl group, the monovalent hetero ring group and the substituted amino group for the substituent which the hetero ring group (f') optionally has, respectively.

"A nitrogen atom not forming a double bond" denotes a nitrogen atom bonding to other three atoms each via a single bond.

"Containing a nitrogen atom not forming a double bond in the ring" means that $-N(-R^N)-$ (wherein, $R^N$ represents a hydrogen atom or a substituent) or a group represented by the formula (DN) is contained in the ring.

[Chemical Formula 92]

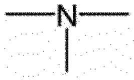

(DN)

The compound (F) is preferably a thermally activated delayed fluorescent (TADF) compound, since a light emitting device containing the composition of the present embodiment is more excellent in light emission efficiency. Hereinafter, the difference between the value of the energy level in the lowest singlet excited state and the value of the energy level in the lowest triplet excited state of a compound is referred to also as $\Delta E_{ST}$. $\Delta E_{ST}$ of the compound (F) is the same as $|S_F|-|T_F|$.

$\Delta E_{ST}$ of the compound (F) may be 2.0 eV or less, may be 1.5 eV or less, may be 1.0 eV or less, may be 0.80 eV or less, and may be 0.60 eV or less, but it is preferably 0.50 eV or less, and more preferably 0.48 eV or less, since a light emitting device containing the composition of the present embodiment is more excellent in light emission efficiency. Further, $\Delta E_{ST}$ of the compound (F) may be 0.001 eV or more, may be 0.01 eV or more, may be 0.10 eV or more, may be 0.20 eV or more, may be 0.30 eV or more, and may be 0.40 eV or more.

The half-value width of light emission spectrum at room temperature of a compound can be determined by measuring the wavelength at the longest wavelength side at a light emission strength of 0.5 and the wavelength at the shortest wavelength side at a light emission strength of 0.5 when the light emission spectrum is standardized so that the light emission strength for $\lambda_{PL,RT}$ is 1 in measurement of $\lambda_{PL,RT}$ described above, respectively, and calculating the difference of them.

In the case of use of a light emitting device for the display application, particularly when a color filter is used together, it is preferable that the half-value widths of light emission spectrum of the composition for light emitting device and the light emitting device containing the same are each small. Since the phosphorescent compound represented by the formula (1) is a compound showing light emission from triplet excited state at room temperature, the light emitting device containing the phosphorescent compound represented by the formula (1) is excellent in light emission efficiency in many cases, however, the half-value width of light emission spectrum of the light emitting device containing the phosphorescent compound represented by the formula (1) is large in many cases, and particularly 50 nm or more in many cases. In contrast, since the compound (F) is a compound that cannot utilize triplet excited state as light emission at room temperature excluding a case in which the compound (F) is a TADF compound, and the like, the light emission efficiency of the light emitting device containing the compound (F) is not excellent in many cases, however, the compound (F) has larger degree of freedom in material design than the phosphorescent compound represented by the formula (1) and the material design suppressing structural change in the molecule is possible, hence, the half-value width of light emission spectrum of the light emitting device containing the compound (F) can be made smaller than the half-value width of light emission spectrum of the light emitting device containing the phosphorescent compound represented by the formula (1).

The composition of the present embodiment contains a phosphorescent compound represented by the formula (1) and a compound (F), and efficient energy transfer from the phosphorescent compound represented by the formula (1) to the compound (F) can be realized, and light emission based on the light emission spectrum of the compound (F) can be attained at light emission efficiency equivalent to the excellent light emission efficiency of the phosphorescent compound represented by the formula (1). Therefore, the composition of the present embodiment preferably contains a phosphorescent compound represented by the formula (1) and a compound (F) having a half-value width of light emission spectrum of 50 nm or less, more preferably contains a phosphorescent compound represented by the formula (1) and a compound (F) having a half-value width of light emission spectrum of 30 nm or less, further preferably contains a phosphorescent compound represented by the formula (1) and a compound (F) having a half-value width of light emission spectrum of 25 nm or less, and particularly preferably contains a phosphorescent compound represented by the formula (1) and a compound (F) having a half-value width of light emission spectrum of 20 nm or less.

The half-value width of light emission spectrum of the compound (F) is preferably 5 nm or more and 100 nm or less, more preferably 5 nm or more and 50 nm or less, further preferably 10 nm or more and 30 nm or less, particularly preferably 15 nm or more and 25 nm or less, and especially preferably 15 nm or more and 20 nm or less, since the composition of the present embodiment becomes suitable for the display application, energy transfer from the phosphorescent compound represented by the formula (1) to the compound (F) becomes more efficient via reduction of the Stokes shift of the compound (F), and resultantly, a light emitting device containing the composition of the present embodiment is more excellent in light emission efficiency.

Hereinafter, the number of the atom (a) in the condensed hetero ring skeleton (f) per 1000 of the molecular weight of the compound (F) is expressed as $N_f$, the number of a nitrogen atom in the condensed hetero ring skeleton (f) per 1000 of the molecular weight of the compound (F) is expressed as $N_N$, and the number of a boron atom in the condensed hetero ring skeleton (f) per 1000 of the molecular weight of the compound (F) is expressed as $N_B$. $N_f$ is the same as $N_N+N_B$.

$N_B$ is preferably 0 or more and 3.0 or less, more preferably 0 or more and 1.5 or less, further preferably 0.1 or more

and 1.5 or less, and particularly preferably 0.5 or more and 1.2 or less, since a light emitting device containing the composition of the present embodiment is more excellent in light emission efficiency.

$N_N$ is preferably 0.01 or more and 4.5 or less, more preferably 0.1 or more and 4.0 or less, further preferably 0.5 or more and 3.0 or less, and particularly preferably 1.0 or more and 3.0 or less, since a light emitting device containing the composition of the present embodiment is more excellent in light emission efficiency.

In the composition of the present embodiment, $N_N$+$N_B$ is 0.01 or more and 4.5 or less, and $N_N$+$N_B$ is preferably 0.1 or more and 4.5 or less, more preferably 0.2 or more and 4.5 or less, further preferably 0.5 or more and 4.5 or less, particularly preferably 1.0 or more and 4.5 or less, and especially preferably 2.0 or more and 4.0 or less, since a light emitting device containing the composition of the present embodiment is more excellent in light emission efficiency.

The reason why $N_f$ which is a total index of the number of nitrogen atoms and the number of boron atoms (namely, $N_N$+$N_B$) is defined in the compound (F) is, for example, that the number of nitrogen atoms and boron atoms in the condensed hetero ring skeleton (f), which is a characteristic skeleton of the compound (F), significantly affects the charge transportability of the composition of the present embodiment, and affects the half-value width of the light emission spectrum of the compound (F).

The composition of the present embodiment contains a phosphorescent compound represented by the formula (1) and a compound (F), and the phosphorescent compound represented by the formula (1) has at least one group represented by the formula (1-T) as a substituent, and the compound (F) satisfies the formula (B). As described above, realizing efficient energy transfer from the phosphorescent compound represented by the formula (1) to the compound (F) is important for giving excellent light emission efficiency of the light emitting device containing the composition of the present embodiment, and the energy transfer includes two types: that is, energy transfer in which the lowest triplet excited state of the phosphorescent compound represented by the formula (1) transitions into the lowest triplet excited state of the compound (F) (hereinafter, referred to as energy transfer D), and energy transfer in which the lowest triplet excited state of the phosphorescent compound represented by the formula (1) transitions into the lowest singlet excited state of the compound (F) (hereinafter, referred to as energy transfer F). Since the compound (F) is a compound that cannot utilize the triplet excited state as light emission at room temperature excluding a case in which the compound (F) is a TADF compound, and the like, the energy transfer D is not efficient, and the energy transfer F becomes efficient. The speed of energy transfer D and the speed energy transfer F are each depend on the distance between the phosphorescent compound represented by the formula (1) and the compound (F), and both speeds tend to decrease as the distance incases, however, the dependence on the distance of the speed of the energy transfer D is larger than that of the speed of the energy transfer F, therefore, it is necessary to set the distance in an appropriate range in order to minimize the decrease in the speed of the energy transfer F and to make the energy transfer F superior to the energy transfer D. Here, it can be said that the formula (B) is an index showing how many substituents the compound (F) has in addition to the light emitting site. That is, the formula (B) is designed to set the distance in an appropriate range, in combination with a fact that the phosphorescent compound represented by the formula (1) has at lest one group represented by the formula (1-T), and is important for giving excellent light emission efficiency of the light emitting device containing the composition of the present embodiment.

In the composition of the present embodiment, when the compound (F) is a compound that can utilize triplet excited state as light emission at room temperature including a case in which the compound (F) is a TADF compound, and the like, $|T_P|$-$|S_F|$ is preferably -0.30 or more, since the light emission efficiency is not excessively lost even if the speed of the energy transfer F is not sufficiently superior to the speed of the energy transfer D, and when the compound (F) is a compound that cannot utilize triplet excited state as light emission at room temperature, $|T_P|$-$|S_F|$ is preferably -0.28 or more, more preferably -0.24 or more, and particularly preferably -0.20 or more, since the loss in energy transfer from the phosphorescent compound represented by the formula (1) to the compound (F) is more suppressed, and resultantly, a light emitting device containing the composition of the present embodiment is more excellent in light emission efficiency.

In the composition of the present embodiment, $|T_P|$-$|S_F|$ is preferably 0.50 or less, more preferably 0 or less, further preferably -0.05 or less, and particularly preferably -0.10 or less, since the loss in energy transfer from the phosphorescent compound represented by the formula (1) to the compound (F) is more suppressed, and resultantly, a light emitting device containing the composition of the present embodiment is more excellent in light emission efficiency.

In the composition of the present embodiment, $|T_P|$-$|S_F|$ is preferably -0.30 or more and 0.50 or less, more preferably -0.28 or more and 0 or less, further preferably -0.24 or more and -0.05 or less, and particularly preferably -0.20 or more and -0.10 or less, since the loss in energy transfer from the phosphorescent compound represented by the formula (1) to the compound (F) is more suppressed, and resultantly, a light emitting device containing the composition of the present embodiment is more excellent in light emission efficiency.

[Low molecular compound (F)]

When the compound (F) is a low molecular compound, the molecular weight of the compound (F) is preferably $1\times10^2$ to $5\times10^3$, more preferably $2\times10^2$ to $3\times10^3$, further preferably $3\times10^2$ to $2\times10^3$, and particularly preferably $6.5\times10^2$

to $1.5 \times 10^3$.

When the compound (F) is a low molecular compound, the compound (F) is preferably a compound represented by the formula (1-1), the formula (1-2) or the formula (1-3), more preferably a compound represented by the formula (1-2) or the formula (1-3), and further preferably a compound represented by the formula (1-2), since the light emitting device of the present embodiment is more excellent in light emission efficiency.

[Chemical Formula 93]

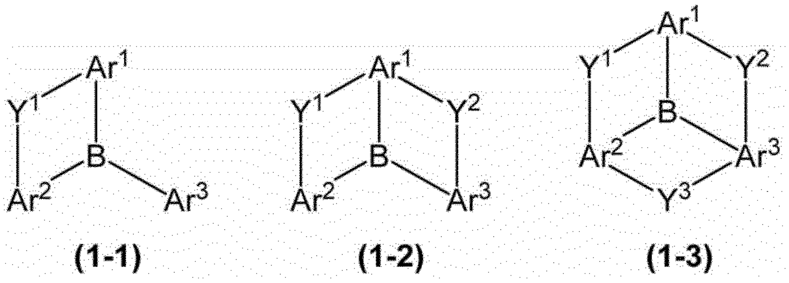

(1-1) (1-2) (1-3)

$Ar^1$, $Ar^2$ and $Ar^3$ are each preferably a group obtained by removing from a monocyclic, bicyclic or tricyclic aromatic hydrocarbon or a monocyclic, bicyclic or tricyclic heterocyclic compound one or more hydrogen atoms bonding directly to atoms constituting the ring, more preferably a group obtained by removing from a monocyclic aromatic hydrocarbon or a monocyclic heterocyclic compound one or more hydrogen atoms bonding directly to atoms constituting the ring, further preferably a group obtained by removing from benzene, pyridine or diazabenzene one or more hydrogen atoms bonding directly to atoms constituting the ring, and particularly preferably a group obtained by removing from benzene one or more hydrogen atoms bonding directly to atoms constituting the ring, since the light emitting device of the present embodiment is more excellent in light emission efficiency, and these groups optionally have a substituent.

The examples and preferable ranges of the substituent which $Ar^1$, $Ar^2$ and $Ar^3$ optionally have are the same as the examples and preferable ranges of the substituent which the hetero ring group (f') optionally has.

$Y^1$ is preferably an oxygen atom, a sulfur atom, a group represented by -N(Ry)- or a methylene group, more preferably an oxygen atom, a sulfur atom or a group represented by -N(Ry)-, and further preferably a group represented by -N(Ry)-, and these groups optionally have a substituent.

$Y^2$ and $Y^3$ are each preferably a single bond, an oxygen atom, a sulfur atom, a group represented by -N(Ry)- or a methylene group, more preferably a single bond, an oxygen atom, a sulfur atom or a group represented by -N(Ry)-, further preferably an oxygen atom, a sulfur atom or a group represented by -N(Ry)-, and particularly preferably a group represented by -N(Ry)-, and these groups optionally have a substituent.

It is preferable that all of $Y^1$, $Y^2$ and $Y^3$ are each an oxygen atom, a sulfur atom or a group represented by - N(Ry)-, and it is more preferable that all of $Y^1$, $Y^2$ and $Y^3$ are each a group represented by -N(Ry)-, since the light emitting device of the present embodiment is more excellent in light emission efficiency.

The examples and preferable ranges of the substituent which $Y^1$, $Y^2$ and $Y^3$ optionally have are the same as the examples and preferable ranges of the substituent which the hetero ring group (f') optionally has.

Ry is preferably an alkyl group, a cycloalkyl group, an aryl group or a monovalent hetero ring group, more preferably an aryl group or a monovalent hetero ring group, and further preferably an aryl group, and these groups optionally have a substituent.

The examples and preferable ranges of the aryl group and the monovalent hetero ring group for Ry are the same as the examples and preferable ranges of the aryl group and the monovalent hetero ring group for the substituent which the hetero ring group (f') optionally has, respectively.

The examples and preferable ranges of the substituent which Ry optionally has are the same as the examples and preferable ranges of the substituent which the hetero ring group (f') optionally has.

Ry may be bonded directly or via a connecting group to $Ar^1$, $Ar^2$ or $Ar^3$, but it is preferable that it is not bonded. The connecting group includes, for example, a group represented by -O-, a group represented by -S-, a group represented by -N(Ry)-, an alkylene group, a cycloalkylene group, an arylene group and a divalent hetero ring group, and is preferably a group represented by -O-, a group represented by -S-, a group represented by -N(Ry)- or a methylene group, and these groups optionally have a substituent.

Ry may be bonded directly or via a connecting group to $Ar^1$, $Ar^2$ or $Ar^3$, but it is preferable that it is not bonded.

When the compound (F) is a low molecular compound, it is preferable that the compound (F) has a group represented by the formula (D-A), the formula (D-B) or the formula (D-C) as a substituent, it is more preferable that Ry is a group represented by the formula (D-A), the formula (D-B) or the formula (D-C), and it is further preferable that Ry is a group

represented by the formula (D-A), since the color purity of the light emitting device containing the composition of the present embodiment is more excellent (the half-value width of light emission spectrum of the light emitting device is narrower), and particularly, the loss in light emission efficiency in the light emitting device using a color filter together is more suppressed, and resultantly, a light emitting device containing the composition of the present embodiment is more excellent in light emission efficiency.

When the compound (F) is a low molecular compound, $N_B$ and $N_N$ can be determined, for example, by the following method.

If the molecular weight of the compound (F) is expressed as $M_F$, the summed value of the number of boron atoms contained in the ring for all condensed hetero ring skeletons (f) contained in the compound (F) is expressed as $S_B$, and the summed value of the number of nitrogen atoms contained in the ring for all condensed hetero ring skeletons (f) contained in the compound (F) is expressed as $S_N$, then, $N_B$ and $N_N$ are each determined as described below. The molecular weight of the low molecular compound can be calculated, for example, using the value of Molecular Weight of ChemDraw (available from Perkin Elmer Informatics).

$$N_B = (S_B \times 1000)/M_F$$

$$N_N = (S_N \times 1000)/M_F$$

When the compound (F) is a low molecular compound, specific calculation methods for $N_B$ and $N_N$ will be described in detail by taking compounds F2 and F3 described later as examples, respectively. In the compound F2, $S_B = 1$, $S_N = 2$, and $M_F = 922.17$, and in the compound F3, $S_B = 1$, $S_N = 2$, and $M_F = 896.13$.

$N_B$ and $N_N$ of the compound F2 are each determined as described below.

$$N_B = 1 \times 1000/922.17 = 1.08$$

$$N_N = 2 \times 1000/922.17 = 2.17$$

$N_B$ and $N_N$ of the compound F3 are each determined as described below.

$$N_B = 1 \times 1000/896.13 = 1.12$$

$$N_N = 2 \times 1000/896.13 = 2.23$$

When the compound (F) is a low molecular compound, compounds represented by the following formulae and compounds F2 to F7 described below, and the like, are exemplified as the compound (F). In the formulae, $Z^1$ represents an oxygen atom or a sulfur atom.

[Chemical Formula 94]

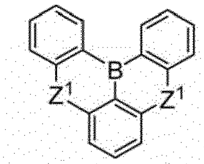
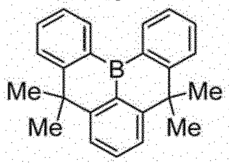
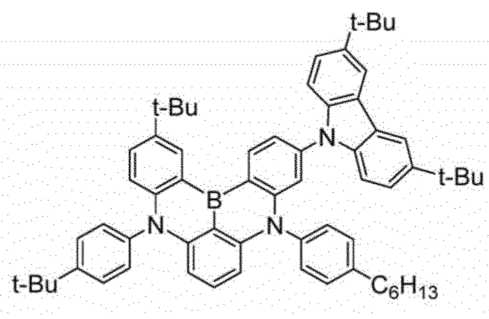
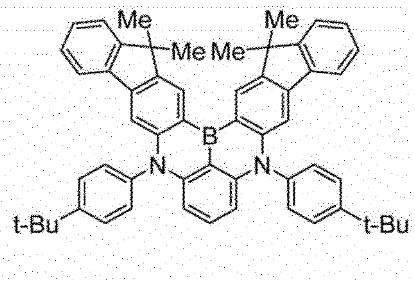

[Chemical Formula 95]

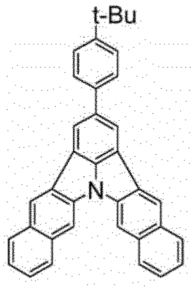

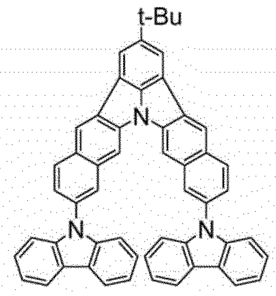

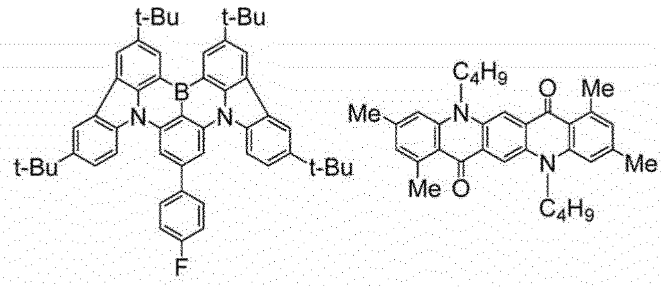

[Chemical Formula 96]

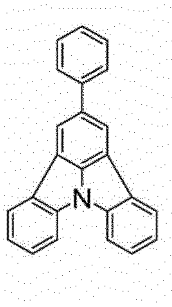

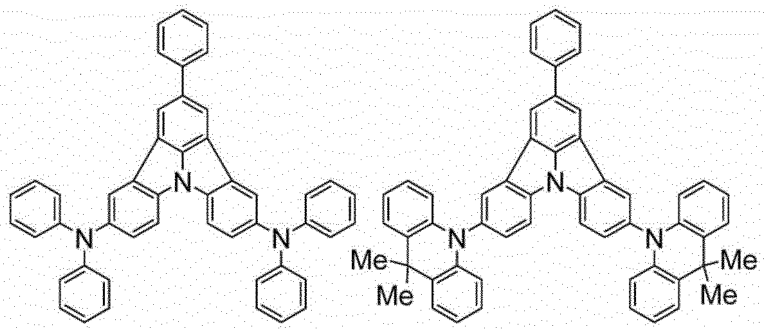

[Polymer compound (F)]

When the compound (F) is a polymer compound, the polystyrene-equivalent number-average molecular weight of the compound (F) is preferably $5\times10^3$ to $1\times10^6$, more preferably $1\times10^4$ to $5\times10^5$, and more preferably $5\times10^4$ to $2\times10^5$. When the compound (F) is a polymer compound, the polystyrene-equivalent weight-average molecular weight of the compound (F) is preferably $1\times10^4$ to $2\times10^6$, more preferably $2\times10^4$ to $1\times10^6$, and more preferably $1\times10^5$ to $5\times10^5$.

When the compound (F) is a polymer compound, the compound (F) may be any of a block copolymer, a random copolymer, an alternative copolymer or a graft copolymer, and may also be in another form, and it is preferably a copolymer obtained by copolymerizing multiple kinds of raw material monomers.

When the compound (F) is a polymer compound, the compound (F) is preferably a polymer compound containing a constitutional unit represented by the formula (F).

[Chemical Formula 97]

$$\left[ Ar^{F1} \right] \quad \textbf{(F)}$$

$Ar^{F1}$ represents a divalent hetero ring group (f'), or, a divalent group in which an arylene group and a divalent hetero ring group (f') are bonded directly, and these groups optionally have a substituent.

The examples and preferable ranges of the arylene group in the divalent group in which an arylene group and a divalent hetero ring group (f') are bonded directly for $Ar^{F1}$ are the same as the examples and preferable ranges of the group represented by $Ar^{Y1}$ described below, respectively.

The examples and preferable ranges of the substituent which $Ar^{F1}$ optionally has are the same as the examples and preferable ranges of the substituent which the hetero ring group (f') optionally has, respectively.

The constitutional unit represented by the formula (F) may be contained only alone or in combination of two or more in the compound (F).

When the compound (F) is a polymer compound, it is preferable that a constitutional unit represented by the formula (Y) is further contained, since a light emitting device containing the composition of the present embodiment is more excellent in light emission efficiency.

[Chemical Formula 98]

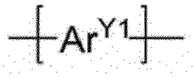 (Y)

[wherein, $Ar^{Y1}$ represents an arylene group optionally having a substituent.]

The group represented by $Ar^{Y1}$ is preferably a phenylene group, a naphthalenediyl group, an anthracenediyl group, a phenanthrenediyl group, a dihydrophenanthrenediyl group, a pyrenediyl group, a fluorenediyl group or a dibenzocycloheptanediyl group, more preferably a phenylene group, a naphthalenediyl group, an anthracenediyl group, a phenanthrenediyl group, a dihydrophenanthrenediyl group or a fluorenediyl group, and further preferably a phenylene group, an anthracenediyl group or a fluorenediyl group, since a light emitting device containing the composition of the present embodiment is more excellent in light emission efficiency, and these groups optionally have a substituent.

The group represented by $Ar^{Y1}$ is preferably a group represented by the formula (A-1) to the formula (A-14) or the formula (A-19) to the formula (A-23), more preferably a group represented by the formula (A-1) to the formula (A-9), the formula (A-11), the formula (A-12) or the formula (A-19) to the formula (A-21), further preferably a group represented by the formula (A-1) to (A-3), the formula (A-8), the formula (A-9), the formula (A-11) or the formula (A-12), and particularly preferably a group represented by the formula (A-1), the formula (A-2), the formula (A-9) or the formula (A-11), since a light emitting device containing the composition of the present embodiment is more excellent in light emission efficiency, and these groups optionally have a substituent.

The substituent which the group represented by $Ar^{Y1}$ optionally has is preferably a fluorine atom, an alkyl group, a cycloalkyl group, an aryl group, a monovalent hetero ring group, an alkoxy group, a cycloalkoxy group or a substituted amino group, more preferably an alkyl group, a cycloalkyl group, an aryl group, a monovalent hetero ring group or a substituted amino group, further preferably an alkyl group, a cycloalkyl group, an aryl group or a monovalent hetero ring group, particularly preferably an alkyl group, a cycloalkyl group or an aryl group, and especially preferably an alkyl group or an aryl group, and these groups optionally further have a substituent.

The examples and preferable ranges of the aryl group, the monovalent hetero ring group and the substituted amino group for the substituent which the group represented by $Ar^{Y1}$ optionally has are the same as the examples and preferable ranges of the aryl group, the monovalent hetero ring group and the substituted amino group for the substituent which the hetero ring group (f') optionally has, respectively.

The examples and preferable ranges of the substituent which the substituent which the group represented by $Ar^{Y1}$ optionally has optionally further has are the same as the examples and preferable ranges of the substituent which the substituent which the hetero ring group (f') optionally has optionally further has.

The constitutional unit represented by the formula (Y) is preferably a constitutional unit represented by the formula (Y-1) to the formula (Y-4) , more preferably a constitutional unit represented by the formula (Y-1), the formula (Y-2) or the formula (Y-4), and further preferably a constitutional unit represented by the formula (Y-1) or the formula (Y-2), since a light emitting device containing the composition of the present embodiment is more excellent in light emission efficiency.

[Chemical Formula 99]

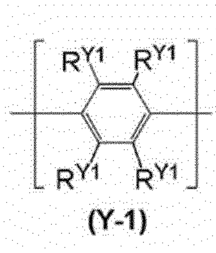
(Y-1)

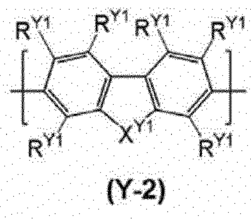
(Y-2)

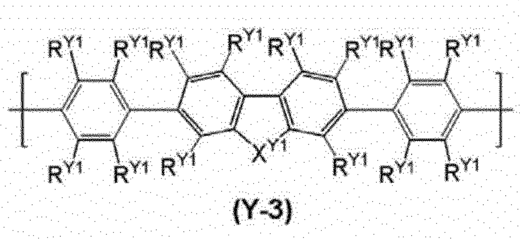
(Y-3)

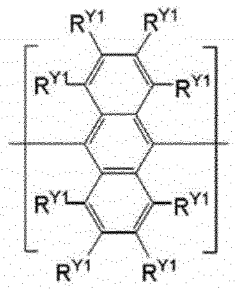
(Y-4)

[wherein,

$R^{Y1}$ represents the same meaning as described above.

$X^{Y1}$ represents a group represented by $-C(R^{Y2})_2-$, $-C(R^{Y2})=C(R^{Y2})-$ or $-C(R^{Y2})_2-C(R^{Y2})_2-$. $R^{Y2}$ represents a hydrogen atom, a fluorine atom, an alkyl group, a cycloalkyl group, an aryl group, a monovalent hetero ring group, an alkoxy

group, a cycloalkoxy group or a substituted amino group, and these groups optionally have a substituent. A plurality of $R^{Y2}$ may be the same or different, and groups $R^{Y2}$ may be combined together to form a ring together with carbon atoms to which they are attached.]

$R^{Y2}$ is preferably an alkyl group, a cycloalkyl group, an aryl group, a monovalent hetero ring group or a substituted amino group, and more preferably an alkyl group, a cycloalkyl group or an aryl group, and these groups optionally have a substituent.

The examples and preferable ranges of the aryl group, the monovalent hetero ring group and the substituted amino group for the group represented by $R^{Y2}$ are the same as the examples and preferable ranges of the aryl group, the monovalent hetero ring group and the substituted amino group for the substituent which the hetero ring group (f') optionally has, respectively.

The examples and preferable ranges of the substituent which $R^{Y2}$ optionally has are the same as the examples and preferable ranges of the substituent which the substituent which the hetero ring group (f') optionally has optionally further has, respectively.

The combination of two groups $R^{Y2}$ in the group represented by $-C(R^{Y2})_2-$ for $X^{Y1}$ is preferably a combination in which both are alkyl groups or cycloalkyl groups, a combination in which both are aryl groups, a combination in which both are monovalent hetero ring groups, or a combination in which one is an alkyl group or a cycloalkyl group and the other is an aryl group or a monovalent hetero ring group, and more preferably a combination in which one is an alkyl group or a cycloalkyl group and the other is an aryl group, and these groups optionally have a substituent.

Two groups $R^{Y2}$ may be combined together to form a ring together with atoms to which they are attached, and when $R^{Y2}$ forms a ring, the group represented by $-C(R^{Y2})_2-$ is preferably a group represented by the formula (Y-A1) to the formula (Y-A5), and more preferably a group represented by the formula (Y-A4), and these groups optionally have a substituent.

[Chemical Formula 100]

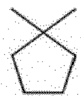
(Y-A1)

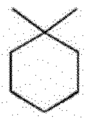
(Y-A2)

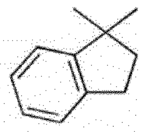
(Y-A3)

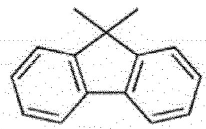
(Y-A4)

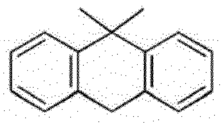
(Y-A5)

The combination of two groups $R^{Y2}$ in the group represented by $-C(R^{Y2})=C(R^{Y2})-$ for $X^{Y1}$ is preferably a combination in which both are alkyl groups or cycloalkyl groups, or a combination in which one is an alkyl group or a cycloalkyl group and the other is an aryl group, and these groups optionally have a substituent.

Four groups $R^{Y2}$ in the group represented by $-C(R^{Y2})_2-C(R^{Y2})_2-$ for $X^{Y1}$ are preferably alkyl groups or cycloalkyl groups optionally having a substituent.

A plurality of $R^{Y2}$ may be combined together to form a ring together with atoms to which they are attached, and when $R^{Y2}$ forms a ring, the group represented by $-C(R^{Y2})_2-C(R^{Y2})_2-$ is preferably a group represented by the formula (Y-B1) to the formula (Y-B5), and more preferably a group represented by the formula (Y-B3), and these groups optionally have a substituent.

[Chemical Formula 101]

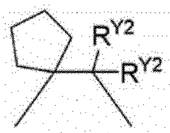
(Y-B1)

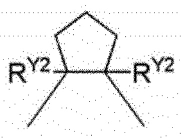
(Y-B2)

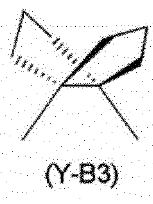
(Y-B3)

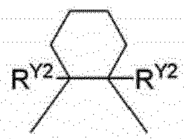
(Y-B4)

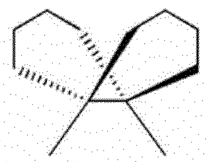
(Y-B5)

[wherein, $R^{Y2}$ represents the same meaning as described above.]

$X^{Y1}$ is preferably a group represented by $-C(R^{Y2})_2-$.

The constitutional unit represented by the formula (Y-1) is preferably a constitutional unit represented by the formula (Y-1'). The constitutional unit represented by the formula (Y-2) is preferably a constitutional unit represented by the

formula (Y-2'). The constitutional unit represented by the formula (Y-3) is preferably a constitutional unit represented by the formula (Y-3'). The constitutional unit represented by the formula (Y-4) is preferably a constitutional unit represented by the formula (Y-4').

[Chemical Formula 102]

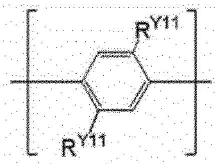
(Y-1')

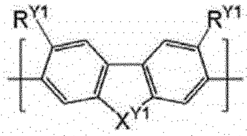
(Y-2')

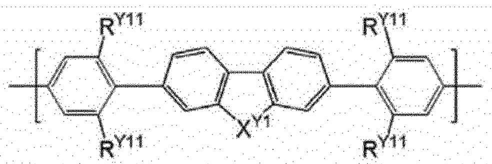
(Y-3')

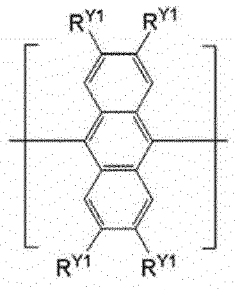
(Y-4')

[wherein,

$R^{Y1}$ and $X^{Y1}$ represent the same meaning as described above.
$R^{Y11}$ represents a fluorine atom, an alkyl group, a cycloalkyl group, an aryl group, a monovalent hetero ring group, an alkoxy group, a cycloalkoxy group or a substituted amino group, and these groups optionally have a substituent. A plurality of $R^{Y11}$ may be the same or different.]
$R^{Y11}$ is preferably an alkyl group, a cycloalkyl group, an aryl group or a monovalent hetero ring group, more preferably an alkyl group, a cycloalkyl group or an aryl group, and further preferably an alkyl group or a cycloalkyl group, and these groups optionally have a substituent.

The examples and preferable ranges of the aryl group, the monovalent hetero ring group and the substituted amino group for the group represented by $R^{Y11}$ are the same as the examples and preferable ranges of the aryl group, the monovalent hetero ring group and the substituted amino group for the substituent which the hetero ring group (f') optionally has, respectively.
The examples and preferable ranges of the substituent which $R^{Y11}$ optionally has are the same as the examples and preferable ranges of the substituent which the substituent which the hetero ring group (f') optionally has optionally further has.
The constitutional unit represented by the formula (Y) includes, for example, constitutional units represented by the formula (Y-11) to the formula (Y-49) .

[Chemical Formula 103]

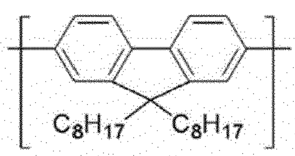
(Y-11)

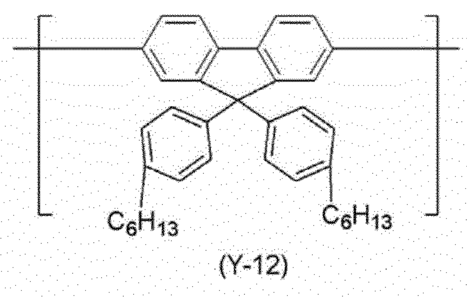
(Y-12)

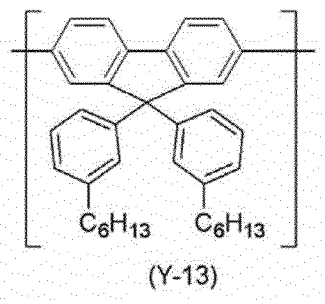
(Y-13)

[Chemical Formula 104]

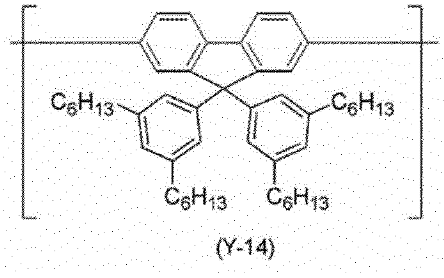
(Y-14)

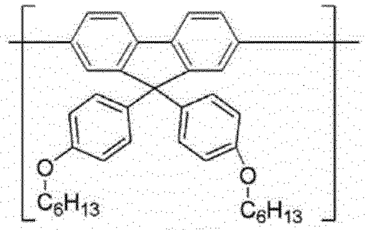
(Y-15)

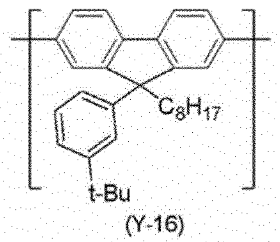
(Y-16)

[Chemical Formula 105]

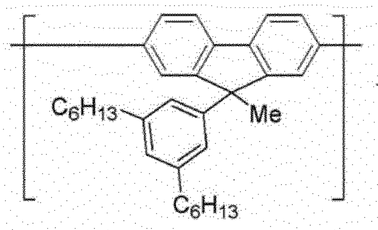
(Y-17)

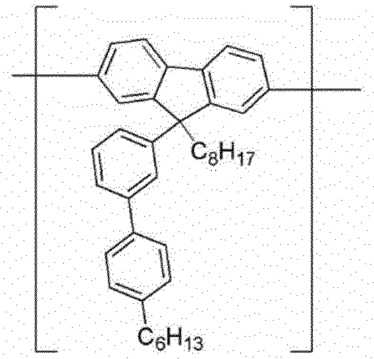
(Y-18)

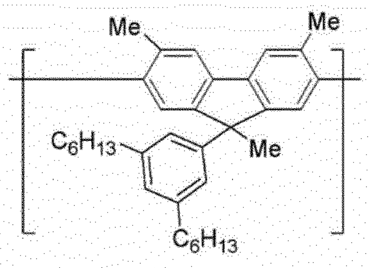
(Y-19)

[Chemical Formula 106]

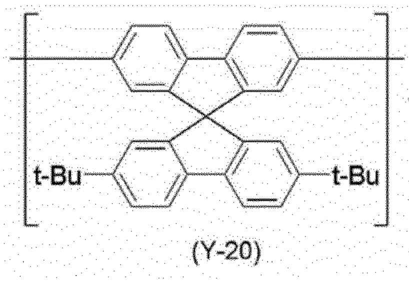
(Y-20)

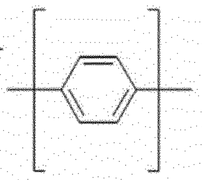
(Y-21)

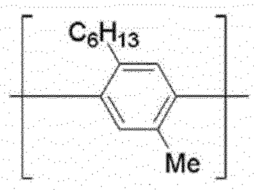
(Y-22)

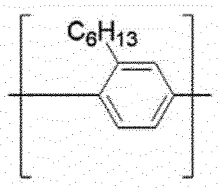
(Y-23)

[Chemical Formula 107]

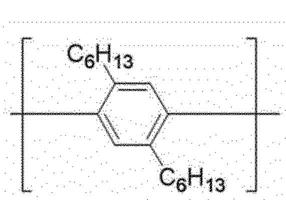
(Y-24)

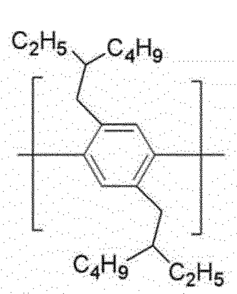
(Y-25)

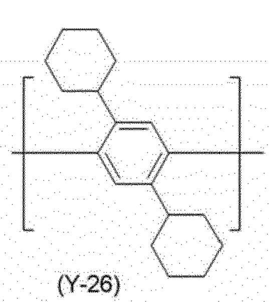
(Y-26)

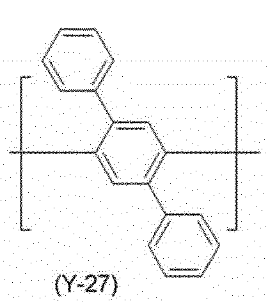
(Y-27)

[Chemical Formula 108]

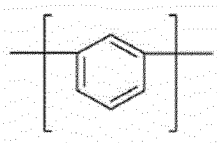
(Y-28)

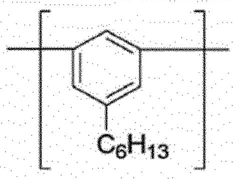
(Y-29)

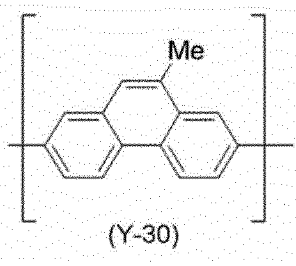
(Y-30)

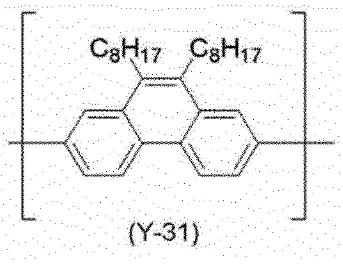
(Y-31)

[Chemical Formula 109]

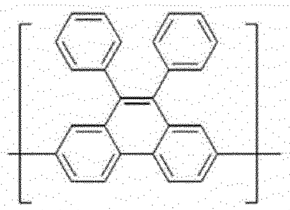
(Y-32)

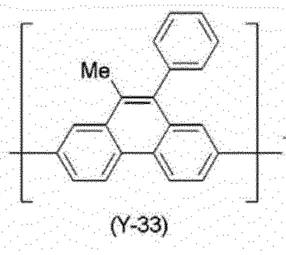
(Y-33)

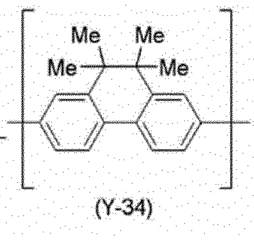
(Y-34)

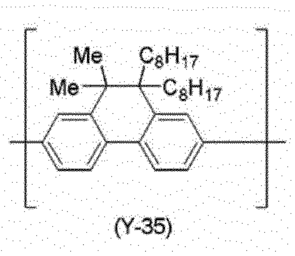
(Y-35)

[Chemical Formula 110]

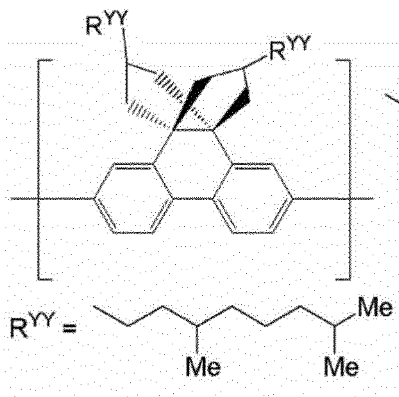
(Y-36)

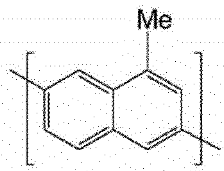
(Y-37)

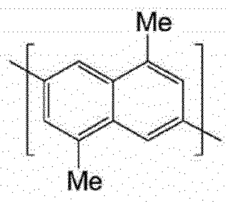
(Y-38)

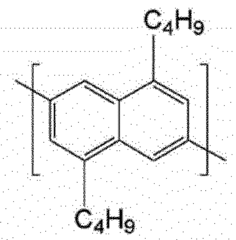
(Y-39)

[Chemical Formula 111]

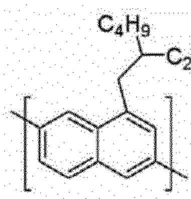
(Y-40)

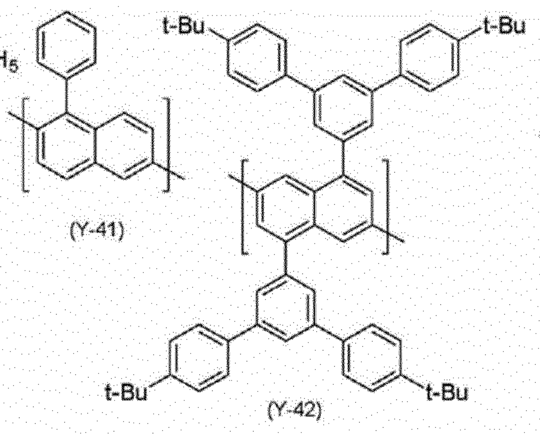
(Y-41)

(Y-42)

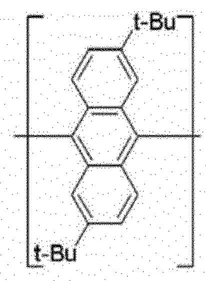
(Y-43)

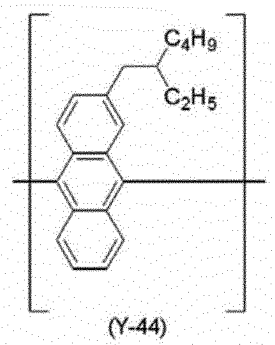
(Y-44)

[Chemical Formula 112]

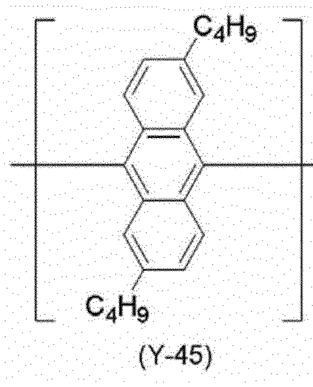

(Y-45)

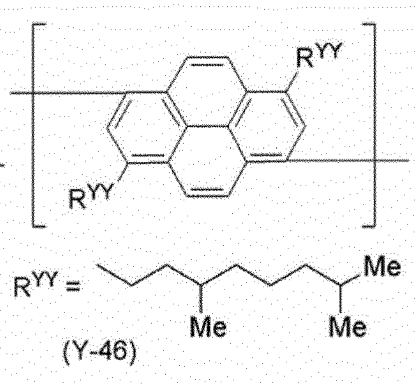

(Y-46)

[Chemical Formula 113]

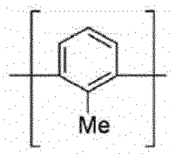

(Y-47)

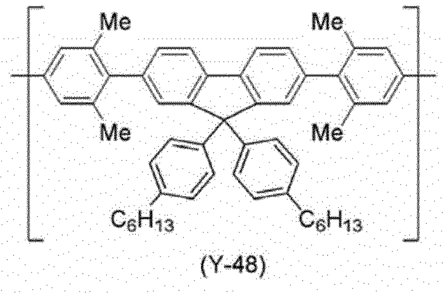

(Y-48)

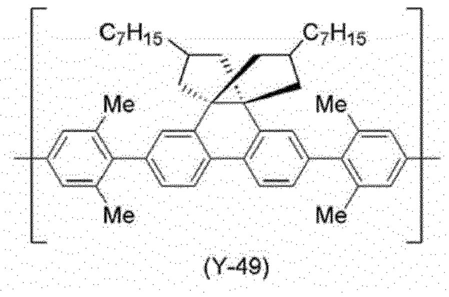

(Y-49)

The constitutional unit represented by the formula (Y) is preferably 0.5 mol% to 90 mol%, and more preferably 30 mol% to 80 mol%, with respect to the total amount of constitutional units contained in the compound (F), since a light emitting device containing the composition of the present embodiment is more excellent in light emission efficiency.

The constitutional unit represented by the formula (Y) may be contained only alone or in combination of two or more in the compound (F).

When the compound (F) is a polymer compound, the number of boron atoms contained in the ring of the condensed hetero ring skeleton (f) and the number of nitrogen atoms contained in the ring of the condensed hetero ring skeleton (f) mean the average value of the number of boron atoms contained in the ring of the condensed hetero ring skeleton (f) per 1000 of the average molecular weight of the polymer compound and the average value of the number of nitrogen atoms contained in the ring of the condensed hetero ring skeleton (f) per 1000 of the average molecular weight of the polymer compound, respectively. $N_B$ and $N_N$ can be determined, for example, by the following method.

In the polymer compound containing k kinds of constitutional units (k is an integer of 1 or more), if the average molecular weight of the polymer compound is expressed as $M_{FP}$, the molecular weight of the j-th kind of constitutional unit is expressed as $M_j$ (j is an integer satisfying $1 \leq j \leq k$), the ratio of the molar number of the j-th kind of the constitutional unit with respect to the sum of the molar numbers of all constitutional units excluding the end group is expressed as $P_j$, the summed value of the number of boron atoms contained in the ring for all condensed hetero ring skeletons (f) contained in the j-th kind of constitutional unit is expressed as $S_{Bj}$, and the summed value of the number of nitrogen atoms contained in the ring for all condensed hetero ring skeletons (f) contained in the j-th kind of constitutional unit is expressed as $S_{Nj}$, then, $N_B$ and $N_N$ can be determined as described below, respectively. $M_j$ can be calculated in the same manner as for a case in which the compound (F) is a low molecular compound.

[Mathematical formula 1]

$$M_{FP} = \sum_{j=1}^{k} M_j P_j$$

$$N_B = \left( \sum_{j=1}^{k} S_{Bj} P_j \right) \times 1000 / M_{FP}$$

$$N_N = \left( \sum_{j=1}^{k} S_{Nj} P_j \right) \times 1000 / M_{FP}$$

When the compound (F) is a polymer compound, the specific calculation method for $N_B$ and $N_N$ will be explained by taking a polymer compound TP-3 described in International Publication No. WO 2019/004247 as an example. The polymer compound TP-3 is a copolymer constituted of a constitutional unit derived from the compound M12, a constitutional unit derived from the compound T3, and a constitutional unit derived from the compound M13 at a molar ratio of 45:5:50, according to the theoretical values calculate from the amounts of the charged raw materials. The molecular weight of the constitutional unit derived from the compound M12 is 388.64, the molecular weight of the constitutional unit derived from the compound T3 is 795.92, and the molecular weight of the constitutional unit derived from the compound M13 is 484.73.

[Chemical Formula 114]

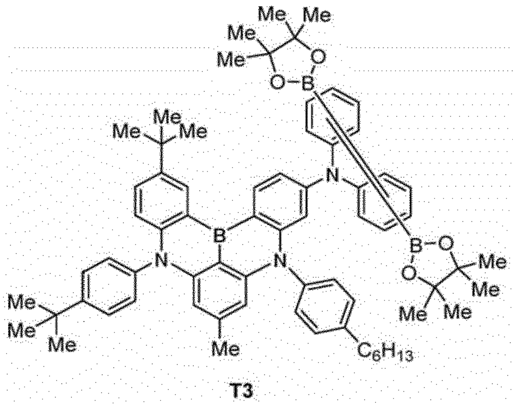

T3

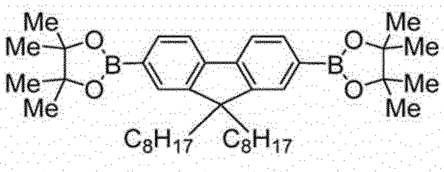

M12

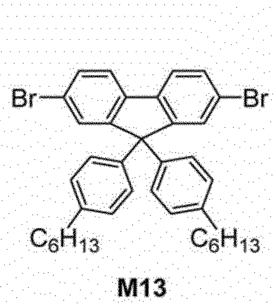

M13

$M_{FP}$ of the above-described polymer compound TP-3 can be determined as described below.

$M_{FP} = (388.64 \times 0.45) + (795.92 \times 0.05) + (484.73 \times 0.50) = 457.05$

$N_B$ of the above-described polymer compound TP-3 can be determined as described below.

$N_B = \{(0 \times 0.45) + (1 \times 0.05) + (0 \times 0.50)\} \times 1000/457.049 = 0.109$

$N_N$ of the above-described polymer compound TP-3 can be determined as described below.

$N_N = \{(0 \times 0.45) + (2 \times 0.05) + (0 \times 0.50)\} \times 1000/457.049 = 0.219$

The constitutional unit represented by the formula (F) includes, for example, a constitutional unit containing a group obtained by removing from an example in which the compound (F) is a low molecular compound two hydrogen atoms, and constitutional units represented by the following formulae.

[Chemical Formula 115]

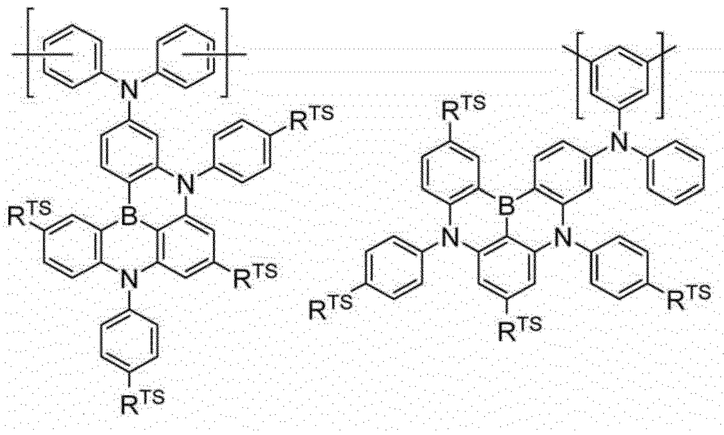

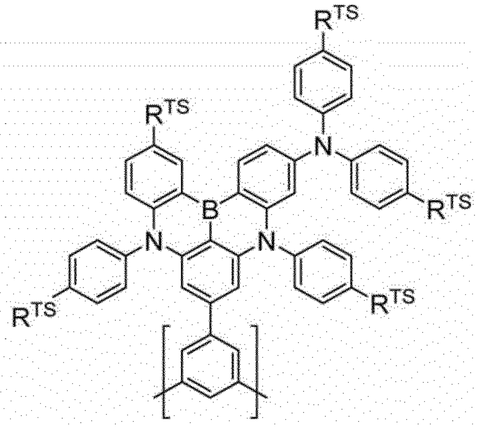

[Chemical Formula 116]

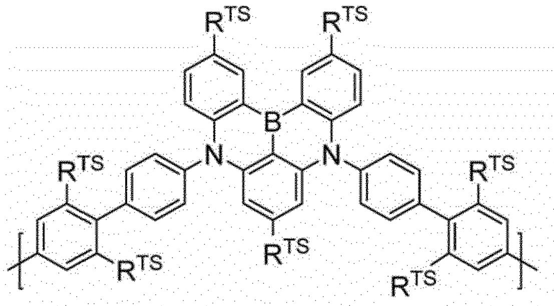

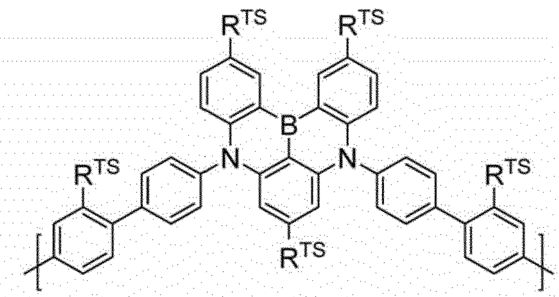

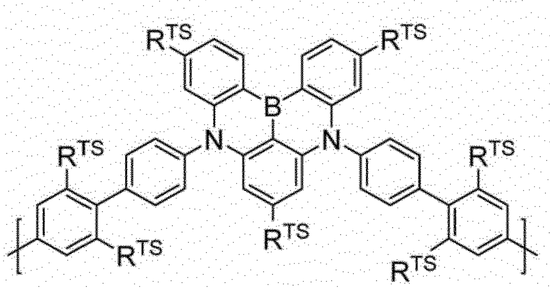

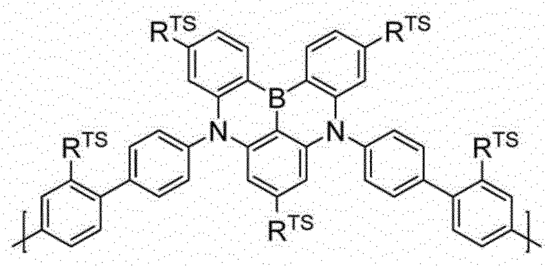

In the formulae, $R^{TS}$ is a hydrogen atom, an alkyl group, an aryl group, or a monovalent hetero ring group, and these groups optionally further have a substituent. A plurality of $R^{TS}$ may be the same or different.

[Polymer compound (F) production method]

When the compound (F) is a polymer compound, the compound (F) can be produced, for example, by condensation-polymerizing a compound represented by the formula (M-Y1), a compound represented by the formula (M-F1), and the other compound (for example, a compound represented by the formula (M-Y2)). In the present specification, compounds used for production of the compound (F) of the present embodiment are collectively called "raw material monomer" in some cases.

[Chemical Formula 117] $Z^{C1}$-$Ar^{Y1}$-$Z^{C2}$ **(M-Y1)** $Z^{C3}$-$Ar^{F1}$-$Z^{C4}$ **(M-F)** $Z^{C5}$-$Ar^{Y1}$-$Z^{C6}$ **(M-Y2)**

[wherein,

$Ar^{Y1}$ and $Ar^{F1}$ represent the same meaning as described above.

$Z^{C1}$ to $Z^{C6}$ each independently represent a group selected from the group consisting of Group A of substituent and

Group B of substituent.]

For example, when $Z^{C1}$ to $Z^{C4}$ are groups selected from Group A of substituent, $Z^{C5}$ and $Z^{C6}$ are selected from groups selected from Group B of substituent, respectively.

For example, when $Z^{C1}$ to $Z^{C4}$ are groups selected from Group B of substituent, $Z^{C5}$ and $Z^{C6}$ are selected from groups selected from Group A of substituent, respectively.

<Group A of substituent>

A chlorine atom, a bromine atom, an iodine atom, and groups represented by $-O-S(=O)_2R^{C1}$ (wherein, $R^{C1}$ represents an alkyl group, a cycloalkyl group or an aryl group, and these groups optionally have a substituent.).

<Group B of substituent>

Groups represented by $-B(OR^{C2})_2$ (wherein, $R^{C2}$ represents a hydrogen atom, an alkyl group, a cycloalkyl group or an aryl group, and these groups optionally have a substituent. A plurality of $R^{C2}$ may be the same or different, and may be combined together to form a ring structure together with oxygen atoms to which they are attached.);
Groups represented by $-BF_3Q'$ (wherein, Q' represents Li, Na, K, Rb or Cs);
Groups represented by -MgY' (wherein, Y' represents a chlorine atom, a bromine atom or an iodine atom);
Groups represented by -ZnY" (wherein, Y'' represents a chlorine atom, a bromine atom or an iodine atom); and
Groups represented by $-Sn(R^{C3})_3$ (wherein, $R^{C3}$ represents a hydrogen atom, an alkyl group, a cycloalkyl group or an aryl group, and these groups optionally have a substituent. A plurality of $R^{C3}$ may be the same or different, and may be combined together to form a ring structure together with tin atoms to which they are attached.).

As the group represented by $-B(OR^{C2})_2$, groups represented by the following formulae are exemplified.

[Chemical Formula 118]

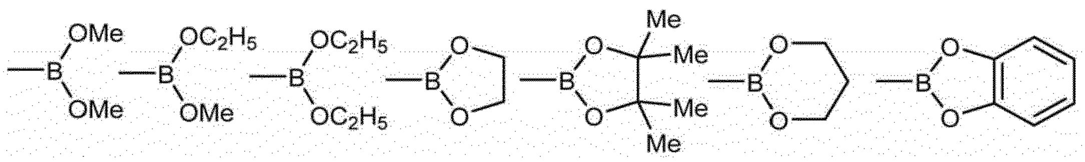

A compound having a group selected from Group A of substituent and a compound having a group selected from Group B of substituent are condensation-polymerized according to a known coupling reaction, and a carbon atom bonding to a group selected from Group A of substituent and a carbon atom bonding to a group selected from Group B of substituent are bonded mutually. Therefore, if a compound having two groups selected from Group A of substituent and a compound having two groups selected from Group B of substituent are subjected to a known coupling reaction, a condensed polymer of these compounds can be obtained by condensation polymerization.

The condensation polymerization is usually conducted in the presence of a catalyst, a base and a solvent, and if necessary, a phase transfer catalyst may be allowed to coexist in the condensation polymerization.

The catalyst includes, for example, transition metal complexes such as palladium complexes such as bis(triphenylphosphine)palladium (II) dichloride, bis(tris-o-methoxyphenylphosphine)palladium (II) dichloride, tetrakis (triphenylphosphine)palladium (0), tris(dibenzylideneacetone)dipalladium (0), palladium acetate, and the like, nickel complexes such as tetrakis (triphenylphosphine)nickel (0), [1,3-bis(diphenylphosphino)propane)nickel (II) dichloride, bis(1,4-cyclooctadiene)nickel (0), and the like; and, these transition metal complexes further having a ligand such as triphenylphosphine, tri(o-tolyl)phosphine, tri(tert-butyl)phosphine, tricyclohexylphosphine, 1,3-bis(diphenylphosphino)propane, bipyridyl, and the like. The catalyst may be used singly or in combination of two or more.

The use amount of the catalyst is usually 0.00001 mol equivalent to 3 mol equivalent in terms of the amount of a transition metal with respect to the sum of the molar numbers of raw material monomers.

The base and the phase transfer catalyst includes, for example, inorganic bases such as sodium carbonate, potassium carbonate, cesium carbonate, potassium fluoride, cesium fluoride, tripotassium phosphate, and the like; organic bases such as tetrabutylammonium fluoride, tetraethylammonium hydroxide, tetrabutylammonium hydroxide, and the like; and phase transfer catalysts such as tetrabutylammonium chloride, tetrabutylammonium bromide, and the

like. The base and the phase transfer catalyst may each be used singly or in combination of two or more.

The use amounts of the base and the phase transfer catalyst are each usually 0.001 mol equivalent to 100 mol equivalent with respect to the total molar number of raw material monomers.

The solvent includes, for example, organic solvents such as toluene, xylene, mesitylene, tetrahydrofuran, 1,4-dioxane, dimethoxyethane, N,N-dimethylacetamide, N,N-dimethylformamide, and the like, and water. The solvent may be used singly or in combination of two or more.

The use amount of the solvent is usually 10 parts by mass to 100000 parts by mass with respect to 100 parts by mass of the sum of raw material monomers.

The reaction temperature of the condensation polymerization is usually -100°C to 200°C. The reaction time of the condensation polymerization is usually 1 hour or more.

For the post treatment of the polymerization reaction, known methods, for example, a method in which water-soluble impurities are removed by liquid separation, a method in which a reaction solution after the polymerization reaction is added to a lower alcohol such as methanol and the like, the deposited precipitate is filtrated, then, dried, and other methods, are used each singly or used in combination. When the purity of the polymer host is low, it can be purified by usual methods such as, for example, crystallization, reprecipitation, continuous extraction with a Soxhlet extractor, column chromatography and the like.

[Host material]

It is preferable for the composition of the present embodiment to further contain a host material having at least one function selected from hole injectability, hole transportability, electron injectability and electron transportability, since a light emitting device containing the composition of the present embodiment is more excellent in light emission efficiency. The composition of the present embodiment may contain the host material only singly or two or more of them. The host material is different from each of the phosphorescent compound represented by the formula (1) and the compound (F).

It is preferable that the host material contains no metal atom.

When the composition of the present embodiment further contains a host material, the content of the host material is usually $1\times10^2$ parts by mass to $1\times10^5$ parts by mass, preferably $1\times10^2$ parts by mass to $1\times10^4$ parts by mass, more preferably $1\times10^2$ parts by mass to $1\times10^3$ parts by mass, and further preferably $2\times10^2$ parts by mass to $8\times10^2$ parts by mass, with the sum of the phosphorescent compound represented by the formula (1) and the compound (F) being 100 parts by mass.

When the composition of the present embodiment further contains a host material, it is preferable that the host material interacts with the phosphorescent compound represented by the formula (1) and the compound (F) physically, chemically or electrically. By this interaction, for example, the light emitting property, charge transporting property or charge injection property of the composition of the present embodiment can be improved or adjusted.

Taking a light emitting material as an example when the composition of the present embodiment further contains a host material, the host material interacts with the phosphorescent compound represented by the formula (1) and the compound (F) electrically, thereby electric energy is transmitted efficiently from the host material to the phosphorescent compound represented by the formula (1), and further, electric energy is transmitted efficiently from the phosphorescent compound represented by the formula (1) to the compound (F), as a result, the compound (F) can be allowed to emit light more efficiently, and the light emitting device of the present embodiment is more excellent in light emission efficiency.

From the above-described viewpoint, it is preferable that the absolute value of the energy level of the lowest triplet excited state of the host material is larger than $|T_P|$ and $|T_F|$, since a light emitting device containing the composition of the present embodiment is more excellent in light emission efficiency. Further, it is preferable that the absolute value of the energy level of the lowest singlet excited state of the host material is larger than $|T_F|$, since a light emitting device containing the composition of the present embodiment is more excellent in light emission efficiency.

The host material is preferably one which shows solubility in solvents capable of dissolving the phosphorescent compound represented by the formula (1) and the compound (F), since the light emitting device of the present embodiment can be fabricated by a wet method.

The host material is classified into low molecular compounds (low molecular host) and polymer compounds (polymer host), and the composition of the present embodiment may contain any host material. The host material which may be contained in the composition of the present embodiment is preferably a low molecular host, since the light emitting device of the present embodiment is more excellent in light emission efficiency.

The polymer host includes, for example, polymer compounds as the hole transporting material described later, and polymer compounds as the electron transporting material described later.

[Low molecular host]

The low molecular host is preferably a compound represented by the formula (H-1), since the light emitting device

of the present embodiment is more excellent in light emission efficiency. It is preferable that the compound represented by the formula (H-1) is a compound having no condensed hetero ring skeleton (f) in the compound.

The molecular weight of the compound represented by the formula (H-1) is preferably $1\times10^2$ to $5\times10^3$, more preferably $2\times10^2$ to $3\times10^3$, further preferably $3\times10^2$ to $1.5\times10^3$, and particularly preferably $4\times10^2$ to $1\times10^3$.

The aryl group and the monovalent hetero ring group for $Ar^{H1}$ and $Ar^{H2}$ include, for example, groups obtained by removing from benzene, naphthalene, anthracene, phenanthrene, dihydrophenanthrene, triphenylene, fluorene, benzofluorene, spirobifluorene, benzospirobifluorene, pyrene, chrysene, pyridine, diazabenzene, triazine, carbazole, azacarbazole, diazacarbazole, azanaphthalene, diazanaphthalene, dibenzofuran, dibenzothiophene, phenoxazine, phenothiazine, 9,10-dihydroacridine, 5,10-dihydrophenazine, azaanthracene, diazaanthracene, azaphenanthrene, diazaphenanthrene, indolocarbazole or indenocarbazole one hydrogen atom bonding directly to an atom constituting the ring, and represent preferably a group obtained by removing from benzene, naphthalene, anthracene, phenanthrene, fluorene, spirobifluorene, pyrene, pyridine, diazabenzene, triazine, azanaphthalene, diazanaphthalene, carbazole, azacarbazole, dibenzofuran, dibenzothiophene, phenoxazine, phenothiazine, indolocarbazole or indenocarbazole one hydrogen atom bonding directly to an atom constituting the ring, more preferably a group obtained by removing from benzene, naphthalene, anthracene, fluorene, spirobifluorene, pyridine, diazabenzene, triazine, carbazole, dibenzofuran or a dibenzothiophene one hydrogen atom bonding directly to an atom constituting the ring, and further preferably a group obtained by removing from benzene or carbazole one hydrogen atom bonding directly to an atom constituting the ring, since a light emitting device containing the composition of the present embodiment is more excellent in light emission efficiency, and these groups optionally have a substituent.

The substituent which $Ar^{H1}$ and $Ar^{H2}$ optionally have is preferably a halogen atom, an alkyl group, a cycloalkyl group, an alkoxy group, a cycloalkoxy group, an aryl group, a monovalent hetero ring group or a substituted amino group, more preferably an alkyl group, a cycloalkyl group, an aryl group or a monovalent hetero ring group, and further preferably an alkyl group or a cycloalkyl group, and these groups optionally further have a substituent.

The examples and preferable ranges of the aryl group and the monovalent hetero ring group for the substituent which $Ar^{H1}$ and $Ar^{H2}$ optionally have are the same as the examples and preferable ranges of the aryl group and the monovalent hetero ring group for $Ar^{H1}$ and $Ar^{H2}$, respectively.

The substituent which an amino group has in the substituted amino group for the substituent which $Ar^{H1}$ and $Ar^{H2}$ optionally have is preferably an aryl group or a monovalent hetero ring group, and more preferably an aryl group, and these groups optionally further have a substituent. The examples and preferable ranges of the aryl group and the monovalent hetero ring group for the substituent which an amino group has are the same as the examples and preferable ranges of the aryl group and the monovalent hetero ring group for $Ar^{H1}$ and $Ar^{H2}$, respectively.

The substituent which the substituent which $Ar^{H1}$ and $Ar^{H2}$ optionally have optionally further has is preferably a halogen atom, an alkyl group, a cycloalkyl group, an alkoxy group, a cycloalkoxy group, an aryl group, a monovalent hetero ring group or a substituted amino group, more preferably an alkyl group, a cycloalkyl group, an aryl group or a monovalent hetero ring group, and further preferably an alkyl group or a cycloalkyl group, and these groups optionally further have a substituent, but it is preferable that they do not further have a substituent.

The examples and preferable ranges of the aryl group, the monovalent hetero ring group and the substituted amino group for the substituent which the substituent which $Ar^{H1}$ and $Ar^{H2}$ optionally have optionally further has are the same as the examples and preferable ranges of the aryl group, the monovalent hetero ring group and the substituted amino group for the substituent which $Ar^{H1}$ and $Ar^{H2}$ optionally have.

$n^{H1}$ is preferably 1. $n^{H2}$ is preferably 0.

$n^{H3}$ is usually an integer of 0 or more and 10 or less, preferably an integer of 0 or more and 5 or less, more preferably an integer of 1 or more and 3 or less, and further preferably 2.

$L^{H1}$ is preferably an arylene group or a divalent hetero ring group, since a light emitting device containing the composition of the present embodiment is more excellent in light emission efficiency.

$L^{H1}$ includes, for example, groups obtained by removing from benzene, naphthalene, anthracene, phenanthrene, dihydrophenanthrene, triphenylene, fluorene, benzofluorene, spirobifluorene, benzospirobifluorene, pyrene, chrysene, pyridine, diazabenzene, triazine, carbazole, azacarbazole, diazacarbazole, azanaphthalene, diazanaphthalene, dibenzofuran, dibenzothiophene, phenoxazine, phenothiazine, 9,10-dihydroacridine, 5,10-dihydrophenazine, azaanthracene, diazaanthracene, azaphenanthrene, diazaphenanthrene, indolocarbazole or indenocarbazole two hydrogen atoms bonding directly to atoms constituting the ring, and is preferably a group obtained by removing from benzene, naphthalene, anthracene, phenanthrene, fluorene, spirobifluorene, pyrene, pyridine, diazabenzene, triazine, azanaphthalene, diazanaphthalene, carbazole, azacarbazole, dibenzofuran, dibenzothiophene, phenoxazine, phenothiazine, indolocarbazole or indenocarbazole two hydrogen atoms bonding directly to atoms constituting the ring, more preferably a group obtained by removing from benzene, naphthalene, anthracene, fluorene, spirobifluorene, pyridine, diazabenzene, triazine, carbazole, dibenzofuran or a dibenzothiophene one hydrogen atom bonding directly to an atom constituting the ring, and further preferably a group obtained by removing from benzene, naphthalene, anthracene, carbazole, dibenzofuran or dibenzothiophene two hydrogen atoms bonding directly to atoms constituting the

ring, and these groups optionally have a substituent.

The substituent which $L^{H1}$ optionally has is preferably a halogen atom, an alkyl group, a cycloalkyl group, an alkoxy group, a cycloalkoxy group, an aryl group, a monovalent hetero ring group or a substituted amino group, more preferably an alkyl group, an alkoxy group, an aryl group or a monovalent hetero ring group, and further preferably an alkyl group, an aryl group or a monovalent hetero ring group, and these groups optionally further have a substituent.

The examples and preferable ranges of the aryl group, the monovalent hetero ring group and the substituted amino group for the substituent which $L^{H1}$ optionally has are the same as the examples and preferable ranges of the aryl group, the monovalent hetero ring group and the substituted amino group for the substituent which $Ar^{H1}$ and $Ar^{H2}$ optionally have, respectively.

The examples and preferable ranges of the substituent which the substituent which the substituent which $L^{H1}$ optionally has optionally has optionally further has are the same as the examples and preferable ranges of the substituent which the substituent which $Ar^{H1}$ and $Ar^{H2}$ optionally have optionally further has.

$R^{H21}$ is preferably an aryl group or a monovalent hetero ring group, and these groups optionally have a substituent.

The definition and examples of the aryl group and the monovalent hetero ring group represented by $R^{H21}$ are the same as the definition and examples of , the aryl group and the monovalent hetero ring group represented by $Ar^{H1}$ and $Ar^{H2}$ .

The definition and examples of the substituent which $R^{H21}$ optionally has are the same as the definition and examples of the substituent which $Ar^{H1}$ and $Ar^{H2}$ optionally have.

The compound represented by the formula (H-1) is preferably a compound represented by the formula (H-2).

[Chemical Formula 119]

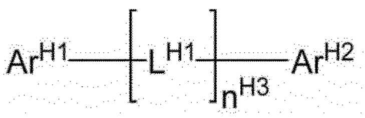

**(H-2)**

[wherein, $Ar^{H1}$, $Ar^{H2}$, $n^{H3}$ and $L^{H1}$ represent the same meaning as described above.]

As the low molecular host material, compounds represented by the following formulae and a compound H1 described below are exemplified.

[Chemical Formula 120]

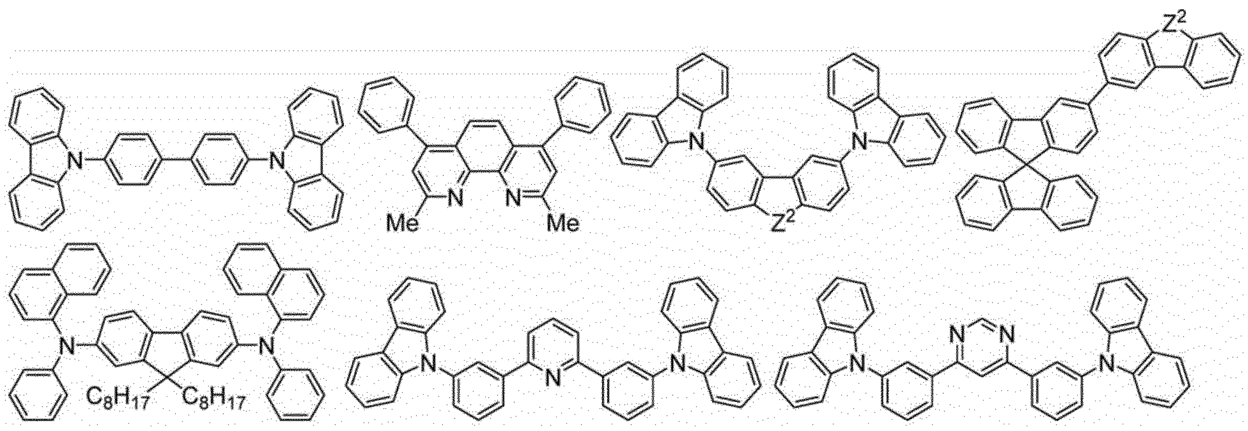

[Chemical Formula 121]

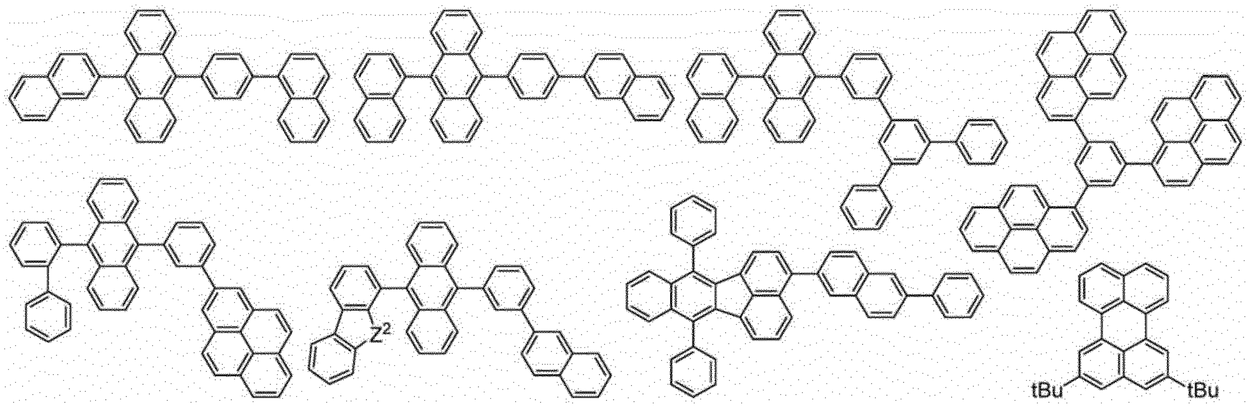

[Chemical Formula 122]

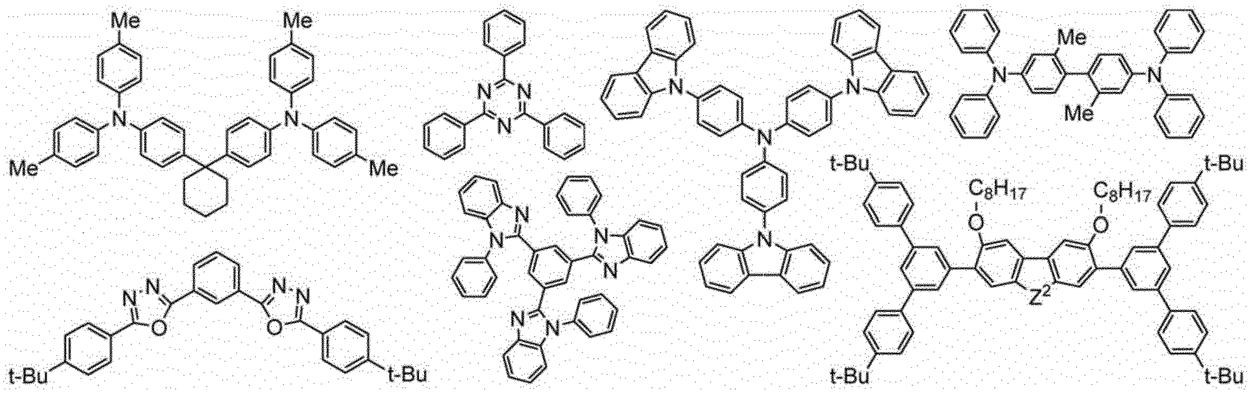

[Chemical Formula 123]

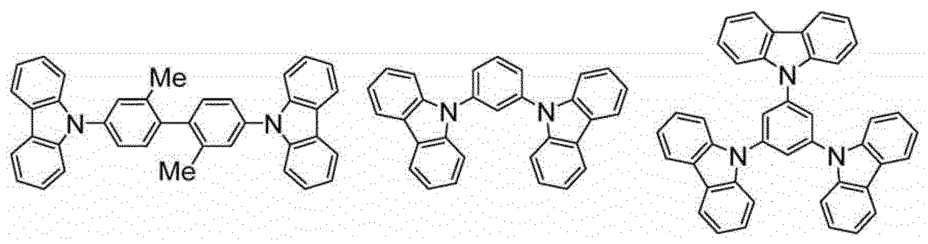

In the formulae, $Z^2$ represents an oxygen atom or a sulfur atom.

[Polymer host]

The polymer host material includes, for example, polymer compounds as the hole transporting material described later, and polymer compounds as the electron transporting material described later. It is preferable that the polymer host material is a compound having no condensed hetero ring skeleton (f) in the compound.

The polystyrene-equivalent number-average molecular weight of the polymer host material is preferably $5\times10^3$ to $1\times10^6$, more preferably $1\times10^4$ to $5\times10^5$, and more preferably $5\times10^4$ to $2\times10^5$. The polystyrene-equivalent weight-average molecular weight of the polymer host material is preferably $1\times10^4$ to $2\times10^6$, more preferably $2\times10^4$ to $1\times10^6$, and more preferably $1\times10^5$ to $5\times10^5$.

The polymer host material may be any of a block copolymer, a random copolymer, an alternative copolymer, or a graft copolymer, and may also be in another form, and it is preferably a copolymer obtained by copolymerizing multiple kinds of raw material monomers.

The polymer host material is preferably a polymer compound containing the constitutional unit represented by the

above-described formula (Y) or the following formula (Z), and more preferably a polymer compound containing each of the constitutional unit represented by the above-described formula (Y) and the following formula (Z), since a light emitting device containing the composition of the present embodiment is more excellent in light emission efficiency. The examples and preferable ranges of the constitutional unit represented by the formula (Y) which the polymer host material may contain are the same as the examples and preferable ranges of the constitutional unit represented by the formula (Y) for the compound (F).

[Chemical Formula 124]

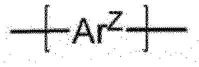 (Z)

[wherein, $Ar^Z$ represents a divalent hetero ring group, or, a divalent group in which an arylene group and a divalent hetero ring group are directly bonded, and these groups optionally have a substituent.]

The number of carbon atoms of the divalent hetero ring group for $Ar^Z$ is, not including the number of carbon atoms of the substituent, usually 2 or more and 60 or less, preferably 2 or more and 30 or less, and more preferably 3 or more and 15 or less.

The number of hetero atoms of the divalent hetero ring group for $Ar^Z$ is, not including the number of hetero atoms of the substituent, usually 1 or more and 30 or less, preferably 1 or more and 10 or less, more preferably 1 or more and 5 or less, and further preferably 1 or more and 3 or less.

The divalent hetero ring group for $Ar^Z$ is preferably a group obtained by removing from a hetero ring containing at least one hetero atom selected from the group consisting of a boron atom, a nitrogen atom, an oxygen atom, a silicon atom, a phosphorus atom, a sulfur atom and a selenium atom as the ring constituent atom two hydrogen atoms bonding directly to carbon atoms or hetero atoms constituting the ring, more preferably a group obtained by removing from a hetero ring containing at least one hetero atom selected from the group consisting of a nitrogen atom, an oxygen atom and a sulfur atom as the ring constituent atom two hydrogen atoms bonding directly to carbon atoms or hetero atoms constituting the ring, and further preferably a group obtained by removing from a hetero ring containing a nitrogen atom as the ring constituent atom two hydrogen atoms bonding directly to carbon atoms or hetero atoms constituting the ring (hereinafter, referred to also as "divalent nitrogen-containing hetero ring group"), and these groups optionally have a substituent.

Regarding the divalent hetero ring group for $Ar^Z$, the divalent hetero ring group other than the divalent nitrogen-containing hetero ring group includes, for example, groups obtained by removing from a borole ring, a furan ring, a silole ring, a phosphole ring, a thiophene ring, a selenophene ring, a benzofuran ring, a benzothiophene ring, a dibenzoborole ring, a dibenzofuran ring, a dibenzosilole ring, a dibenzophosphole ring, a dibenzothiophene ring or a dibenzoselenophene ring two hydrogen atoms bonding directly to carbon atoms or hetero atoms constituting the ring, and is preferably a group obtained by removing from a furan ring, a thiophene ring, a benzofuran ring, a benzothiophene ring, a dibenzofuran ring or a dibenzothiophene ring two hydrogen atoms bonding directly to carbon atoms or hetero atoms constituting the ring, and more preferably a group represented by the formula (AA-12) to the formula (AA-15), since they are advantageous for improving the light emission efficiency of a light emitting device, and these groups optionally have a substituent.

Regarding the divalent hetero ring group for $Ar^Z$, a divalent hetero ring group having no condensed hetero ring skeleton (f) is preferred.

Regarding the divalent hetero ring group for $Ar^Z$, the divalent nitrogen-containing hetero ring group is preferably a divalent nitrogen-containing hetero ring group containing a nitrogen atom not forming a double bond, since it is advantageous for improving the light emission efficiency and for improving the charge transportability (especially, for improving the hole transportability) of a light emitting device, and this group optionally has a substituent. Further, regarding the divalent hetero ring group for $Ar^Z$, the divalent nitrogen-containing hetero ring group is preferably a divalent nitrogen-containing hetero ring group containing a nitrogen atom forming a double bond as the ring constituent atom (hereinafter, referred to also as "divalent nitrogen-containing hetero ring group containing a nitrogen atom forming a double bond"), since it is advantageous for improving the light emission efficiency and for improving the charge transportability (especially, for improving the electron transportability) of a light emitting device, and this group optionally has a substituent.

The "nitrogen atom forming a double bond" means a nitrogen atom having a double bond between a nitrogen atom and an atom bonding to the nitrogen atom.

"Containing a nitrogen atom forming a double bond as the ring constituent atom" means that a group represented by -N= is contained in the ring.

The divalent nitrogen-containing hetero ring group containing a nitrogen atom not forming a double bond for $Ar^Z$ includes, for example, groups obtained by removing from a pyrrole ring, an indole ring, an isoindole ring, a carbazole ring, a dihydroacridine ring, a 5,10-dihydrophenazine ring, an acridone ring, a quinacridone ring, a phenoxazine ring, a phenothiazine ring, an indolocarbazole ring or an indenocarbazole ring two hydrogen atoms bonding directly to carbon

atoms or hetero atoms constituting the ring, and is preferably a group obtained by removing from a carbazole ring, a dihydroacridine ring, a 5,10-dihydrophenazine ring, a phenoxazine ring, a phenothiazine ring, an indolocarbazole ring or an indenocarbazole ring two hydrogen atoms bonding directly to carbon atoms or hetero atoms constituting the ring, more preferably a group obtained by removing from a carbazole ring, a dihydroacridine ring, a 5,10-dihydrophenazine ring, a phenoxazine ring or a phenothiazine ring two hydrogen atoms bonding directly to carbon atoms or hetero atoms constituting the ring, further preferably a group obtained by removing from a carbazole ring, a phenoxazine ring or a phenothiazine ring two hydrogen atoms bonding directly to carbon atoms or hetero atoms constituting the ring, and particularly preferably a group obtained by removing from a phenoxazine ring two hydrogen atoms bonding directly to carbon atoms or hetero atoms constituting the ring, since they are advantageous for improving the light emission efficiency of a light emitting device, and these groups optionally have a substituent.

The divalent nitrogen-containing hetero ring group containing a nitrogen atom not forming a double bond is preferably a group represented by the formula (AA-10), the formula (AA-11), the formula (AA-18) to the formula (AA-22), the formula (AA-33) or the formula (AA-34), more preferably a group represented by the formula (AA-10), the formula (AA-11), the formula (AA-18) to the formula (AA-21), and further preferably a group represented by the formula (AA-18) or the formula (AA-19), since it is advantageous for improving the light emission efficiency and for improving the charge transportability (especially, for improving the hole transportability) of a light emitting device.

The divalent nitrogen-containing hetero ring group containing a nitrogen atom forming a double bond for $Ar^Z$ includes groups obtained by removing from a diazole ring, a triazole ring, an oxadiazole ring, a thiadiazole ring, a thiazole ring, an oxazole ring, a benzodiazole ring, a benzotriazole ring, a benzooxadiazole ring, a benzothiadiazole ring, an azacarbazole ring, a diazacarbazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring or a triazaphenanthrene ring two hydrogen atoms bonding directly to carbon atoms or hetero atoms constituting the ring, and is preferably a group obtained by removing from a pyridine ring, a diazabenzene ring, a triazine ring, an azanaphthalene ring, a diazanaphthalene ring, an azaanthracene ring, a diazaanthracene ring, an azaphenanthrene ring or a diazaphenanthrene ring two hydrogen atoms bonding directly to carbon atoms constituting the ring, more preferably a group obtained by removing from a pyridine ring, a diazabenzene ring, a triazine ring, an azanaphthalene ring or a diazanaphthalene ring two hydrogen atoms bonding directly to carbon atoms constituting the ring, further preferably a group obtained by removing from a pyridine ring, a diazabenzene ring or a triazine ring two hydrogen atoms bonding directly to carbon atoms constituting the ring, and particularly preferably a group obtained by removing from a triazine ring two hydrogen atoms bonding directly to carbon atoms constituting the ring, since the are advantageous for improving the light emission efficiency of a light emitting device, and these groups optionally have a substituent.

The divalent nitrogen-containing hetero ring group containing a nitrogen atom forming a double bond is preferably a group represented by the formula (AA-1) to the formula (AA-9), more preferably a group represented by the formula (AA-1) to the formula (AA-4), and further preferably a group represented by the formula (AA-4), since it is advantageous for improving the light emission efficiency and for improving the charge transportability (especially, for improving the electron transportability) of a light emitting device.

The examples and preferable examples of the arylene group in a divalent group in which an arylene group and a divalent hetero ring group are directly bonded for $Ar^Z$ are the same as the examples and preferable examples of the group represented by $Ar^{Y1}$.

The examples and preferable examples of the divalent hetero ring group in a divalent group in which an arylene group and a divalent hetero ring group are directly bonded for $Ar^Z$ are the same as the examples and preferable examples of the divalent hetero ring group represented by $Ar^Z$.

Examples of the divalent group in which an arylene group and a divalent hetero ring group are directly bonded for $Ar^Z$ include, for example, examples of the divalent group in which a group represented by $Ar^{Y1}$ and a divalent hetero ring group represented by $Ar^Z$ are directly bonded.

The substituent which the group represented by $Ar^Z$ optionally has is preferably a fluorine atom, an alkyl group, a cycloalkyl group, an aryl group, a monovalent hetero ring group, an alkoxy group, a cycloalkoxy group or a substituted amino group, more preferably an alkyl group, a cycloalkyl group, an aryl group or a monovalent hetero ring group, and further preferably an alkyl group or an aryl group, and these groups optionally further have a substituent.

The examples and preferable examples of the aryl group, the monovalent hetero ring group and the substituted amino group for the substituent which the group represented by $Ar^Z$ optionally has are the same as the examples and preferable examples of the aryl group, the monovalent hetero ring group and the substituted amino group for the substituent which the group represented by $Ar^{Y1}$ optionally has, respectively.

The examples and preferable examples of the substituent which the substituent which the group represented by $Ar^Z$ optionally has optionally further has are the same as the examples and preferable examples of the substituent which the substituent which the group represented by $Ar^{Y1}$ optionally has optionally further has.

The constitutional unit represented by the formula (Z) is preferably a constitutional unit represented by the

formula (Z-1) to the formula (Z-4), and more preferably a constitutional unit represented by the formula (Z-1) or the formula (Z-3), since it is advantageous for improving the light emission efficiency and for improving the charge transportability (especially, for improving the electron transportability) of a light emitting device. Further, the constitutional unit represented by the formula (Z) is preferably a constitutional unit represented by the formula (Z-5) to the formula (Z-7) described later, and more preferably a constitutional unit represented by the formula (Z-5), since it is advantageous for improving the light emission efficiency and for improving the charge transportability (especially, for improving the hole transportability) of a light emitting device.

[Chemical Formula 125]

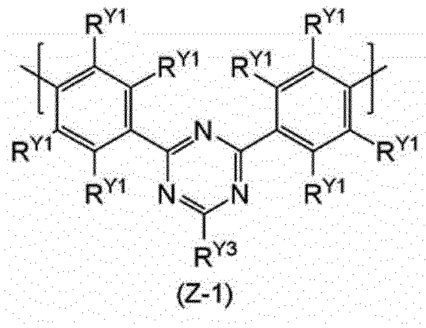

(Z-1)

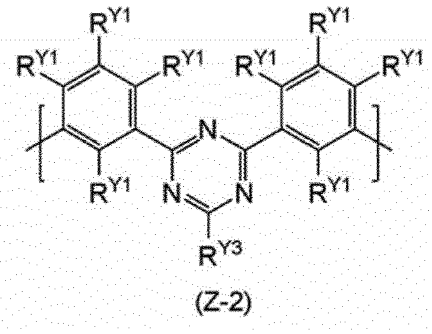

(Z-2)

[Chemical Formula 126]

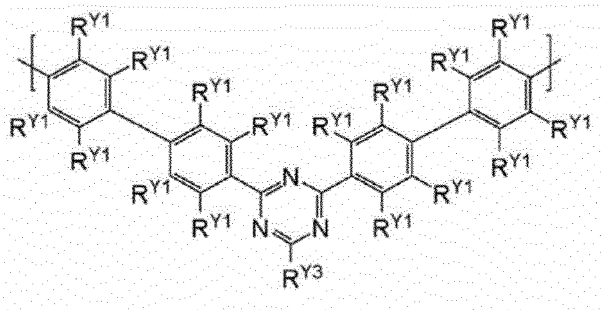

(Z-3)

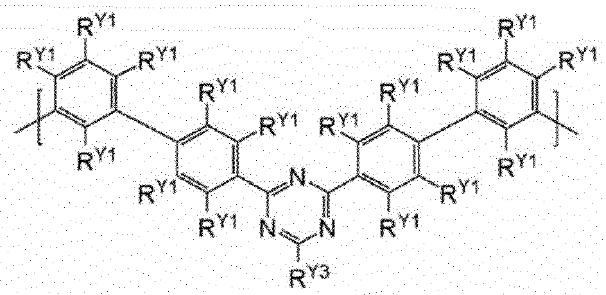

(Z-4)

[wherein, $R^{Y1}$ and $R^{Y3}$ each independently represent hydrogen atom, fluorine atom, an alkyl group, a cycloalkyl group, an aryl group, a monovalent hetero ring group, an alkoxy group, a cycloalkoxy group or a substituted amino group, and these groups optionally have a substituent. A plurality of $R^{Y1}$ may be the same or different, and may be combined together to form a ring together with carbon atoms to which they are attached.]

$R^{Y1}$ is preferably a hydrogen atom, an alkyl group, a cycloalkyl group, an aryl group or a monovalent hetero ring group, more preferably a hydrogen atom, an alkyl group, a cycloalkyl group or an aryl group, and further preferably a hydrogen atom or an alkyl group, and these groups optionally have a substituent.

$R^{Y3}$ is preferably an alkyl group, a cycloalkyl group, an aryl group or a monovalent hetero ring group, more preferably aryl group or a monovalent hetero ring group, and further preferably an aryl group, and these groups optionally have a substituent.

The examples and preferable examples of the aryl group, the monovalent hetero ring group and the substituted amino group for the group represented by $R^{Y1}$ and $R^{Y3}$ are the same as the examples and preferable examples of the aryl group, the monovalent hetero ring group and the substituted amino group for the substituent which the group represented by $Ar^{Y1}$ optionally has, respectively.

The examples and preferable examples of the substituent which $R^{Y1}$ and $R^{Y3}$ optionally have are the same as the examples and preferable examples of the substituent which the group represented by $Ar^{Y1}$ optionally has.

The constitutional unit represented by the formula (Z-1) is preferably a constitutional unit represented by the formula (Z-1'). Further, the constitutional unit represented by the formula (Z-3) is preferably a constitutional unit represented by the formula (Z-3').

[Chemical Formula 127]

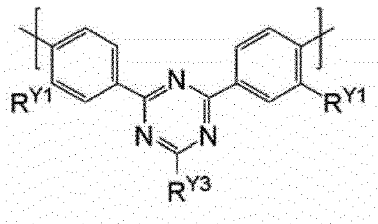

(Z-1')

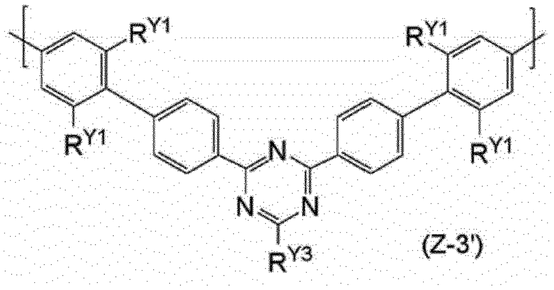

(Z-3')

[wherein, $R^{Y1}$ and $R^{Y3}$ represent the same meaning as described above.]

[Chemical Formula 128]

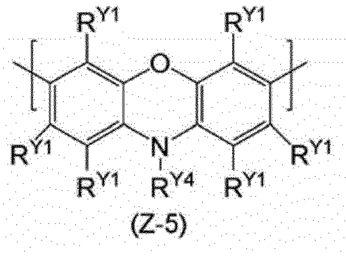

(Z-5)

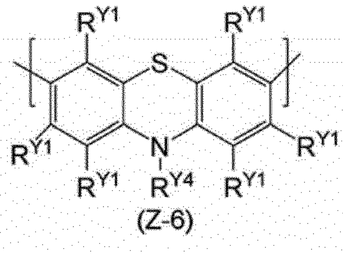

(Z-6)

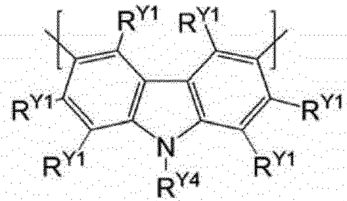

(Z-7)

[wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent hetero ring group, and these groups optionally have a substituent.]

$R^{Y4}$ is preferably an alkyl group, a cycloalkyl group, an aryl group or a monovalent hetero ring group, more preferably an aryl group or a monovalent hetero ring group, and further preferably an aryl group, and these groups optionally have a substituent.

The examples and preferable examples of the aryl group and the monovalent hetero ring group for the group represented by $R^{Y4}$ are the same as the examples and preferable examples of the aryl group and the monovalent hetero ring group for the substituent which the group represented by $Ar^{Y1}$ optionally has, respectively.

The examples and preferable examples of the substituent which $R^{Y4}$ optionally has are the same as the examples and preferable examples of the substituent which the group represented by $Ar^{Y1}$ optionally has.

The constitutional unit represented by the formula (Z) includes, for example, constitutional units composed of divalent hetero ring groups represented by the formula (Z-201) to the formula (Z-215), and constitutional units composed of divalent groups in which an arylene group and a divalent hetero ring group are directly bonded represented by the formula (Z-301) to the formula (Z-310).

[Chemical Formula 129]

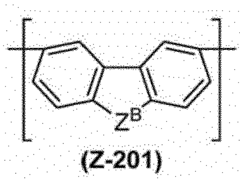

**(Z-201)**

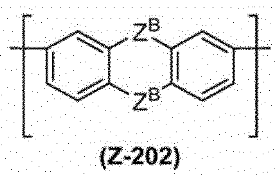

**(Z-202)**

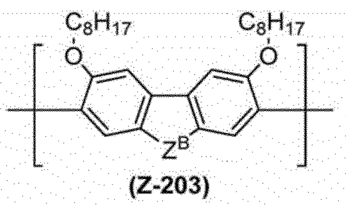

**(Z-203)**

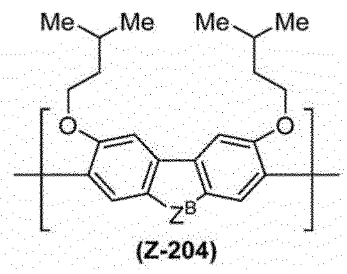

**(Z-204)**

[Chemical Formula 130]

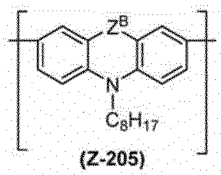

(Z-205)

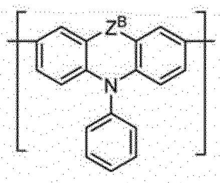

(Z-207)

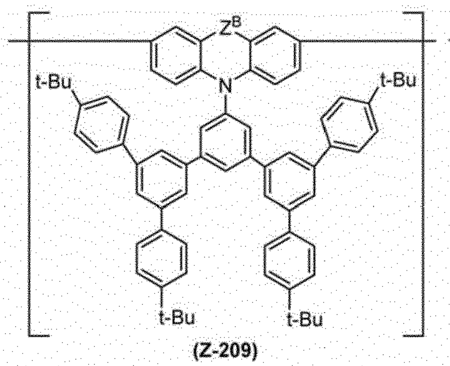

(Z-209)

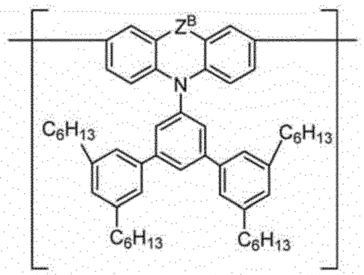

(Z-210)

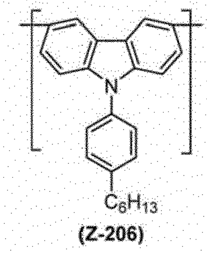

(Z-206)

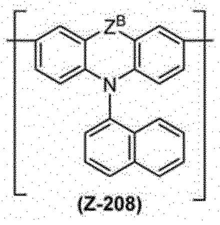

(Z-208)

[Chemical Formula 131]

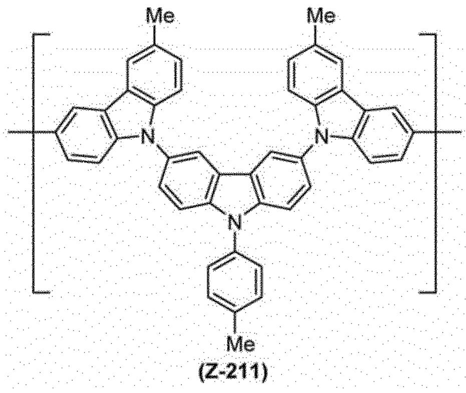

(Z-211)

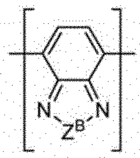

(Z-211)

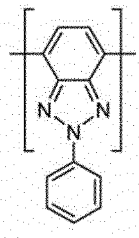

(Z-212)

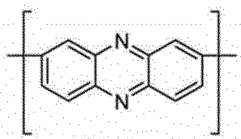

(Z-213)

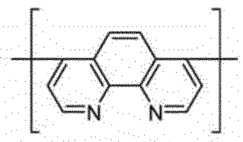

(Z-214)

[Chemical Formula 132]

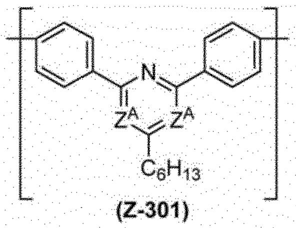

(Z-301)

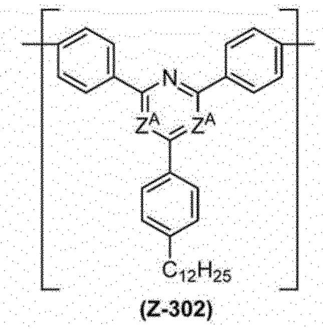

(Z-302)

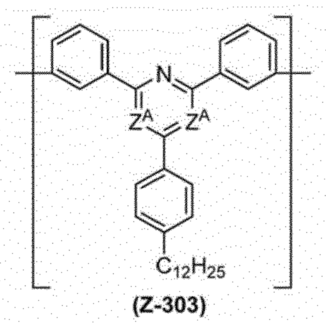

(Z-303)

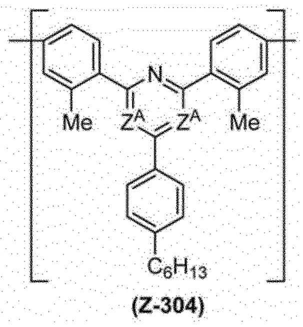

(Z-304)

[Chemical Formula 133]

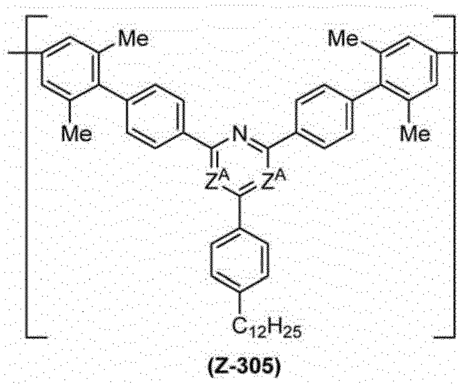
(Z-305)

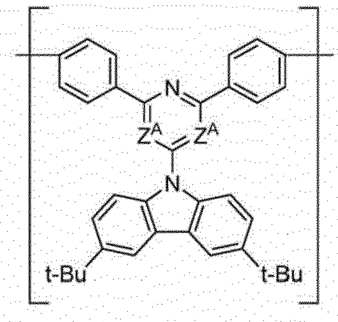
(Z-306)

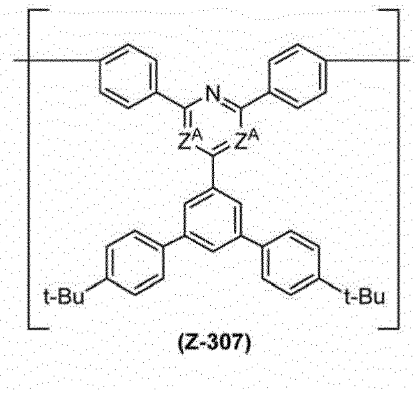
(Z-307)

[Chemical Formula 134]

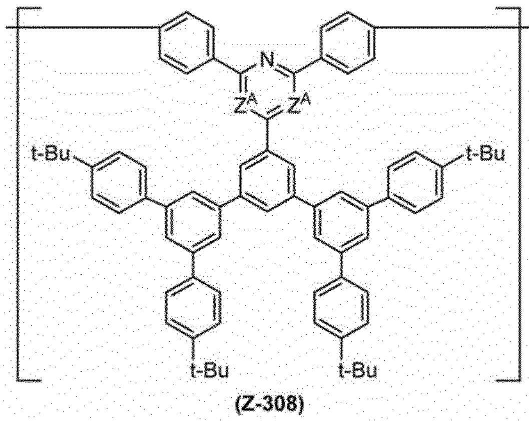
(Z-308)

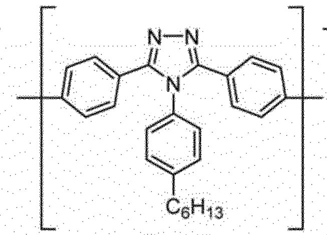
(Z-309)

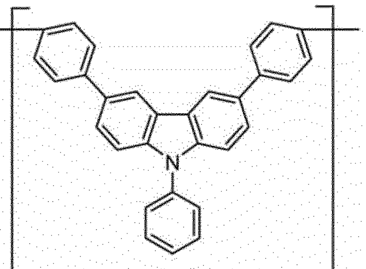
(Z-310)

[Hole transporting material]

The hole transporting material is classified into low molecular compounds and polymer compounds, and polymer compounds are preferred. The hole transporting material optionally has a cross-linkable group.

The low molecular compound includes, for example, aromatic amine compounds such as triphenylamine and derivatives thereof, N,N'-di-1-naphthyl-N,N'-diphenylbenzidine ($\alpha$-NPD), N,N'-diphenyl-N,N'-di(m-tolyl)benzidine (TPD), and the like.

The polymer compound includes, for example, polyvinylcarbazole and derivatives thereof; and polyarylenes having an aromatic amine structure in the side chain or main chain and derivatives thereof. The polymer compound may also be a compound to which an electron accepting site is bonded. The electron accepting site includes, for example, fullerene, tetrafluorotetracyanoquinodimethane, tetracyanoethylene, trinitrofluorenone, and the like, preferably includes fullerene.

When the composition of the present embodiment contains a hole transporting material, the blending amount of the hole transporting material is usually 1 parts by mass to 400 parts by mass, and preferably 5 parts by mass to 150 parts by mass, when the sum of the phosphorescent compound represented by the formula (1) and the compound (F) is taken as 100 parts by mass.

The hole transporting material may be used singly or in combination of two or more.

[Electron transporting material]

The electron transporting material is classified into low molecular compounds and polymer compounds. The electron transporting material may have a cross-linkable group.

The low molecular compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

When the composition of the present embodiment contains an electron transporting material, the blending amount of the electron transporting material is usually 1 part by mass to 400 parts by mass, and preferably 5 parts by mass to 150 parts by mass, when the sum of the phosphorescent compound represented by the formula (1) and the compound (F) is taken as 100 parts by mass.

The electron transporting material may be used singly or in combination of two or more.

[Hole injection material and electron injection material]

The hole injection material and the electron injection material are each classified into low molecular compounds and polymer compounds. The hole injection material and the electron injection material may have a cross-linkable group.

The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer containing an aromatic amine structure in the main chain or side chain, and the like.

When the composition of the present embodiment contains a hole injection material and an electron injection material, the blending amounts of the hole injection material and the electron injection material are each usually 1 part by mass to 400 parts by mass, and preferably 5 parts by mass to 150 parts by mass, when the sum of the phosphorescent compound represented by the formula (1) and the compound (F) is taken as 100 parts by mass.

The electron injection material and the hole injection material may each be used singly or in combination of two or more.

[Ion doping]

When the hole injection material or the electron injection material contains an electrically conductive polymer, the electric conductivity of the electrically conductive polymer is preferably $1\times10^{-5}$ S/cm to $1\times10^{3}$ S/cm. For adjusting the electric conductivity of the electrically conductive polymer within such a range, the electrically conductive polymer can be doped with an appropriate amount of ions.

The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more kinds thereof.

[Light emitting material]

The light emitting material (different from the phosphorescent compound represented by the formula (1) and the compound (F)) is classified into low molecular compounds and polymer compounds. The light emitting material optionally has a cross-linkable group.

The low molecular compound includes, for example, phosphorescent compounds such as naphthalene and derivatives thereof, anthracene and derivatives thereof, perylene and derivatives thereof, and the like, and phosphorescent compounds different from the phosphorescent compound represented by the formula (1) (hereinafter, referred to also as "other phosphorescent compound"). The other phosphorescent compound includes, for example, phosphorescent compounds having iridium, platinum or europium as the central metal atom.

The polymer compound includes polymer compounds containing, for example, a phenylene group, a naphthalenediyl group, fluorenediyldiyl group, a phenanthrenediyl group, a dihydrophenanthrenediyl group, a group represented by the formula (X), a carbazolediyl group, a phenoxazinediyl group, a phenothiazinediyl group, an anthracenediyl group, a pyrenediyl group, and the like.

The light emitting material is preferably other phosphorescent compound.

The other phosphorescent compounds includes, for example, compounds shown below.

[Chemical Formula 135]

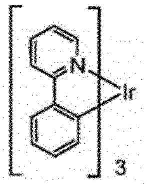

Ir(ppy)$_3$

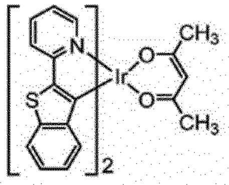

Btp$_2$Ir(acac)

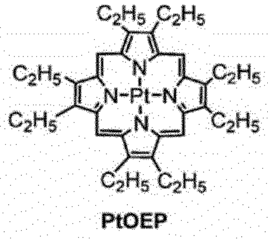

PtOEP

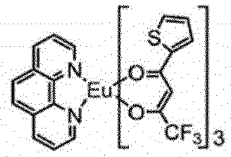

Eu(TTA)$_3$phen

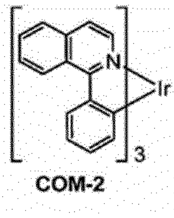

COM-2

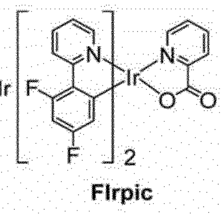

FIrpic

In the composition of the present embodiment, the content of the light emitting material is usually 0.001 parts by mass to 10 parts by mass, when the sum of the phosphorescent compound represented by the formula (1) and the compound (F) is taken as 100 parts by mass.

[Antioxidant]

The antioxidant may advantageously be a compound that is soluble in the same solvent as that for the phosphorescent compound represented by the formula (1) and the compound (F) and does not inhibit light emission and charge transportation, and includes, for example, phenol type antioxidants and phosphorus-based antioxidants.
In the composition of the present embodiment, the blending amount of the antioxidant is usually 0.001 parts by mass to 10 parts by mass, when the sum of the phosphorescent compound represented by the formula (1) and the compound (F) is taken as 100 parts by mass.
The antioxidant may be used singly or in combination of two or more.

<Ink>

The composition of the present embodiment may contain a solvent. Hereinafter, the composition of the present embodiment containing a solvent is referred to as "ink".
The ink of the present embodiment can be suitably used for application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method, and the like.
The viscosity of the ink of the present embodiment may advantageously be adjusted depending on the type of the application method, and is preferably 1 mPa•s to 30 mPa•s at 25°C, when applied to printing methods in which a solution passes through a discharge device such as an inkjet printing method, and the like, since clogging and flight curving in discharging less likely to occur.
The solvent contained in the ink of the present embodiment is a solvent capable of dissolving or uniformly dispersing solid components in the ink. The solvent includes, for example, chlorine-based solvents such as 1,2-dichloroethane, 1,1,2-trichloroethane, chlorobenzene, o-dichlorobenzene, and the like; ether type solvents such as THF, dioxane, anisole, 4-methylanisole, and the like; aromatic hydrocarbon type solvents such as toluene, xylene, mesitylene, ethylbenzene, n-hexylbenzene, cyclohexylbenzene, and the like; aliphatic hydrocarbon type solvents such as cyclohexane, methylcyclohexane, n-pentane, n-hexane, n-heptane, n-octane, n-nonane, n-decane, n-dodecane, bicyclohexyl, and the like; ketone type solvents such as acetone, methylethylketone, cyclohexanone, acetophenone, and the like; ester type solvents such as ethyl acetate, butyl acetate, ethyl cellosolve acetate, methyl benzoate, phenyl acetate, and the like; polyhydric alcohol type solvents such as ethylene glycol, glycerin, 1,2-hexanediol, and the like; alcohol type solvents such as isopropyl alcohol, cyclohexanol, and the like; sulfoxide type solvents such as dimethyl sulfoxide, and the like; and amide type solvents such as N-methyl-2-pyrrolidone, N,N-dimethylformamide, and the like. The solvent may be used singly or in combination of two or more.
In the ink of the present embodiment, the blending amount of the solvent is usually 1000 parts by mass to 100000 parts by mass, and preferably 2000 parts by mass to 20000 parts by mass, when the sum of the phosphorescent compound represented by the formula (1) and the compound (F) is taken as 100 parts by mass.
The ink of the present embodiment may contain other components than the phosphorescent compound represented by the formula (1), the compound (F) and the solvent. For example, the ink of the present embodiment may further contain at least one material selected from the group consisting of the host material, the hole transporting material, the hole injection material, the electron transporting material, the electron injection material, the light emitting material (different from the phosphorescent compound represented by the formula (1) and the compound (F)) and the antioxidant described above.

<Film>

The film contains the phosphorescent compound represented by the formula (1) and the compound (F).
The film is suitable as the light emitting layer in a light emitting device.
The film can be fabricated by an application method such as, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method, and the like, using the ink of the present embodiment.
The thickness of the film is usually 1 nm to 10 μm.

<Light emitting device>

The light emitting device of the present embodiment is a light emitting device containing the composition of the present embodiment.
The light emitting device of the present embodiment has, for example, an anode, a cathode, and a layer containing the composition of the present embodiment disposed between the anode and the cathode.

[Layer constitution]

The layer containing the composition of the present embodiment is usually at least one layer such as a light emitting layer, a hole transporting layer, a hole injection layer, an electron transporting layer, or an electron injection layer, with a light emitting layer being preferred. These layers contain a light emitting material, a hole transporting material, a hole injection material, an electron transporting material, or an electron injection material, respectively. The method for forming these layers includes, for example, a method of vacuum vapor deposition from power, and a method by film formation from solution or melted state when a low molecular compound is used, and for example, a method by film formation from solution or melted state when a polymer compound is used. Each of the layers can be formed, for example, by dissolving a light emitting material, a hole transporting material, a hole injection material, an electron transporting material, or an electron injection material in the solvent described above to prepare an ink-like composition, then, applying the same application method as for fabrication of a film described above using the composition.
The light emitting device has a light emitting layer between an anode and a cathode. The light emitting device of the present embodiment preferably has at least one of a hole injection layer and a hole transporting layer between an anode and a light emitting layer, from the standpoint of hole injectability and hole transportability, and preferably has at least one of an electron injection layer and an electron transporting layer between a cathode and a light emitting layer, from the standpoint of electron injectability and electron transportability.
The materials of a hole transporting layer, an electron transporting layer, a light emitting layer, a hole injection layer and an electron injection layer include the hole transporting material, the electron transporting material, the light emitting material, the hole injection material and the electron injection material and the like described above, respectively, in addition to the composition of the present embodiment.
When the material of a hole transporting layer, the material of an electron transporting layer and the material of a light emitting layer are soluble in a solvent used in forming layers adjacent to the hole transporting layer, the electron transporting layer and the light emitting layer, respectively, it is preferable that the material has a cross-linkable group for avoiding the material from being dissolved in the solvent, in fabricating a light emitting device. After forming each layer using the material having a cross-linkable group, the cross-linkable group can be cross-linked to insolubilize the layer.
The order and number of layers to be laminated and the thickness of each layer can be adjusted in consideration of light emission efficiency, luminance life, and the like.
When the light emitting device of the present embodiment has an electron transporting layer, the electron transporting material contained in the electron transporting layer includes low molecular compounds or polymer compounds, with low molecular compounds are being preferred. The polymer compound contained in the electron transporting layer is preferably a polymer compound containing at least one constitutional unit selected from the group consisting of the constitutional unit represented by the formula (ET-1) and the constitutional unit represented by the formula (ET-2) (hereinafter, referred to also as "polymer compound of electron transporting layer").

[Chemical Formula 136]

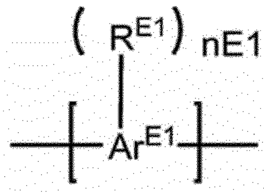

(ET-1)

[wherein,

nE1 represents an integer of 1 or more.
$Ar^{E1}$ represents an aromatic hydrocarbon group or a hetero ring group, and these groups optionally have a substituent other than $R^{E1}$.
$R^{E1}$ represents a group represented by the formula (ES-1). When a plurality of $R^{E1}$ are present, they may be the same or different.]

[Chemical Formula 137]

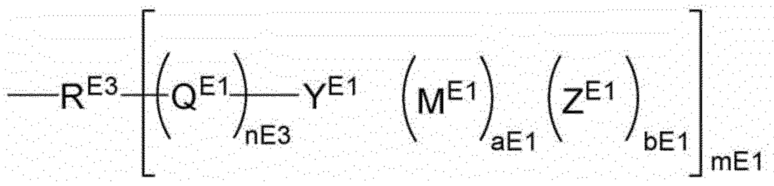

(ES-1)

[wherein,

nE3 represents an integer of 0 or more, aE1 represents an integer of 1 or more, bE1 represents an integer of 0 or more, and mE1 represents an integer of 1 or more. When a plurality of nE3, aE1 and bE1 are present, they may be the same or different at each occurrence. When $R^{E3}$ is a single bond, then, mE1 is 1. In addition, aE1 and bE1 are selected so that the charge of the group represented by the formula (ES-1) is 0.
$R^{E3}$ represents a single bond, a hydrocarbon group, a hetero ring group or $-O-R^{E3'}-$ ($R^{E3'}$ represents a hydrocarbon group or a hetero ring group), and these groups optionally have a substituent.
$Q^{E1}$ represents an alkylene group, a cycloalkylene group, an arylene group, an oxygen atom or a sulfur atom, and these groups optionally have a substituent. When a plurality of $Q^{E1}$ are present, they may be the same or different.
$Y^{E1}$ represents $-CO_2^-$, $-SO_3^-$, $-SO_2^-$ or $-PO_3^{2-}$. When a plurality of $Y^{E1}$ are present, they may be the same or different.
$M^{E1}$ represents an alkali metal cation, an alkaline earth metal cation or an ammonium cation, and this ammonium cation optionally has a substituent. When a plurality of $M^{E1}$ are present, they may be the same or different.
$Z^{E1}$ represents $F^-$, $Cl^-$, $Br^-$, $I^-$, $OH^-$, $B(R^{E4})_4^-$, $R^{E4}SO_3^-$, $R^{E4}COO^-$, $NO_3^-$, $SO_4^{2-}$, $HSO_4^-$, $PO_4^{3-}$, $HPO_4^{2-}$, $H_2PO_4^-$, $BF_4^-$ or $PF_6^-$. $R^{E4}$ represents an alkyl group, a cycloalkyl group or an aryl group, and these groups optionally have a substituent. When a plurality of $Z^{E1}$ are present, they may be the same or different.]
nE1 is usually an integer of 1 to 4, and preferably 1 or 2.

The aromatic hydrocarbon group or the hetero ring group represented by $Ar^{E1}$ is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazolediyl group nE1 hydrogen atoms bonding directly to atoms constituting the ring, and optionally has a substituent other than $R^{E1}$.
The substituent other than $R^{E1}$, which $Ar^{E1}$ optionally has, includes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group, a cycloalkynyl group, a carboxyl group, and a group represented by the formula (ES-3).

$$-O-(C_{n'}H_{2n'}O)_{nx}-C_{m'}H_{2m'+1} \qquad (ES-3)$$

[wherein, n', m' and nx each independently represent an integer of 1 or more.]

nE3 is usually an integer of 0 to 10, preferably an integer of 0 to 8, and more preferably an integer of 0 to 2.

aE1 is usually an integer of 1 to 10, preferably an integer of 1 to 5, and more preferably 1 or 2.

bE1 is usually an integer of 0 to 10, preferably an integer of 0 to 4, and more preferably 0 or 1.

mE1 is usually an integer of 1 to 5, preferably 1 or 2, and more preferably 0 or 1.

When $R^{E3}$ is -O-$R^{E3'}$-, the group represented by the formula (ES-1) is a group shown below.

[Chemical Formula 138]

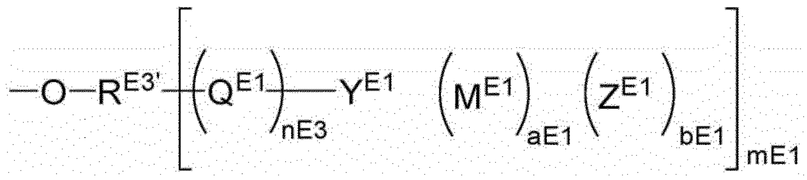

$R^{E3}$ is preferably a hydrocarbon group or a hetero ring group, more preferably an aromatic hydrocarbon group or an aromatic hetero ring group, and further preferably an aromatic hydrocarbon group.

The substituent which $R^{E3}$ optionally has includes an alkyl group, a cycloalkyl group, an aryl group, a monovalent hetero ring group, and a group represented by the formula (ES-3), and is preferably a group represented by the formula (ES-3).

$Q^{E1}$ is preferably an alkylene group, an arylene group or an oxygen atom, and more preferably an alkylene group or an oxygen atom.

$Y^{E1}$ is preferably $-CO_2^-$, $-SO_2^-$ or $PO_3^{2-}$, and more preferably $-CO_2^-$.

The alkali metal cation represented by $M^{E1}$ includes, for example, $Li^+$, $Na^+$, $K^+$, $Rb^+$, and $Cs^+$, and is preferably $K^+$, $Rb^+$ or $Cs^+$, and more preferably $Cs^+$.

The alkaline earth metal cation represented by $M^{E1}$ includes, for example, $Be^{2+}$, $Mg^{2+}$, $Ca^{2+}$, $Sr^{2+}$, and $Ba^{2+}$, and is preferably $Mg^{2+}$, $Ca^{2+}$, $Sr^{2+}$ or $Ba^{2+}$, and more preferably $Ba^{2+}$.

$M^{E1}$ is preferably an alkali metal cation or an alkaline earth metal cation, and more preferably an alkali metal cation.

$Z^{E1}$ is preferably $F^-$, $Cl^-$, $Br^-$, $I^-$, $OH^-$, $B(R^{E4})_4^-$, $R^{E4}SO_3^-$, $RE^4COO^-$ or $NO_3^-$, and preferably $F^-$, $Cl^-$, $Br^-$, $I^-$, $OH^-$, $RE^4SO_3^-$ or $RE^4COO^-$. $R^{E4}$ is preferably an alkyl group.

The group represented by the formula (ES-1) includes, for example, groups represented by the following formulae.

[Chemical Formula 139]

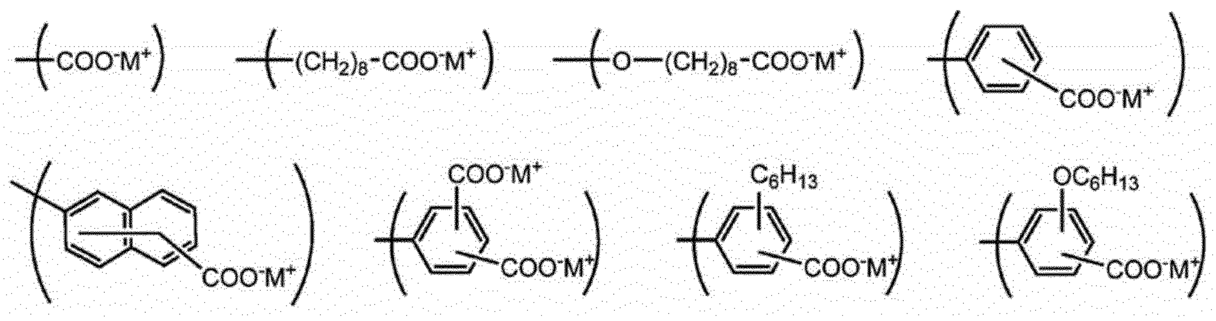

[Chemical Formula 140]

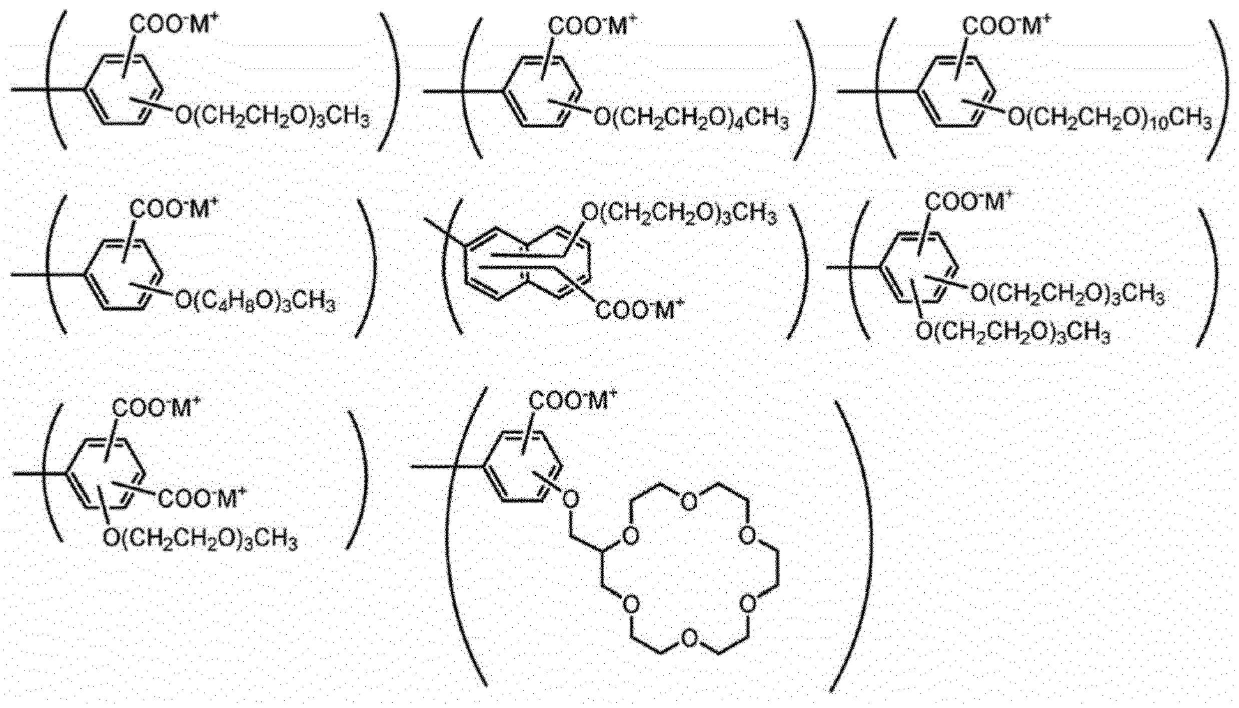

[wherein, $M^+$ represents $Li^+$, $Na^+$, $K^+$, $Cs^+$ or $N(CH_3)_4^+$. When a plurality of $M^+$ are present, they may be the same or different.]

[Chemical Formula 141]

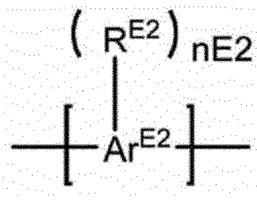
(ET-2)

[wherein,

nE2 represents an integer of 1 or more.
$Ar^{E2}$ represents an aromatic hydrocarbon group or a hetero ring group, and these groups optionally have a substituent other than $R^{E2}$.
$R^{E2}$ represents a group represented by the formula (ES-2). When a plurality of $R^{E2}$ are present, they may be the same or different.]

[Chemical Formula 142]

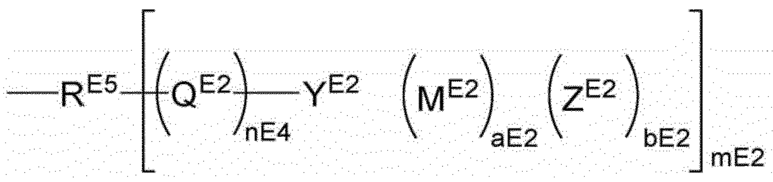
(ES-2)

[wherein,

nE4 represents an integer of 0 or more, aE2 represents an integer of 1 or more, bE2 represents an integer of 0 or more,

and mE2 represents an integer of 1 or more. When a plurality of nE4, aE2 and bE2 are present, they may be the same or different at each occurrence. When $R^{E5}$ is a single bond, then, mE2 is 1. In addition, aE2 and bE2 are selected so that the charge of the group represented by the formula (ES-2) is 0.

$R^{E5}$ reprsents a single bond, a hydrocarbon group, a hetero ring group or -O-$R^{E5'}$- ($R^{E5'}$ represents a hydrocarbon group or a hetero ring group.), and these groups optionally have a substituent.

$Q^{E2}$ represents an alkylene group, a cycloalkylene group, an arylene group, an oxygen atom or a sulfur atom, and these groups optionally have a substituent. When a plurality of $Q^{E2}$ are present, they may be the same or different.

$Y^{E2}$ represents $-C^+R^{E6}_2$, $-N^+R^{E6}_3$, $-P^+R^{E6}_3$, $-S^+R^{E6}_2$ or - $I^+R^{E6}_2$. $R^{E6}$ represents a hydrogen atom, an alkyl group, a cycloalkyl group or an aryl group, and these groups optionally have a substituent. A plurality of $R^{E6}$ may be the same or different. When a plurality of $Y^{E2}$ are present, they may be the same or different.

$M^{E2}$ represents $F^-$, $Cl^-$, $Br^-$, $I^-$, OH, B $(R^{E7})_4^-$, $R^{E7}SO_3^-$, $R^{E7}COO^-$, $BF_4^-$, $SbCl_6^-$ or $SbF_6^-$. $R^{E7}$ represents an alkyl group, a cycloalkyl group or an aryl group, and these groups optionally have a substituent.

When a plurality of $M^{E2}$ are present, they may be the same or different.

$Z^{E2}$ represents an alkali metal cation or an alkaline earth metal cation. When a plurality of $Z^{E2}$ are present, they may be the same or different.]

nE2 is usually an integer of 1 to 4, and preferably 1 or 2.

The aromatic hydrocarbon group or the hetero ring group represented by $Ar^{E2}$ is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazolediyl group nE2 hydrogen atoms bonding directly to atoms constituting the ring, and optionally has a substituent other than $R^{E2}$.

The substituent other than $R^{E2}$, which $Ar^{E2}$ optionally has, is the same as the substituent other than $R^{E1}$, which $Ar^{E1}$ optionally has.

nE4 is usually an integer of 0 to 10, preferably an integer of 0 to 8, and more preferably an integer of 0 to 2.

aE2 is usually an integer of 1 to 10, preferably an integer of 1 to 5, and more preferably 1 or 2.

bE2 is usually an integer of 0 to 10, preferably an integer of 0 to 4, and more preferably 0 or 1.

mE2 is usually an integer of 1 to 5, preferably 1 or 2, and more preferably 0 or 1.

When $R^{E5}$ is -O-$R^{E5'}$, the group represented by the formula (ES-2) is a group shown below.

[Chemical Formula 143]

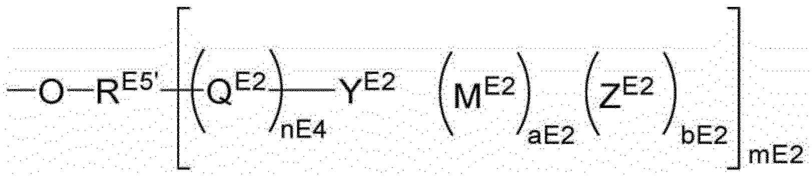

$R^{E5}$ is preferably a hydrocarbon group or a hetero ring group, more preferably an aromatic hydrocarbon group or an aromatic hetero ring group, and further preferably an aromatic hydrocarbon group.

The substituent which $R^{E5}$ optionally has includes an alkyl group, a cycloalkyl group, an aryl group, a monovalent hetero ring group, and a group represented by the formula (ES-3), and is preferably a group represented by the formula (ES-3).

$Q^{E2}$ is preferably an alkylene group, an arylene group or an oxygen atom, and more preferably an alkylene group or an oxygen atom.

$Y^{E2}$ is preferably $-C^+R^{E6}_2$, $-N^+R^{E6}_3$, $-P^+R^{E6}_3$ or $-S^+R^{E6}_2$, and more preferably $-N^+R^{E6}_3$. $R^{E6}$ is preferably a hydrogen atom, an alkyl group or an aryl group, and more preferably a hydrogen atom or an alkyl group.

$M^{E2}$ is preferably $F^-$, $Cl^-$, $Br^-$, $I^-$, B $(R^{E7})_4^-$, $R^{E7}SO_3^-$, $R^{E7}COO^-$, $BF_4^-$ or $SbF^{6-}$, and more preferably $Br^-$, $I^-$, B $(R^{E7})_4^-$, $R^{E7}COO^-$ or $SbF^{6-}$. $R^{E7}$ is preferably an alkyl group.

The alkali metal cation represented by $Z^{E2}$ includes, for example, $Li^+$, $Na^+$, $K^+$, $Rb^+$, and $Cs^+$, and is preferably $Li^+$, $Na^+$ or $K^+$.

The alkaline earth metal cation represented by $Z^{E2}$ includes, for example, $Be^{2+}$, $Mg^{2+}$, $Ca^{2+}$, $Sr^{2+}$, and $Ba^{2+}$, and is preferably $Mg^{2+}$ or $Ca^{2+}$.

$Z^{E2}$ is preferably an alkali metal cation.

The group represented by the formula (ES-2) includes, for example, groups represented by the following formulae.

[Chemical Formula 144]

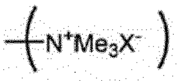
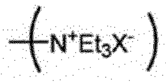
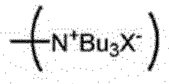
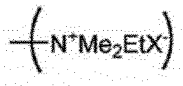
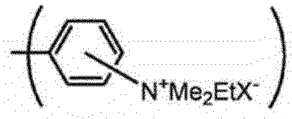
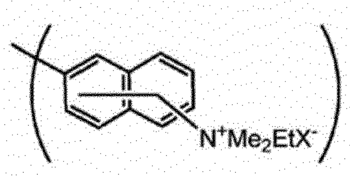
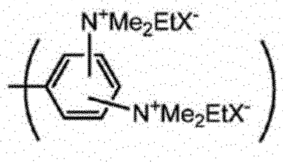
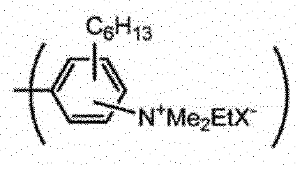
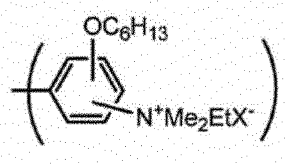

[Chemical Formula 145]

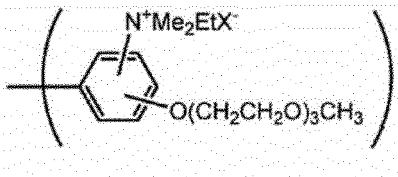
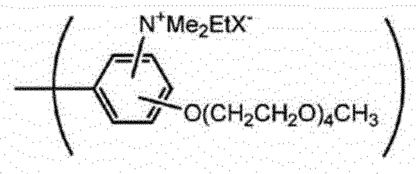
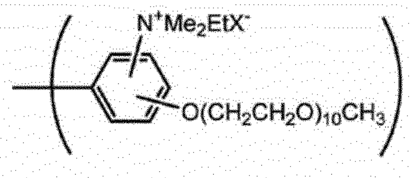
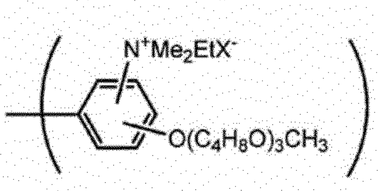
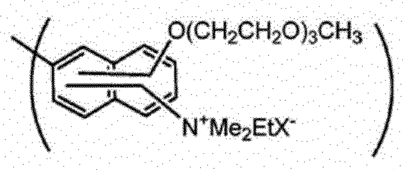
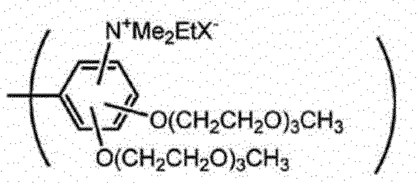
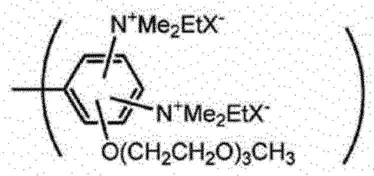
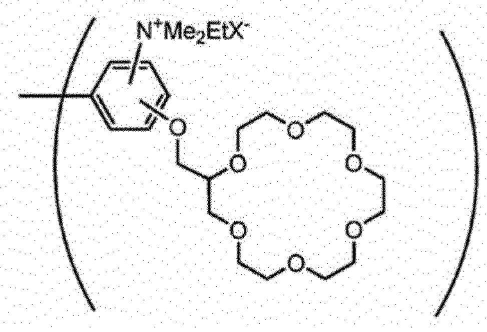

[wherein, $X^-$ represents $F^-$, $Cl^-$, $Br^-$, $I^-$, $B(C_6H_5)_4^-$, $CH_3COO^-$ or $CF_3SO_3^-$. When a plurality of $X^-$ are present, they may be the same or different.]

The constitutional unit represented by the formula (ET-1) or (ET-2) includes, for example, constitutional units represented by the formulae (ET-31) to (ET-38).

[Chemical Formula 146]

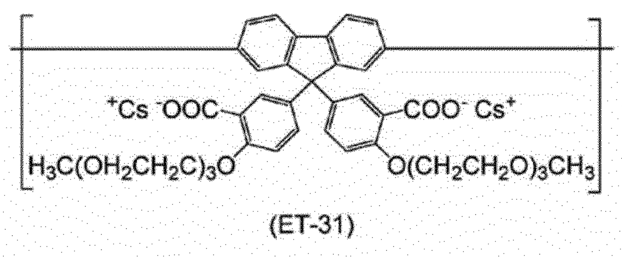

(ET-31)

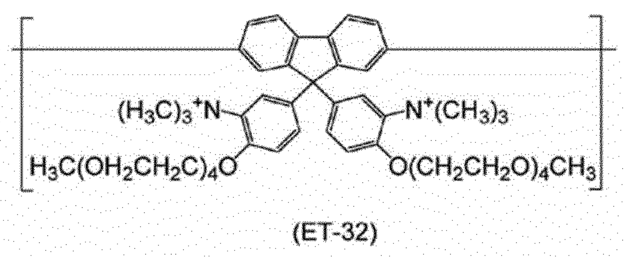

(ET-32)

[Chemical Formula 147]

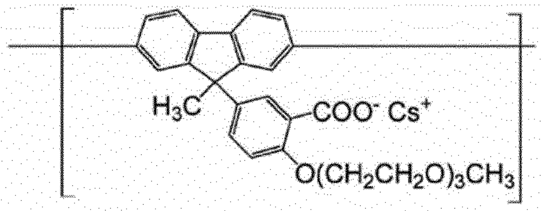

(ET-33)

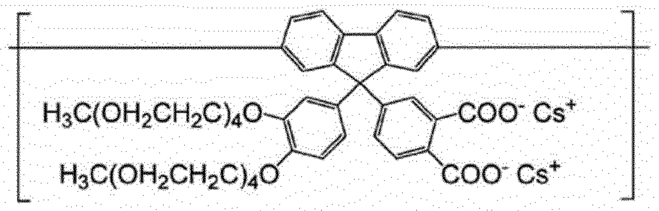

(ET-34)

[Chemical Formula 148]

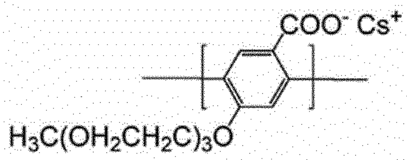

(ET-35)

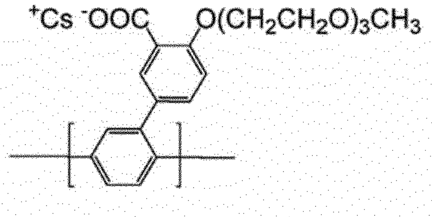

(ET-36)

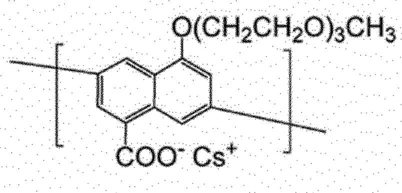

(ET-37)

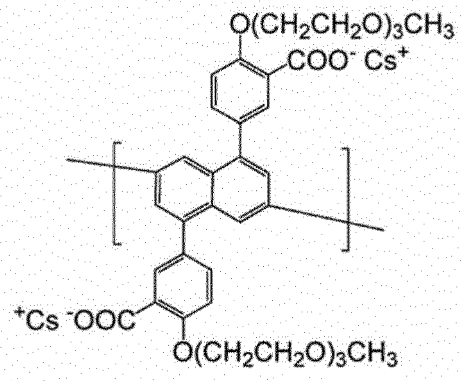

(ET-38)

The polymer compound for the electron transporting layer can be synthesized according to methods described in, for example, Japanese Unexamined Patent Application Publication (JP-A) No. 2009-239279, JP-A No. 2012-033845, JP-A No. 2012-216821, JP-A No. 2012-216822, and JP-A No. 2012-216815.

The low molecular compound contained in the electron transporting layer is preferably a low molecular compound having a phosphine oxide group, and includes, for example, low molecular compounds represented by the following formulae.

[Chemical Formula 149]

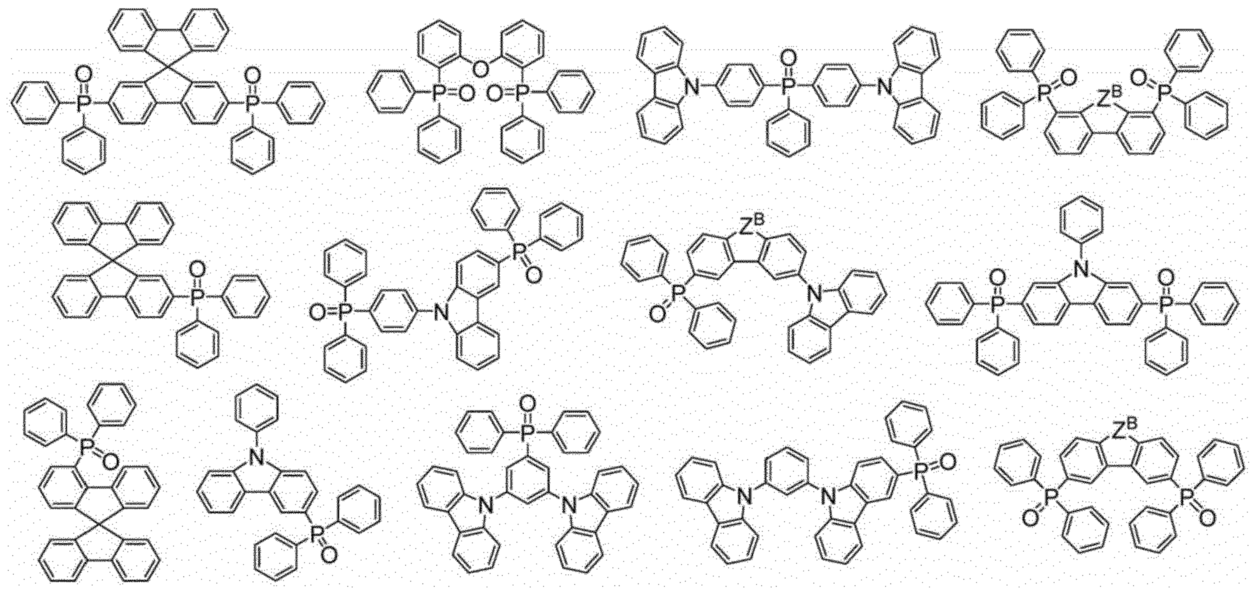

[wherein, $Z^B$ represents the same meaning as described above.]

[Substrate/electrode]

The light emitting device of the present embodiment may have a substrate. The substrate in the light emitting device may advantageously be a substrate on which an electrode can be formed and which does not change chemically in forming an organic layer (for example, a light emitting layer, a hole transporting layer, a hole injection layer, an electron transporting layer, an electron injection layer, and the like), and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, and includes preferably indium oxide, zinc oxide, tin oxide; electrically conductive compounds such as indium•-tin•oxide (ITO), indium•zinc•oxide, and the like; argentine-palladium-copper (APC) composite; NESA, gold, platinum, silver, and copper.

The material of the cathode includes, for example, metals such as lithium, sodium, potassium, rubidium, cesium, beryllium, magnesium, calcium, strontium, barium, aluminum, zinc, indium, and the like; alloys composed of two or more of them; alloys composed of one or more of them and one or more of silver, copper, manganese, titanium, cobalt, nickel, tungsten, and tin; and, graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like.

The anode and the cathode each may take a laminated structure composed of two or more layers.

[Application of light emitting device]

The light emitting device of the present embodiment is useful, for example, for illumination and display applications.

Suitable embodiments of the present invention have been explained above, but the present invention is not limited to the above-mentioned embodiments.

For example, one aspect of the present invention may relate to a method for producing a composition.

In one embodiment, the composition production method may be a production method having a step of preparing a phosphorescent compound represented by the formula (1), a sorting step of soring a compound (F) having a condensed hetero ring skeleton containing at least one atom (a) selected from the group consisting of a nitrogen atom and a boron atom in the ring, satisfying the formula (B), and in which the value of the energy level in the lowest triplet excited state ($T_F$ (eV)) satisfies the formula (A) with respect to the value of the energy level in the lowest triplet excited state of the phosphorescent compound prepared in the preparation step ($T_P$ (eV)), and a production step of mixing the phosphorescent compound prepared in the preparation step with the compound (F) sorted in the sorting step to obtain a composition (hereinafter, referred to also as production method (1)).

In the sorting step of the production method (1), the compound (F) may be further sorted so that the value of the

energy level in the lowest singlet excited state ($S_F$ (eV)) satisfies the formula (C) with respect to the value of the energy level in the lowest triplet excited state of the phosphorescent compound prepared in the preparation step ($T_P$ (eV)).

The production method (1) may further contain a step of determining the value of the energy level in the lowest triplet excited state of the phosphorescent compound prepared in the preparation step ($T_P$ (eV)). Further, the production method (1) may further contain a step of determining the value of the energy level in the lowest triplet excited state of the compound (F) ($T_F$ (eV)). In addition, the production method (1) may further contain a step of determining the value of the energy level in the lowest singlet excited state of the compound (F) ($S_F$ (eV)).

In another embodiment, the composition production method may also be a production method having a preparation step for preparing a compound (F) having a condensed hetero ring skeleton containing at least one atom (a) selected from the group consisting of a nitrogen atom and a boron atom in the like and satisfying the formula (B), a sorting step for sorting a phosphorescent compound represented by the formula (1) in which the value of the energy level in the lowest triplet excited state ($T_P$ (eV)) satisfies the formula (A) with respect to the value of the energy level in the lowest triplet excited state of the compound (F) prepared in the preparation step ($T_F$ (eV)), and a production step of mixing the compound (F) prepared in the preparation step with the phosphorescent compound sorted in the sorting step to obtain a composition (hereinafter, referred to also as production method (2)).

In the sorting step of the production method (2), the phosphorescent compound may be further sorted so that the value of the energy level in the lowest triplet excited state ($T_P$ (eV)) satisfies the formula (C) with respect to the value of the energy level in the lowest singlet excited state of the compound (F) prepared in the preparation step ($S_F$ (eV)).

The production method (2) may further contain a step of determining the value of the energy level in the lowest triplet excited state of the compound (F) prepared in the preparation step ($T_F$ (eV)). Further, the production method (2) may further contain a step of determining the value of the energy level in the lowest singlet excited state of the compound (F) prepared in the preparation step ($S_F$ (eV)). In addition, the production method (2) may further contain a step of determining the value of the energy level in the lowest triplet excited state of the phosphorescent compound ($T_P$ (eV)).

Still another aspect of the present invention may relate to a light emitting device production method.

In one embodiment, the light emitting device production method may be a method for producing a light emitting device containing an anode, a cathode, and an organic layer disposed between the anode and the cathode, and this production method may have a step of producing a composition by the above-described production method (for example, production method (1) or production method (2)), and a step of forming an organic layer using the composition produced in the above-described step.

Regarding the organic layer formation method in this embodiment, the organic layer can be formed, for example, using the same method as for film fabrication described above. Further, in the light emitting device production method of the present embodiment, the production method explained in the section of <Light emitting device> described above may be used. In addition, the light emitting device obtained by the light emitting device production method of the present embodiment includes, for example, the light emitting devices explained in the section of <Light emitting device> described above.

## EXAMPLES

Hereinafter, the present invention will be illustrated further in detail by examples, but the present invention is not limited to these examples.

In examples, the polystyrene-equivalent number-average molecular weight (Mn) and polystyrene-equivalent weightaverage molecular weight (Mw) of polymer compounds were determined by size exclusion chromatography (SEC) described below, using tetrahydrofuran as the mobile phase.

A polymer compound to be measured was dissolved in tetrahydrofuran at a concentration of about 0.05% by mass, and 10 $\mu$L of the solution was injected into SEC. The mobile phase was flowed at a flow rate of 1.0 mL/min. As the column, PLgel MIXED-B (manufactured by Polymer Laboratories Inc.) was used. As the detector, UV-VIS detector (trade name: UV-8320GPC, manufactured by Tosoh Corp.) was used.

In examples, the values at $S_1$ level and $T_1$ level of a compound were calculated using Gaussian09 as the quantum chemical calculation program. As the basis function, 6-31G* was used for atoms other than iridium, and lanl2dz was used for an iridium atom. Structural optimization of the base state of a compound was performed by a density general function method (B3LYP method), and the energies at $S_1$ and $T_1$ levels were determined by a time-dependent density general function method (B3LYP method) using the obtained optimum structure.

In examples, $\lambda_{PL,RT}$ of a compound and the half value width (hereinafter, referred to also as "FWHM (full-width half maximum)") of the emission spectrum were measured by a spectrophotometer (FP-6500, manufactured by JASCO Corporation) at room temperature. A xylene solution prepared by dissolving a compound in xylene at a concentration of about $8 \times 10^{-4}$% by mass was used as a sample. As the excitation light, ultraviolet (UV) light with a wavelength of 325 nm was used.

In examples, $\lambda_{ABS,\ RT}$ of a compound was measured by an ultraviolet-visible spectrophotometer (Cary 5E,

manufactured by Varian) at room temperature. A xylene solution prepared by dissolving a compound in xylene at a concentration of about 8×$10^{-4}$% by mass was used as a sample.

<Acquisition and synthesis of compounds H1, E1, P1 to P9, F1 to F7>

Compounds H1, E1, P1, P6, P7 and F1 manufactured by Luminescence Technology Corp. were used.

A compound P2 was synthesized with reference to a method described in International Publication No. WO 2017/130977.

A compound P3 was synthesized with reference to a method described in JP-A No. 2013-147451.

A compound P4 was synthesized with reference to a method described in International Publication No. WO 2017/170916.

A compound P5 was synthesized by the following method.

A compound P8 was synthesized with reference to a method described in JP-A No. 2013-237789.

A compound P9 was synthesized with reference to a method described in International Publication No. WO 2009/131255.

A compound F2 was synthesized by the following method.

Compounds F3 and F4 were synthesized with reference to a method described in International Publication No. WO 2015/102118.

A compound F5 was synthesized by the following method.

A compound F6 manufactured by Tokyo Chemical Industry Co., Ltd. was used.

A compound F7 was synthesized with reference to a method described in J. Phys. Chem. B 2005,109, 16, 8008-8016.

[Chemical Formula 150]

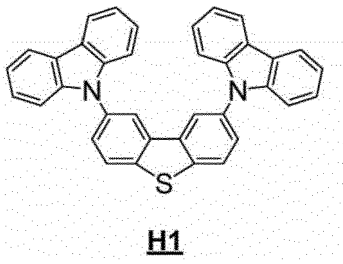

H1

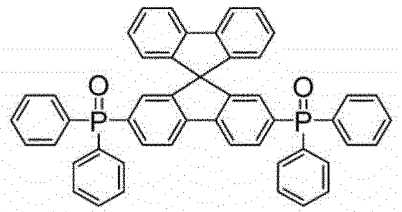

E1

[Chemical Formula 151]

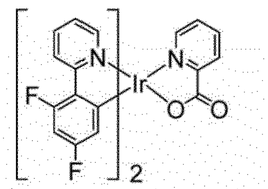

P1

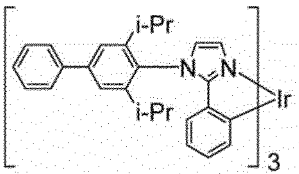

P2

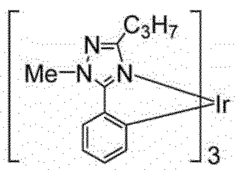

P3

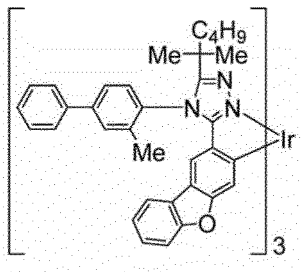

P4

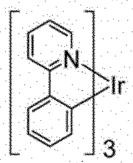

P6

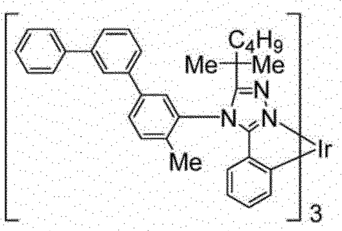

P5

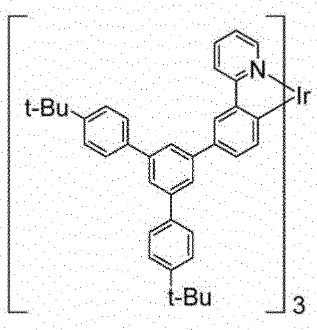

P9

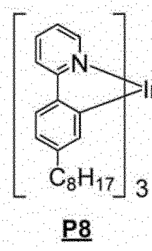

P8

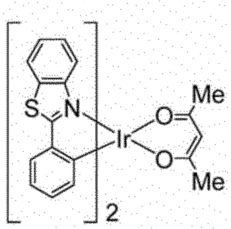

P7

[Chemical Formula 152]

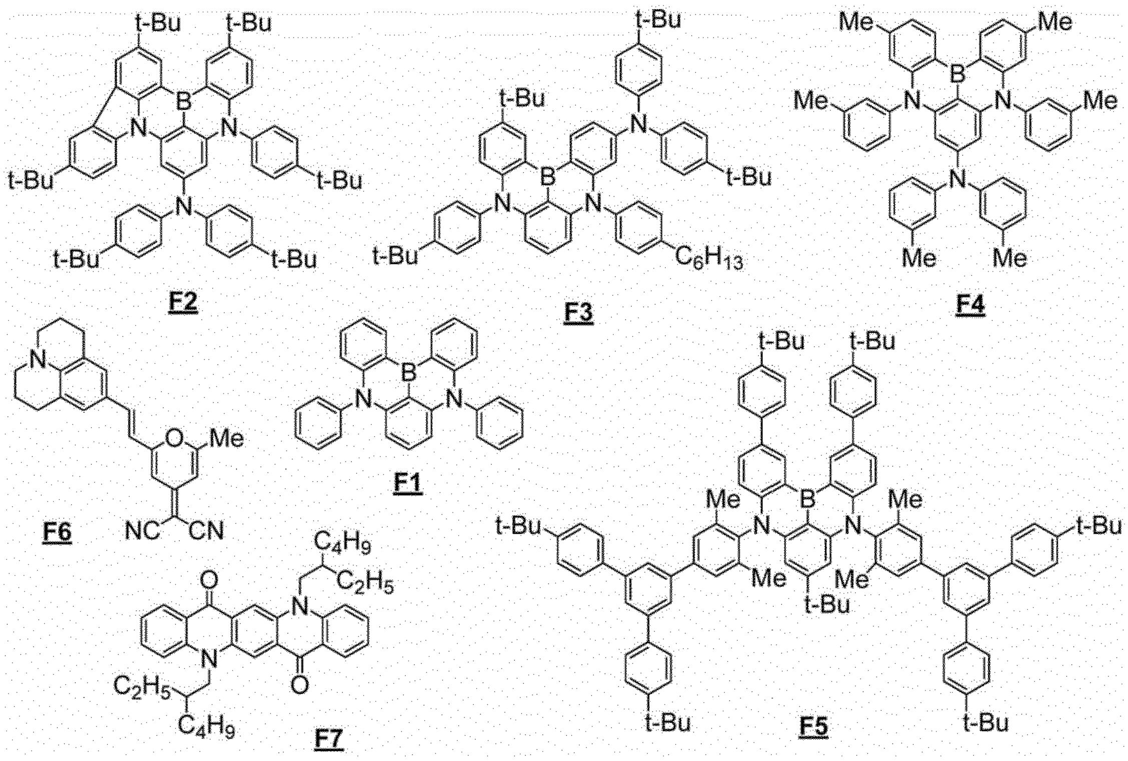

F2 F3 F4 F1 F6 F7 F5

<Synthesis Example P5> Synthesis of compound P5

A compound P5 was synthesized by the following method.

[Chemical Formula 153]

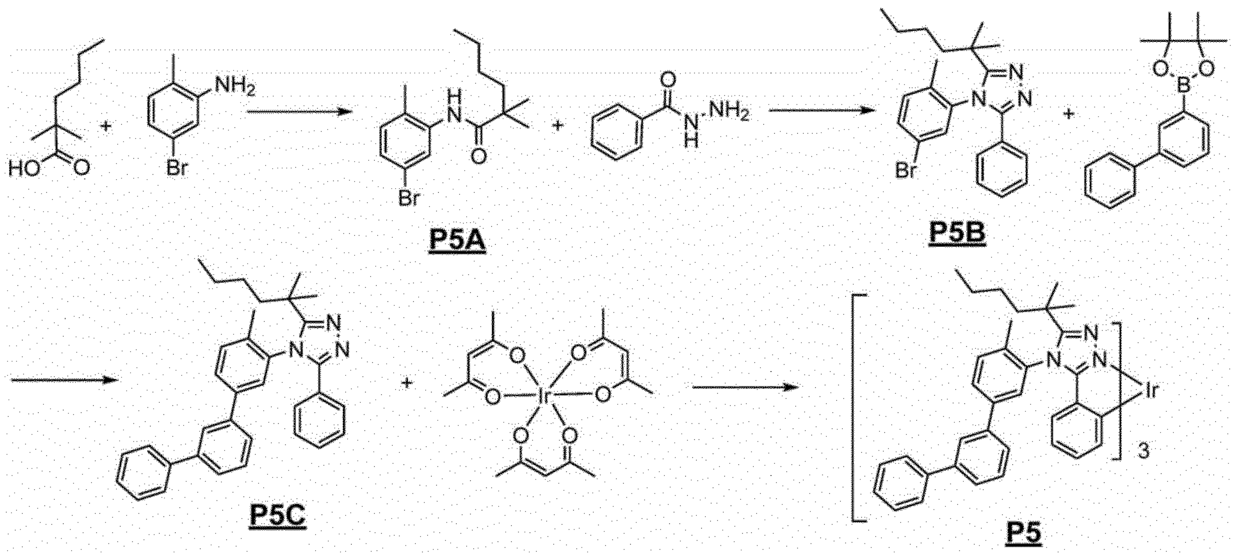

P5A P5B P5C P5

An argon gas atmosphere was made in a reaction vessel, then, 2,2'-dimethylhexanoic acid (23.8 g), chloroform (143 mL) and N,N'-dimethylformamide (0.12 g) were added, and the mixture was stirred at 50°C. Thionyl chloride (21.6 g) was dropped to this, and the mixture was stirred at 50°C for 3 hours to generate 2,2'-dimethylhexanoyl chloride.

A nitrogen gas atmosphere was made in a separately prepared reaction vessel, then, 5-bromo-2-methylaniline (29.3 g), chloroform (293 mL) and triethylamine (21.9 mL) were added, and stirred. Thereafter, the reaction vessel was

cooled using an ice bath, and 2,2'-dimethylhexanoyl chloride prepared above was dropped to this. After dropping, stirring of the mixture at room temperature was continued for 2.5 hours, and thereafter, a 1 mol/L sodium carbonate aqueous solution (165 mL) was added and the mixture was stirred at room temperature. The solution was liquid-separated, and to the resultant organic layer was added 1 mol/L hydrochloric acid (83 mL) and the mixture was stirred at room temperature. The solution was liquid-separated, and washed with ion exchanged water. The resultant washed solution was liquid-separated, the resultant organic layer was dried over magnesium sulfate, then, filtrated. The resultant filtrate was concentrated under reduced pressure, then, recrystallized twice using heptane, and dried at 40°C under reduced pressure, to obtain a compound P5A (39 g, white solid) at a yield of 76%. The compound P5A had an HPLC area percentage value of 98.7%.

The measurement results of NMR of the compound P5A were as described below.

$^1$H-NMR (400 MHz, $CDCl_3$) $\delta$ (ppm) = 8.06 (1H, d), 7.25-7.11 (2H, m), 7.04 (1H, d), 2.17 (3H, s), 1.60-1.53 (2H, m), 1.32-1.22 (10H, m), 0.87 (3H, s).

An argon gas atmosphere was made in a reaction vessel, then, the compound P5A (25 g), monochlorobenzene (200 mL), 2-fluoropyridine (7.6 mL) and trifluoromethanesulfonic anhydride (15 mL) were added, and stirred at room temperature for 30 minutes. To this was added benzoyl hydrazine (12 g), and the mixture was stirred at 90°C for 3.5 hours. Thereafter, to this was added ion exchanged water (250 mL) and the organic layer was washed. After liquid separation, to the resultant organic layer was added a 1 mol/L sodium hydrogen carbonate aqueous solution (66 mL) and the organic layer was extracted, and the resultant organic layer was washed with ion exchanged water. The resultant organic layer was concentrated under reduced pressure to obtain an oil. To the resultant oil was added a mixed solvent of chloroform and THF (volume ratio 8:2, 50 mL) for dissolution, then, the solution was filtrated through a filter paved with silica gel, and the resultant filtrate was concentrated under reduced pressure. Thereafter, it was recrystallized using heptane, and dried at 50°C under reduced pressure, to obtain a compound P5B (27.3 g) as a white solid at a yield of 83%. The compound P5B had an HPLC area percentage value of 99.1%.

The measurement results of NMR of the compound P5B were as described below.

$^1$H-NMR (400 MHz, $CDCl_3$) $\delta$ (ppm) = 7.58-7.50 (2H, m), 7.35-7.22 (5H, m), 7.12-7.07 (1H, d), 1.71 (3H, s), 1.67-1.57 (1H, m), 1.45-1.07 (11H, m), 0.88 (3H, t).

An argon gas atmosphere was made in a reaction vessel, then, the compound P5B (7.0 g), 2-([1,1'-biphenyl]-3-yl)-4,4,5,5-tetramethyl-1,3,2-dioxaborolane (5.2 g) and toluene were added and stirred at room temperature. To this was added bis(di-tert-butyl(4-dimethylaminobiphenyl)phosphine)dichloropalladium (60 mg) and the mixture was heated at 80°C. Thereafter, a 40% by mass tetrabutylammonium aqueous solution (66 g) was dropped, and the mixture was stirred at 80°C for 16 hours. Thereafter, the reaction vessel was cooled down to room temperature, to cause liquid separation. The resultant organic layer was washed with ion exchanged water. The resultant washed solution was liquid-separated, and the resultant organic layer was washed with ion exchanged water. The resultant washed solution was liquid-separated, the resultant organic layer was dried over magnesium sulfate, then, filtrated. To the resultant filtrate was added activated carbon, the mixture was stirred at room temperature for 30 minutes, then, filtrated through a filter paved with Celite. The resultant filtrate was concentrated under reduced pressure, then, purified through a silica gel column using a mixed solvent of toluene and ethyl acetate (volume ratio 9:1). Thereafter, it was recrystallized three times using a mixed solvent of heptane and 2-propanol (volume ratio 5:1), and dried at 50°C under reduced pressure, to obtain a compound P5C(5.5 g, white solid) at a yield of 66%. The compound P5C had an HPLC area percentage value of 99.5% or more.

The measurement results of LC-MS and NMR of the compound P5C were as described below.

LC-MS (APCI, positive): m/z = 542 $[M+H]^+$
$^1$H-NMR (400 MHz, $CDCl_3$) $\delta$ (ppm) = 7.82 (1H, t), 7.73-7.71 (2H, m), 7.64-7.57 (4H, m), 7.53 (1H, t), 7.45 (2H, t), 7.40-7.33 (3H, m), 7.32-7.25 (2H, m), 7.22 (2H, t), 1.80 (3H, s), 1.78-1.67 (1H, m), 1.52-1.42 (1H, m), 1.37 (3H, s), 1.35-1.16 (4H, m), 1.14 (3H, s), 0.82 (3H, t).

An argon gas atmosphere was made in a reaction vessel, then, trisacetylacetonatoiridium (1.2 g), the compound P5C(5.0 g) and pentadecane (25 mL) were added, and stirred for 55 hours under reflux with heating. Thereafter, to this was added toluene, and the solution was filtrated through a filter paved with silica gel, and a yellow solution containing a metal complex P5 was extracted with a mixed solvent of toluene and ethyl acetate. The resultant solution was concentrated under reduced pressure to obtain a solid, then, the resultant solid was purified by silica gel column chromatography (a mixed solvent of toluene and ethyl acetate) to obtain a solid. The resultant solid was recrystallized using a mixed solvent of toluene and acetonitrile and recrystallized using a mixed solvent of toluene and ethanol multiple times, and dried at 50°C under reduced pressure, to obtain a compound P5 (3.5 g, yellow solid) at a yield of 82%. The compound P5 had an HPLC area percentage value of 96%.

The measurement results of LC-MS and NMR of the compound P5 were as described below.

LC-MS (APPI, positive): m/z = 1645.8 $[M+H]^+$

$^1$H-NMR (400 MHz, $CD_2Cl_2$) δ (ppm) = 7.89-7.69 (9H, m), 7.67-7.31 (27H, m), 6.99-6.38 (9H, m), 6.12-6.10 (3H, m), 2.23-1.82 (9H, m), 1.47-0.84 (36H, m), 0.78-0.46 (9H, m).

<Synthesis Example F2> Synthesis of compound F2

A compound F2 was synthesized by the following method.

[Chemical Formula 154]

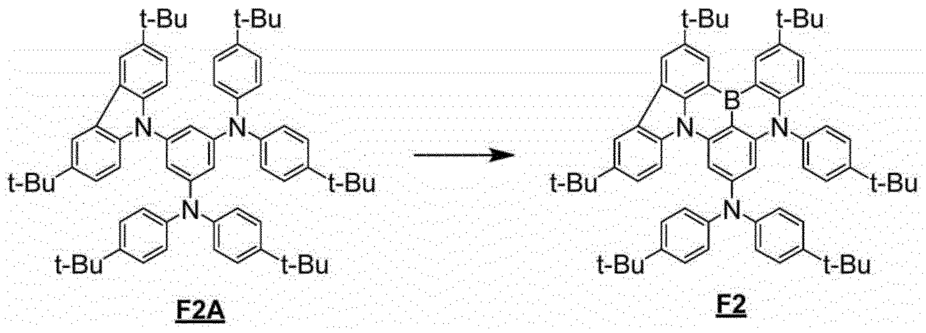

A nitrogen gas atmosphere was made in a reaction vessel, then, a compound F2A (22.5 g) synthesized by a method described in Angewandte Chemie, International Edition, 2018, vol. 57, pp. 11316-11320 and chlorobenzene were added and stirred, to this was added boron triiodide (16.4 g), and the mixture was stirred with heating at 90°C for 6 hours. Thereafter, the mixture was cooled down to room temperature, N,N-diisopropylethylamine (14.3 mL) was dropped, and stirring of the mixture at room temperature was continued for 15 minutes. To the resultant solution was added a 10% by mass sodium sulfite aqueous solution (70 mL). The above operation was repeated twice, the resultant organic layers were mixed, and the mixture was washed with a 10% by mass sodium sulfite aqueous solution and ion exchanged water. The resultant washed solution was liquid-separated, the resultant organic layer was dried over magnesium sulfate, then, filtrated through a filter loaded with 45 g of Florisil. The resultant filtrate was concentrated, then, to this was added acetonitrile (340 mL), and the mixture was stirred for 1 hour, and the resultant solid was filtrated. The resultant solid was dissolved in toluene (790 mL). To the resultant solution was added Carbolafin (33 g) and the mixture was stirred for 1 hour, then, filtrated through a filter paved with Celite, and the foregoing operation was repeated three times. The resultant solution was concentrated under reduced pressure, and the resultant solid was recrystallized with a mixed solvent of toluene and acetonitrile and a mixed solvent of toluene and ethanol multiple times, and dried at 50°C under reduced pressure, to obtain a compound F2 (30.9 g, yellow solid).

The measurement results of LC-MS and NMR of the compound F2 were as described below.

LC-MS (APCI, positive): m/z = 922 $[M+H]^+$

$^1$H-NMR ($CDCl_3$, 400 MHz) δ (ppm) = 9.05 (d, 1H), 9.00 (d, 1H), 8.32 (d, 1H), 8.15 (d, 1H), 7.52 (td, 2H), 7.43 (d, 1H) 7.38 (d, 1H), 7.32-7.22 (m, 6H), 7.20 (td, 2H)7.13 (td, 4H), 6.65 (d, 1H), 6.16 (d, 1H), 1.62 (s, 9H), 1.48 (s, 9H), 1.43 (s, 9H), 1.36 (s, 18H), 1.34 (s, 9H).

<Synthesis Example F5> Synthesis of compound F5

A compound F5 was synthesized by the following method.

[Chemical Formula 155]

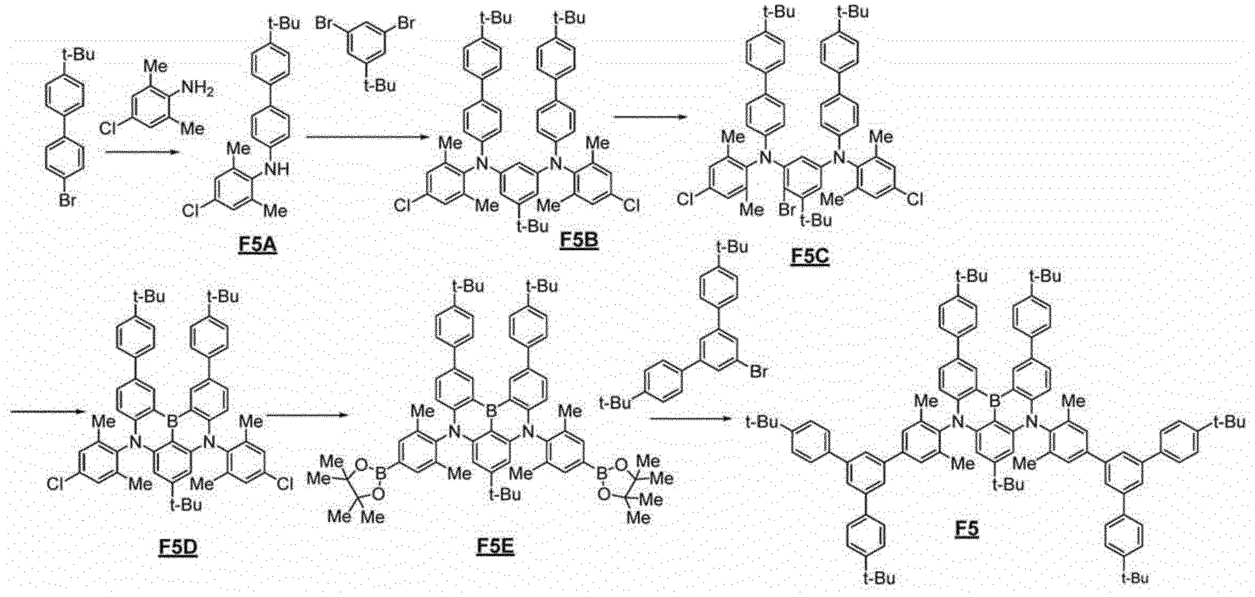

An argon gas atmosphere was made in a reaction vessel, then, 4-bromo-4'-tert-butylbiphenyl (30 g), 4-chloro-2,6-dimethylaniline (17.76 g), $Pd_2(dba)_3(dba)_{0.92}$ (0.88 g), t-$Bu_3PHBF_4$ (0.95 g), t-BuONa (14.95 g), and toluene (900 mL) were added, and the mixture was stirred at 50°C for 4 hours. Thereafter, the mixture was cooled down to room temperature, reaction solution was filtrated through a short column laminated with silica gel•Celite. The filtrate was concentrated under reduced pressure, to obtain a coarse product. This coarse product was purified by silica gel column chromatography (a mixed solvent of hexane and toluene), then, concentrated under reduced pressure. Thereafter, the purified product was recrystallized with a mixed liquid of toluene and isopropyl alcohol, then, dried, to obtain a compound F5A (25.2 g, white solid). The compound F5A had an HPLC area percentage value of 99%.

The measurement results of NMR of the compound F5A were as described below.

$^1$H-NMR ($CD_2Cl_2$-$d_2$, 400 MHz): $\delta$ (ppm) = 7.44-7.36 (m, 6H), 7.11 (s, 2H), 6.52 (td, 2H), 5.26 (br, 1H), 2.18 (s, 6H), 1.31 (s, 9H)

An argon gas atmosphere was made in a reaction vessel, then, the compound F5A (24.30 g), 1,3-dibromo-5-tert-butylbenzene (9.7 g), $Pd_2(dba)_3(dba)_{0.92}$ (0.56 g), t-$Bu_3PHBF_4$ (0.60 g), t-BuONa (7.98 g), and toluene (291 mL) were added, and the mixture was stirred at 50°C for 4 hours. Thereafter, the mixture was cooled down to room temperature, and the reaction solution was filtrated through a short column laminated with silica gel•Celite. The filtrate was concentrated under reduced pressure, to obtain a coarse product. This coarse product was purified by silica gel column chromatography (a mixed solvent of hexane and toluene), then, concentrated under reduce pressure, and dried, to obtain a compound F5B (18.1 g, white solid). The compound F5B had an HPLC area percentage value of 99%.

The measurement results of NMR of the compound F5B were as described below.

$^1$H-NMR ($CD_2Cl_2$-$d_2$, 400 MHz): $\delta$ (ppm) = 7.47-7.45 (m, 4H), 7.41-7.38 (m, 8H), 7.09 (s, 4H), 6.92 (td, 4H), 6.52 (d, 2H), 6.48 (t, 1H), 1.97 (s, 12H), 1.32 (s, 18H), 1.10 (s, 9H).

An argon gas atmosphere was made in a reaction vessel, then, the compound F5B (18.1 g) and chloroform (363 mL) were added, and the mixture was cooled down to 0°C, then, to this was added N-bromosuccinimide (3.93 g) in portions and the mixture was stirred. Thereafter, the stirred mixture was washed with a sodium sulfite aqueous solution, then, concentrated under reduced pressure. Thereafter, toluene (180 mL) was added, and the mixture was filtrated through a short column laminated with silica gel•Celite, and concentrated under reduced pressure. Thereafter, the concentrated product was recrystallized with a mixed liquid of toluene and ethanol, then, dried, to obtain a compound F5C(17.5 g, white solid). The compound F5C had an HPLC area percentage value of 99%.

The measurement results of NMR of the compound F5C were as described below.

$^1$H-NMR ($CD_2Cl_2$-$d_2$, 400 MHz): $\delta$ (ppm) = 7.49-7.33 (m, 14H), 7.06 (s, 2H), 6.99 (s, 2H), 6.88 (s, 1H), 6.84 (d, 2H), 6.65 (br, 2H), 6.32 (s, 1H), 1.89 (s, 12H), 1.42 (s, 9H), 1.31 (s, 18H).

An argon gas atmosphere was made in a reaction vessel, then, the compound F5C and xylene (429.5 mL) were added, and the mixture was cooled down to -40°C, then, to this was added a sec-BuLi•cyclohexane solution (1.0 M, 18.3 mL) slowly. The reaction solution was stirred at -10°C for 1 hour. Thereafter, the reaction solution was cooled down to -60°C, $BBr_3$ (3.57 mL) was added, and the mixture was stirred for 1 hour. Thereafter, the temperature was gradually increased up to 90°C to react. Thereafter, the reaction solution was cooled down to room temperature, N,N-diisopropylamine (31.4 mL) and toluene (258 mL) were added, and the organic layer was washed with a sodium sulfite aqueous solution and ion exchanged water. The resultant organic layer was concentrated under reduced pressure, to obtain a

yellow solid. The resultant solid was purified by silica gel column chromatography (a mixed solvent of hexane and toluene), then, concentrated under reduced pressure, and dried. Thereafter, the dried product was recrystallized with a mixed liquid of toluene and ethanol, then, dried, to obtain a compound F5D (6.6 g, yellow solid). The compound F5D had an HPLC area percentage value of 99%.

The measurement results of NMR of the compound F5D were as described below.

$^1$H-NMR ($CD_2Cl_2$-$d_2$, 400 MHz): $\delta$ (ppm) = 9.36 (d, 2H), 7.75-7.71 (m, 6H), 7.51 (d, 4H), 7.39 (s, 4H), 6.74 (d, 2H), 6.18 (s, 2H), 1.91 (s, 12H), 1.37 (s, 18H), 1.04 (s, 9H).

An argon gas atmosphere was made in a reaction vessel, then, the compound F5D (10 g), bis(pinacolato)diboron (5.72 g), potassium acetate (6.5 g), $Pd_2(dba)_3(dba)_{0.92}$ (0.21 g), 2-dicyclohexylphosphino-2',4',6'-triisopropylbiphenyl (0.38 g) and cyclopentyl methyl ether (130 mL) were added, and the mixture was stirred with heating for 45 hours. Thereafter, toluene (130 mL) was added, and the mixture was filtrated through a filter paved with Celite, and the resultant filtrate was concentrated under reduced pressure, acetonitrile was added, and the resultant solid was collected by filtration. Thereafter, toluene and activated carbon were added, and the mixture was stirred at room temperature for 30 minutes, then, filtrated through a filter paved with Celite, and the resultant filtrate was concentrated under reduced pressure, and further recrystallized with a mixed solvent of toluene and acetonitrile, to obtain a compound F5E (5.8 g) as a yellow solid. The compound F5E showed an HPLC area percentage value of 99.5% or more.

The measurement results of NMR of the compound F5E were as described below.

$^1$H-NMR ($CD_2Cl_2$-$d_2$, 400 MHz): $\delta$ (ppm) = 9.37 (d, 2H), 7.77 (s, 4H), 7.73 (d, 4H), 7.68 (dd, 2H), 7.51 (d, 4H), 6.68 (d, 2H), 6.19 (s, 2H), 1.93 (s, 12H), 1.38-1.37 (m, 42H), 1.00 (s, 9H).

An argon gas atmosphere was made in a reaction vessel, then, the compound F5E (2.3 g), 2-bromo-4, 6-di(4-tert-butylphenyl)benzene (1.9 g), $Pd_2(dba)_3(dba)_{0.92}$ (0.02 g), 2-dicyclohexylphosphino-2', 6'-dimethoxybiphenyl (0.04 g), toluene (115 mL), a 40% by mass tetrabutylammonium hydroxide aqueous solution (7.1 g), and ion exchanged water (28 mL) were added, and the mixture was stirred with heating for 1 hour. The resultant reaction solution was cooled down to room temperature, then, ion exchanged water (40 mL) was added, and the aqueous layer was removed. The resultant organic layer was washed with ion exchanged water, then, dried over anhydrous magnesium sulfate, and filtrated, and the resultant filtrate was concentrated under reduced pressure. Toluene and activated carbon were added, and the mixture was stirred at room temperature for 30 minutes, then, filtrated through a filter paved with Celite, and the resultant filtrate was concentrated under reduced pressure. Recrystallization was performed with a mixed solvent of toluene and acetonitrile, to obtain a compound F5 (3.0 g) as a yellow solid. The compound F5 showed an HPLC area percentage value of 99.0% or more.

The measurement results of LC-MS and NMR of the compound F5 were as described below.

LC-MS (APCI, positive): m/z = 1476.9 $[M+H]^+$

$^1$H-NMR ($CD_2Cl_2$-$d_2$, 400 MHz): $\delta$ (ppm) = 9.46 (d, 2H), 7.98 (d, 4H), 7.88 (t, 2H), 7.74-7.82 (m, 18H), 7.54-7.59 (m, 12H), 6.94 (d, 2H), 6.35 (s, 2H), 2.07 (t, 12H), 1.34-1.45 (m, 54H), 1.04-1.08 (m, 9H).

<Synthesis of compounds H2, P10 to P15, F8 to F11>

A compound H2 was synthesized with reference to a method described in JP-A No. 2015-110751.

A compound P10 was synthesized with reference to a method described in JP-A No. 2013-147551.

Compounds P11 to P12 were synthesized by the following method.

A compound P13 was synthesized with reference to a method described in International Publication No. WO 2008/090795 and International Publication No. WO 2006/121811.

A compound P14 was synthesized with reference to a method described in International Publication No. WO 2016/006523.

A compound P15 was synthesized by the following method.

Compounds F8 to F10 were synthesized by the following method.

A compound F11 was synthesized with reference to a method described in Angew. Chem. Int. Ed. 2020, 59, 17442-17446.

[Chemical Formula 156]

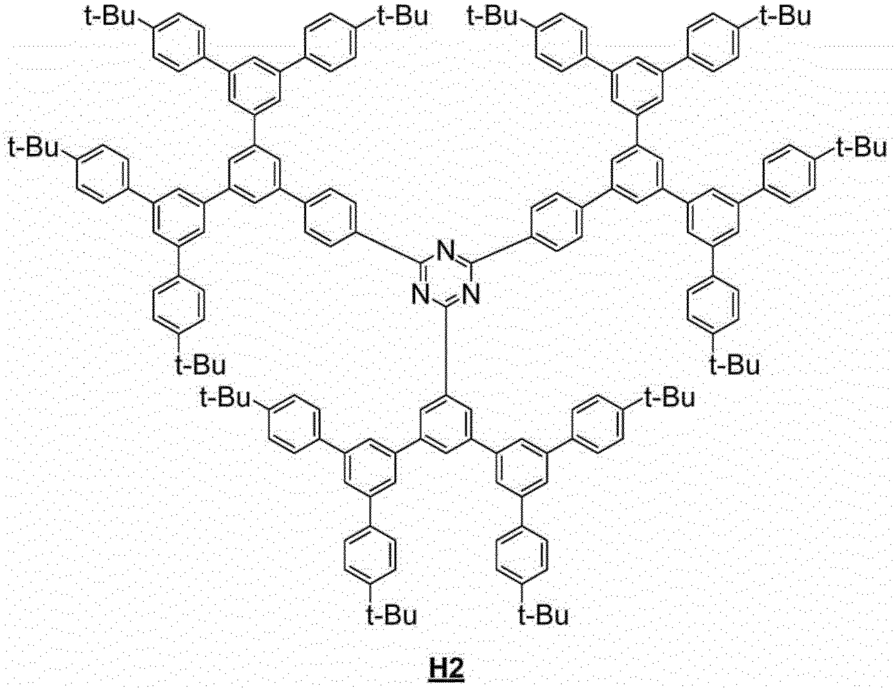

**H2**

[Chemical Formula 157]

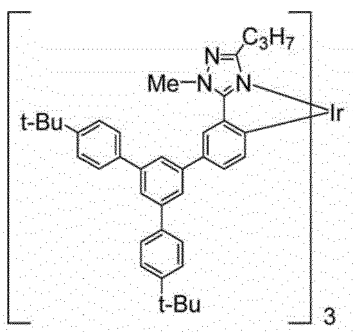

**P10**

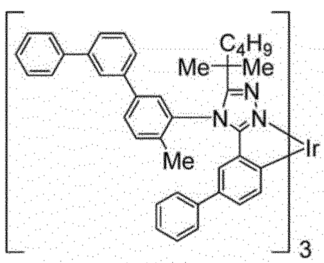

**P11**

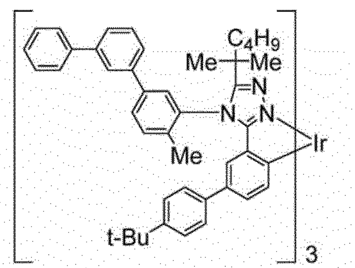

**P12**

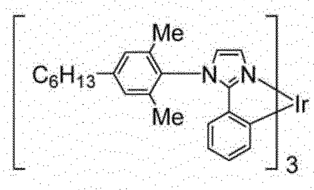

**P13**

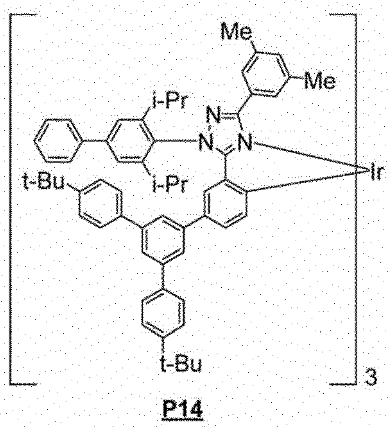

**P14**

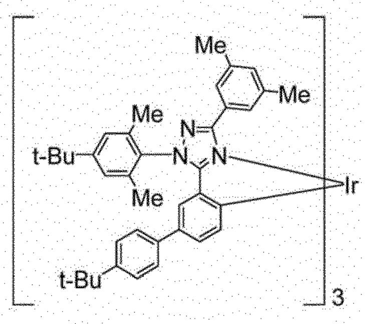

**P15**

[Chemical Formula 158]

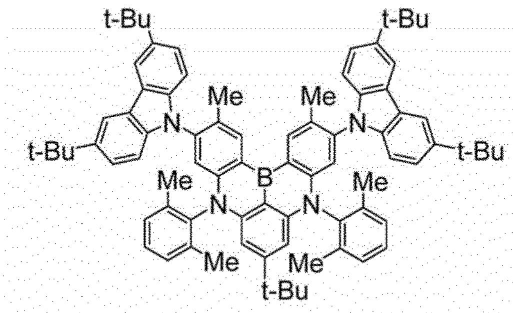

**F8**

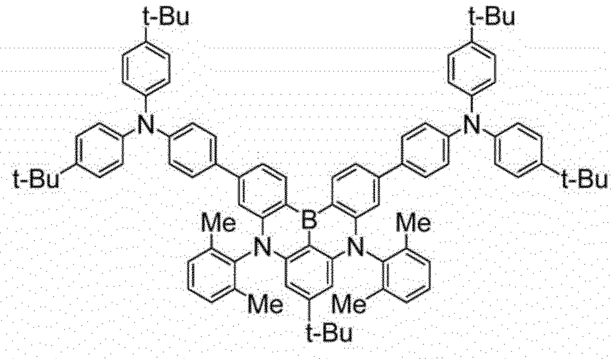

**F9**

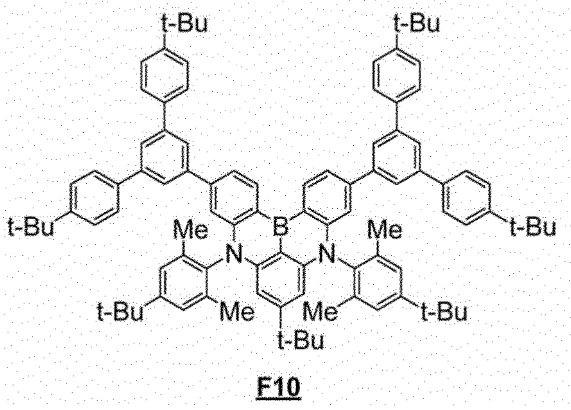

**F10**

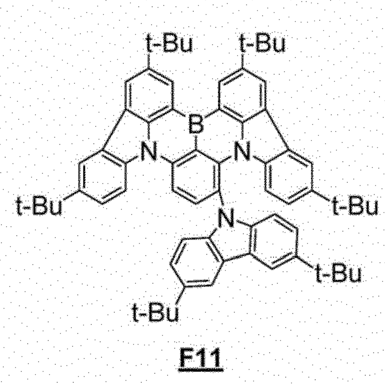

**F11**

<Synthesis Example P11> Synthesis of compound P11

A compound P11 was synthesized by the following method.

[Chemical Formula 159]

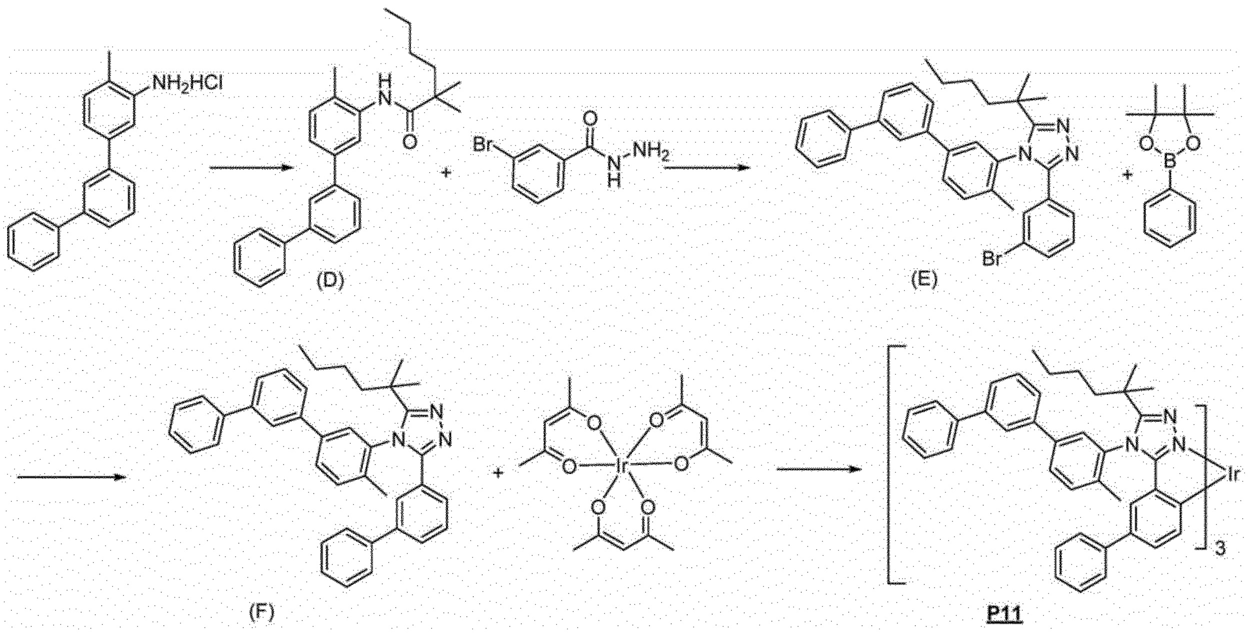

(D) (E) (F) **P11**

An argon gas atmosphere was made in a reaction vessel, then, 2,2'-dimethylhexanoic acid (11.8 g), chloroform (60 mL) and N,N'-dimethylformamide (0.07 g) were added, and the mixture was stirred at 50°C. Thionyl chloride (11.3 g) was dropped to this, and the mixture was stirred at 50°C for 3 hours to generate 2,2'-dimethylhexanoyl chloride.

A nitrogen gas atmosphere was made in a separately prepared reaction vessel, then, 2-methyl-5-(3-phenylphenyl)anilinehydrochloride (22.0 g), chloroform (176 mL) and triethylamine (20.7 mL) were added, and stirred. Thereafter, the reaction vessel was cooled using an ice bath, and the 2,2'-dimethylhexanoyl chloride solution prepared above was dropped to this. After dropping, stirring of the mixture at room temperature was continued for 2.5 hours, and thereafter, a 1 mol/L sodium carbonate aqueous solution (82 mL) were added, and the mixture was stirred at room temperature. The resultant solution was liquid-separated, and to the organic layer was added 1 mol/L hydrochloric acid (41 mL), and the mixture was stirred at room temperature. The resultant solution was liquid-separated, and washed with ion exchanged water. The washed solution was liquid-separated, the organic layer was dried over magnesium sulfate, then, filtrated. The filtrate was concentrated under reduced pressure, then, recrystallized using heptane, and dried at 40°C under reduced pressure, to obtain a compound (D) (27 g, white solid) at a yield of 94%. The compound (D) had an HPLC area percentage value of 99.5% or more.

The measurement results of NMR of the compound (D) were as described below.

$^1$H-NMR (400 MHz, $CDCl_3$) $\delta$ (ppm) = 8.08 (1H, d), 7.91 (1H, t), 7.64 (2H, d), 7.57 (2H, t), 7.51-7.41 (3H, m), 7.38-7.31 (2H, m), 7.28 (1H, d), 7.24 (1H, br), 2.28 (3H, s), 1.60 (2H, m), 1.37-1.30 (10H, m), 0.88 (3H, t).

An argon gas atmosphere was made in a reaction vessel, then, the compound (D) (25 g), monochlorobenzene (84 mL), 2-fluoropyridine (2.6 mL) and trifluoromethanesulfonic anhydride (5 mL) were added, and stirred at room temperature for 30 minutes. To this was added 3-bromobenzoyl hydrazine (6.4 g), and the mixture was stirred at 90°C for 4.5 hours. Thereafter, to this were added ion exchanged water (105 mL) and heptane (105 mL), and the organic layer was washed. After liquid separation, to the resultant organic layer was added a 1 mol/L sodium hydrogen carbonate aqueous solution (45 mL), and the organic layer was extracted, and the organic layer was washed with ion exchanged water. The resultant organic layer was concentrated under reduced pressure to obtain an oil. To the oil was added a mixed solvent of chloroform and THF (volume ratio 8:2, 50 mL) for dissolution, then, the solution was filtrated through a filter paved with silica gel, and the resultant filtrate was concentrated under reduced pressure. Thereafter, the concentrated product was recrystallized using heptane, and dried at 50°C under reduced pressure, to obtain a compound (E) (14.3 g) as a white solid at a yield of 93%. The compound (E) had an HPLC area percentage value of 99.5% or more.

An argon gas atmosphere was made in a reaction vessel, then, the compound (E) (13.6 g), 2-phenyl-4,4,5,5-tetramethyl-1,3,2-dioxaborolane (5.4 g) and toluene (136 mL) were added, and the mixture was stirred at room temperature. To this was added [(di(1-adamantyl)-N-butylphosphine)-2-(2'-amino-1,1'-biphenyl)]palladium (II)methanesulfonic acid salt (175 mg), and the mixture was heated at 80°C. Thereafter, a mixed solution of a 40% by mass tetrabutylammonium aqueous solution (38 g) and ion exchanged water (56 mL) was dropped, and the mixture was stirred at 80°C for 16 hours. Thereafter, the reaction vessel was cooled down to room temperature, and the reaction solution was liquid-separated. The resultant organic layer was washed with ion exchanged water. The washed solution was liquid-separated, and the resultant organic layer was washed with ion exchanged water. The washed solution was liquid-separated, the resultant organic layer was dried over magnesium sulfate, then, filtrated. To the filtrate was added silica gel (49 g), and the mixture was stirred at room temperature for 30 minutes, then, filtrated through a filter paved with Celite. The upper side of the filter was washed with a mixed solvent of chloroform and tetrahydrofuran. The resultant filtrate was concentrated under reduced pressure, then, recrystallized three times using a mixed solvent of heptane and 2-propanol (volume ratio 8:1), and dried at 50°C under reduced pressure, to obtain a compound (F) (12.2 g, white solid) at a yield of 90%. The compound (F) had an HPLC area percentage value of 99.5% or more.

The measurement results of LC-MS and NMR of the compound (F) were as described below.

LC-MS (APPI, positive): m/z = 562 $[M+H]^+$
$^1$H-NMR (400 MHz, $CDCl_3$) $\delta$ (ppm) = 7.82 (2H, t), 7.75 (1H, d), 7.63-7.60 (4H, m), 7.59-7.53 (3H, m), 7.49-7.43 (3H, m), 7.38-7.33 (3H, m), 7.26-7.22 (5H, m), 1.80-1.73 (4H, m), 1.56-1.40 (4H, m), 1.35-1.18 (7H, m), 0.82 (3H, t).

An argon gas atmosphere was made in a reaction vessel, then, trisacetylacetonatoiridium (2.2 g), the compound (F) (10 g) and pentadecane (40 mL) were added, and the mixture was stirred for 67 hours under reflux with heating. Thereafter, to this was added toluene, and the mixture was filtrated through a filter paved with silica gel, then, a yellow solution containing a compound P11 was extracted using a mixed solvent of toluene and ethyl acetate. The resultant solution was concentrated under reduced pressure to obtain a solid, then, the solid was purified by silica gel column chromatography (a mixed solvent of toluene and ethyl acetate), to obtain a solid. The solid was recrystallized using a mixed solvent of toluene and acetonitrile and recrystallized using a mixed solvent of toluene and ethanol multiple times, and dried at 50°C under reduced pressure, to obtain a compound P11 (3.5 g, yellow solid) at a yield of 82%. The compound P11 had an HPLC area percentage value of 99.5% or more.

The measurement results of LC-MS and NMR of the compound P11 were as described below.

LC-MS (APCI, positive): m/z = 1874.9 $[M+H]^+$
$^1$H-NMR (400 MHz, $CD_2Cl_2$) $\delta$ (ppm) = 7.93-7.68 (m, 9H), 7.65-7.28 (m, 27H), 7.21-7.04 (m, 15H), 7.00-6.71 (m, 6H),

6.40-6.25 (m, 3H), 2.33-1.82 (m, 9H), 1.80-1.54 (m, 3H), 1.48-0.80 (m, 33H), 0.79-0.32 (m, 9H).

<Synthesis Example P12> Synthesis of compound P12

A compound P12 was synthesized by the following method.

[Chemical Formula 160]

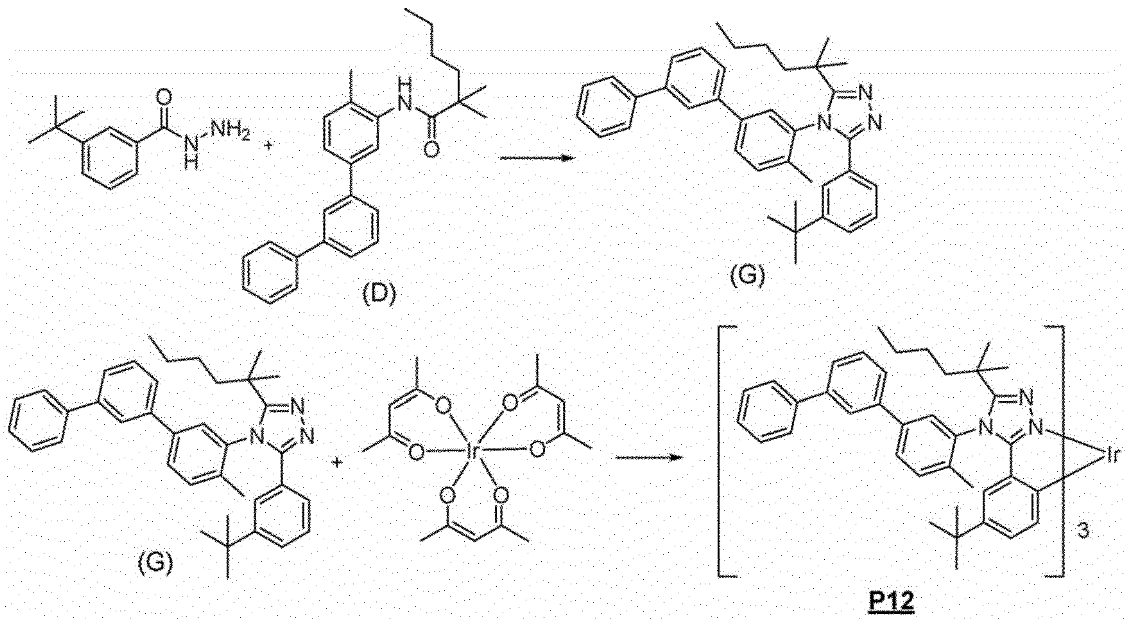

(D) (G)

(G) P12

An argon gas atmosphere was made in a reaction vessel, then, the compound (D) (40 g), monochlorobenzene (320 mL), 2-fluoropyridine (9.8 mL) and trifluoromethanesulfonic anhydride (19 mL) were added, and the mixture was stirred at room temperature for 30 minutes. To this was added 3-tert-butylbenzoyl hydrazine (22 g), and the mixture was stirred at 90°C for 3.5 hours. Thereafter, to this was added ion exchanged water (360 mL) and the organic layer was washed. After liquid separation, to the resultant organic layer was added a 1 mol/L sodium hydrogen carbonate aqueous solution (77 mL) and the organic layer was extracted, and the organic layer was washed with ion exchanged water. The resultant organic layer was concentrated under reduced pressure, to obtain an oil. To the oil was added a mixed solvent of chloroform and THF (volume ratio 8:2, 90 mL) for dissolution, then, the solution was filtrated through a filter paved with silica gel, and the resultant filtrate was concentrated under reduced pressure. Thereafter, the concentrated product was recrystallized using a mixed solvent of heptane and 2-propanol (volume ratio 5:0.3, 295 mL), and dried at 50°C under reduced pressure, to obtain a compound ( G) (47.6 g) as a white solid at a yield of 85%. The compound ( G) had an HPLC area percentage value of 99.9%.

The measurement results of NMR of the compound ( G) were as described below.

$^1$H-NMR (400 MHz, $CD_2Cl_2$) δ (ppm) = 7.79 (1H, t), 7.73 (1H, d), 7.68 (1H, dd), 7.65-7.58 (3H, m), 7.58-7.50 (2H, m), 7.48-7.40 (3H, m), 7.35 (1H, tt), 7.33-7.27 (2H, m), 7, 23-7.18 (2H, m), 1.80 (3H, s), 1.78-1.68 (1H, m), 1.53-1.41 (1H, m), 1.38 (3H, s), 1.35-1.18 (4H, m), 1.16 (3H, s), 1.06 (9H, s), 0.81 (3H, t).

TLC-MS (positive): m/z = 542.3 $[M+H]^+$

An argon gas atmosphere was made in a reaction vessel, then, trisacetylacetonatoiridium (1.5 g), the compound ( G) (6.8 g) and pentadecane (34 mL) were added, and the mixture was stirred for 30 hours under reflux with heating. Thereafter, to this was added toluene, and the mixture was filtrated through a filter paved with silica gel, and a yellow solution containing a compound P12 was extracted using a mixed solvent of toluene and ethyl acetate. The resultant solution was concentrated under reduced pressure to obtain a solid, then, the resultant solid was purified by silica gel column chromatography (a mixed solvent of toluene and ethyl acetate), to obtain a solid. The resultant solid was recrystallized using a mixed solvent of heptane and 2-propanol multiple times, and dried at 50°C under reduced pressure, to obtain a compound P12 (4.3 g, yellow solid) at a yield of 75%. The compound P12 had an HPLC area percentage value of 94%.

The measurement results of LC-MS and NMR of the compound P12 were as described below.

TLC-MS (positive): m/z = 1814.7 $[M+H]^+$
$^1$H-NMR (400 MHz, $CD_2Cl_2$) δ (ppm) = 7.89-7.28 (72H, m), 6.95-6.30 (6H, m), 6.02-6.20 (3H, m), 2.23-0.50 (45H, m).

<Synthesis Example P15> Synthesis of compound P15

A compound P15 was synthesized by the following method.

[Chemical Formula 161]

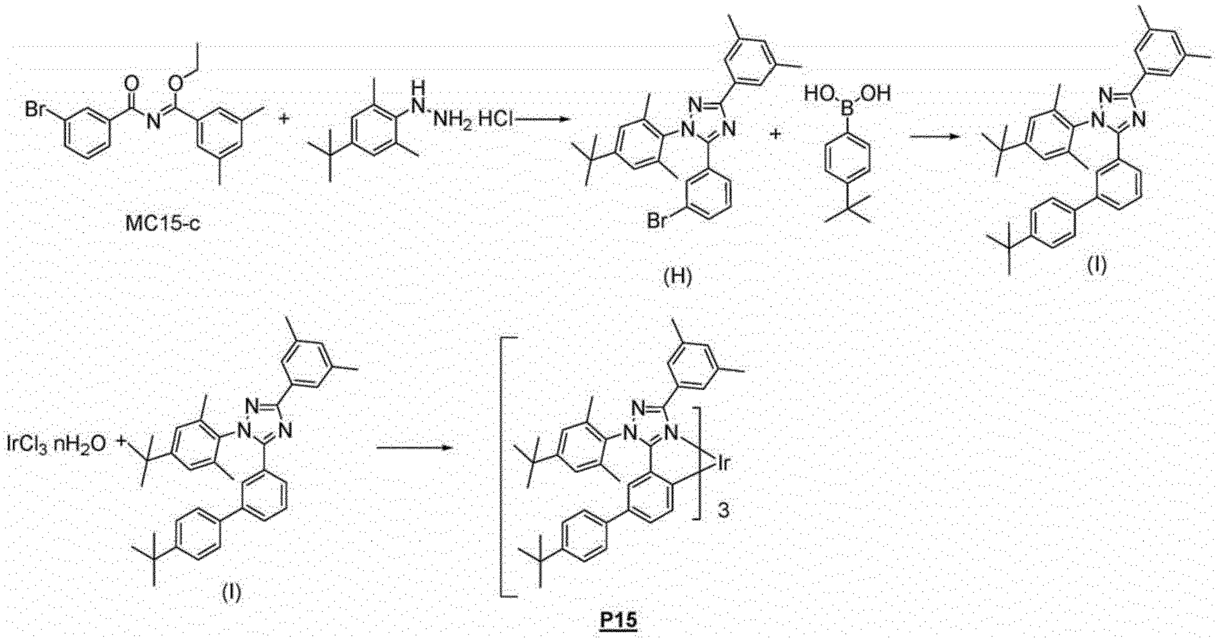


An argon gas atmosphere was made in a reaction vessel, then, 2,6-dimethyl-4-tert-butylphenylhydrazine hydrochloride (101 g) and tert-butylmethyl ether (1070 mL) were added, the reaction vessel was cooled by placing in an ice bath. Thereafter, to this was added a sodium hydroxide aqueous solution (1 mol/L, 1330 mL), and the mixture was stirred for 30 minutes while cooling the reaction vessel in the ice bath. The organic layer of the resultant reaction solution was extracted, to obtain a tert-butyl methyl ether solution as the organic layer.

An argon gas atmosphere was made in a separately prepared reaction vessel, then, the compound MC15-c (145 g) and chloroform (3200 mL) were added, and the reaction vessel was cooled by placing in an ice bath. Thereafter, to this was added the tert-butyl methyl ether solution obtained above. Thereafter, the reaction vessel was stirred for 7 hours while cooling in the ice bath, then, stirred at room temperature for 70 hours. To the resultant reaction solution was added ion exchanged water (3200 mL), and the organic layer was extracted, toluene (500 mL) was added, and the organic layer was partially concentrated under reduced pressure, to obtain a toluene solution. The toluene solution was purified by silica gel column chromatography (toluene solvent), recrystallized twice using a mixed solvent of ethanol and methanol (mass ratio 1:1), then, dried at 50°C under reduced pressure, to obtain a compound (H) (129 g, yield: 66%) as a white solid. The compound (H) had an HPLC area percentage value of 99.5% or more.

LC-MS (ESI, positive): m/z = 542.4 $[M+H]^+$
$^1$H-NMR ($CDCl_3$, 400 MHz): δ (ppm) = 7.90 (2H, s), 7.80 (1H, d), 7.58-7.55 (1H, m), 7.48 (1H, d), 7.38 (1H, t), 7.27-7.10 (3H, m), 2.35 (6H, s), 1.94 (6H, s), 1.34 (9H, s).

An argon gas atmosphere was made in a reaction vessel, then, the compound (H) (87 g), 4-tert-butylphenylboronic acid (35 g), bis(di-tert-butyl(4-dimethylaminophenyl)phosphine)dichloropalladium (II) (1.3 g), toluene (1500 mL) and 20% by mass tetrabutylammonium hydroxide aqueous solution (555 g) were added, and the mixture was stirred for 4 hours under reflux with heating. The solution was cooled down to room temperature, then, to this was added ion exchanged water, and the organic layer was extracted. The organic layer was washed with ion exchanged water, to obtain an organic layer. The organic layer was dried over anhydrous sodium sulfate, then, silica gel (170 g) was added and the mixture was filtrated, and the filtrate was concentrated under reduced pressure, to obtain a solid. The solid was recrystallized twice using a mixed solvent of ethyl acetate and acetonitrile (volume ratio 1:1), then, dried at 50°C under

reduced pressure, to obtain a compound (I) (73 g, yield: 76%) as a white solid. The compound (I) had an HPLC area percentage value of 99.5% or more.
LC-MS (ESI, positive): m/z = 486.3 $[M+H]^+$

An argon gas atmosphere was made in a reaction vessel, then, indium chloride n-hydrate (10.1 g), the compound (H) (32.3 g), ion exchanged water (81 mL) and diglyme (253 mL) were added, and the mixture was stirred with heating at 140°C for 48 hours. Thereafter, to this was added toluene, and the mixture was washed with ion exchanged water, to obtain an organic layer. The resultant organic layer was concentrated under reduced pressure, to obtain a solid. The resultant solid was purified by silica gel chromatography (a mixed solvent of toluene and ethanol). Thereafter, the solid was dried at 50°C under reduced pressure, to obtain a yellowish brown solid (38.0 g).

An argon gas atmosphere was made in a separately prepared reaction vessel, then, the solid (30.8 g) obtained above, silver trifluoromethanesulfonate (11.2 g), the compound (H) (19.7 g), diphenyl ether (76 mL) and 2,6-rutidine (16.9 mL) were added, and the mixture was stirred with heating at 165°C for 50 hours. Thereafter, the mixture was cooled down to room temperature, toluene was added, and the mixture was filtrated through a filter paved with Celite, to the resultant filtrate was added silica gel (228 g) and the mixture was filtrated, and the resultant filtrate was concentrated under reduced pressure, to obtain a yellow liquid. To the resultant liquid was added hexane (760 mL) and the mixture was stirred at 0°C for 1 hour, to obtain a precipitate. The precipitate was collected by filtration, and the resultant precipitate was recrystallized twice using a mixed solvent of toluene and heptane (volume ratio 3:10). Thereafter, the recrystallized precipitate was dried at 50°C under reduced pressure, to obtain a compound P15 (15.8 g, yield: 30%) as a yellow solid. The compound P15 had an HPLC area percentage value of 99.5% or more.

LC-MS (APCI, positive): m/z = 1815.0 $[M+H]^+$
$^1$H-NMR ($CD_2Cl_2$, 300 MHz): $\delta$ (ppm) = 8.03 (s, 6H), 7.35 (s, 6H), 7.31-7.26 (m, 6H), 7.11-7.03 (m, 6H), 6.98-6.90 (m, 6H), 6.62-6.57 (m, 3H), 6.52 (d, 3H), 2.11 (s, 18H), 1.97 (s, 9H), 1.68 (s, 9H), 1.46 (s, 27H), 1.33 (s, 27H).

<Synthesis Example F8> Synthesis of compound F8

A compound F8 was synthesized by the following method.

[Chemical Formula 162]

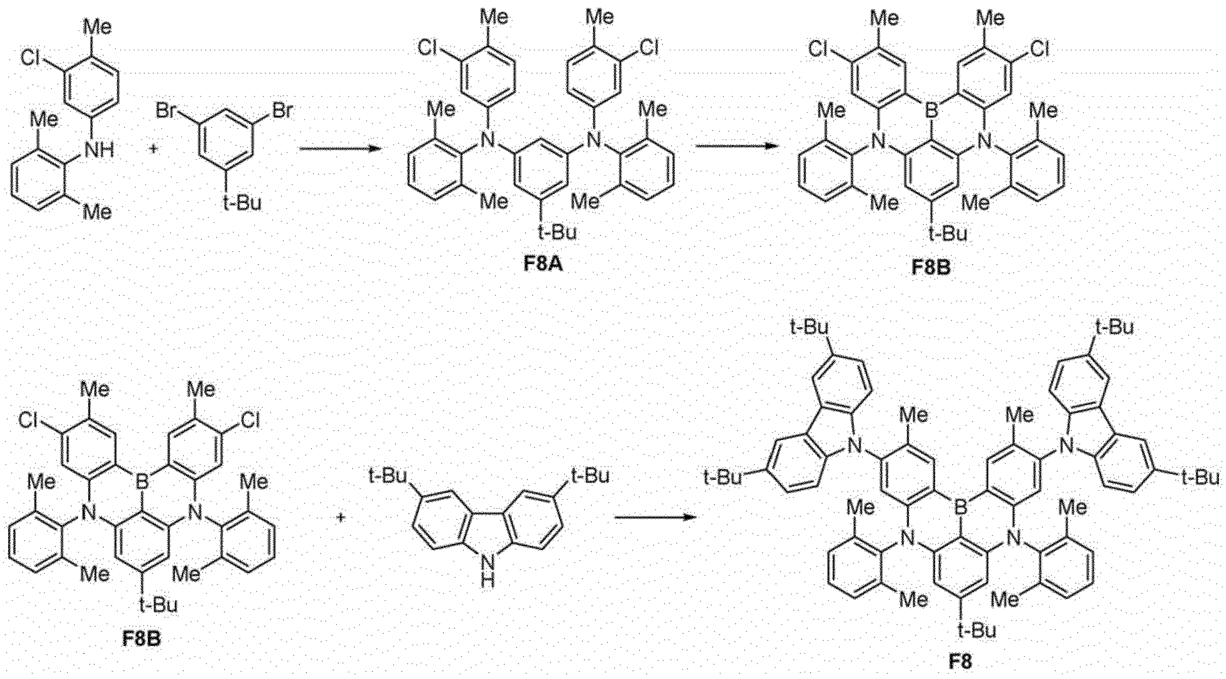

F8A F8B F8B F8

An argon gas atmosphere was made in a reaction vessel, then, N-(3-chloro-4-methylphenyl)-2,6-dimethylbenzeneamine (20.0 g), 1,3-dibromo-5-tert-butylbenzene (11.7 g), tris(dibenzylideneacetone)dipalladium (1.1 g), tri-tert-butylphosphonium tetrafluoroborate (0.72 g), sodium tert-butoxide (9.6 g) and toluene (500 mL) were added, and the mixture was stirred at 50°C for 4 hours. Thereafter, water (400 mL) was added, and the mixture was stirred at room temperature. The reaction solution was liquid-separated, and washed with ion exchanged water. The washed solution was

liquid-separated, the resultant organic layer was dried over magnesium sulfate, then, filtrated. The filtrate was concentrated under reduced pressure, then, to the resultant oil was added toluene for dissolution, then, the solution was filtrated through a filter paved with silica gel, and the resultant filtrate was concentrated under reduced pressure. Thereafter, the concentrated product was recrystallized twice using a mixed solvent of toluene, ethyl acetate and acetonitrile, and dried at 40°C under reduced pressure, to obtain a compound F8A (19.2 g, white solid) at a yield of 77%. The compound F8A had an LC area percentage value of 98.6%.

The measurement results of NMR of the compound F8A were as described below.

$^1$H-NMR (400 MHz, $CDCl_3$) $\delta$ (ppm) = 7.11-7.03 (m, 6H), 6.97 (d, 2H), 6.88 (d, 2H), 6.67 (dd, 2H), 6.51 (t, 1H), 6.42 (d, 2H), 2.34 (s, 6H), 1.92 (s, 12H), 1.07 (s, 9H).

An argon gas atmosphere was made in a reaction vessel, then, the compound F8A (5.5 g), boron triiodide (6.9 g) and 1,2-dichlorobenzene (66 mL) were added, and the mixture was stirred at 120°C for 75 hours. Thereafter, N,N-diisopropylethylamine (6.8 mL) and a 10% by mass sodium sulfite aqueous solution (23 mL) were added, and the mixture was stirred at room temperature. The reaction solution was liquid-separated, and washed with ion exchanged water. The washed solution was liquid-separated, the resultant organic layer was dried over magnesium sulfate, then, filtrated. The filtrate was concentrated under reduced pressure, then, the concentrated product was recrystallized once using a mixed solvent of toluene and acetonitrile, and dried at 40°C under reduced pressure, to obtain a compound F8B (2.0 g, yellow solid) at a yield of 40%. The compound F8B had an LC area percentage value of 96.9%. The foregoing steps were repeated, to obtain a necessary amount of the compound F8B.

The measurement results of NMR of the compound F8B were as described below.

$^1$H-NMR (400 MHz, $CDCl_3$) $\delta$ (ppm) = 8.74 (s, 2H), 7.41-7.29 (md, 6H), 6.68 (s, 2H), 6.05 (s, 2H), 2.56 (s, 6H), 1.90 (s, 12H), 0.98 (s, 9H).

An argon gas atmosphere was made in a reaction vessel, then, the compound F8B (8.0 g), 3,6-di-tert-butylcarbazole (7.1 g), tris(dibenzylideneacetone)dipalladium (0.45 g), 2-di-tert-butylphosphino-2',4',6'-triisopropylbiphenyl (0.66 g), a toluene solution (1 mol/L, 28 mL) of lithium(bistrimethylsilyl)amide, and xylene (76 mL) were added, and the mixture was stirred at 130°C for 6 hours. Thereafter, the solution was liquid-separated, and washed with ion exchanged water. The washed solution was liquid-separated, the resultant organic layer was dried over magnesium sulfate, then, filtrated. The filtrate was concentrated under reduced pressure, then, purified through a silica gel column using a mixed solvent of toluene and heptane. Thereafter, the purified product was recrystallized multiple times using a mixed solvent of toluene and acetonitrile, and dried at 40°C under reduced pressure, to obtain a compound F8 (4.0 g, yellow solid) at a yield of 28%. The compound F8 had an LC area percentage value of 97.0%.

The measurement results of NMR of the compound F8 were as described below.

$^1$H-NMR (400 MHz, $CDCl_3$) $\delta$ (ppm) = 9.09 (s, 2H), 8.13 (d, 4H), 7.42 (dd, 4H), 7.24 (d, 6H), 7.00 (d, 4H), 6.82 (s, 2H), 6.12 (s, 2H), 2.11 (s, 6H), 1.99 (s, 12H), 1.47 (s, 36H), 1.00 (s, 9H).

LC-MS (APCI, positive): m/z = 1115.7 $[M+H]^+$

<Synthesis Example F9> Synthesis of compound F9

A compound F9 was synthesized by the following method.

[Chemical Formula 163]

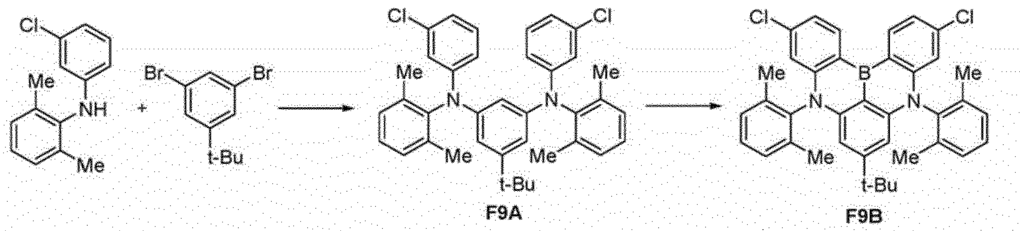

F9A F9B

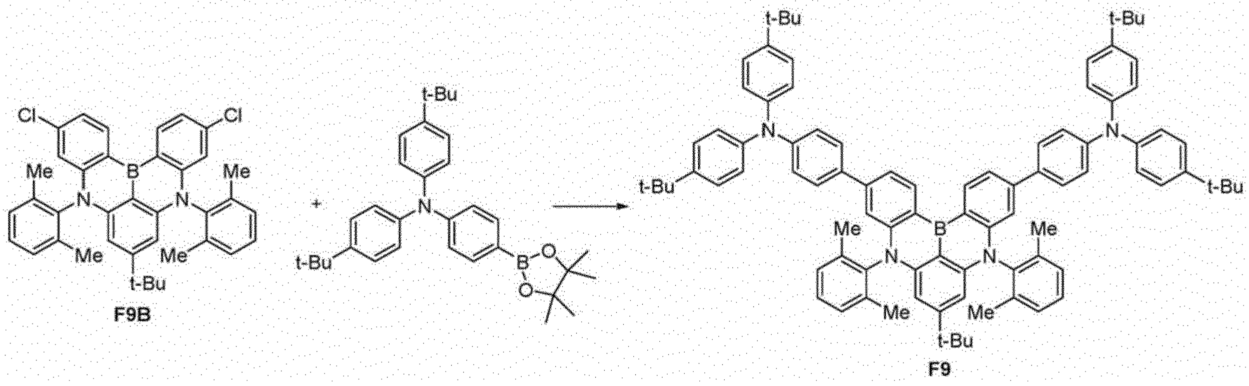

F9B F9

An argon gas atmosphere was made in a reaction vessel, then, N-(3-chlorophenyl)-2,6-dimethyl-benzeneamine (10.0 g), 1,3-dibromo-5-tert-butylbenzene (5.8 g), tris(dibenzylideneacetone)dipalladium (0.35 g), tri-tert-butylphosphonium tetrafluoroborate (0.34 g), sodium tert-butoxide (5.7 g) and toluene (250 mL) were added, and the mixture was stirred at 50°C for 5 hours. Thereafter, water (100 mL) was added, and the mixture was stirred at room temperature. The solution was liquid-separated, and washed with ion exchanged water. The resultant washed solution was liquid-separated, the resultant organic layer was dried over magnesium sulfate, then, filtrated. The resultant filtrate was concentrated under reduced pressure, then, purified through a silica gel column using a mixed solvent of toluene and heptane (volume ratio 1:9). Thereafter, the purified product was recrystallized once using a mixed solvent of toluene, ethyl acetate and methanol, and dried at 40°C under reduced pressure, to obtain a compound F9A (8.3 g, white solid) at a yield of 71%. The compound F9A had an LC area percentage value of 97.8%.

The measurement results of NMR of the compound F9A were as described below.

$^1$H-NMR (400 MHz, $CD_2Cl_2$) $\delta$ (ppm) = 7.14-7.02 (8H, m), 6.79 (2H, t), 6.73 (4H, td), 6.53 (1H, t), 6.50 (2H, d), 1.95 (12H, s), 1.05 (9H, s).

TLC-MS (positive): m/z = 593.2 $[M+H]^+$

An argon gas atmosphere was made in a reaction vessel, then, the compound F9A (2.0 g), boron triiodide (2.6 g) and 1,2-dichlorobenzene (40 mL) were added, and the mixture was stirred at 120°C for 90 hours. Thereafter, N,N-diisopropylethylamine (8.9 g) and a 10% by mass sodium sulfite aqueous solution (20 mL) was added, and the mixture was stirred at room temperature. The solution was liquid-separated, and washed with ion exchanged water. The resultant washed solution was liquid-separated, the resultant organic layer was dried over magnesium sulfate, then, filtrated. The resultant filtrate was concentrated under reduced pressure, then, the concentrated product was recrystallized once using a mixed solvent of toluene and acetonitrile, and dried at 40°C under reduced pressure, to obtain a compound F9B (0.76 g, yellow solid) at a yield of 30%. The compound F9B had an LC area percentage value of 97.6%.

The measurement results of NMR of the compound F9B were as described below.

$^1$H-NMR (400 MHz, $CD_2Cl_2$) $\delta$ (ppm) = 8.81 (2H, d), 7.43-7.32 (6H, m), 7.20 (2H, dd), 6.65 (2H, d), 6.12 (2H, s), 1.88 (12H, s), 0.95 (9H, s).

TLC-MS (positive): m/z = 601.2 $[M+H]^+$

An argon gas atmosphere was made in a reaction vessel, then, the compound F9B (0.10 g), 4-(1,1-dimethylethyl)-N-[4-(1,1-dimethylethyl)phenyl]-N-[4-(4,4,5,5-tetramethyl-1,3,2-dioxaborolane-2-yl)phenyl]-benzeneamine (0.18 g), [(di(1-adamantyl)-N-butylphosphine)-2-(2'-amino-1,1'-biphenyl)]palladium (II)methanesulfonic acid salt (4.8 mg), a 5% by mass sodium carbonate aqueous solution (13 mL) and toluene (10 mL) were added, and the mixture was stirred at 80°C for 5 hours. Thereafter, the solution was liquid-separated, and washed with ion exchanged water. The resultant washed solution was liquid-separated, the resultant organic layer was dried over magnesium sulfate, then, filtrated. The resultant filtrate was concentrated under reduced pressure, then, purified through a silica gel column using a mixed solvent

of toluene and heptane. Thereafter, the purified product was recrystallized once using a mixed solvent of toluene and acetonitrile, and dried at 40°C under reduced pressure, to obtain a compound F9 (0.19 g, yellow solid) at a yield of 83%. The compound F9 had an LC area percentage value of 99.9%.

The measurement results of NMR of the compound F9 were as described below.

$^1$H-NMR (400 MHz, $CD_2Cl_2$) δ (ppm) = 9.01 (2H, d), 7.48 (2H, d), 7.42-7.30 (10H, m), 7.28 (8H, d), 7.03-6.95 (12H, m), 6.85 (2H, d), 6.12 (2H, s), 1.92 (12H, s), 1.29 (36H, s), 0.98 (9H, s).
TLC-MS (positive): m/z = 1243.5 $[M+H]^+$

<Synthesis Example F10> Synthesis of compound F10

A compound F10 was synthesized by the following method.

[Chemical Formula 164]

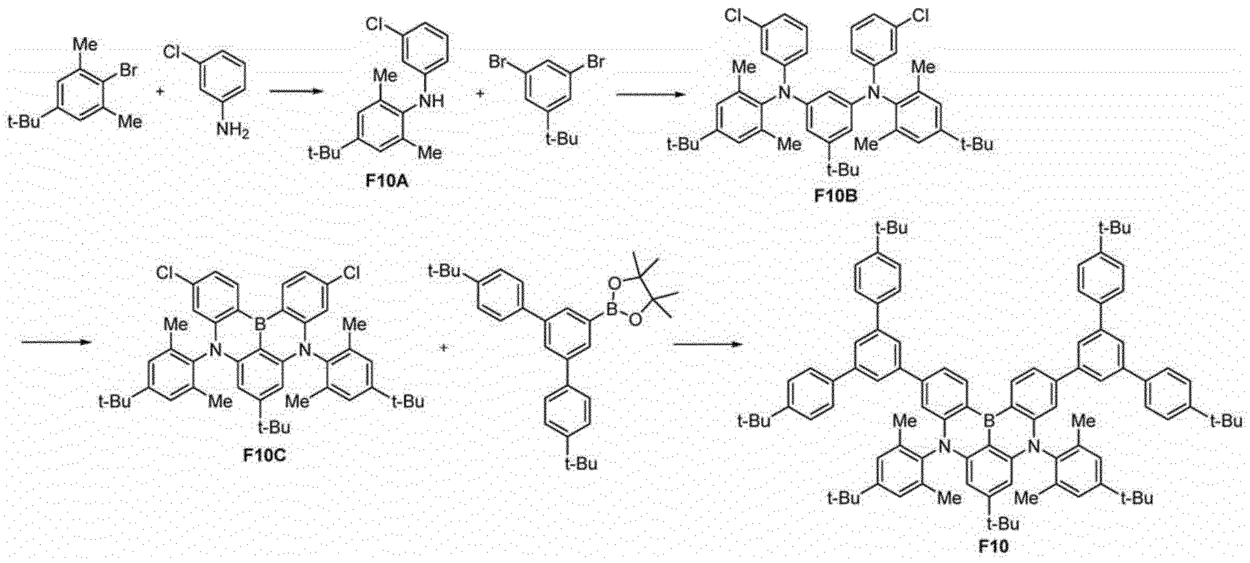

F10A F10B F10C F10

An argon gas atmosphere was made in a reaction vessel, then, 2-bromo-5-tert-butyl-1,3-dimethylbenzene (5.0 g), 3-chloroaniline (3.2 g), tris(dibenzylideneacetone)dipalladium (0.10 g), tri-tert-butylphosphonium tetrafluoroborate (0.10 g), sodium tert-butoxide (4.0 g) and toluene (90 mL) were added, and the mixture was stirred at 50°C for 5 hours. Thereafter, water (10 mL) was added, and the mixture was stirred at room temperature. The solution was liquid-separated, and washed with ion exchanged water. The resultant washed solution was liquid-separated, the resultant organic layer was dried over magnesium sulfate, then, filtrated. The resultant filtrate was concentrated under reduced pressure, then, purified through a silica gel column using a mixed solvent of toluene and heptane (volume ratio 2:8). Thereafter, the purified product was recrystallized once using methanol, and dried at 40°C under reduced pressure, to obtain a compound F10A (3.8 g, white solid) at a yield of 64%. The compound F10A had a GC area percentage value of 99.7%.

The measurement results of NMR of the compound F10A were as described below.

$^1$H-NMR (400 MHz, $CD_2Cl_2$) δ (ppm) = 7.12-7.07 (3H, m), 7.04 (1H, t), 6.69 (1H, t), 6.82 (1H, d), 6.77 (1H, d), 6.44 (1H, d), 6.17 (1H, d), 6.10 (1H, t), 5.70 (1H, broad-s), 5.19 (1H, broad-s), 2.19 (6H, s), 1.29 (9H, s).
TLC-MS (positive): m/z = 288.1 $[M+H]^+$

An argon gas atmosphere was made in a reaction vessel, then, the compound F10A (3.7 g), 1,3-dibromo-5-tert-butylbenzene (1.9 g), tris(dibenzylideneacetone)dipalladium (0.11 g), tri-tert-butylphosphonium tetrafluoroborate (0.11 g), sodium tert-butoxide (1.8 g) and toluene (44 mL) were added, and the mixture was stirred at 50°C for 5 hours. Thereafter, water (20 mL) was added, and the mixture was stirred at room temperature. The solution was liquid-separated, and washed with ion exchanged water. The washed solution was liquid-separated, the resultant organic layer was dried over magnesium sulfate, then, filtrated. The filtrate was concentrated under reduced pressure, then, the concentrated product was purified through a silica gel column using a mixed solvent of toluene and heptane (volume ratio 1:9). Thereafter, the purified product was recrystallized once using a mixed solvent of toluene, ethyl acetate and acetonitrile,

and dried at 40°C under reduced pressure, to obtain a compound F10B (2.5 g, white solid) at a yield of 55%. The compound F10B had an LC area percentage value of 97.7%.

The measurement results of NMR of the compound F10B were as described below.

$^1$H-NMR (400 MHz, $CD_2Cl_2$) δ (ppm) = 7.06 (4H, s), 7.02 (2H, t), 6.78 (2H, t), 6.73-6.68 (4H, m), 6.58 (2H, d), 6.36 (1H, t), 1.92 (12H, s), 1.30 (18H, s), 1.08 (9H, s).
TLC-MS (positive): m/z = 705.3 $[M+H]^+$

An argon gas atmosphere was made in a reaction vessel, then, the compound F10B (2.0 g), boron triiodide (2.2 g) and 1,2-dichlorobenzene (40 mL) were added, and the mixture was stirred at 120°C for 90 hours. Thereafter, N,N-diisopropylethylamine (7.5 g) and a 10% by mass sodium sulfite aqueous solution (20 mL) were added, and the mixture was stirred at room temperature. The reaction solution was liquid-separated, and washed with ion exchanged water. The washed solution was liquid-separated, the resultant organic layer was dried over magnesium sulfate, then, filtrated. The filtrate was concentrated under reduced pressure, then, the concentrated product was recrystallized once using a mixed solvent of toluene and acetonitrile, and dried at 40°C under reduced pressure, to obtain a compound F10C(1.1 g, yellow solid) at a yield of 50%. The compound F10C had an LC area percentage value of 92.0%.

The measurement results of NMR of the compound F10C were as described below.

$^1$H-NMR (400 MHz, $CD_2Cl_2$) δ (ppm) = 8.80 (2H, d), 7.36 (4H, s), 7.19 (2H, dd), 6.72 (2H, d), 6.07 (2H, s), 1.85 (12H, s), 1.41 (18H, s), 0.94 (9H, s).
TLC-MS (positive): m/z = 713.3 $[M+H]^+$

An argon gas atmosphere was made in a reaction vessel, then, the compound F10C(0.30 g), 2-[4,4''-bis(1,1-dimethylethyl)[1,1':3',1"-terphenyl]-5"-yl]-4,4,5,5-tetramethyl-1,3,2-dioxaborolane (0.43 g), [(di(1-adamantyl)-N-butylphosphine)-2-(2'-amino-1,1'-biphenyl)]palladium (II)methanesulfonic acid salt (12 mg), a 5% by mass sodium carbonate aqueous solution (15 mL) and toluene (15 mL) were added, and the mixture was stirred at 80°C for 5 hours. Thereafter, the solution was liquid-separated, and washed with ion exchanged water. The washed solution was liquid-separated, the resultant organic layer was dried over magnesium sulfate, then, filtrated. The filtrate was concentrated under reduced pressure, then, purified through a silica gel column using a mixed solvent of toluene and heptane. Thereafter, the purified product was recrystallized once using a mixed solvent of toluene and acetonitrile, and dried at 40°C under reduced pressure, to obtain a compound F10 (0.34 g, yellow solid) at a yield of 61%. The compound F10 had an LC area percentage value of 99.7%.

The measurement results of NMR of the compound F10 were as described below.

$^1$H-NMR (400 MHz, $CD_2Cl_2$) δ (ppm) = 9.11 (2H, d), 7.75 (2H, t), 7.70 (4H, d), 7.66 (2H, dd), 7.57 (8H, d), 7.48 (8H, d), 7.40 (4H, s), 7.06 (2H, d), 6.26 (2H, s), 1.94 (12H, s), 1.41 (18H, s), 1.36 (36H, s), 1.12 (9H, s).
TLC-MS (positive): m/z = 1324.6 $[M+H]^+$

<Quantum chemical calculation of $|S_P|$ and $|T_P|$ of compounds P1 to P15 and $|S_F|$ and $|T_F|$ of compounds F1 to F11>

The calculation results of $|S_P|$ and $|T_P|$ of compounds P1 to P15 and $|S_F|$ and $|T_F|$ of compounds F1 to F11 are shown in Table 1.

[Table 1]

| Compound | $\|S_P\|$ [eV] | $\|T_P\|$ [eV] | Compound | $\|S_F\|$ [eV] | $\|T_F\|$ [eV] |
|---|---|---|---|---|---|
| P1 | 3.10 | 2.73 | F1 | 3.13 | 2.64 |
| P2 | 3.05 | 2.89 | F2 | 2.96 | 2.53 |
| P3 | 3.31 | 2.97 | F3 | 3.05 | 2.59 |
| P4 | 2.92 | 2.89 | F4 | 3.17 | 2.70 |
| P5 | 2.97 | 2.89 | F5 | 2.99 | 2.56 |
| P6 | 2.90 | 2.64 | F6 | 2.77 | 1.71 |
| P7 | 2.71 | 2.12 | F7 | 2.71 | 2.00 |
| P8 | 2.90 | 2.63 | | | |
| P9 | 2.86 | 2.58 | | | |
| P10 | 3.27 | 2.87 | F8 | 2.97 | 2.51 |
| P11 | 3.03 | 2.82 | F9 | 2.88 | 2.50 |

(continued)

| Compound | $\|S_P\|$ [eV] | $\|T_P\|$ [eV] | Compound | $\|S_F\|$ [eV] | $\|T_F\|$ [eV] |
|---|---|---|---|---|---|
| P12 | 2.90 | 2.83 | F10 | 2.91 | 2.50 |
| P13 | 3.29 | 2.90 | F11 | 2.69 | 2.37 |
| P14 | 3.29 | 2.83 | | | |
| P15 | 3.28 | 2.85 | | | |

<Measurement of various maximum peak wavelengths of compounds P1 to P15, compounds F1 to F11 and polymer compounds PF1 to PF2>

$\lambda_{PL,RT}$ and FWHM of compounds P1 to P15, compounds F1 to F11 and polymer compounds PF1 to PF2, $\lambda_{ABS,RT}$ of compounds F1 to F7, and, $\lambda_{PL,77K}$ of compounds P3, P5, P11, polymer compounds PF1 and PF2 are shown in Table 2.

[Table 2]

| Compound | $\lambda_{ABS,RT}$ [nm] | $\lambda_{PL,RT}$ [nm] | FWHM [nm] | $\lambda_{PL,77K}$ [nm] |
|---|---|---|---|---|
| F1 | 439 | 452 | 21.6 | |
| F2 | 451 | 465 | 21.4 | |
| F3 | 441 | 454 | 21.2 | |
| F4 | 427 | 440 | 19.1 | |
| F5 | 454 | 465 | 18.3 | |
| F6 | 488 | 568 | 70.2 | |
| F7 | 512 | 522 | 21.8 | |
| P1 | | 470 | 47.4 | |
| P2 | | 471 | 51.0 | |
| P3 | | 450 | 49.9 | 443 |
| P4 | | 450 | 56.9 | |
| P5 | | 465 | 55.1 | 455 |
| P6 | | 510 | 59.7 | |
| P7 | | 614 | 32.0 | |
| P8 | | 508 | 55.8 | |
| P9 | | 513 | 54.7 | |
| F8 | 456 | 469 | 19.1 | |
| F9 | 456 | 471 | 19.7 | |
| F10 | 461 | 477 | 21.4 | |
| F11 | 484 | 514 | 38.2 | |
| PF1 | | 468 | 23.2 | 509 |
| PF2 | | 451 | 24.0 | 483 |
| P10 | | 469 | 50.8 | |
| P11 | | 475 | 54.5 | 467 |
| P12 | | 471 | 61.2 | |
| P13 | | 470 | 54.1 | |
| P14 | | 469 | 47.4 | |
| P15 | | 472 | 55.2 | |

<Synthesis Example MX> Synthesis of compounds M1 to M6

A compound M1 was synthesized with reference to a method described in International Publication No. WO 2015/145871.

A compound M2 was synthesized with reference to a method described in International Publication No. WO 2013/146806.

A compound M3 was synthesized with reference to a method described in International Publication No. WO 2005/049546.

A compound M4 was synthesized with reference to a method described in JP-A No. 2010-189630.

A compound M5 was synthesized with reference to a method described in International Publication No. WO 2012/086671.

A compound M6 was synthesized with reference to a method described in JP-A No. 2012-036388.

[Chemical Formula 165]

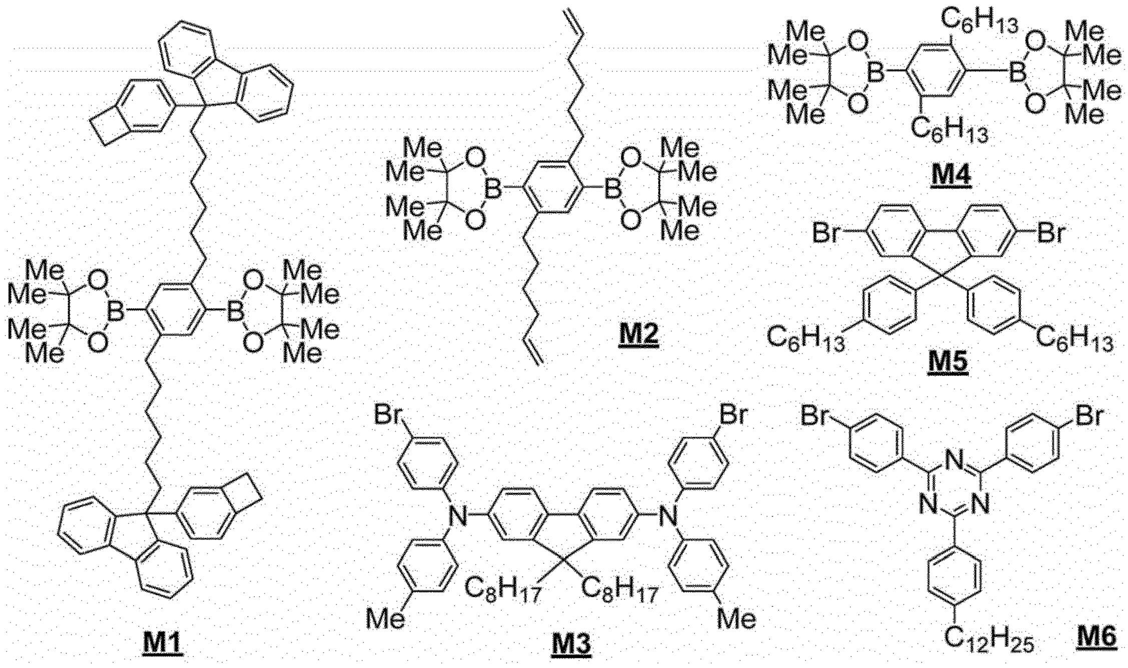

M1 M2 M3 M4 M5 M6

<Synthesis Example MY> Synthesis of compounds M7 to M9

A compound M7 was synthesized with reference to a method described in International Publication No. WO 2013/191088.

Compounds M8 and M9 were synthesized with reference to a method described in International Publication No. WO 2019/004248.

[Chemical Formula 166]

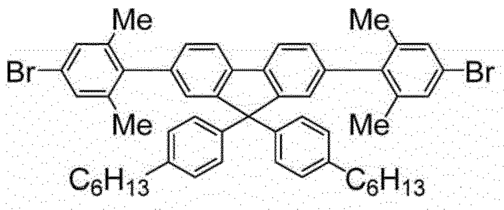

**M7**

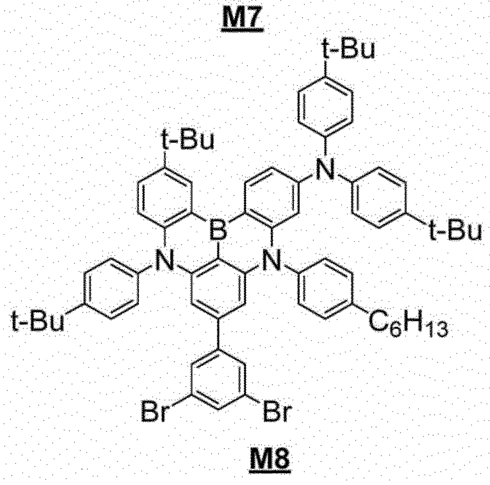

**M8**

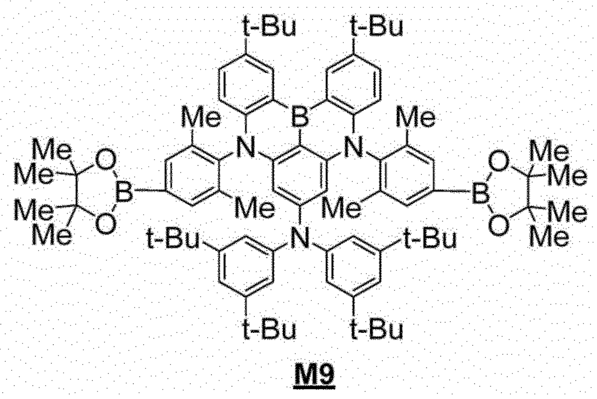

**M9**

<Synthesis Example HTL-1> Synthesis of polymer compound HTL-1

The polymer compound HTL-1 was synthesized according to a method described in International Publication No. WO 2015/145871 using the compound M1, the compound M2 and the compound M3. The polymer compound HTL-1 had an Mn of $2.3\times10^4$ and an Mw of $1.2\times10^5$.

The polymer compound HTL-1 is a copolymer having a constitutional unit derived from the compound M1, a constitutional unit derived from the compound M2, and a constitutional unit derived from the compound M3 at a molar ratio of 45:5:50, according to the theoretical values calculate from the amounts of the charged raw materials.

<Synthesis Example HP-1> Synthesis of polymer compound HP-1

The polymer compound HP-1 was synthesized according to a method described in JP-A No. 2012-36388, using the compound M4, the compound M5 and the compound M6. The polymer compound HP-1 had an Mn of $9.6\times10^4$ and an Mw of $2.2\times10^5$.

The polymer compound HP-1 is a copolymer constituted of a constitutional unit derived from the compound M4, a constitutional unit derived from the compound M5, and a constitutional unit derived from the compound M6 at a molar ratio of 50:40:10, according to the theoretical values calculate from the amounts of the charged raw materials.

<Synthesis Example PF1> Synthesis of polymer compound PF1

(Step 1) An inert gas atmosphere was made in a reaction vessel, then, the above-described compound M4 (0.3444 g), the above-described compound M7 (0.5762 g), the above-described compound M8 (0.0851 g), dichlorobis(tris-o-methoxyphenylphosphine)palladium (0.27 mg) and toluene (30 mL) were added, and the mixture was heated at 80°C.

(Step 2) Thereafter, a 20% by mass tetraethylammonium hydroxide aqueous solution (16.0 g) was dropped into this, and the mixture was refluxed for 6 hours.

(Step 3) Thereafter, phenylboronic acid (45.7 mg) and dichlorobis(tris-o-methoxyphenylphosphine)palladium (0.27 mg) were added to this, and the mixture was stirred at 80°C for 3 hours.

(Step 4) The reaction mixture was cooled, then, a sodium diethyldithiacarbamate aqueous solution was added, and the mixture was stirred at 40°C for 1 hour. The reaction solution was cooled, and the aqueous layer was removed, then, the resultant organic layer was washed with 3% by mass ammonia water twice, and with water twice. The resultant solution was dropped into methanol, and the mixture was stirred, to cause generation of a precipitate. The precipitate was dissolved

in toluene (44 mL), alumina (26 g) was added and the mixture was stirred for 3 hours, then, the resultant suspension was purified by passing through a silica gel column. The resultant solution was dropped into methanol and the mixture was stirred, to cause generation of a precipitate. The precipitate was collected by filtration, and dried, to obtain 0.51 g of a polymer compound PF1. The polymer compound PF1 had an Mn of $6.2\times10^4$ and an Mw of $1.5\times10^5$

The polymer compound PF1 is a copolymer constituted of a constitutional unit derived from the compound M4, a constitutional unit derived from the compound M7, and a constitutional unit derived from the compound M8 at a molar ratio of 50:45:5, according to the theoretical values calculate from the amounts of the charged raw materials.

<Synthesis Example PF2> Synthesis of polymer compound PF2

(Step 1) An inert gas atmosphere was made in a reaction vessel, then, the above-described compound M4 (0.3070 g), the above-described compound M7 (0.6403 g), the above-described compound M9 (0.0927 g), dichlorobis(tris-o-methoxyphenylphosphine)palladium (0.27 mg) and toluene (31 mL) were added, and the mixture was heated at 80°C.

(Step 2) Thereafter, a 20% by mass tetraethylammonium hydroxide aqueous solution (15.7 g) was dropped into this, and the mixture was refluxed for 6 hours.

(Step 3) Thereafter, phenylboronic acid (45.7 mg) and dichlorobis(tris-o-methoxyphenylphosphine)palladium (0.27 mg) were added to this, and the mixture was stirred at 80°C for 3 hours.

(Step 4) The reaction mixture was cooled, then, a sodium diethyldithiacarbamate aqueous solution was added, and the mixture was stirred at 40°C for 1 hour. The reaction solution was cooled, and the aqueous layer was removed, then, the resultant organic layer washed with 3% by mass ammonia water twice, and with water twice. The resultant solution was dropped into methanol and the mixture was stirred, to cause generation of a precipitate. The precipitate was dissolved in toluene (44 mL), alumina (27 g) was added and the mixture was stirred for 3 hours, then, the resultant suspension was purified by passing through a silica gel column. The resultant solution was dropped into methanol and the mixture was stirred, to cause generation of a precipitate. The precipitate was collected by filtration, and dried, to obtain 0.52 g of a polymer compound PF2. The polymer compound PF2 had an Mn of $6.3\times10^4$ and an Mw of $1.5\times10^5$.

The polymer compound PF2 is a copolymer constituted of a constitutional unit derived from the compound M4, a constitutional unit derived from the compound M7, and a constitutional unit derived from the compound M9 at a molar ratio of 45:50:5, according to the theoretical values calculate from the amounts of the charged raw materials.

<Comparative Example BCD1> Fabrication and evaluation of light emitting device BCD1

(Formation of anode and hole injection layer)

An ITO film with a thickness of 45 nm was attached to a glass substrate by a sputtering method, to form an anode. On the anode, a hole injection material (product name: ND-3202, manufactured by Nissan Chemical Corporation) was spin-coated, to form a film with a thickness of 35 nm. The substrate carrying the hole injection layer laminated thereon was placed under an air atmosphere, and heated on a hot plate at 50°C for 3 minutes, and further heated at 230°C for 15 minutes, to form a hole injection layer.

(Formation of hole transporting layer)

The polymer compound HTL-1 was dissolved in xylene at a concentration of 0.6% by mass. The resultant xylene solution was spin-coated on the hole injection layer to form a film with a thickness of 20 nm, which was then heated on a hot plate at 180°C for 60 minutes under a nitrogen gas atmosphere, to form a hole transporting layer.

(Formation of light emitting layer)

The compound H1, the compound P1 and the compound F1 (compound H1/compound P1/compound F1 = 73% by mass/25% by mass/2% by mass) were dissolved at a concentration of 2% by mass in chlorobenzene. The resultant chlorobenzene solution was spin-coated on the hole transporting layer to form a film with a thickness of 60 nm, which was then heated at 130°C for 10 minutes under a nitrogen gas atmosphere, to form a light emitting layer.

(Formation of electron transporting layer)

The compound E1 was dissolved at a concentration of 0.4% by mass in 2,2,3,3,4,4,5,5-octafluoro-1-pentanol. The resultant 2,2,3,3,4,4,5,5-octafluoro-1-pentanol solution was spin-coated on the hole transporting layer to form a film with a thickness of 20 nm, which was then heated at 130°C for 10 minutes under a nitrogen gas atmosphere, to form an

electron transporting layer.

(Formation of cathode)

The substrate carrying the electron transporting layer formed thereon was placed in a vapor deposition machine, and the inner pressure thereof was reduced down to $1.0\times10^{-4}$ Pa or less, then, sodium fluoride was vapor-deposited with a thickness of about 4 nm on the electron transporting layer, then, aluminum was vapor-deposited with a thickness of about 80 nm on the sodium fluoride layer, as cathodes. After vapor deposition, the substrate carrying the cathode formed thereon was sealed with a glass substrate, to fabricate a light emitting device BCD1.

(Evaluation of light emitting device)

Voltage was applied to the light emitting device BCD1, to observe EL light emission. The light emitting device was evaluated every 0.2 V in the range of voltage from -5 V to 12 V, and at 5000 cd/$m^2$, the external quantum efficiency (hereinafter, referred to also as "EQE") was 4.5%, and the CIE chromaticity coordinate (x, y) was (0.149, 0.301). The results are shown in Table 3.

<Comparative Example BCD2> Fabrication and evaluation of light emitting device BCD2

A light emitting device BCD2 was fabricated in the same manner as in Co mParative Example BCD1 except that the compound H1, the compound P1 and the compound F2 (compound H1/compound P1/compound F2 = 73% by mass/25% by mass/2% by mass) were used instead of "the compound H1, the compound P1 and the compound F1 (compound H1/compound P1/compound F1 = 73% by mass/25% by mass/2% by mass)" in (Formation of light emitting layer) of Co mParative Example BCD1.

Voltage was applied to the light emitting device BCD2, to observe EL light emission. At 5000 cd/$m^2$, EQE was 4.6%, and the CIE chromaticity coordinate (x, y) was (0.132, 0.248). The results are shown in Table 3.

<Comparative Example BCD3> Fabrication and evaluation of light emitting device BCD3

A light emitting device BCD3 was fabricated in the same manner as in Co mParative Example BCD1 except that the compound H1, the compound P2 and the compound F1 (compound H1/compound P2/compound F1 = 73% by mass/25% by mass/2% by mass) were used instead of "the compound H1, the compound P1 and the compound F1 (compound H1/compound P1/compound F1 = 73% by mass/25% by mass/2% by mass)" in (Formation of light emitting layer) of Co mParative Example BCD1.

Voltage was applied to the light emitting device BCD3, to observe EL light emission. At 5000 cd/$m^2$, EQE was 5.6%, and the CIE chromaticity coordinate (x, y) was (0.175, 0.357). The results are shown in Table 3.

<Comparative Example BCD4> Fabrication and evaluation of light emitting device BCD4

A light emitting device BCD4 was fabricated in the same manner as in Co mParative Example BCD1 except that the compound H1, the compound P3 and the compound F1 (compound H1/compound P3/compound F1 = 73% by mass/25% by mass/2% by mass) were used instead of "the compound H1, the compound P1 and the compound F1 (compound H1/compound P1/compound F1 = 73% by mass/25% by mass/2% by mass)" in (Formation of light emitting layer) of Co mParative Example BCD1.

Voltage was applied to the light emitting device BCD4, to observe EL light emission. At 5000 cd/$m^2$, EQE was 7.3%, and the CIE chromaticity coordinate (x, y) was (0.139, 0.110). The results are shown in Table 3.

<Example BD1> Fabrication and evaluation of light emitting device BD1

A light emitting device BD1 was fabricated in the same manner as in Co mParative Example BCD1 except that the compound H1, the compound P3 and the compound F2 (compound H1/compound P3/compound F2 = 73% by mass/25% by mass/2% by mass) were used instead of "the compound H1, the compound P1 and the compound F1 (compound H1/compound P1/compound F1 = 73% by mass/25% by mass/2% by mass)" in (Formation of light emitting layer) of Co mParative Example BCD1.

Voltage was applied to the light emitting device BD1, to observe EL light emission. At 5000 cd/$m^2$, EQE was 12.6%, and the CIE chromaticity coordinate (x, y) was (0.121, 0.153). The results are shown in Table 3. The half-value width of the light emission spectrum of the light emitting device BD1 at 5000 cd/$m^2$ was 28.6 nm.

<Example BD2> Fabrication and evaluation of light emitting device BD2

A light emitting device BD2 was fabricated in the same manner as in Example BD1 except that the compound H1, the compound P4 and the compound F2 (compound H1/compound P4/compound F2 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD2, to observe EL light emission. At 5000 cd/$m^2$, EQE was 10.1%, and the CIE chromaticity coordinate (x, y) was (0.121, 0.151). The results are shown in Table 3. The half-value width of the light emission spectrum of the light emitting device BD2 at 5000 cd/$m^2$ was 28.7 nm.

<Example BD3> Fabrication and evaluation of light emitting device BD3

A light emitting device BD3 was fabricated in the same manner as in Example BD1 except that the compound H1, the compound P5 and the compound F2 (compound H1/compound P5/compound F2 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD3, to observe EL light emission. At 5000 cd/$m^2$, EQE was 11.9%, and the CIE chromaticity coordinate (x, y) was (0.134, 0.212). The results are shown in Table 3. The half-value width of the light emission spectrum of the light emitting device BD3 at 5000 cd/$m^2$ was 31.3 nm.

<Example BD4> Fabrication and evaluation of light emitting device BD4

A light emitting device BD4 was fabricated in the same manner as in Example BD1 except that the compound H1, the compound P3 and the compound F3 (compound H1/compound P3/compound F3 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD4, to observe EL light emission. At 5000 cd/$m^2$, EQE was 9.5%, and the CIE chromaticity coordinate (x, y) was (0.138, 0.101). The results are shown in Table 3.

<Example BD5> Fabrication and evaluation of light emitting device BD5

A light emitting device BD5 was fabricated in the same manner as in Example BD1 except that the compound H1, the compound P5 and the compound F3 (compound H1/compound P5/compound F3 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD5, to observe EL light emission. At 5000 cd/$m^2$, EQE was 11.8%, and the CIE chromaticity coordinate (x, y) was (0.158, 0.247). The results are shown in Table 3.

<Example BD6> Fabrication and evaluation of light emitting device BD6

A light emitting device BD6 was fabricated in the same manner as in Example BD1 except that the compound H1, the compound P5 and the compound F4 (compound H1/compound P5/compound F4 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD6, to observe EL light emission. At 5000 cd/$m^2$, EQE was 11.3%, and the CIE chromaticity coordinate (x, y) was (0.169, 0.327). The results are shown in Table 3.

<Example BD7> Fabrication and evaluation of light emitting device BD7

A light emitting device BD7 was fabricated in the same manner as in Example BD1 except that the compound H1, the compound P3 and the compound F5 (compound H1/compound P3/compound F5 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD7, to observe EL light emission. At 5000 cd/$m^2$, EQE was 13.4%, and the CIE chromaticity coordinate (x, y) was (0.122, 0.136). The results are shown in Table 3. The half-value width of the light emission spectrum of the light emitting device BD7 at 5000 cd/$m^2$ was 25.0 nm.

<Example BD8> Fabrication and evaluation of light emitting device BD8

A light emitting device BD8 was fabricated in the same manner as in Example BD1 except that the compound H1, the compound P4 and the compound F5 (compound H1/compound P4/compound F5 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.
Voltage was applied to the light emitting device BD8, to observe EL light emission. At 5000 cd/m$^2$, EQE was 10.0%, and the CIE chromaticity coordinate (x, y) was (0.122, 0.134). The results are shown in Table 3. The half-value width of the light emission spectrum of the light emitting device BD8 at 5000 cd/m$^2$ was 24.8 nm.

<Example BD9> Fabrication and evaluation of light emitting device BD9

A light emitting device BD9 was fabricated in the same manner as in Example BD1 except that the compound H1, the compound P5 and the compound F5 (compound H1/compound P5/compound F5 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.
Voltage was applied to the light emitting device BD9, to observe EL light emission. At 5000 cd/m$^2$, EQE was 11.6%, and the CIE chromaticity coordinate (x, y) was (0.136, 0.204). The results are shown in Table 3. The half-value width of the light emission spectrum of the light emitting device BD9 at 5000 cd/m$^2$ was 26.8 nm.

<Example BD10> Fabrication and evaluation of light emitting device BD10

A light emitting device BD10 was fabricated in the same manner as in Example BD1 except that the compound H1, the compound P10 and the compound F2 (compound H1/compound P10/compound F2 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.
Voltage was applied to the light emitting device BD10, to observe EL light emission. At 5000 cd/m$^2$, EQE was 9.8%, and the CIE chromaticity coordinate (x, y) was (0.125, 0.185). The results are shown in Table 3. The half-value width of the light emission spectrum of the light emitting device BD10 at 5000 cd/m$^2$ was 30.4 nm.

<Example BD11> Fabrication and evaluation of light emitting device BD11

A light emitting device BD11 was fabricated in the same manner as in Example BD1 except that the compound H1, the compound P11 and the compound F2 (compound H1/compound P11/compound F2 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.
Voltage was applied to the light emitting device BD11, to observe EL light emission. At 5000 cd/m$^2$, EQE was 13.5%, and the CIE chromaticity coordinate (x, y) was (0.143, 0.303). The results are shown in Table 3. The half-value width of the light emission spectrum of the light emitting device BD11 at 5000 cd/m$^2$ was 38.3 nm.

<Example BD12> Fabrication and evaluation of light emitting device BD12

A light emitting device BD12 was fabricated in the same manner as in Example BD1 except that the compound H1, the compound P10 and the compound F8 (compound H1/compound P10/compound F8 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.
Voltage was applied to the light emitting device BD12, to observe EL light emission. At 5000 cd/m$^2$, EQE was 10.3%, and the CIE chromaticity coordinate (x, y) was (0.119, 0.201). The results are shown in Table 3. The half-value width of the light emission spectrum of the light emitting device BD12 at 5000 cd/m$^2$ was 28.1 nm.

<Example BD13> Fabrication and evaluation of light emitting device BD13

A light emitting device BD13 was fabricated in the same manner as in Example BD1 except that the compound H1, the compound P10 and the compound F9 (compound H1/compound P10/compound F9 = 73% by mass/25% by mass/2% by mass) were used instead of "the compound H1, the compound P3 and the compound F2 (compound

H1/compound P3/compound F2 = 73% by mass/25% by mass/2% by mass)" in (Formation of light emitting layer) of Example BD1.

Voltage was applied to the light emitting device BD13, to observe EL light emission. At 5000 cd/$m^2$, EQE was 9.0%, and the CIE chromaticity coordinate (x, y) was (0.116, 0.216). The results are shown in Table 3. The half-value width of the light emission spectrum of the light emitting device BD13 at 5000 cd/$m^2$ was 28.2 nm.

<Example BD14> Fabrication and evaluation of light emitting device BD14

A light emitting device BD14 was fabricated in the same manner as in Example BD1 except that the compound H1, the compound P10 and the compound F10 (compound H1/compound P10/compound F10 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD14, to observe EL light emission. At 5000 cd/$m^2$, EQE was 11.1%, and the CIE chromaticity coordinate (x, y) was (0.112, 0.271). The results are shown in Table 3. The half-value width of the light emission spectrum of the light emitting device BD14 at 5000 cd/$m^2$ was 29.7 nm.

<Example BD15> Fabrication and evaluation of light emitting device BD15

A light emitting device BD15 was fabricated in the same manner as in Example BD1 except that the compound H1, the compound P11 and the compound F8 (compound H1/compound P11/compound F8 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD15, to observe EL light emission. At 5000 cd/$m^2$, EQE was 12.6%, and the CIE chromaticity coordinate (x, y) was (0.133, 0.290). The results are shown in Table 3. The half-value width of the light emission spectrum of the light emitting device BD15 at 5000 cd/$m^2$ was 31.4 nm.

<Example BD16> Fabrication and evaluation of light emitting device BD16

A light emitting device BD16 was fabricated in the same manner as in Example BD1 except that the compound H1, the compound P11 and the compound F9 (compound H1/compound P11/compound F9 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD16, to observe EL light emission. At 5000 cd/$m^2$, EQE was 12.5%, and the CIE chromaticity coordinate (x, y) was (0.127, 0.286). The results are shown in Table 3. The half-value width of the light emission spectrum of the light emitting device BD16 at 5000 cd/$m^2$ was 29.4 nm.

<Example BD17> Fabrication and evaluation of light emitting device BD17

A light emitting device BD17 was fabricated in the same manner as in Example BD1 except that the compound H1, the compound P11 and the compound F10 (compound H1/compound P11/compound F10 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BD17, to observe EL light emission. At 5000 cd/$m^2$, EQE was 14.5%, and the CIE chromaticity coordinate (x, y) was (0.124, 0.332). The results are shown in Table 3. The half-value width of the light emission spectrum of the light emitting device BD17 at 5000 cd/$m^2$ was 31.8 nm.

[Table 3]

| Example /Comparaive Example | Device | Conformation | Emission Layer Mixing Ratio (wt%) | $N_f$ | $\lvert T_P\rvert$-$\lvert S_F\rvert$ [eV] | $\lvert T_P\rvert$-$\lvert T_F\rvert$ [eV] | EQE 5kcd/m$^2$ | CIE(x,y) 5kcd/m$^2$ |
|---|---|---|---|---|---|---|---|---|
| Comparative Example BCD1 | BCD1 | H1/P1/F1 | 73/25/2 | 7.14 | -0.41 | 0.09 | 4.5 | (0.149, 0.301) |
| Comparative Example BCD2 | BCD2 | H1/P1/F2 | 73/25/2 | 3.25 | -0.23 | 0.20 | 4.6 | (0.132, 0.248) |
| Comparative Example BCD3 | BCD3 | H1/P2/F1 | 73/25/2 | 7.14 | -0.25 | 0.25 | 5.6 | (0.175, 0.357) |
| Comparative Example BCD4 | BCD4 | H1/P3/F1 | 73/25/2 | 7.14 | -0.17 | 0.33 | 7.3 | (0.139, 0.110) |
| Example BD1 | BD1 | H1/P3/F2 | 73/25/2 | 3.25 | 0.01 | 0.44 | 12.6 | (0.121, 0.153) |
| Example BD2 | BD2 | H1/P4/F2 | *73/25/2* | 3.25 | -0.07 | 0.36 | 10.1 | (0.121, 0.151) |
| Example BD3 | BD3 | H1/P5/F2 | 73125/2 | 3.25 | -0.07 | 0.36 | 11.9 | (0.134, 0.212) |
| Example BD4 | BD4 | H1/P3/F3 | *73/25/2* | 3.35 | -0.08 | 0.37 | 9.5 | (0.138, 0.101) |
| Example BD5 | BD5 | H1/P5/F3 | 73/25/2 | 3.35 | -0.16 | 0.29 | 11.8 | (0.158, 0.247) |
| Example BD6 | BD6 | H1/P5/F4 | 73/25/2 | 4.47 | -0.29 | 0.19 | 11.3 | (0.169, 0.327) |
| Example BD7 | BD7 | H1/P3/F5 | 73/25/2 | 2.03 | -0.02 | 0.41 | 13.4 | (0.122, 0.136) |
| Example BD8 | BD8 | H1/P4/F5 | 73/2512 | 2.03 | -0.10 | 0.33 | 10.0 | (0.122, 0.134) |
| Example BD9 | BD9 | H1/P5/F5 | 73/25/2 | 2.03 | -0.10 | 0.33 | 11.6 | (0.136, 0.204) |
| Example BD10 | BD10 | H1/P10/F2 | 73/25/2 | 3.25 | -0.09 | 0.34 | 9.8 | (0.125, 0.185) |
| Example BD11 | BD11 | H1/P11/F2 | 73/25/2 | 3.25 | -0.14 | 0.29 | 13.5 | (0.143, 0.303) |
| Example BD12 | BD12 | H1/P10/F8 | 73/25/2 | 4.48 | -0.10 | 0.36 | 10.3 | (0.119, 0.201) |
| Example BD13 | BD13 | H1/P10/F9 | 73/25/2 | 2.41 | -0.01 | 0.37 | 9.0 | (0.118, 0.216) |
| Example BD14 | BD14 | H1/P10/F10 | 73/25/2 | 2.26 | -0.04 | 0.37 | 11.1 | (0.112, 0.271) |
| Example BD15 | BD15 | H1/P11/F8 | 73/25/2 | 4.48 | -0.15 | 0.31 | 12.6 | (0.133, 0.290) |
| Example BD16 | BD16 | H1/P11/F9 | 73/25/2 | 2.41 | -0.06 | 0.32 | 12.5 | (0.127, 0.286) |
| Example BD17 | BD17 | H1/P11/F10 | 73/25/2 | 2.26 | -0.08 | 0.32 | 14.5 | (0.124, 0.332) |

<Example BPD1> Fabrication and evaluation of light emitting device BPD1

A light emitting device BPD1 was fabricated in the same manner as in Example BD1 except that the compound H1, the compound P3 and polymer compound PF1 (compound H1/compound P3/polymer compound PF1 = 55% by mass/25% by mass/20% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD1, to observe EL light emission. At 100 cd/$m^2$, EQE was 16.4%, and the CIE chromaticity coordinate (x, y) was (0.130, 0.153). The results are shown in Table 4. The half-value width of the light emission spectrum of the light emitting device BPD1 at 100 cd/$m^2$ was 27.1 nm.

<Example BPD2> Fabrication and evaluation of light emitting device BPD2

A light emitting device BPD2 was fabricated in the same manner as in Example BD1 except that the compound H1, the compound P5 and polymer compound PF1 (compound H1/compound P5/polymer compound PF1 = 55% by mass/25% by mass/20% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD2, to observe EL light emission. At 100 cd/$m^2$, EQE was 16.0%, and the CIE chromaticity coordinate (x, y) was (0.138, 0.197). The results are shown in Table 4. The half-value width of the light emission spectrum of the light emitting device BPD2 at 100 cd/$m^2$ was 26.0 nm.

<Example BPD3> Fabrication and evaluation of light emitting device BPD3

A light emitting device BPD3 was fabricated in the same manner as in Example BD1 except that the compound H1, the compound P11 and polymer compound PF1 (compound H1/compound P11/polymer compound PF1 = 55% by mass/25% by mass/20% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD3, to observe EL light emission. At 100 cd/$m^2$, EQE was 16.2%, and the CIE chromaticity coordinate (x, y) was (0.143, 0.274). The results are shown in Table 4. The half-value width of the light emission spectrum of the light emitting device BPD3 at 100 cd/$m^2$ was 34.2 nm.

<Example BPD4> Fabrication and evaluation of light emitting device BPD4

A light emitting device BPD4 was fabricated in the same manner as in Example BD1 except that the compound H1, the compound P3 and polymer compound PF2 (compound H1/compound P3/polymer compound PF1 = 55% by mass/25% by mass/20% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD4, to observe EL light emission. At 100 cd/$m^2$, EQE was 11.6%, and the CIE chromaticity coordinate (x, y) was (0.149, 0.141). The results are shown in Table 4. The half-value width of the light emission spectrum of the light emitting device BPD4 at 100 cd/$m^2$ was 40.0 nm.

<Example BPD5> Fabrication and evaluation of light emitting device BPD5

A light emitting device BPD5 was fabricated in the same manner as in Example BD1 except that the compound H1, the compound P5 and polymer compound PF2 (compound H1/compound P5/polymer compound PF1 = 55% by mass/25% by mass/20% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD5, to observe EL light emission. At 100 cd/$m^2$, EQE was 14.7%, and the CIE chromaticity coordinate (x, y) was (0.170, 0.314). The results are shown in Table 4. The half-value width of the light emission spectrum of the light emitting device BPD5 at 100 cd/$m^2$ was 67.8 nm.

<Example BPD7> Fabrication and evaluation of light emitting device BPD7

A light emitting device BPD7 was fabricated in the same manner as in Example BD1 except that the polymer

compound PF1 and the compound P3 (polymer compound PF1/compound P3 = 75% by mass/25% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD7, to observe EL light emission. At 100 cd/$m^2$, EQE was 11.0%, and the CIE chromaticity coordinate (x, y) was (0.127, 0.124). The results are shown in Table 4. The half-value width of the light emission spectrum of the light emitting device BPD7 at 100 cd/$m^2$ was 23.6 nm.

<Example BPD8> Fabrication and evaluation of light emitting device BPD8

A light emitting device BPD8 was fabricated in the same manner as in Example BD1 except that the polymer compound PF1 and the compound P5 (polymer compound PF1/compound P5 = 75% by mass/25% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD8, to observe EL light emission. At 100 cd/$m^2$, EQE was 13.7%, and the CIE chromaticity coordinate (x, y) was (0.127, 0.132). The results are shown in Table 4. The half-value width of the light emission spectrum of the light emitting device BPD8 at 100 cd/$m^2$ was 23.7 nm.

<Example BPD9> Fabrication and evaluation of light emitting device BPD9

A light emitting device BPD9 was fabricated in the same manner as in Example BD1 except that the polymer compound PF1 and the compound P11 (polymer compound PF1/compound P11 = 75% by mass/25% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD9, to observe EL light emission. At 100 cd/$m^2$, EQE was 14.0%, and the CIE chromaticity coordinate (x, y) was (0.130, 0.166). The results are shown in Table 4. The half-value width of the light emission spectrum of the light emitting device BPD9 at 100 cd/$m^2$ was 25.1 nm.

<Example BPD10> Fabrication and evaluation of light emitting device BPD10

A light emitting device BPD10 was fabricated in the same manner as in Example BD1 except that the polymer compound PF2 and the compound P5 (polymer compound PF2/compound P5 = 75% by mass/25% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device BPD10, to observe EL light emission. At 100 cd/$m^2$, EQE was 11.2%, and the CIE chromaticity coordinate (x, y) was (0.162, 0.240). The results are shown in Table 4. The half-value width of the light emission spectrum of the light emitting device BPD10 at 100 cd/$m^2$ was 68.9 nm.

[Table 4]

| Example /Comparaive Example | Device | Conformation | Emission Layer Mixing Ratio (wt%) | $N_f$ | $\|T_P\|-\|S_F\|$ [eV] | $\|T_P\|-\|T_F\|$ [eV] | EQE 100cd/$m^2$ | CIE(x,y) 100cd/$m^2$ |
|---|---|---|---|---|---|---|---|---|
| Example BPD1 | BPD1 | H1/P3/PF1 | 55/25/20 | 0.311 | 0.15 | 0.36 | 16.4 | (0.130, 0.153) |
| Example BPD2 | BPD2 | H1/P5/PF1 | 55/25/20 | 0.311 | 0.08 | 0.29 | 16.0 | (0.138, 0.197) |
| Example BPD3 | BPD3 | H1/P11/PF1 | 55/25/20 | 0.311 | 0.01 | 0.22 | 16.2 | (0.143, 0.274) |
| Example BPD4 | BPD4 | H1/P3/PF2 | 55/25/20 | 0.297 | 0.05 | 0.23 | 11.6 | (0.149, 0.141) |
| Example BPD5 | BPD5 | H1/P5/PF2 | 55/25/20 | 0.297 | -0.02 | 0.16 | 14.7 | (0.170, 0.314) |
| Example BPD7 | BPD7 | P3/PF1 | 25/75 | 0.311 | 0.15 | 0.36 | 11.0 | (0.127, 0.124) |

(continued)

| Example /Comparaive Example | Device | Conformation | Emission Layer Mixing Ratio (wt%) | $N_f$ | $\lvert T_P\rvert - \lvert S_F\rvert$ [eV] | $\lvert T_P\rvert - \lvert T_F\rvert$ [eV] | EQE 100cd/m$^2$ | CIE(x,y) 100cd/m$^2$ |
|---|---|---|---|---|---|---|---|---|
| Example BPD8 | BPD8 | P5/PF1 | 25/75 | 0.311 | 0.08 | 0.29 | 13.7 | (0.127, 0.132) |
| Example BPD9 | BPD9 | P11/PF1 | 25/75 | 0.311 | 0.01 | 0.22 | 14.0 | (0.130, 0.166) |
| Example BDP10 | BDP10 | P5/PF2 | 25/75 | 0.297 | -0.02 | 0.16 | 11.2 | (0.162, 0.240) |

Note that $|T_P|$-$|S_F|$ and $|T_P|$-$|T_F|$ described in Table 4 were calculated based on experimental values described in Table 2.

<Comparative Example RCD1> Fabrication and evaluation of light emitting device RCD1

(Formation of anode and hole injection layer)

An ITO film with a thickness of 45 nm was attached to a glass substrate by a sputtering method, to form an anode. On the anode, a hole injection material (product name: ND-3202, manufactured by Nissan Chemical Corporation) was spin-coated to form a film with a thickness of 65 nm. The substrate carrying the hole injection layer laminated thereon was heated on a hot plate at 50°C for 3 minutes, and further heated at 230°C for 15 minutes under an air atmosphere, to form a hole injection layer.

(Formation of hole transporting layer)

The polymer compound HTL-1 was dissolved in xylene at a concentration of 0.6% by mass. The resultant xylene solution was spin-coated on the hole injection layer to form a film with a thickness of 20 nm, and heated on a hot plate at 180°C for 60 minutes under a nitrogen gas atmosphere, to form a hole transporting layer.

(Formation of light emitting layer)

The polymer compound HP-1, the compound P6 and the compound F6 (compound HP-1/compound P6/compound F6 = 69.5% by mass/30% by mass/0.5% by mass) were dissolved in chlorobenzene at a concentration of 2% by mass. The resultant chlorobenzene solution was spin-coated on the hole transporting layer to form a film with a thickness of 80 nm, and heated at 170°C for 10 minutes under a nitrogen gas atmosphere, to form a light emitting layer.

(Formation of cathode)

The substrate carrying the light emitting layer formed thereon was placed in a vapor deposition machine, and the inner pressure thereof was reduced down to $1.0\times10^{-4}$ Pa or less, then, sodium fluoride was vapor-deposited with a thickness of about 4 nm on the light emitting layer, then, aluminum was vapor-deposited with a thickness of about 80 nm on the sodium fluoride layer, as cathodes. After vapor deposition, the substrate carrying the cathode form thereon was sealed with a glass substrate, to fabricate a light emitting device RCD1.

(Evaluation of light emitting device)

Voltage was applied to the light emitting device RCD1, to observe EL light emission. The light emitting device was evaluated every 0.2 V in the range of voltage from -5 V to 12 V, and at 5000 cd/m$^2$, EQE was 2.3%, and the CIE chromaticity coordinate (x, y) was (0.283, 0.603). The results are shown in Table 5.

<Comparative Example RCD2> Fabrication and evaluation of light emitting device RCD2

A light emitting device RCD2 was fabricated in the same manner as in Co mParative Example RCD1 except that

the polymer compound HP-1, the compound P1 and the compound F6 (compound HP-1/compound P1/compound F6 = 69.5% by mass/30% by mass/0.5% by mass) were used instead of "the polymer compound HP-1, the compound P6 and the compound F6 (compound HP-1/compound P6/compound F6 = 69.5% by mass/30% by mass/0.5% by mass)" in (Formation of light emitting layer) of Co mParative Example RCD1.

Voltage was applied to the light emitting device RCD2, to observe EL light emission. When the voltage was in the range of -5 V to 12 V, 5000 cd/$m^2$ was not reached. The results are shown in Table 5.

<Comparative Example RCD3> Fabrication and evaluation of light emitting device RCD3

A light emitting device RCD3 was fabricated in the same manner as in Co mParative Example RCD1 except that the polymer compound HP-1, the compound P7 and the compound F6 (compound HP-1/compound P7/compound F6 = 69.5% by mass/30% by mass/0.5% by mass) were used instead of "the polymer compound HP-1, the compound P6 and the compound F6 (compound HP-1/compound P6/compound F6 = 69.5% by mass/30% by mass/0.5% by mass)" in (Formation of light emitting layer) of Co mParative Example RCD1.

Voltage was applied to the light emitting device RCD3, to observe EL light emission. When the voltage was in the range of -5 V to 12 V, 5000 cd/$m^2$ was not reached. The results are shown in Table 5.

<Example RD1> Fabrication and evaluation of light emitting device RD1

A light emitting device RD1 was fabricated in the same manner as in Co mParative Example RCD1 except that the polymer compound HP-1, the compound P8 and the compound F6 (compound HP-1/compound P8/compound F6 = 69.5% by mass/30% by mass/0.5% by mass) were used instead of "the polymer compound HP-1, the compound P6 and the compound F6 (compound HP-1/compound P6/compound F6 = 69.5% by mass/30% by mass/0.5% by mass)" in (Formation of light emitting layer) of Co mParative Example RCD1.

Voltage was applied to the light emitting device RD1, to observe EL light emission. At 5000 cd/$m^2$, EQE was 13.2%, and the CIE chromaticity coordinate (x, y) was (0.280, 0.633). The results are shown in Table 5.

<Example RD2> Fabrication and evaluation of light emitting device RD2

A light emitting device RD2 was fabricated in the same manner as in Example RD1 except that the polymer compound HP-1, the compound P9 and the compound F6 (compound HP-1/compound P9/compound F6 = 69.5% by mass/30% by mass/0.5% by mass) were used instead of "the polymer compound HP-1, the compound P8 and the compound F6 (compound HP-1/compound P8/compound F6 = 69.5% by mass/30% by mass/0.5% by mass)" in (Formation of light emitting layer) of Example RD1.

Voltage was applied to the light emitting device RD2, to observe EL light emission. At 5000 cd/$m^2$, EQE was 19.5%, and the CIE chromaticity coordinate (x, y) was (0.307, 0.637). The results are shown in Table 5.

[Table 5]

| Example /Comparaive Example | Device | Conformation | Emission Layer Mixing Ratio (wt%) | $N_f$ | $\|T_P\|-\|S_F\|$ [eV] | $\|T_P\|-\|T_F\|$ [eV] | EQE 5kcd/$m^2$ | CIE(x,y) 5kcd/$m^2$ |
|---|---|---|---|---|---|---|---|---|
| Comparaive Example RCD1 | RCD1 | HP-1/P6/F6 | 69.5/30/0.5 | 2.81 | -0.13 | 0.92 | 2.3 | (0.283, 0.603) |
| Comparaive Example RCD2 | RCD2 | HP-1/P1/F6 | 69.5/30/0.5 | 2.81 | -0.04 | 1.01 | unable to be evaluated | |
| Comparaive Example RCD3 | RCD3 | HP-1/P7/F6 | 69.5/30/0.5 | 2.81 | -0.65 | 0.40 | unable to be evaluated | |
| Example RD1 | RD1 | HP-1/P8/F6 | 69.5/30/0.5 | 2.81 | -0.14 | 0.92 | 13.2 | (0.280, 0.633) |
| Example RD2 | RD2 | HP-1/P9/F6 | 69.5/30/0.5 | 2.81 | -0.19 | 0.87 | 19.5 | (0.307, 0.637) |

<Comparative Example GCD1> Fabrication and evaluation of light emitting device GCD1

A light emitting device GCD1 was fabricated in the same manner as in Co mParative Example RCD1 except that the polymer compound HP-1, the compound P6 and the compound F7 (compound HP-1/compound P6/compound F7 = 69.5% by mass/30% by mass/0.5% by mass) were used instead of "the polymer compound HP-1, the compound P6 and the compound F6 (compound HP-1/compound P6/compound F6 = 69.5% by mass/30% by mass/0.5% by mass)" in (Formation of light emitting layer) of Co mParative Example RCD1.
Voltage was applied to the light emitting device GCD1, to observe EL light emission. When the voltage was in the range of -5 V to 12 V, 100 cd/$m^2$ was not reached. The results are shown in Table 6.

<Example GD1> Fabrication and evaluation of light emitting device GD1

A light emitting device GD1 was fabricated in the same manner as in Co mParative Example GCD1 except that the polymer compound HP-1, the compound P8 and the compound F7 (compound HP-1/compound P8/compound F7 = 69.5% by mass/30% by mass/0.5% by mass) were used instead of "the polymer compound HP-1, the compound P6 and the compound F7 (compound HP-1/compound P6/compound F7 = 69.5% by mass/30% by mass/0.5% by mass)" in (Formation of light emitting layer) of Co mParative Example GCD1.
Voltage was applied to the light emitting device GD1, to observe EL light emission. At 100 cd/$m^2$, EQE was 5.9%, and the CIE chromaticity coordinate (x, y) was (0.271, 0.653). The results are shown in Table 6.

<Example GD2> Fabrication and evaluation of light emitting device GD2

A light emitting device GD2 was fabricated in the same manner as in Example GD1 except that the polymer compound HP-1, the compound P9 and the compound F7 (compound HP-1/compound P9/compound F7 = 69.5% by mass/30% by mass/0.5% by mass) were used instead of "the polymer compound HP-1, the compound P8 and the compound F7 (compound HP-1/compound P8/compound F7 = 69.5% by mass/30% by mass/0.5% by mass)" in (Formation of light emitting layer) of Example GD1.
Voltage was applied to the light emitting device GD2, to observe EL light emission. At 100 cd/$m^2$, EQE was 5.3%, and the CIE chromaticity coordinate (x, y) was (0.290, 0.651). The results are shown in Table 6.

<Example GD3> Fabrication and evaluation of light emitting device GD3

A light emitting device GD3 was fabricated in the same manner as in Example GD1 except that the polymer compound HP-1, the compound P9 and the compound F11 (compound HP-1/compound P9/compound F11 = 69.5% by mass/30% by mass/0.5% by mass) were used instead of "the polymer compound HP-1, the compound P8 and the compound F7 (compound HP-1/compound P8/compound F7 = 69.5% by mass/30% by mass/0.5% by mass)" in (Formation of light emitting layer) of Example GD1.
Voltage was applied to the light emitting device GD3, to observe EL light emission. At 100 cd/$m^2$, EQE was 22.4%, and the CIE chromaticity coordinate (x, y) was (0.297, 0.642). The results are shown in Table 6.

<Example GD4> Fabrication and evaluation of light emitting device GD4

A light emitting device GD4 was fabricated in the same manner as in Example GD1 except that the polymer compound HP-1, the compound P8 and the compound F11 (compound HP-1/compound P8/compound F11 = 69.5% by mass/30% by mass/0.5% by mass) were used instead of "the polymer compound HP-1, the compound P8 and the compound F7 (compound HP-1/compound P8/compound F7 = 69.5% by mass/30% by mass/0.5% by mass)" in (Formation of light emitting layer) of Example GD1.
Voltage was applied to the light emitting device GD4, to observe EL light emission. At 100 cd/$m^2$, EQE was 16.0%, and the CIE chromaticity coordinate (x, y) was (0.271, 0.648). The results are shown in Table 6.

<Example GD5> Fabrication and evaluation of light emitting device GD5

A light emitting device GD5 was fabricated in the same manner as in Example GD1 except that the compound H2, the compound P9 and the compound F11 (compound H2/compound P9/compound F11 = 69.5% by mass/30% by mass/0.5% by mass) were used instead of "the polymer compound HP-1, the compound P8 and the compound F7 (compound HP-1/compound P8/compound F7 = 69.5% by mass/30% by mass/0.5% by mass)" in (Formation of light emitting layer) of Example GD1.
Voltage was applied to the light emitting device GD5, to observe EL light emission. At 100 cd/$m^2$, EQE was 18.6%,

and the CIE chromaticity coordinate (x, y) was (0.281, 0.656). The results are shown in Table 6.

<Example GD6> Fabrication and evaluation of light emitting device GD6

A light emitting device GD6 was fabricated in the same manner as in Example GD1 except that the compound H2, the compound P8 and the compound F11 (compound H2/compound P8/compound F11 = 69.5% by mass/30% by mass/0.5% by mass) were used instead of "the polymer compound HP-1, the compound P8 and the compound F7 (compound HP-1/compound P8/compound F7 = 69.5% by mass/30% by mass/0.5% by mass)" in (Formation of light emitting layer) of Example GD1.

Voltage was applied to the light emitting device GD6, to observe EL light emission. At 100 cd/m$^2$, EQE was 16.5%, and the CIE chromaticity coordinate (x, y) was (0.333, 0.609). The results are shown in Table 6.

[Table 6]

| Example /Comparaive Example | Device | Conformation | Emission Layer Mixing Ratio (wt%) | $N_f$ | $\|T_P\|-\|S_F\|$ [eV] | $\|T_P\|-\|T_F\|$ [eV] | EQE 100cd/m$^2$ | CIE(x,y) 100kcd/m$^2$ |
|---|---|---|---|---|---|---|---|---|
| Example GCD1 | GCD1 | HP-1/P6/F7 | 69.5/30/0.5 | 3.73 | -0.07 | 0.64 | unable to be evaluated | |
| Example GD1 | GD1 | HP-1/P8/F7 | 69.5/30/0.5 | 3.73 | -0.08 | 0.63 | 5.9 | (0.271, 0.653) |
| Example GD2 | GD2 | HP-1/P9/F7 | 68.5/30/0.5 | 3.73 | -0.13 | 0.58 | 5.3 | (0.290, 0.651) |
| Example GD3 | GD3 | HP-1/P9/F11 | 69.5/30/0.5 | 4.36 | -0.11 | 0.21 | 22.4 | (0.297, 0.642) |
| Example GD4 | GD4 | HP-1/P8/F11 | 69.5/30/0.5 | 4.36 | -0.06 | 0.26 | 16.0 | (0.271, 0.648) |
| Example GD5 | GD5 | H2/P9/F11 | 69.5/30/0.5 | 4.36 | -0.11 | 0.21 | 18.6 | (0.281, 0.656) |
| Example GD6 | GD6 | H2/P8/F11 | 69.5/30/0.5 | 4.36 | -0.06 | 0.26 | 16.5 | (0.333, 0.609) |

<Example GD7> Fabrication and evaluation of light emitting device GD7

A light emitting device GD7 was fabricated in the same manner as in Example BD1 except that the compound H1, the compound P10 and the compound F11 (compound H1/compound P10/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD7, to observe EL light emission. At 5000 cd/m$^2$, EQE was 10.3%, and the CIE chromaticity coordinate (x, y) was (0.203, 0.675). The results are shown in Table 7.

<Example GD8> Fabrication and evaluation of light emitting device GD8

A light emitting device GD8 was fabricated in the same manner as in Example BD1 except that the compound H1, the compound P12 and the compound F11 (compound H1/compound P12/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD8, to observe EL light emission. At 5000 cd/m$^2$, EQE was 11.6%, and the CIE chromaticity coordinate (x, y) was (0.217, 0.678). The results are shown in Table 7.

<Example GD9> Fabrication and evaluation of light emitting device GD9

A light emitting device GD9 was fabricated in the same manner as in Example BD1 except that the compound H1, the compound P11 and the compound F11 (compound H1/compound P11/compound F11 = 73% by mass/25% by

mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD9, to observe EL light emission. At 5000 cd/$m^2$, EQE was 12.6%, and the CIE chromaticity coordinate (x, y) was (0.213, 0.681). The results are shown in Table 7.

<Example GD10> Fabrication and evaluation of light emitting device GD10

A light emitting device GD10 was fabricated in the same manner as in Example BD1 except that the compound H1, the compound P13 and the compound F11 (compound H1/compound P13/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD10, to observe EL light emission. At 5000 cd/$m^2$, EQE was 11.8%, and the CIE chromaticity coordinate (x, y) was (0.262, 0.647). The results are shown in Table 7.

<Example GD11> Fabrication and evaluation of light emitting device GD11

A light emitting device GD11 was fabricated in the same manner as in Example BD1 except that the compound H1, the compound P2 and the compound F11 (compound H1/compound P2/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD11, to observe EL light emission. At 5000 cd/$m^2$, EQE was 10.7%, and the CIE chromaticity coordinate (x, y) was (0.221, 0.677). The results are shown in Table 7.

<Example GD12> Fabrication and evaluation of light emitting device GD12

A light emitting device GD12 was fabricated in the same manner as in Example BD1 except that the compound H1, the compound P14 and the compound F11 (compound H1/compound P14/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD12, to observe EL light emission. At 5000 cd/$m^2$, EQE was 9.1%, and the CIE chromaticity coordinate (x, y) was (0.203, 0.676). The results are shown in Table 7.

<Example GD13> Fabrication and evaluation of light emitting device GD13

A light emitting device GD13 was fabricated in the same manner as in Example BD1 except that the compound H1, the compound P15 and the compound F11 (compound H1/compound P15/compound F11 = 73% by mass/25% by mass/2% by mass) were used instead of "the compound H1, the compound P3 and the compound F2 (compound H1/compound P3/compound F2 = 73% by mass/25% by mass/2% by mass)" in (Formation of light emitting layer) of Example BD1.

Voltage was applied to the light emitting device GD13, to observe EL light emission. At 5000 cd/$m^2$, EQE was 9.0%, and the CIE chromaticity coordinate (x, y) was (0.211, 0.675). The results are shown in Table 7.

[Table 7]

| Example /Comparaive Example | Device | Conformation | Emission Layer Mixing Ratio (wt%) | $N_f$ | $\|T_P\|$-$\|S_F\|$ [eV] | $\|T_P\|$-$\|T_F\|$ [eV] | EQE 5kcd/$m^2$ | CIE(x,y) 5kcd/$m^2$ |
|---|---|---|---|---|---|---|---|---|
| Example GD7 | GD7 | H1/P10/F11 | 73/25/2 | 4.36 | 0.18 | 0.50 | 10.3 | (0.203, 0.675) |
| Example GD8 | GD8 | H1/P12/F11 | 73/25/2 | 4.36 | 0.14 | 0.46 | 11.6 | (0.217, 0,678) |

(continued)

| Example /Comparaive Example | Device | Conformation | Emission Layer Mixing Ratio (wt%) | $N_f$ | $\|T_P\|-\|S_F\|$ [eV] | $\|T_P\|-\|T_F\|$ [eV] | EQE 5kcd/$m^2$ | CIE(x,y) 5kcd/$m^2$ |
|---|---|---|---|---|---|---|---|---|
| Example GD9 | GD9 | H1/P11/F11 | 73/25/2 | 4.36 | 0.13 | 0.45 | 12.6 | (0.213, 0.681) |
| Example GD10 | GD10 | H1/P13/F11 | 73/25/2 | 4.36 | 0.21 | 0.53 | 11.8 | (0.262, 0.647) |
| Example GD11 | GD11 | H1/P2/F11 | 73/25/2 | 4.36 | 0.20 | 0.52 | 10.7 | (0.221, 0.677) |
| Example GD12 | GD12 | H1/P14/F11 | 73/25/2 | 4.36 | 0.14 | 0.46 | 9.1 | (0.203, 0.676) |
| Example GD13 | GD13 | H1/P15/F11 | 73/25/2 | 4.36 | 0.16 | 0.48 | 9.0 | (0.211, 0.675) |

Industrial Applicability

According to the present invention, it is possible to provide a composition which is useful for production of a light emitting device excellent in light emission efficiency and a light emitting device containing the composition.

## Claims

**1.** A composition comprising

a phosphorescent compound represented by the formula (1) and
a compound (F) having a condensed hetero ring skeleton containing at least one atom (a) selected from the group consisting of a nitrogen atom and a boron atom in the ring,
wherein if the value of the energy level of the lowest triplet excited state of the phosphorescent compound is expressed as $T_P$ (eV), the value of the energy level of the lowest triplet excited state of the compound (F) is expressed as $T_F$ (eV) and the number of the atom (a) in the condensed hetero ring skeleton per 1000 of the molecular weight of the compound (F) is expressed as $N_f$, then, the formula (A) and the formula (B) are satisfied:

$$|T_P|-|T_F| \geq 0.15 \quad (A)$$

$$0.01 \leq N_f \leq 4.5 \quad (B)$$

[Chemical Formula 1]

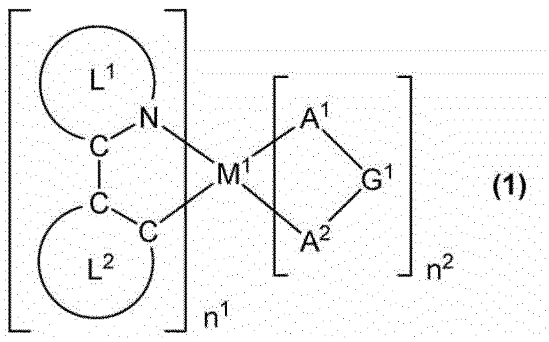

(1)

wherein,

$M^1$ represents a ruthenium atom, a rhodium atom, a palladium atom, an iridium atom or a platinum atom,

$n^1$ represents an integer of 1 or more, $n^2$ represents an integer of 0 or more, and $n^1$+$n^2$ is 2 or 3, providing $n^1$ +$n^2$ is 3 when $M^1$ is a ruthenium atom, a rhodium atom or an iridium atom, while $n^1$+$n^2$ is 2 when $M^1$ is a palladium atom or a platinum atom,

Ring $L^1$ represents an aromatic hetero ring, and this ring optionally has a substituent, when a plurality of the substituents are present, they may be the same or different and may be combined together to form a ring together with atoms to which they are attached, when a plurality of Ring $L^1$ are present, they may be the same or different,

Ring $L^2$ represents an aromatic hydrocarbon ring, and this ring optionally has a substituent, when a plurality of the substituents are present, they may be the same or different and may be combined together to form a ring together with atoms to which they are attached, when a plurality of Ring $L^2$ are present, they may be the same or different,

The substituent which Ring $L^1$ optionally has and the substituent which Ring $L^2$ optionally has may be combined together to form a ring together with atoms to which they are attached,

providing at least one ring selected from the group consisting of Ring $L^1$ and Ring $L^2$ has at least one group represented by the formula (1-T), when a plurality of the groups represented by the formula (1-T) are present, they may be the same or different,

$A^1$-$G^1$-$A^2$ represents an anionic bidentate ligand, $A^1$ and $A^2$ each independently represent a carbon atom, an oxygen atom or a nitrogen atom, and these atoms may be ringconstituent atoms, $G^1$ represents a single bond, or an atomic group constituting a bidentate ligand together with $A^1$ and $A^2$, when a plurality of $A^1$-$G^1$-$A^2$ are present, they may be the same or different,

[Chemical Formula 2] $-R^{1T}$ (1-T)

wherein, $R^{1T}$ represents an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group, and these groups optionally have a substituent.

**2.** The composition according to claim 1, wherein the phosphorescent compound represented by the formula (1) is a phosphorescent compound represented by the formula (1-A):

[Chemical Formula 3]

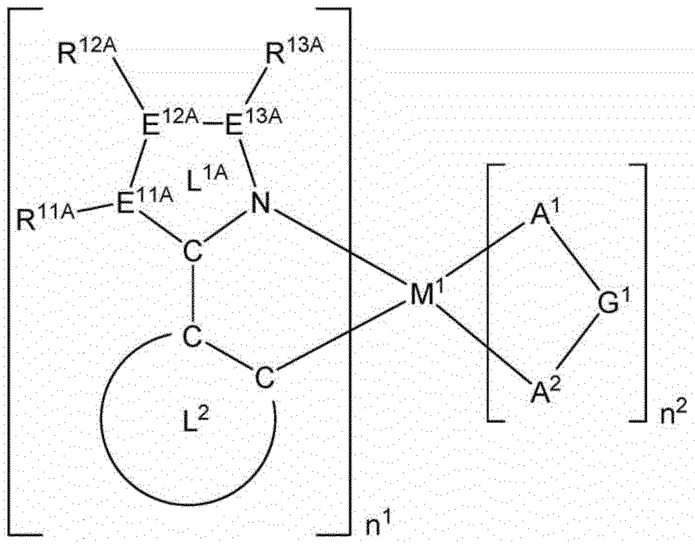

**(1-A)**

wherein, $M^1$, $n^1$, $n^2$, Ring $L^2$ and $A^1$-$G^1$-$A^2$ represent the same meaning as described above,

Ring $L^{1A}$ represent a triazole ring or a diazole ring constituted of a nitrogen atom, a carbon atom, $E^{11A}$, $E^{12A}$ and $E^{13A}$, when a plurality of Ring $L^{1A}$ are present, they may be the same or different,

$E^{11A}$, $E^{12A}$ and $E^{13A}$ each independently represent a nitrogen atom or a carbon atom, when a plurality of $E^{11A}$, $E^{12A}$ and $E^{13A}$ are present, they may be the same or different at each occurrence,

$R^{11A}$, $R^{12A}$ and $R^{13A}$ each independently represent a hydrogen atom or a group represented by the formula (1-T),

when a plurality of $R^{11A}$, $R^{12A}$ and $R^{13A}$ are present, they may be the same or different at each occurrence, $R^{11A}$ and $R^{12A}$ may be combined together to form a ring together with atoms to which they are attached, $R^{12A}$ and $R^{13A}$ may be combined together to form a ring together with atoms to which they are attached, $R^{11A}$ and the substituent which Ring $L^2$ optionally has may be combined together to form a ring together with atoms to which they are attached,

providing at least one selected from the group consisting of $R^{11A}$, $R^{12A}$, $R^{13A}$, and the substituent which Ring $L^2$ optionally has is a group represented by the formula (1-T), when a plurality of the groups represented by the formula (1-T) are present, they may be the same or different,

when $E^{11A}$ is a nitrogen atom, then, $R^{11A}$ may be present or absent, when $E^{12A}$ is a nitrogen atom, then, $R^{12A}$ may be present or absent, when $E^{13A}$ is a nitrogen atom, then, $R^{13A}$ may be present or absent.

**3.** The composition according to claim 2, wherein the phosphorescent compound represented by the formula (1-A) is a phosphorescent compound represented by the formula (1-A-2) :

[Chemical Formula 4]

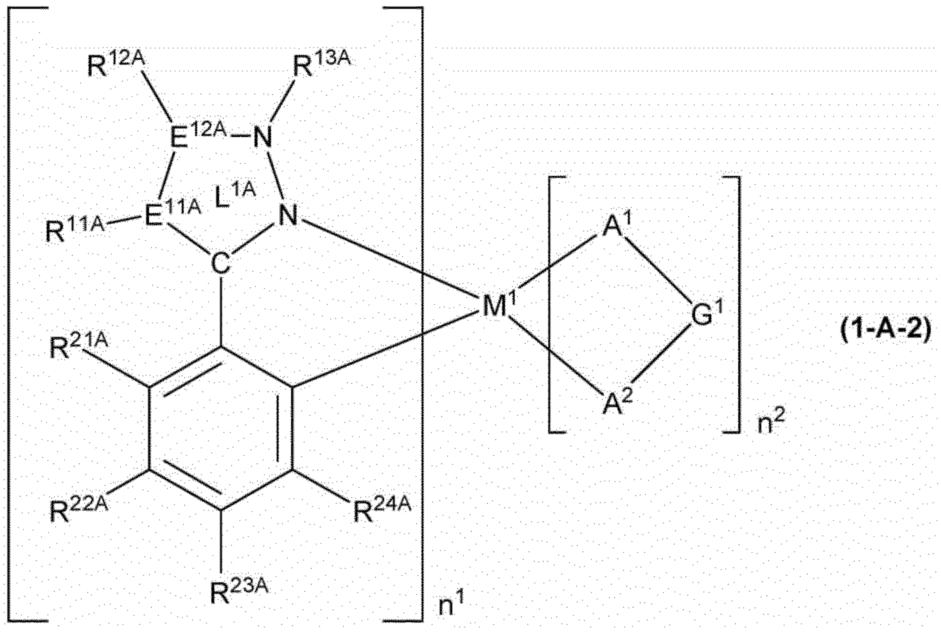

**(1-A-2)**

wherein,

$M^1$, $n^1$, $n^2$, Ring $L^{1A}$, $E^{11A}$, $E^{12A}$, $R^{11A}$, $R^{12A}$, $R^{13A}$ and $A^1$-$G^1$-$A^2$ represent the same meaning as described above, $R^{21A}$, $R^{22A}$, $R^{23A}$ and $R^{24A}$ each independently represent a hydrogen atom or a group represented by the formula (1-T), when a plurality of $R^{21A}$, $R^{22A}$, $R^{23A}$ and $R^{24A}$ are present, they may be the same or different at each occurrence, $R^{21A}$ and $R^{22A}$ may be combined together to form a ring together with atoms to which they are attached, $R^{22A}$ and $R^{23A}$ may be combined together to form a ring together with atoms to which they are attached, $R^{23A}$ and $R^{24A}$ may be combined together to form a ring together with atoms to which they are attached, $R^{11A}$ and $R^{21A}$ may be combined together to form a ring together with atoms to which they are attached,

providing at least one selected from the group consisting of $R^{11A}$, $R^{12A}$, $R^{13A}$, $R^{21A}$, $R^{22A}$, $R^{23A}$ and $R^{24A}$ is a group represented by the formula (1-T).

**4.** The composition according to claim 1, wherein the phosphorescent compound represented by the formula (1) is a phosphorescent compound represented by the formula (1-B):

[Chemical Formula 5]

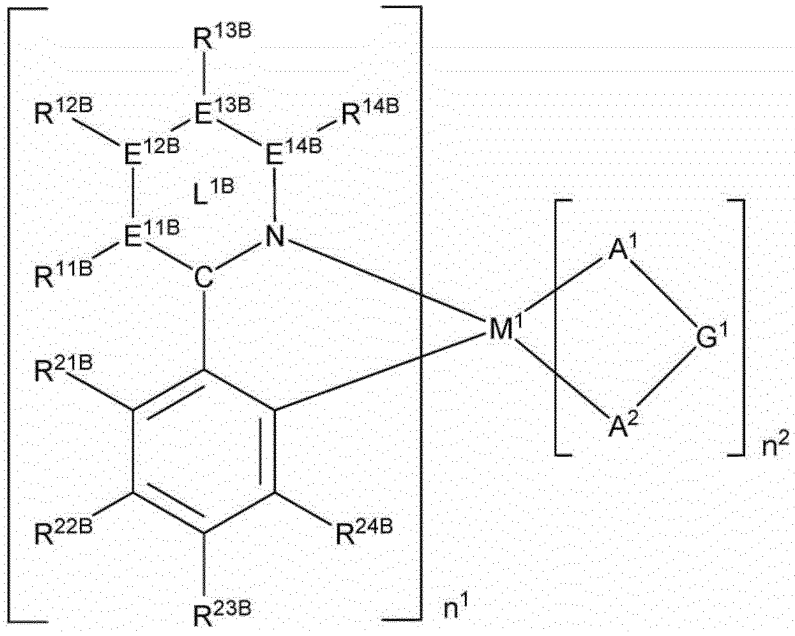

(1-B)

wherein,

$M^1$, $n^1$, $n^2$ and $A^1$-$G^1$-$A^2$ represent the same meaning as described above,
$E^{11B}$, $E^{12B}$, $E^{13B}$ and $E^{14B}$ each independently represent a nitrogen atom or a carbon atom, when a plurality of $E^{11B}$, $E^{12B}$, $E^{13B}$ and $E^{14B}$ are present, they may be the same or different at each occurrence, when $E^{11B}$ is a nitrogen atom, then, $R^{11B}$ is absent, when $E^{12B}$ is a nitrogen atom, then, $R^{12B}$ is absent, when $E^{13B}$ is a nitrogen atom, then, $R^{13B}$ is absent, when $E^{14B}$ is a nitrogen atom, then, $R^{14B}$ is absent,
Ring $L^{1B}$ represents a pyridine ring or a pyrimidine ring constituted of a nitrogen atom, a carbon atom, $E^{11B}$, $E^{12B}$, $E^{13B}$ and $E^{14B}$, when a plurality of Ring $L^{1B}$ are present, they may be the same or different,
$R^{11B}$, $R^{12B}$, $R^{13B}$, $R^{14B}$, $R^{21B}$, $R^{22B}$, $R^{23B}$ and $R^{24B}$ each independently represent a hydrogen atom or a group represented by the formula (1-T), when a plurality of $R^{11B}$, $R^{12B}$, $R^{13B}$, $R^{14B}$, $R^{21B}$, $R^{22B}$, $R^{23B}$ and $R^{24B}$ are present, they may be the same or different at each occurrence, $R^{11B}$ and $R^{12B}$, $R^{12B}$ and $R^{13B}$, $R^{13B}$ and $R^{14B}$, $R^{11B}$ and $R^{21B}$, $R^{21B}$ and $R^{22B}$, $R^{22B}$ and $R^{23B}$, and $R^{23B}$ and $R^{24B}$ may each be combined together to form a ring together with atoms to which they are attached, providing at least one selected from the group consisting of $R^{11B}$, $R^{12B}$, $R^{13B}$, $R^{14B}$, $R^{21B}$, $R^{22B}$, $R^{23B}$ and $R^{24B}$ is a group represented by the formula (1-T).

**5.** The composition according to any one of claims 1 to 4, wherein the $R^{1T}$ is an alkyl group, a cycloalkyl group, a group represented by the formula (D-A), a group represented by the formula (D-B) or a group represented by the formula (D-C) :

[Chemical Formula 6]

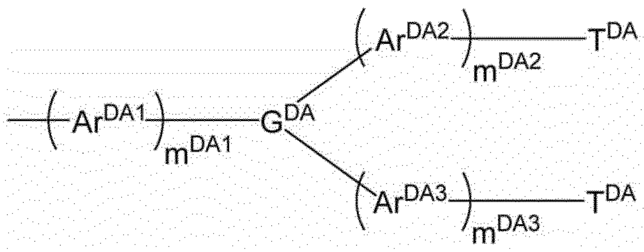

(D-A)

wherein,

$m^{DA1}$, $m^{DA2}$ and $m^{DA3}$ each independently represent an integer of 0 or more,

$G^{DA}$ represents a nitrogen atom, an aromatic hydrocarbon group or a hetero ring group, and these groups optionally have a substituent,
$Ar^{DA1}$, $Ar^{DA2}$ and $Ar^{DA3}$ each independently represent an arylene group or a divalent hetero ring group, and these groups optionally have a substituent, when a plurality of $Ar^{DA1}$, $Ar^{DA2}$ and $Ar^{DA3}$ are present, they may be the same or different at each occurrence,
$T^{DA}$ represents an aryl group or a monovalent hetero ring group, and these groups optionally have a substituent, a plurality of $T^{DA}$ may be the same or different,

[Chemical Formula 7]

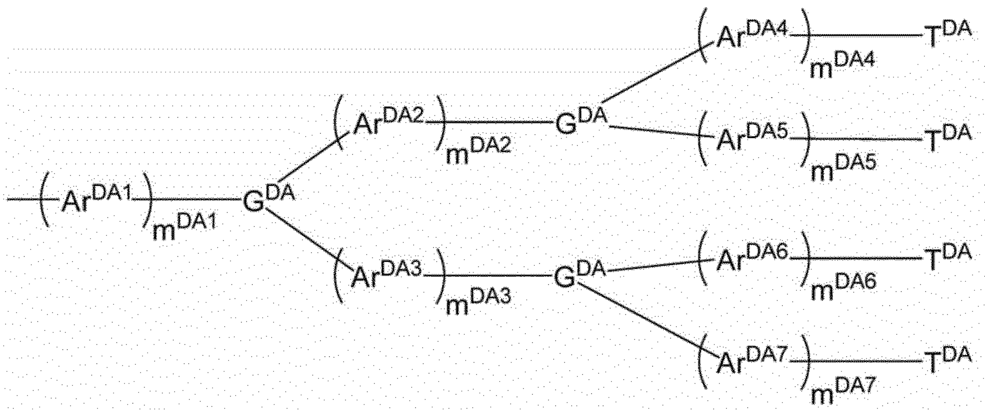

**(D-B)**

wherein,

$m^{DA1}$, $m^{DA2}$, $m^{DA3}$, $m^{DA4}$, $m^{DA5}$, $m^{DA6}$ and $m^{DA7}$ each independently represent an integer of 0 or more,
$G^{DA}$ represents a nitrogen atom, an aromatic hydrocarbon group or a hetero ring group, and these groups optionally have a substituent, a plurality of $G^{DA}$ may be the same or different,
$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent hetero ring group, and these groups optionally have a substituent, when a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence,
$T^{DA}$ represents an aryl group or a monovalent hetero ring group, and these groups optionally have a substituent, a plurality of $T^{DA}$ may be the same or different,

[Chemical Formula 8]

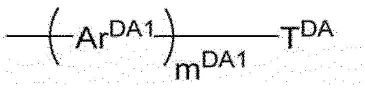

**(D-C)**

wherein,

$m^{DA1}$ represents an integer of 0 or more,
$Ar^{DA1}$ represents an arylene group or a divalent hetero ring group, and these groups optionally have a substituent, when a plurality of $Ar^{DA1}$ are present, they may be the same or different,
$T^{DA}$ represents an aryl group or a monovalent hetero ring group, and these groups optionally have a substituent.

6. The composition according to any one of claims 1 to 5, wherein if the value of the energy level in the lowest singlet excited state of the compound (F) is expressed as $S_F$ (eV), then, the formula (C) is satisfied:

$$|T_P| - |S_F| \geq -0.30 \qquad (C).$$

7. The composition according to any one of claims 1 to 6, wherein the condensed hetero ring skeleton has both a nitrogen atom and a boron atom in the ring, as the atom (a).

8. The composition according to any one of claims 1 to 7, wherein the composition further comprises a compound represented by the formula (H-1):

[Chemical Formula 9]

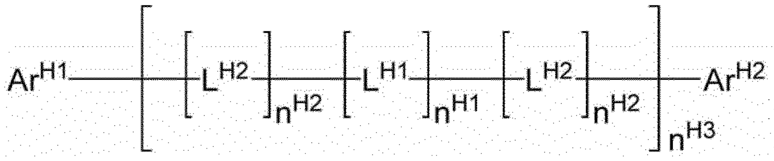

(H-1)

wherein,

$Ar^{H1}$ and $Ar^{H2}$ each independently represent an aryl group or a monovalent hetero ring group, and these groups optionally have a substituent,
$n^{H1}$ and $n^{H2}$ each independently represent 0 or 1, when a plurality of $n^{H1}$ are present, they may be the same or different, a plurality of $n^{H2}$ may be the same or different,
$n^{H3}$ represents an integer of 0 or more,
$L^{H1}$ represents an arylene group, a divalent hetero ring group or a group represented by $-[C(R^{H11})_2]n_{H11}-$, and these groups optionally have a substituent, when a plurality of $L^{H1}$ are present, they may be the same or different,
$n^{H11}$ represents an integer of 1 or more and 10 or less, $R^{H11}$ represents a hydrogen atom, an alkyl group, a cycloalkyl group, an alkoxy group, a cycloalkoxy group, an aryl group or a monovalent hetero ring group, and these groups optionally have a substituent, a plurality of $R^{H11}$ may be the same or different and may be combined together to form a ring together with carbon atoms to which they are attached,
$L^{H2}$ represents a group represented by $-N(-L^{H21}-R^{H21})-$, when a plurality of $L^{H2}$ are present, they may be the same or different,
$L^{H21}$ represents a single bond, an arylene group or a divalent hetero ring group, and these groups optionally have a substituent, $R^{H21}$ represents a hydrogen atom, an alkyl group, a cycloalkyl group, an aryl group or a monovalent hetero ring group, and these groups optionally have a substituent.

9. The composition according to any one of claims 1 to 8, wherein the composition further comprises at least one material selected from the group consisting of a hole transporting material, a hole injection material, an electron transporting material, an electron injection material, a light emitting material, an antioxidant and a solvent.

10. A light emitting device comprising the composition as described in any one of claims 1 to **9.**

**Patentansprüche**

1. Zusammensetzung, umfassend

eine phosphoreszierende Verbindung, dargestellt durch die Formel (1) und
eine Verbindung (F) mit einem kondensierten Heteroringgerüst, das mindestens ein Atom (a) enthält, ausgewählt aus der Gruppe bestehend aus einem Stickstoffatom und einem Boratom im Ring,
wobei, wenn der Wert des Energieniveaus des niedrigsten Triplet-angeregten Zustands der phosphoreszierenden Verbindung als $T_p$ (eV) ausgedrückt wird, der Wert des Energieniveaus des niedrigsten Triplet-angeregten Zustands der Verbindung (F) als $T_F$ (eV) ausgedrückt wird und die Zahl des Atoms (a) im kondensierten Heteroringgerüst pro 1000 des Molekulargewichts der Verbindung (F) als $N_f$ ausgedrückt wird, dann sind die Formel (A) und die Formel (B) erfüllt:

$$|T_P| - |T_F| \geq 0.15 \qquad (A)$$

$$0.01 \leq N_f \leq 4.5 \qquad (B)$$

[Chemische Formel 1]

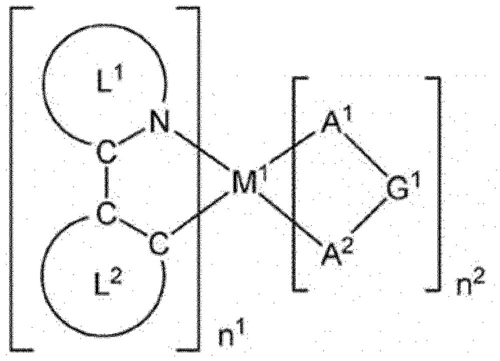

(1)

wobei

$M^1$ ein Rutheniumatom, ein Rhodiumatom, ein Palladiumatom, ein Iridiumatom oder ein Platinatom darstellt, $n^1$ eine ganze Zahl von 1 oder mehr darstellt, $n^2$ eine ganze Zahl von 0 oder mehr darstellt und $n^1 + n^2$ 2 oder 3 ist, vorausgesetzt $n^1 + n^2$ ist 3, wenn $M^1$ ein Rutheniumatom, ein Rhodiumatom oder ein Iridiumatom ist, während $n^1 + n^2$ 2 ist, wenn $M^1$ ein Palladiumatom oder ein Platinatom ist,
Ring $L^1$ einen aromatischen Heteroring darstellt und dieser Ring optional einen Substituenten aufweist, wobei, wenn eine Vielzahl der Substituenten vorhanden ist, diese gleich oder unterschiedlich sein können und miteinander kombiniert sein können, um zusammen mit Atomen, an die sie gebunden sind, einen Ring zu bilden, wobei, wenn eine Vielzahl von Ring $L^1$ vorhanden ist, diese gleich oder unterschiedlich sein können,
Ring $L^2$ einen aromatischen Kohlenwasserstoffring darstellt und dieser Ring optional einen Substituenten aufweist, wobei, wenn eine Vielzahl der Substituenten vorhanden ist, diese gleich oder unterschiedlich sein können und miteinander kombiniert sein können, um zusammen mit Atomen, an die sie gebunden sind, einen Ring zu bilden, wobei, wenn eine Vielzahl von Ring $L^2$ vorhanden ist, diese gleich oder unterschiedlich sein können,
Der Substituent, den Ring $L^1$ optional aufweist, und der Substituent, den Ring $L^2$ optional aufweist, können miteinander kombiniert sein, um zusammen mit Atomen, an die sie gebunden sind, einen Ring zu bilden, vorausgesetzt mindestens ein Ring, ausgewählt aus der Gruppe bestehend aus Ring $L^1$ und Ring $L^2$, weist mindestens eine Gruppe auf, die durch die Formel (1-T) dargestellt ist, wobei, wenn eine Vielzahl der durch die Formel (1-T) dargestellten Gruppen vorhanden ist, diese gleich oder unterschiedlich sein können,
$A^1$-$G^1$-$A^2$ einen anionischen zweizähnigen Liganden darstellt, $A^1$ und $A^2$ jeweils unabhängig voneinander ein Kohlenstoffatom, ein Sauerstoffatom oder ein Stickstoffatom darstellen und diese Atome Ringbestandteilatome sein können, $G^1$ eine Einfachbindung oder eine Atomgruppe darstellt, die zusammen mit $A^1$ und $A^2$ einen zweizähnigen Liganden bildet, wobei, wenn eine Vielzahl von $A^1$-$G^1$-$A^2$ vorhanden ist, diese gleich oder unterschiedlich sein können,

[Chemische Formel 2] $-R^{1T}$ (1-T)

wobei $R^{1T}$ eine Alkylgruppe, eine Cycloalkylgruppe, eine Arylgruppe, eine einwertige Heteroringgruppe, eine Alkoxygruppe, eine Cycloalkoxygruppe, eine Aryloxygruppe, eine Aminogruppe, eine substituierte Aminogruppe, eine Alkenylgruppe, eine Cycloalkenylgruppe, eine Alkinylgruppe oder eine Cycloalkinylgruppe darstellt und diese Gruppen optional einen Substituenten aufweisen.

**2.** Zusammensetzung nach Anspruch 1, wobei die durch die Formel (1) dargestellte phosphoreszierende Verbindung eine phosphoreszierende Verbindung ist, die durch die Formel (1-A) dargestellt wird:

[Chemische Formel 3]

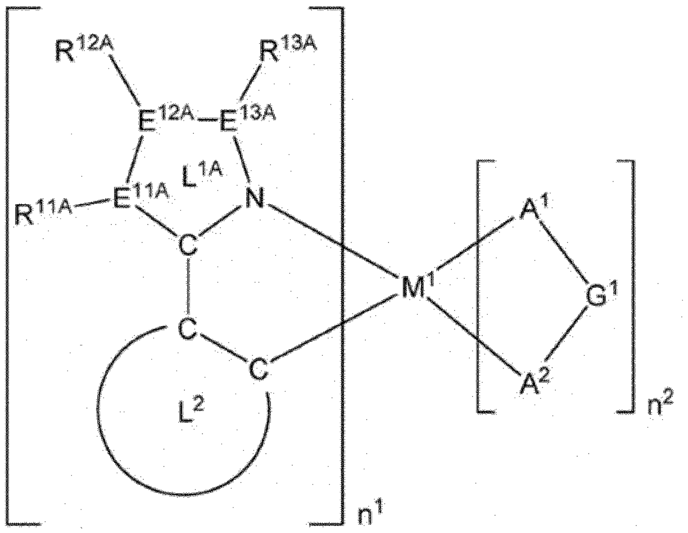

(1-A)

wobei $M^1$, $n^1$, $n^2$, Ring $L^2$ und $A^1$-$G^1$-$A^2$ die gleiche Bedeutung wie oben beschrieben haben,
Ring $L^{1A}$ einen Triazolring oder einen Diazolring darstellt, der aus einem Stickstoffatom, einem Kohlenstoffatom, $E^{11A}$, $E^{12A}$ und $E^{13A}$ besteht, wobei, wenn eine Vielzahl von Ring $L^{1A}$ vorhanden ist, diese gleich oder unterschiedlich sein können,
$E^{11A}$, $E^{12A}$ und $E^{13A}$ jeweils unabhängig voneinander ein Stickstoffatom oder ein Kohlenstoffatom darstellen, wobei, wenn eine Vielzahl von $E^{11A}$, $E^{12A}$ und $E^{13A}$ vorhanden ist, diese bei jedem Vorkommen gleich oder unterschiedlich sein können,
$R^{11A}$, $R^{12A}$ und $R^{13A}$ jeweils unabhängig voneinander ein Wasserstoffatom oder eine durch die Formel (1-T) dargestellte Gruppe darstellen, wobei, wenn eine Vielzahl von $R^{11A}$, $R^{12A}$ und $R^{13A}$ vorhanden ist, diese bei jedem Vorkommen gleich oder unterschiedlich sein können, $R^{11A}$ und $R^{12A}$ miteinander kombiniert sein können, um zusammen mit Atomen, an die sie gebunden sind, einen Ring zu bilden, $R^{12A}$ und $R^{13A}$ miteinander kombiniert sein können, um zusammen mit Atomen, an die sie gebunden sind, einen Ring zu bilden, $R^{11A}$ und der Substituent, den Ring $L^2$ optional aufweist, miteinander kombiniert sein können, um zusammen mit Atomen, an die sie gebunden sind, einen Ring zu bilden,
vorausgesetzt mindestens eines aus der Gruppe bestehend aus $R^{11A}$, $R^{12A}$, $R^{13A}$ und dem Substituenten, den Ring $L^2$ optional aufweist, ist eine Gruppe, die durch die Formel (1-T) dargestellt wird, wobei, wenn eine Vielzahl der durch die Formel (1-T) dargestellten Gruppen vorhanden ist, diese gleich oder unterschiedlich sein können, wenn $E^{11A}$ein Stickstoffatom ist, dann kann $R^{11A}$vorhanden oder nicht vorhanden sein, wenn $E^{12A}$ ein Stickstoffatom ist, dann kann $R^{12A}$ vorhanden oder nicht vorhanden sein, wenn $E^{13A}$ein Stickstoffatom ist, dann kann $R^{13A}$ vorhanden oder nicht vorhanden sein.

**3.** Zusammensetzung nach Anspruch 2, wobei die durch die Formel (1-A) dargestellte phosphoreszierende Verbindung eine phosphoreszierende Verbindung ist, die durch die Formel (1-A-2) dargestellt wird:

[Chemische Formel 4]

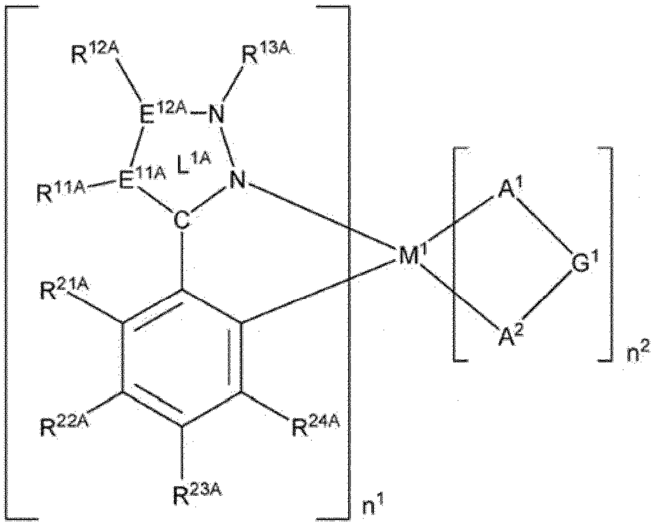

(1-A-2)

wobei

$M^1$, $n^1$, $n^2$, Ring $L^{1A}$, $E^{11A}$, $E^{12A}$, $R^{11A}$, $R^{12A}$, $R^{13A}$ und $A^1$-$G^1$-$A^2$ die gleiche Bedeutung wie oben beschrieben haben,

$R^{21A}$, $R^{22A}$, $R^{23A}$ und $R^{24A}$ jeweils unabhängig voneinander ein Wasserstoffatom oder eine durch die Formel (1-T) dargestellte Gruppe darstellen, wobei, wenn eine Vielzahl von $R^{21A}$, $R^{22A}$, $R^{23A}$ und $R^{24A}$ vorhanden ist, diese bei jedem Vorkommen gleich oder unterschiedlich sein können, $R^{21A}$ und $R^{22A}$ miteinander kombiniert sein können, um zusammen mit Atomen, an die sie gebunden sind, einen Ring zu bilden, $R^{22A}$ und $R^{23A}$ miteinander kombiniert sein können, um zusammen mit Atomen, an die sie gebunden sind, einen Ring zu bilden, $R^{23A}$ und $R^{24A}$ miteinander kombiniert sein können, um zusammen mit Atomen, an die sie gebunden sind, einen Ring zu bilden, $R^{11A}$ und $R^{21A}$ miteinander kombiniert sein können, um zusammen mit Atomen, an die sie gebunden sind, einen Ring zu bilden,

vorausgesetzt mindestens eines aus der Gruppe bestehend aus $R^{11A}$, $R^{12A}$, $R^{13A}$, $R^{21A}$, $R^{22A}$, $R^{23A}$ und $R^{24A}$ ist eine durch die Formel (1-T) dargestellte Gruppe.

**4.** Zusammensetzung nach Anspruch 1, wobei die durch die Formel (1) dargestellte phosphoreszierende Verbindung eine phosphoreszierende Verbindung ist, die durch die Formel (1-B) dargestellt wird:

[Chemische Formel 5]

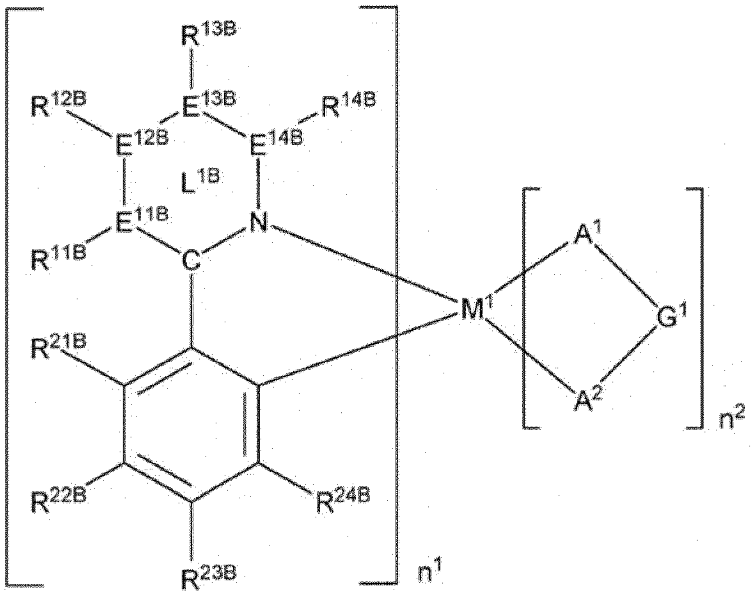

(1-B)

wobei

$M^1$, $n^1$, $n^2$ und $A^1$-$G^1$-$A^2$ die gleiche Bedeutung wie oben beschrieben haben,
$E^{11B}$, $E^{12B}$, $E^{13B}$ und $E^{14B}$ jeweils unabhängig voneinander ein Stickstoffatom oder ein Kohlenstoffatom darstellen, wobei, wenn eine Vielzahl von $E^{11B}$, $E^{12B}$, $E^{13B}$ und $E^{14B}$ vorhanden ist, diese bei jedem Vorkommen gleich oder unterschiedlich sein können, wobei, wenn $E^{11B}$ ein Stickstoffatom ist, $R^{11B}$ nicht vorhanden ist, wobei, wenn $E^{12B}$ ein Stickstoffatom ist, $R^{12B}$ nicht vorhanden ist, wobei, wenn $E^{13B}$ ein Stickstoffatom ist, $R^{13B}$ nicht vorhanden ist, wobei, wenn $E^{14B}$ ein Stickstoffatom ist, $R^{14B}$ nicht vorhanden ist,
Ring $L^{1B}$ einen Pyridinring oder einen Pyrimidinring darstellt, der aus einem Stickstoffatom, einem Kohlenstoffatom, $E^{11B}$, $E^{12B}$, $E^{13B}$ und $E^{14B}$ besteht, wobei, wenn eine Vielzahl von Ring $L^{1B}$ vorhanden ist, diese gleich oder unterschiedlich sein können,
$R^{11B}$ $R^{12B}$, $R^{13B}$, $R^{14B}$, $R^{21B}$, $R^{22B}$, $R^{23B}$ und $R^{24B}$ jeweils unabhängig voneinander ein Wasserstoffatom oder eine durch die Formel (1-T) dargestellte Gruppe darstellen, wobei, wenn eine Vielzahl von $R^{11B}$ $R^{12B}$, $R^{13B}$ $R^{14B}$, $R^{21B}$, $R^{22B}$, $R^{23B}$ und $R^{24B}$ vorhanden ist, diese bei jedem Vorkommen gleich oder unterschiedlich sein können, $R^{11B}$ und $R^{12B}$, $R^{12B}$ und $R^{13B}$, $R^{13B}$ und $R^{14B}$, $R^{11B}$ und $R^{21B}$, $R^{21B}$ und $R^{22B}$, $R^{22B}$ und $R^{23B}$ sowie $R^{23B}$ und $R^{24B}$ jeweils miteinander kombiniert sein können, um zusammen mit Atomen, an die sie gebunden sind, einen Ring zu bilden, vorausgesetzt mindestens eines aus der Gruppe bestehend aus $R^{11B}$ $R^{12B}$, $R^{13B}$ $R^{14B}$, $R^{21B}$, $R^{22B}$, $R^{23E}$ und $R^{24E}$ ist eine Gruppe, die durch die Formel (1-T) dargestellt wird.

5. Zusammensetzung nach einem der Ansprüche 1 bis 4, wobei $R^{1T}$ eine Alkylgruppe, eine Cycloalkylgruppe, eine Gruppe, die durch die Formel (D-A) dargestellt wird, eine Gruppe, die durch die Formel (D-B) dargestellt wird, oder eine Gruppe, die durch die Formel (D-C) dargestellt wird, ist:

[Chemische Formel 6]

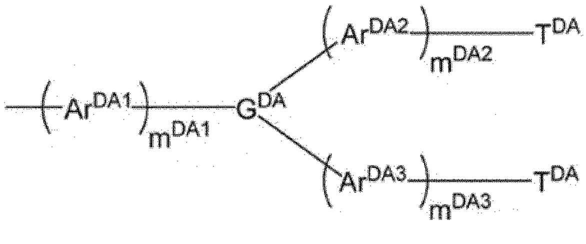

(D-A)

wobei

$m^{DA1}$, $m^{DA2}$ und $m^{DA3}$ jeweils unabhängig voneinander eine ganze Zahl von 0 oder mehr darstellen,
$G^{DA}$ ein Stickstoffatom, eine aromatische Kohlenwasserstoffgruppe oder eine Heteroringgruppe darstellt und diese Gruppen optional einen Substituenten aufweisen,
$Ar^{DA1}$, $Ar^{DA2}$ und $Ar^{DA3}$ jeweils unabhängig voneinander eine Arylengruppe oder eine zweiwertige Heteroringgruppe darstellen und diese Gruppen optional einen Substituenten aufweisen, wobei, wenn eine Vielzahl von $Ar^{DA1}$, $Ar^{DA2}$ und $Ar^{DA3}$ vorhanden ist, diese bei jedem Vorkommen gleich oder unterschiedlich sein können,
$T^{DA}$ eine Arylgruppe oder eine einwertige Heteroringgruppe darstellt und diese Gruppen optional einen Substituenten aufweisen, wobei eine Vielzahl von $T^{DA}$ gleich oder unterschiedlich sein können,

[Chemische Formel 7]

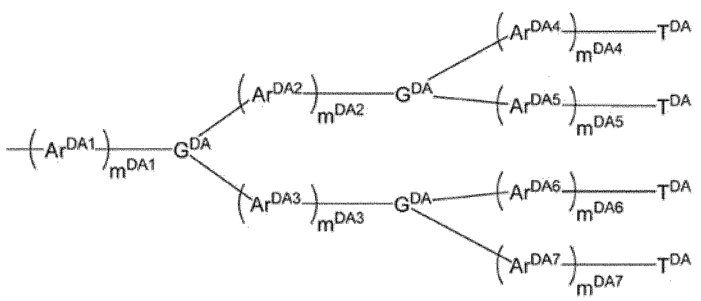

(D-B)

wobei

$m^{DA1}$, $m^{DA2}$, $m^{DA3}$, $m^{DA4}$, $m^{DA5}$, $m^{DA6}$ und $m^{DA7}$ unabhängig voneinander eine ganze Zahl von 0 oder mehr darstellen,
$G^{DA}$ ein Stickstoffatom, eine aromatische Kohlenwasserstoffgruppe oder eine Heteroringgruppe darstellt und diese Gruppen optional einen Substituenten aufweisen, wobei eine Vielzahl von $G^{DA}$ gleich oder unterschiedlich sein können,
$Ar^{DA1}$, $Ar^{DA2}$, $Ar^{DA3}$, $Ar^{DA4}$, $Ar^{DA5}$, $Ar^{DA6}$ und $Ar^{DA7}$ unabhängig voneinander eine Arylengruppe oder eine zweiwertige Heteroringgruppe darstellen und diese Gruppen optional einen Substituenten aufweisen, wobei, wenn eine Vielzahl von $Ar^{DA1}$, $Ar^{DA2}$, $Ar^{DA3}$, $Ar^{DA4}$, $Ar^{DA5}$, $Ar^{DA6}$ und $Ar^{DA7}$ vorhanden ist, diese bei jedem Vorkommen gleich oder unterschiedlich sein können,
$T^{DA}$ eine Arylgruppe oder eine einwertige Heteroringgruppe darstellt und diese Gruppen optional einen Substituenten aufweisen, wobei eine Vielzahl von $T^{DA}$ gleich oder unterschiedlich sein können,

[Chemische Formel 8]

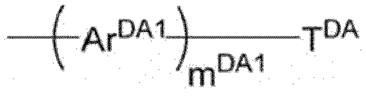

(D-C)

wobei

$m^{DA1}$ eine ganze Zahl von 0 oder mehr darstellt,
$Ar^{DA1}$ eine Arylengruppe oder eine zweiwertige Heteroringgruppe darstellt und diese Gruppen optional einen Substituenten aufweisen, wobei, wenn eine Vielzahl von $Ar^{DA1}$ vorhanden ist, diese gleich oder unterschiedlich sein können,
$T^{DA}$ eine Arylgruppe oder eine einwertige Heteroringgruppe darstellt und diese Gruppen optional einen Substituenten aufweisen.

**6.** Zusammensetzung nach einem der Ansprüche 1 bis 5, wobei, wenn der Wert des Energieniveaus im niedrigsten Singulett-angeregten Zustand der Verbindung (F) als $S_F$ (eV) ausgedrückt wird, die Formel (C) erfüllt ist:

$$|T_P|-|S_F| \geq -0.30 \qquad (C).$$

7. Zusammensetzung nach einem der Ansprüche 1 bis 6, wobei das kondensierte Heteroringgerüst sowohl ein Stickstoffatom als auch ein Boratom im Ring als Atom (a) aufweist.

8. Zusammensetzung nach einem der Ansprüche 1 bis 7, wobei die Zusammensetzung ferner eine Verbindung umfasst, die durch die Formel (H-1) dargestellt wird:

[Chemische Formel 9]

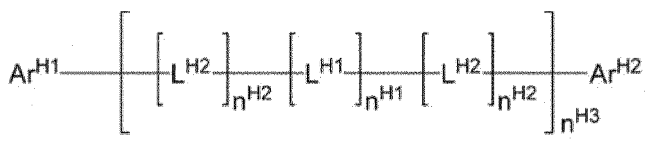

**(H-1)**

wobei

$Ar^{H1}$ und $Ar^{H2}$ jeweils unabhängig voneinander eine Arylgruppe oder eine einwertige Heteroringgruppe darstellen und diese Gruppen optional einen Substituenten aufweisen,
$n^{H1}$ und $n^{H2}$ jeweils unabhängig voneinander 0 oder 1 darstellen, wobei, wenn eine Vielzahl von $n^{H1}$ vorhanden ist, diese gleich oder unterschiedlich sein können, eine Vielzahl von $n^{H2}$ gleich oder unterschiedlich sein können,
$n^{H3}$ eine ganze Zahl von 0 oder mehr darstellt,
$L^{H1}$ eine Arylengruppe, eine zweiwertige Heteroringgruppe oder eine durch - $C(R^{H11})_2]n_{H11}$- dargestellte Gruppe darstellt und diese Gruppen optional einen Substituenten aufweisen, wobei, wenn eine Vielzahl von $L^{H1}$ vorhanden ist, diese gleich oder unterschiedlich sein können,
$n^{H11}$ eine ganze Zahl von 1 oder mehr und 10 oder weniger darstellt, $R^{H11}$ ein Wasserstoffatom, eine Alkylgruppe, eine Cycloalkylgruppe, eine Alkoxygruppe, eine Cycloalkoxygruppe, eine Arylgruppe oder eine einwertige Heteroringgruppe darstellt und diese Gruppen optional einen Substituenten aufweisen, eine Vielzahl von $R^{H11}$ gleich oder unterschiedlich sein können und miteinander kombiniert sein können, um zusammen mit Kohlenstoffatomen, an die sie gebunden sind, einen Ring zu bilden,
$L^{H2}$ eine Gruppe darstellt, die durch $-N(-L^{H21}-R^{H21})-$ dargestellt wird, wobei, wenn eine Vielzahl von $L^{H2}$ vorhanden ist, diese gleich oder unterschiedlich sein können,
$L^{H21}$ eine Einfachbindung, eine Arylengruppe oder eine zweiwertige Heteroringgruppe darstellt und diese Gruppen optional einen Substituenten aufweisen, $R^{H21}$ ein Wasserstoffatom, eine Alkylgruppe, eine Cycloalkylgruppe, eine Arylgruppe oder eine einwertige Heteroringgruppe darstellt und diese Gruppen optional einen Substituenten aufweisen.

9. Zusammensetzung nach einem der Ansprüche 1 bis 8, wobei die Zusammensetzung ferner mindestens ein Material umfasst, das aus der Gruppe ausgewählt ist, die aus einem Lochtransportmaterial, einem Lochinjektionsmaterial, einem Elektronentransportmaterial, einem Elektroneninjektionsmaterial, einem lichtemittierenden Material, einem Antioxidationsmittel und einem Lösungsmittel besteht.

10. Lichtemittierende Vorrichtung, die die Zusammensetzung nach einem der Ansprüche 1 bis 9 umfasst.

## Revendications

1. Composition, comprenant

un composé phosphorescent représenté par la formule (1), et
un composé (F) ayant un squelette d'hétéro-anneau condensé contenant au moins un atome (a) sélectionné parmi le groupe constitué d'un atome d'azote et d'un atome de bore dans l'anneau,
dans laquelle, si la valeur du niveau d'énergie de l'état excité triplet le plus bas du composé phosphorescent est exprimée sous la forme $T_P$ (eV), la valeur du niveau d'énergie de l'état excité triplet le plus bas du composé (F) est exprimée sous la forme $T_F$ (eV), et le nombre de l'atome (a) dans le squelette d'hétéro-anneau condensé par 1 000 du poids moléculaire du composé (F) est exprimé sous la forme $N_f$, alors, la formule (A) et la formule (B) sont

respectées :

$$|T_P| - |T_F| \geq 0{,}15 \qquad (A)$$

$$0{,}01 \leq N_f \leq 4{,}5 \qquad (B)$$

[Formule Chimique 1]

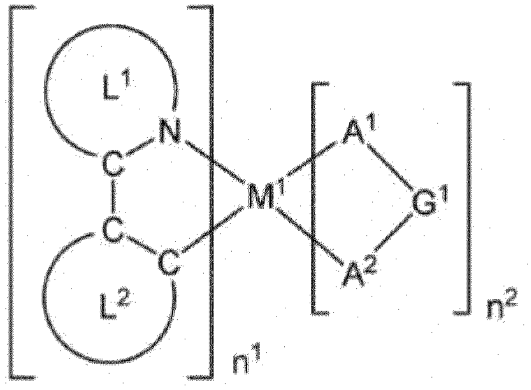

(1)

dans laquelle,

$M^1$ représente un atome de ruthénium, un atome de rhodium, un atome de palladium, un atome d'iridium, ou un atome de platine,
$n^1$ représente un nombre entier de 1 ou plus, $n^2$ représente un nombre entier de 0 ou plus, et $n^1$+$n^2$ est 2 ou 3, à condition que $n^1$+$n^2$ soit 3 lorsque $M^1$ est un atome de ruthénium, un atome de rhodium ou un atome d'iridium, alors que $n^1$+$n^2$ soit 2 lorsque $M^1$ est un atome de palladium ou un atome de platine,
l'anneau $L^1$ représente un hétéro-anneau aromatique, et cet anneau a facultativement un substituant, lorsqu'une pluralité des substituants sont présents, ils peuvent être les mêmes ou différents et peuvent être combinés ensemble pour former un anneau conjointement avec des atomes auxquels ils sont attachés, lorsqu'une pluralité de l'anneau $L^1$ sont présents, ils peuvent être les mêmes ou différents,
l'anneau $L^2$ représente un anneau hydrocarbure aromatique, et cet anneau a facultativement un substituant, lorsqu'une pluralité des substituants sont présents, ils peuvent être les mêmes ou différents et peuvent être combinés ensemble pour former un anneau conjointement avec des atomes auxquels ils sont attachés, lorsqu'une pluralité de l'anneau $L^2$ sont présents, ils peuvent être les mêmes ou différents,
le substituent que l'anneau $L^1$ a facultativement et le substituant que l'anneau $L^2$ a facultativement peuvent être combinés ensemble pour former un anneau conjointement avec des atomes auxquels ils sont attachés, à condition qu'au moins un anneau sélectionné parmi le groupe constitué de l'anneau $L^1$ et de l'anneau $L^2$ ait au moins un groupe représenté par la formule (1-T), lorsqu'une pluralité des groupes représentés par la formule (1-T) sont présents, ils peuvent être les mêmes ou différents,
$A^1$-$G^1$-$A^2$ représente un ligand bidentate anionique, $A^1$ et $A^2$ représentent chacun indépendamment un atome de carbone, un atome d'oxygène, ou un atome d'azote, et ces atomes peuvent être des atomes constituants d'anneau, $G^1$ représente une liaison unique, ou un groupe atomique constituant un ligand bidentate conjointement avec $A^1$ et $A^2$, lorsqu'une pluralité de $A^1$-$G^1$-$A^2$ sont présents, ils peuvent être les mêmes ou différents,

[Formule Chimique 2] $-R^{1T}$ (1-T)

dans laquelle, $R^{1T}$ représente un groupe alkyle, un groupe cycloalkyle, un groupe aryle, un groupe hétéro-anneau monovalent, un groupe alkoxy, un groupe cycloalkoxy, un groupe aryloxy, un groupe amino, un groupe amino substitué, un groupe alcényle, un groupe cycloalcényle, un groupe alkynyle, ou un groupe cycloalkynyle, et ces groupes ont facultativement un substituant.

**2.** Composition selon la revendication 1, dans laquelle le composé phosphorescent représenté par la formule (1) est un composé phosphorescent représenté par la formule (1-A) :

[Formule Chimique 3]

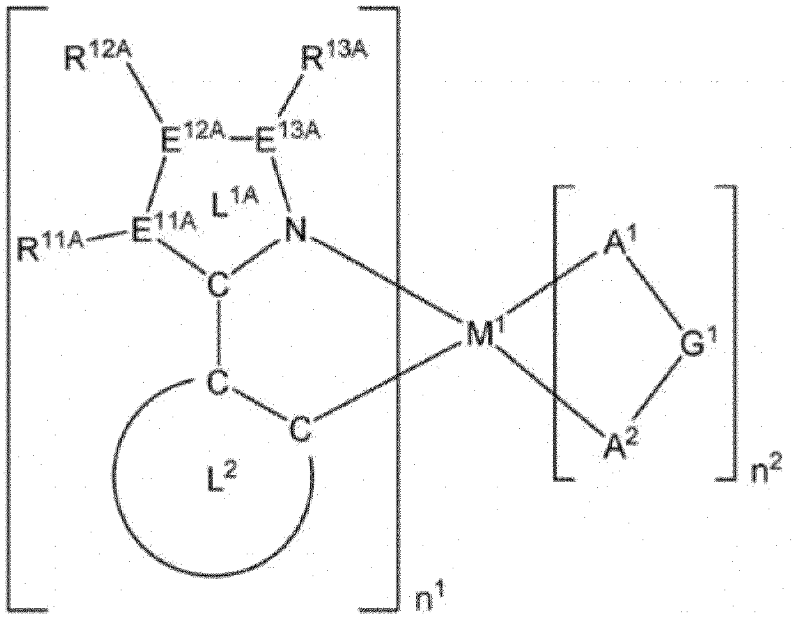

(1-A)

dans laquelle, $M^1$, $n^1$, $n^2$, l'anneau $L^2$ et $A^1$-$G^1$-$A^2$ représentent la même signification que celle décrite ci-dessus, l'anneau $L^{1A}$ représente un anneau triazole ou un anneau diazole constitué d'un atome d'azote, d'un atome de carbone, de $E^{11A}$, de $E^{12A}$, et de $E^{13A}$, lorsqu'une pluralité de l'anneau $L^{1A}$ sont présents, ils peuvent être les mêmes ou différents,

$E^{11A}$, $E^{12A}$, et $E^{13A}$ représentent chacun indépendamment un atome d'azote ou un atome de carbone, lorsqu'une pluralité de $E^{11A}$, de $E^{12A}$, et de $E^{13A}$ sont présents, ils peuvent être les mêmes ou différents dans chaque cas, $R^{11A}$, $R^{12A}$, et $R^{13A}$ représentent chacun indépendamment un atome d'hydrogène ou un groupe représenté par la formule (1-T), lorsqu'une pluralité de $R^{11A}$, de $R^{12A}$, et de $R^{13A}$ sont présents, ils peuvent être les mêmes ou différents dans chaque cas, $R^{11A}$ et $R^{12A}$ peuvent être combinés ensemble pour former un anneau conjointement avec des atomes auxquels ils sont attachés, $R^{12A}$ et $R^{13A}$ peuvent être combinés ensemble pour former un anneau conjointement avec des atomes auxquels ils sont attachés, $R^{11A}$ et le substituant que l'anneau $L^2$ a facultativement peuvent être combinés ensemble pour former un anneau conjointement avec des atomes auxquels ils sont attachés,

à condition qu'au moins un sélectionné parmi le groupe constitué de $R^{11A}$, de $R^{12A}$, et de $R^{13A}$, et du substituant que l'anneau $L^2$ a facultativement soit un groupe représenté par la formule (1-T), lorsqu'une pluralité des groupes représentés par la formule (1-T) sont présents, ils peuvent être les mêmes ou différents,

lorsque $E^{11A}$ est un atome d'azote, alors, $R^{11A}$ peut être présent ou absent, lorsque $E^{12A}$ est un atome d'azote, alors, $R^{12A}$ peut être présent ou absent, lorsque $E^{13A}$ est un atome d'azote, alors, $R^{13A}$ peut être présent ou absent.

**3.** Composition selon la revendication 2, dans laquelle le composé phosphorescent représenté par la formule (1-A) est un composé phosphorescent représenté par la formule (1-A-2) :

[Formule Chimique 4]

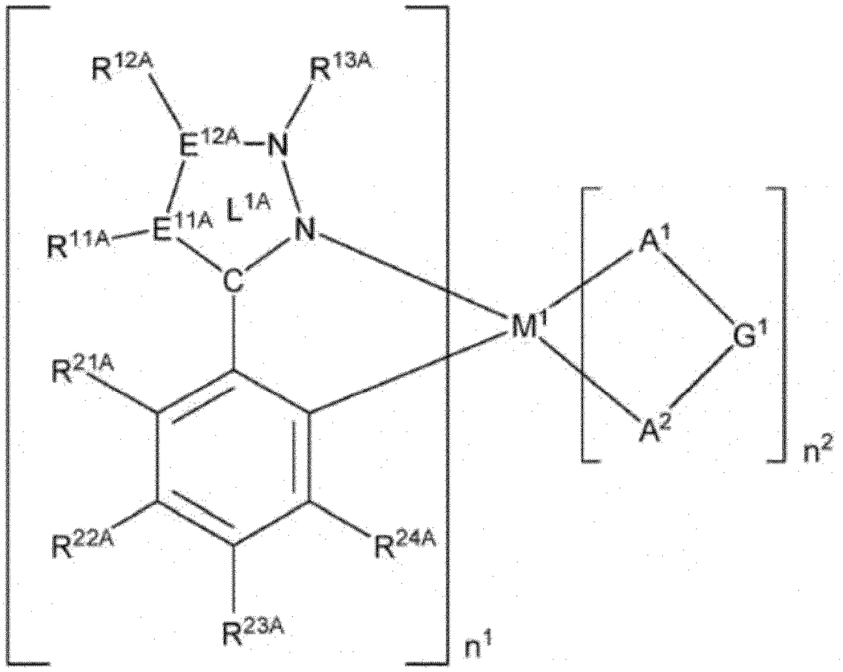

(1-A-2)

dans laquelle,

$M^1$, $n^1$, $n^2$, l'anneau $L^{1A}$, $E^{11A}$, $E^{12A}$, $R^{11A}$, $R^{12A}$, $R^{13A}$ et $A^1$-$G^1$-$A^2$ représentent la même signification que celle décrite ci-dessus,

$R^{21A}$, $R^{22A}$, $R^{23A}$, et $R^{24A}$ représentent chacun indépendamment un atome d'hydrogène ou un groupe représenté par la formule (1-T), lorsqu'une pluralité de $R^{21A}$, de $R^{22A}$, de $R^{23A}$, et de $R^{24A}$ sont présents, ils peuvent être les mêmes ou différents dans chaque cas, $R^{21A}$ et $R^{22A}$ peuvent être combinés ensemble pour former un anneau conjointement avec des atomes auxquels ils sont attachés, $R^{22A}$ et $R^{23A}$ peuvent être combinés ensemble pour former un anneau conjointement avec des atomes auxquels ils sont attachés, $R^{23A}$ et $R^{24A}$ peuvent être combinés ensemble pour former un anneau conjointement avec des atomes auxquels ils sont attachés, $R^{11A}$ et $R^{21A}$ peuvent être combinés ensemble pour former un anneau conjointement avec des atomes auxquels ils sont attachés,

à condition qu'au moins un sélectionné parmi le groupe constitué de $R^{11A}$, de $R^{12A}$, de $R^{13A}$, de $R^{21A}$, de $R^{22A}$, de $R^{23A}$, et de $R^{24A}$ soit un groupe représenté par la formule (1-T).

**4.** Composition selon la revendication 1, dans laquelle le composé phosphorescent représenté par la formule (1) est un composé phosphorescent représenté par la formule (1-B) :

[Formule Chimique 5]

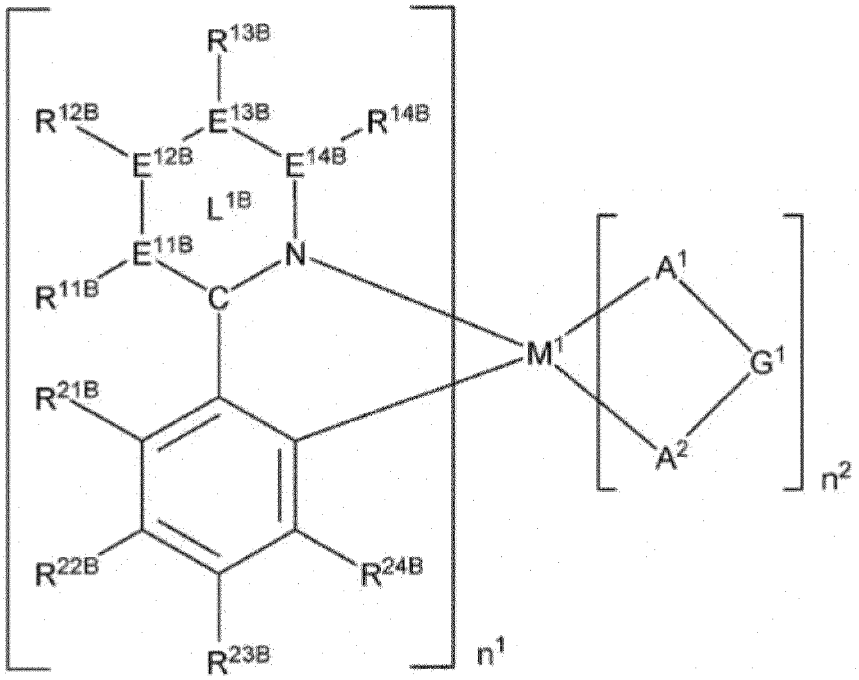

(1-B)

dans laquelle,

$M^1$, $n^1$, $n^2$ et $A^1$-$G^1$-$A^2$ représentent la même signification que celle décrite ci-dessus,
$E^{11B}$, $E^{12B}$, $E^{13B}$, et $E^{14B}$ représentent chacun indépendamment un atome d'azote ou un atome de carbone, lorsqu'une pluralité de $E^{11B}$, de $E^{12B}$, de $E^{13B}$, et de $E^{14B}$ sont présents, ils peuvent être les mêmes ou différents dans chaque cas, lorsque $E^{11B}$ est un atome d'azote, alors, $R^{11B}$ est absent, lorsque $E^{12B}$ est un atome d'azote, alors, $R^{12B}$ est absent, lorsque $E^{13B}$ est un atome d'azote, alors, $R^{13B}$ est absent, lorsque $E^{14B}$ est un atome d'azote, alors, $R^{14B}$ est absent,
l'anneau $L^{1B}$ représente un anneau pyridine ou un anneau pyrimidine constitué d'un atome d'azote, d'un atome de carbone, de $E^{11B}$, de $E^{12B}$, de $E^{13B}$, et de $E^{14B}$, lorsqu'une pluralité de l'anneau $L^{1B}$ sont présents, ils peuvent être les mêmes ou différents,
$R^{11B}$, $R^{12B}$, $R^{13B}$, $R^{14B}$, $R^{21B}$, $R^{22B}$, $R^{23B}$, et $R^{24B}$ représentent chacun indépendamment un atome d'hydrogène ou un groupe représenté par la formule (1-T), lorsqu'une pluralité de $R^{11B}$, de $R^{12B}$, de $R^{13B}$, de $R^{14B}$, de $R^{21B}$, de $R^{22B}$, de $R^{23B}$, et de $R^{24B}$ sont présents, ils peuvent être les mêmes ou différents dans chaque cas, $R^{11B}$ et $R^{12B}$, $R^{12B}$ et $R^{13B}$, $R^{13B}$ et $R^{14B}$, $R^{11B}$ et $R^{21B}$, $R^{21B}$ et $R^{22B}$, $R^{22B}$ et $R^{23B}$ et $R^{23B}$ et $R^{24B}$ peuvent chacun être combinés ensemble pour former un anneau conjointement avec des atomes auxquels ils sont attachés, à condition qu'au moins un sélectionné parmi le groupe constitué de $R^{11B}$, de $R^{12B}$, de $R^{13B}$, de $R^{14B}$, de $R^{21B}$, de $R^{22B}$, de $R^{23B}$, et de $R^{24B}$ soit un groupe représenté par la formule (1-T).

**5.** Composition selon l'une quelconque des revendications 1 à 4, dans laquelle $R^{1T}$ est un groupe alkyle, un groupe cycloalkyle, un groupe représenté par la formule (D-A), un groupe représenté par la formule (D-B) ou un groupe représenté par la formule (D-C) :

[Formule Chimique 6]

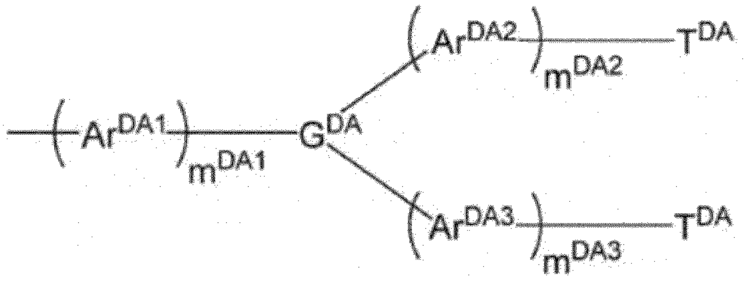

(D-A)

dans laquelle,

$m^{DA1}$, $m^{DA2}$, et $m^{DA3}$ représentent chacun indépendamment un nombre entier de 0 ou plus,
$G^{DA}$ représente un atome d'azote, un groupe hydrocarbure aromatique, ou un groupe hétéro-anneau, et ces groupes ont facultativement un substituant,
$Ar^{DA1}$, $Ar^{DA2}$, et $Ar^{DA3}$ représentent chacun indépendamment un groupe arylène ou un groupe hétéro-anneau divalent, et ces groupes ont facultativement un substituant, lorsqu'une pluralité de $Ar^{DA1}$, de $Ar^{DA2}$, et de $Ar^{DA3}$ sont présents, ils peuvent être les mêmes ou différents dans chaque cas,
$T^{DA}$ représente un groupe aryle ou un groupe hétéro-anneau monovalent, et ces groupes ont facultativement un substituant, une pluralité de $T^{DA}$ peuvent être les mêmes ou différents,

[Formule Chimique 7]

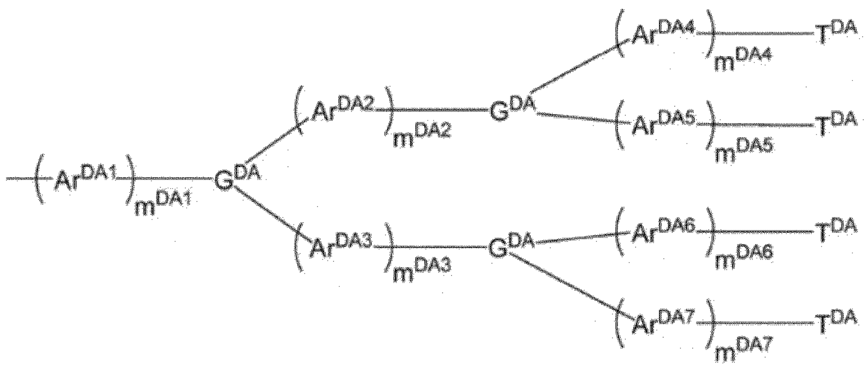

(D-B)

dans laquelle,

$m^{DA1}$, $m^{DA2}$, $m^{DA3}$, $m^{DA4}$, $m^{DA5}$, $m^{DA6}$, et $m^{DA7}$ représentent chacun indépendamment un nombre entier de 0 ou plus,
$G^{DA}$ représente un atome d'azote, un groupe hydrocarbure aromatique ou un groupe hétéro-anneau, et ces groupes ont facultativement un substituant, une pluralité de $G^{DA}$ peuvent être les mêmes ou différents,
$Ar^{DA1}$, $Ar^{DA2}$, $Ar^{DA3}$, $Ar^{DA4}$, $Ar^{DA5}$, $Ar^{DA6}$, et $Ar^{DA7}$ représentent chacun indépendamment un groupe arylène ou un groupe hétéro-anneau divalent, et ces groupes ont facultativement un substituant, lorsqu'une pluralité de $Ar^{DA1}$, de $Ar^{DA2}$, de $Ar^{DA3}$, de $Ar^{DA4}$, de $Ar^{DA5}$, de $Ar^{DA6}$, et de $Ar^{DA7}$ sont présents, ils peuvent être les mêmes ou différents dans chaque cas,
$T^{DA}$ représente un groupe aryle ou un groupe hétéro-anneau monovalent, et ces groupes ont facultativement un substituant, une pluralité de $T^{DA}$ peuvent être les mêmes ou différents,

[Formule Chimique 8]

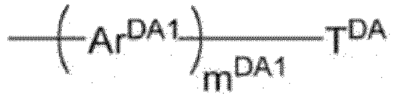

(D-C)

dans laquelle,

$m^{DA1}$ représente un nombre entier de 0 ou plus,
$Ar^{DA1}$ représente un groupe arylène ou un groupe hétéro-anneau divalent, et ces groupes ont facultativement un substituant, lorsqu'une pluralité de $Ar^{DA1}$ sont présents, ils peuvent être les mêmes ou différents,
$T^{DA}$ représente un groupe aryle ou un groupe hétéro-anneau monovalent, et ces groupes ont facultativement un substituant.

**6.** Composition selon l'une quelconque des revendications 1 à 5, dans laquelle, si la valeur du niveau d'énergie dans l'état excité singulet le plus bas du composé (F) est exprimée sous la forme $S_F$ (eV), alors, la formule (C) est respectée :

$$|T_P| - |S_F| \geq -0{,}30 \qquad (C).$$

**7.** Composition selon l'une quelconque des revendications 1 à 6, dans laquelle le squelette d'hétéro-anneau condensé a à la fois un atome d'azote et un atome de bore dans l'anneau, comme l'atome (a).

**8.** Composition selon l'une quelconque des revendications 1 à 7, dans laquelle la composition comprend en outre un composé représenté par la formule (H-1)

[Formule Chimique 9]

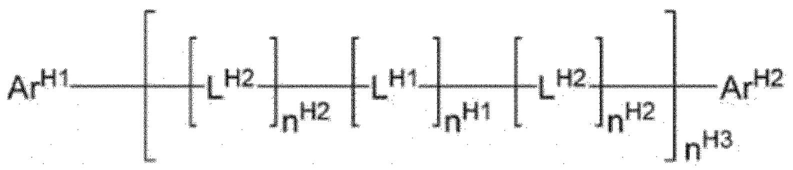

**(H-1)**

dans laquelle,

$Ar^{H1}$ et $Ar^{H2}$ représentent chacun indépendamment un groupe aryle ou un groupe hétéro-anneau monovalent, et ces groupes ont facultativement un substituant,
$n^{H1}$ et $n^{H2}$ représentent chacun indépendamment 0 ou l, lorsqu'une pluralité de $n^{H1}$ sont présents, ils peuvent être les mêmes ou différents, une pluralité de $n^{H2}$ peuvent être les mêmes ou différents,
$n^{H3}$ représente un nombre entier de 0 ou plus,
$L^{H1}$ représente un groupe arylène, un groupe hétéro-anneau divalent ou un groupe représenté par $-[C(R^{H11})_2]n_{H11}-$, et ces groupes ont facultativement un substituant, lorsqu'une pluralité de $L^{H1}$ sont présents, ils peuvent être les mêmes ou différents,
$n^{H11}$ représente un nombre entier de 1 ou plus et 10 ou moins, $R^{H11}$ représente un atome d'hydrogène, un groupe alkyle, un groupe cycloalkyle, un groupe alkoxy, un groupe cycloalkoxy, un groupe aryle ou un groupe hétéro-anneau monovalent, et ces groupes ont facultativement un substituant, une pluralité de $R^{H11}$ peuvent être les mêmes ou différents et peuvent être combinés ensemble pour former un anneau conjointement avec des atomes de carbone auxquels ils sont attachés,
$L^{H2}$ représente un groupe représenté par $-N(-L^{H21}-R^{H21})-$, lorsqu'une pluralité de $L^{H2}$ sont présents, ils peuvent être les mêmes ou différents,
$L^{H21}$ représente une liaison unique, un groupe arylène ou un groupe hétéro-anneau divalent, et ces groupes ont facultativement un substituant, $R^{H21}$ représente un atome d'hydrogène, un groupe alkyle, un groupe cycloalkyle, un groupe aryle ou un groupe hétéro-anneau monovalent, et ces groupes ont facultativement un substituant.

**9.** Composition selon l'une quelconque des revendications 1 à 8, dans laquelle la composition comprend en outre au moins un matériau sélectionné parmi le groupe constitué d'un matériau de transport de trou, d'un matériau d'injection de trou, d'un matériau de transport d'électron, d'un matériau d'injection d'électron, d'un matériau luminescent, d'un antioxydant, et d'un solvant.

**10.** Dispositif luminescent, comprenant la composition telle que décrite dans l'une quelconque des revendications 1 à 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2015207077 A1
- US 2018040821 A1
- US 2017166599 A1
- WO 2017018326 A
- WO 2004026886 A
- WO 2006121811 A
- WO 2011024761 A
- WO 2007097153 A
- JP 2009239279 A
- JP 2012033845 A
- JP 2012216821 A
- JP 2012216822 A
- JP 2012216815 A
- WO 2017130977 A
- JP 2013147451 A
- WO 2017170916 A
- JP 2013237789 A
- WO 2009131255 A
- WO 2015102118 A
- JP 2015110751 A
- JP 2013147551 A
- WO 2008090795 A
- WO 2016006523 A
- WO 2015145871 A
- WO 2013146806 A
- WO 2005049546 A
- JP 2010189630 A
- WO 2012086671 A
- JP 2012036388 A
- WO 2013191088 A
- WO 2019004248 A


### Non-patent literature cited in the description


- *Journal of the American Chemical Society*, 1985, vol. 107, 1431-1432
- *Journal of The American Chemical Society*, 1984, vol. 106, 6647-6653
- *J. Phys. Chem. B*, 2005, vol. 109 (16), 8008-8016
- *Angewandte Chemie*, 2018, vol. 57, 11316-11320
- *Angew. Chem. Int. Ed.*, 2020, vol. 59, 17442-17446